# EUROPEAN PATENT SPECIFICATION

(11) **EP 4 507 479 B1**
(45) Date of publication and mention of the grant of the patent: **23.09.2026**
(21) Application number: 24172102.6
(22) Date of filing: 24.04.2024
(51) Int. Cl.: H10K 85/30, H10K 50/11, H10K 101/10, C09K 11/06, C07F 15/00

(54) **LIGHT-EMITTING DEVICE INCLUDING ORGANOMETALLIC COMPOUND, ELECTRONIC APPARATUS INCLUDING THE LIGHT-EMITTING DEVICE, AND THE ORGANOMETALLIC COMPOUND**
LICHTEMITTIERENDE VORRICHTUNG MIT ORGANOMETALLISCHER VERBINDUNG, ELEKTRONISCHE VORRICHTUNG MIT DER LICHTEMITTIERENDEN VORRICHTUNG UND ORGANOMETALLISCHE VERBINDUNG
DISPOSITIF ÉLECTROLUMINESCENT COMPRENANT UN COMPOSÉ ORGANOMÉTALLIQUE, APPAREIL ÉLECTRONIQUE COMPRENANT LE DISPOSITIF ÉLECTROLUMINESCENT ET LE COMPOSÉ ORGANOMÉTALLIQUE

(30) Priority: 07.08.2023 KR 20230103126
(43) Date of publication of application: 12.02.2025
(60) Divisional application: 26193899.7 / 4 803 527
(73) Proprietor: Samsung Display Co., Ltd., Yongin-si, Gyeonggi-do 17113 (KR)
(72) Inventor: Oh, Chanseok, 17113 Yongin-si, Gyeonggi-do (KR); Kim, Sungbum, 17113 Yongin-si, Gyeonggi-do (KR); Ahn, Seihwan, 17113 Yongin-si, Gyeonggi-do (KR); Lee, Jaesung, 17113 Yongin-si, Gyeonggi-do (KR); Lee, Jihyung, 17113 Yongin-si, Gyeonggi-do (KR); Ju, Jinhee, 17113 Yongin-si, Gyeonggi-do (KR); Han, Junghoon, 17113 Yongin-si, Gyeonggi-do (KR)
(74) Representative: Gulde & Partner

(56) References cited:
- EP-A1- 3 940 805
- WO-A1-2024/158229
- US-A1- 2023 165 134

## Description

### BACKGROUND

### 1. Field

One or more aspects of embodiments of the present invention relate to an organometallic compound, a light-emitting device including the organometallic compound, and an electronic apparatus including the light-emitting device.

### 2. Description of the Related Art

From among light-emitting devices, self-emissive devices have relatively wide viewing angles, relatively high contrast ratios, relatively short response times, and excellent or suitable characteristics in terms of luminance, driving voltage, and response speed.

In a light-emitting device, a first electrode may be arranged on a substrate, and a hole transport region, an emission layer, an electron transport region, and a second electrode may sequentially be arranged on the first electrode. Holes provided from the first electrode move toward the emission layer through the hole transport region, and electrons provided from the second electrode move toward the emission layer through the electron transport region. Carriers, such as the holes and the electrons, recombine in the emission layer to produce excitons. The excitons may transition (i.e., relax) from an excited state to a ground state to thereby generate light. For example, US 2023/165134 A1 discloses transition metal compounds having 1,2,3-triazine and formulations comprising these transition metal compounds having 1,2,3-triazine. WO 2024/158229 A1 describes multifunctional compounds and an organic light-emitting diode comprising same. EP 3 940 805 A1 relates to a light-emitting device comprising a first compound and a second compound, a third compound, a fourth compound, or any combination thereof, each having a specific formula.

### SUMMARY

The invention is defined by the appended claims. The description that follows is subjected to this limitation. Any invention lying outside the scope of said claims is only intended for illustrative as well as comparative purposes.

One or more aspects of embodiments of the present invention are directed towards an organometallic compound, a light-emitting device including the organometallic compound, an electronic apparatus including the light-emitting device, and the organometallic compound.

Additional aspects will be set forth in part in the description which follows and, in part, will be apparent from the description, or may be learned by practice of the presented embodiments of the invention.

According to a first aspect of the present invention , an organometallic compound is represented by Formula 1-1 or Formula 1-2: 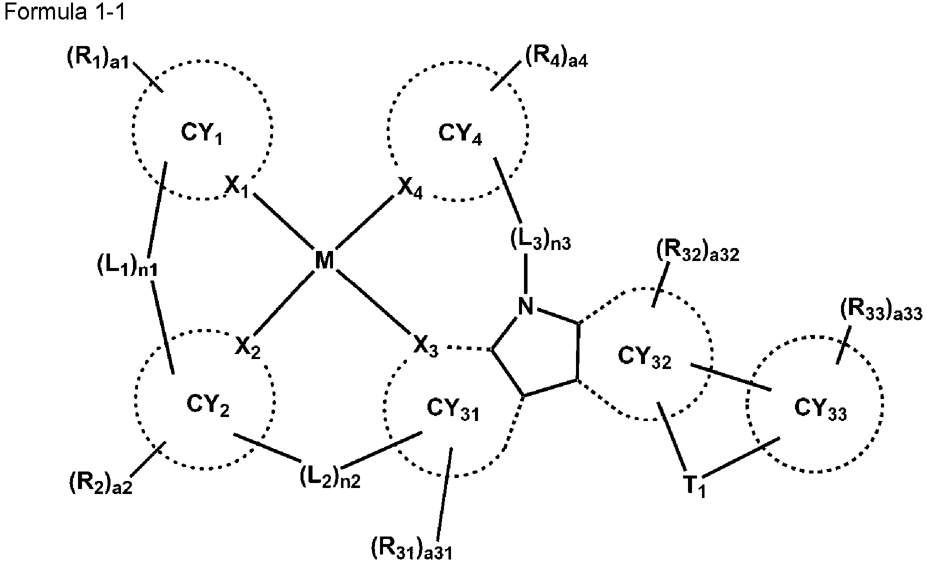 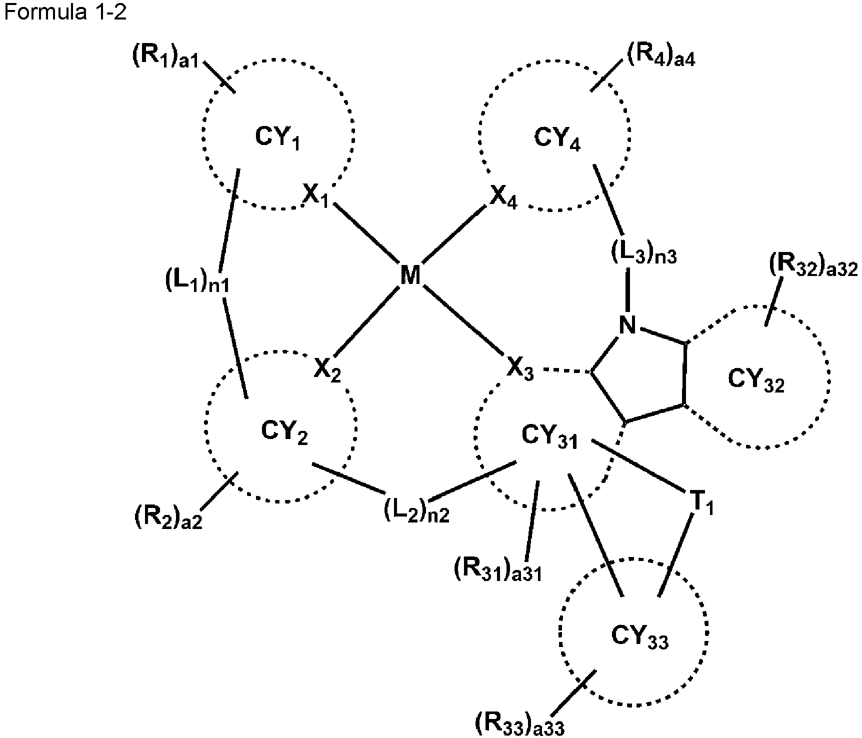 wherein, in Formulae 1-1 and 1-2,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₁ to X₄ are each independently C or N,
ring CY₁, ring CY₂, ring CY₃₁ to ring CY₃₃, and ring CY₄ are each independently a C₅-C₃₀ carbocyclic group or a C₁-C₃₀ heterocyclic group,
L₁ to L₃ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', wherein * and *' each indicate a binding site to a neighboring atom,
n1 to n3 are each independently an integer from 1 to 5,
in Formulae 1-1 and 1-2, T₁ is a group represented by Formula T-1 or T-2: 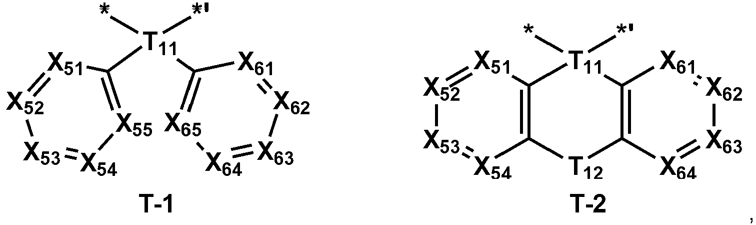 and
wherein, in Formulae T-1 and T-2,
   T₁₁ is C, Si, or Ge,
   T₁₂ is a single bond, *-C(Z₃)(Z₄)-*', *-Si(Z₃)(Z₄)-*', or *-Ge(Z₃)(Z₄)-*', wherein * and *' each indicate a binding site to a neighboring atom,
   X₅₁ is C(Z₁₁) or N, X₅₂ is C(Z₁₂) or N, X₅₃ is C(Z₁₃) or N, X₅₄ is C(Z₁₄) or N, and X₅₅ is C(Z₁₅) or N,
   X₆₁ is C(Z₂₁) or N, X₆₂ is C(Z₂₂) or N, X₆₃ is C(Z₂₃) or N, X₆₄ is C(Z₂₄) or N, and X₆₅ is C(Z₂₅) or N,
   Z₁₁ to Z₁₅ and Z₃, Z₂₁ to Z₂₅ and Z₄are each independently a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ,a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),,
   two or more neighboring groups of Z₁₁ to Z₁₅, Z₂₁ to Z₂₅, Z₃, and Z₄ are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and
   * and *' each indicate a binding site to a neighboring atom,

      ,
   R₁, R₂, R₃₁ to R₃₃, R₄, R₁ₐ, and R_{1b} are independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
   at least one R₁ is a group represented by Formula S1: 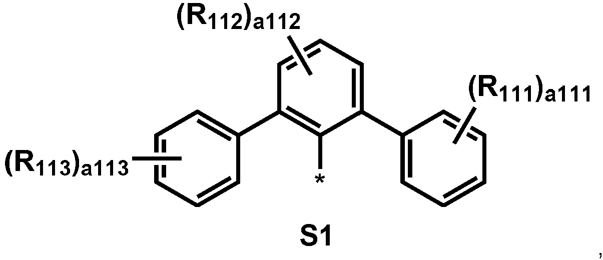 and
   wherein, in Formula S1,
      R₁₁₁ to R₁₁₃ are each defined as in connection with R₁ in Formula 1-1 or Formula 1-2,
      a111 is an integer from 1 to 5,
      a112 is an integer from 1 to 3,
      a113 is an integer from 1 to 5, and
      * indicates a binding site to a neighboring atom,
      a2, a31 to a33, and a4 are each independently an integer from 1 to 20,
      two or more neighboring groups of R₁ in the number of a1, R₂ in the number of a2, R₃₁ in the number of a31, R₃₂ in the number of a32, R₃₃ in the number of a33, and R₄ in the number of a4 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
      R₁₀ₐ is
      hydrogen, -F, -Cl, -Br, -I, a hydroxyl group, a cyano group, or a nitro group,
      a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof,
      a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof, or
      -Si(Q₃₁)(Q₃₂)(Q₃₃), -N(Q₃₁)(Q₃₂), -B(Q₃₁)(Q₃₂), -C(=O)(Q₃₁), -S(=O)2(Q₃₁), or - P(=O)(Q₃₁)(Q₃₂), and
      Q₁ to Q₃, Q₁₁ to Q₁₃, Q₂₁ to Q₂₃, and Q₃₁ to Q₃₃ may each independently be hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group, or
      a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

Similar compounds are disclosed in US2023/165134 and EP3940805.

According to a second aspect of the present invention a light-emitting device comprises a first electrode; a second electrode facing the first electrode; an interlayer between the first electrode and the second electrode and comprises an emission layer; wherein the light-emitting device comprises an organometallic compound according to the first aspect.

According to a third aspect, an electronic apparatus includes the light-emitting device according to the second aspect.

According to a fourth aspect, an electronic equipment includes the light-emitting device.

### BRIEF DESCRIPTION OF THE DRAWINGS

The accompanying drawings are included to provide a further understanding of the preceding and other aspects, features, and advantages of certain embodiments of the present invention are incorporated in and constitute a part of this specification. The drawings illustrate example embodiments and, together with the following description taken in conjunction with the accompanying drawings, serve to make the principles of the present invention more apparent. In the drawings:
FIG. 1 is a schematic view of the structure of a light-emitting device according to one or more embodiments of the present invention.
FIG. 2 is a schematic cross-sectional view of the structure of an electronic apparatus according to one or more embodiments of the present invention.
FIG. 3 is a schematic cross-sectional view of the structure of an electronic apparatus according to one or more embodiments of the present invention; and
FIG. 4 is a schematic perspective view of the structure of electronic equipment including a light-emitting device according to one or more embodiments of the present invention.
FIG. 5 is a perspective view of the exterior of a vehicle as electronic equipment including a light-emitting device according to one or more embodiments of the present invention;
FIGS. 6A-6C are each a schematic view of the interior of a vehicle that includes electronic equipment including a light-emitting device according to one or more embodiments of the present invention.

### DETAILED DESCRIPTION

Reference will now be made in more detail to embodiments of the present invention, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described, by referring to the drawings, to explain aspects of the present description.

As utilized herein, the term "and/or" includes any and all combinations of one or more of the associated listed items. Expressions such as "at least one of," "one of," and "selected from," when preceding a list of elements, modify the entire list of elements and do not modify the individual elements of the list. For example, throughout the invention, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

The terminology used herein is for the purpose of describing embodiments and is not intended to limit the embodiments described herein. Unless otherwise defined, all chemical names, technical and scientific terms, and terms defined in common dictionaries should be interpreted as having meanings consistent with the context of the related art, and should not be interpreted in an ideal or overly formal sense. It will be understood that, although the terms first, second, and/or the like may be used herein to describe various elements, these elements should not be limited by these terms. These terms are only used to distinguish one element from another element. Thus, a first element could be termed a second element without departing from the teachings of the present invention. Similarly, a second element could be termed a first element.

As used herein, singular forms such as "a," "an," and "the" are intended to include the plural forms as well, unless the context clearly indicates otherwise.

It will be further understood that the terms "comprise," "comprises," "comprising," "has," "have," "having," "include," "includes," and/or " including," when used in this specification, specify the presence of stated features, steps, operations, elements, and/or components, but do not preclude the presence or addition of one or more other features, steps, operations, elements, components, and/or groups thereof.

As used herein, the terms "use," "using," and "used" may be considered synonymous with the terms "utilize," "utilizing," and "utilized," respectively.

As used herein, the term "and/or" includes any, and all, combination(s) of one or more of the associated listed items.

The term "may" will be understood to refer to "one or more embodiments of the present invention," some of which include the described element and some of which exclude that element and/or include an alternate element. Similarly, alternative language such as "or" refers to "one or more embodiments of the present invention," each including a corresponding listed item.

It will be understood that when an element is referred to as being "on," "connected to," or "on" another element, it may be directly on, connected, or coupled to the other element or one or more intervening elements may also be present. When an element is referred to as being "directly on," "directly connected to," or "directly coupled to" another element, there are no intervening elements present.

Spatially relative terms, such as "beneath," "below," "lower," "above," "upper," "bottom," "top," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

In this context, "consisting essentially of" means that any additional components will not materially affect the chemical, physical, optical or electrical properties of the semiconductor film.

Further, in this specification, the phrase "on a plane," or "plan view," means viewing a target portion from the top, and the phrase "on a cross-section" means viewing a cross-section formed by vertically cutting a target portion from the side.

An aspect of the invention provides a light-emitting device including:
a first electrode;
a second electrode facing the first electrode;
an interlayer arranged between the first electrode and the second electrode and including an emission layer; and
an organometallic compound represented by Formula 1-1 or Formula 1-2: 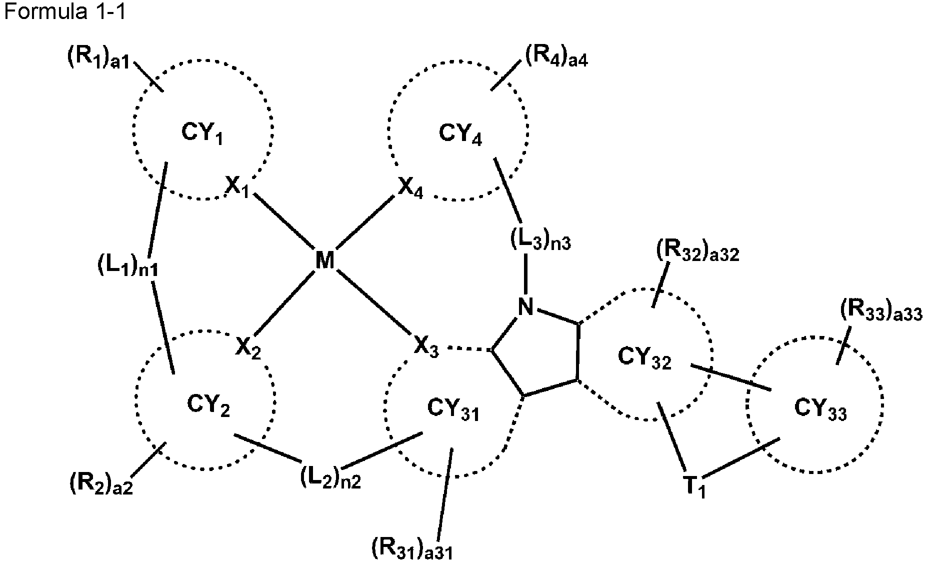 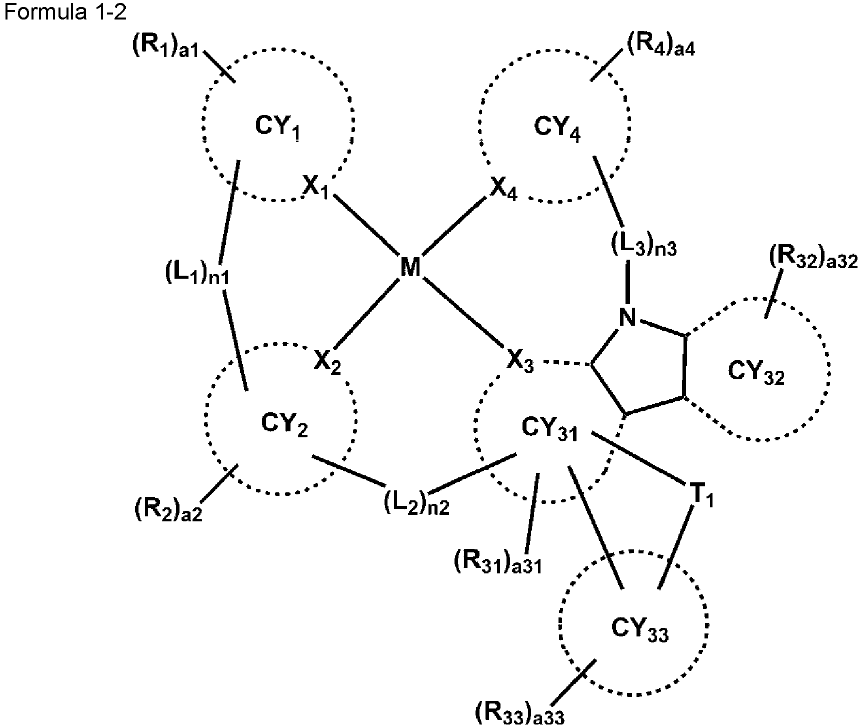
wherein Formulae 1-1 and 1-2 are each as described herein.

In one or more embodiments,
the first electrode of the light-emitting device may be an anode,
the second electrode of the light-emitting device may be a cathode,
the interlayer may further include a hole transport region arranged between the first electrode and the emission layer and an electron transport region arranged between the emission layer and the second electrode,
the hole transport region may include a hole injection layer, a hole transport layer, an emission auxiliary layer, an electron blocking layer, or any combination thereof, and
the electron transport region may include a hole blocking layer, an electron transport layer, an electron injection layer, or any combination thereof.

In one or more embodiments, the interlayer of the light-emitting device includes the organometallic compound represented by Formula 1-1 or Formula 1-2.

In one or more embodiments, the emission layer of the light-emitting device may include the organometallic compound represented by Formula 1-1 or Formula 1-2.

In one or more embodiments, the emission layer of the light-emitting device may include a dopant and a host, and the dopant may include the organometallic compound represented by Formula 1-1 or Formula 1-2. For example, the organometallic compound may act as a dopant. For example, the emission layer may be to emit (e.g., configured to emit) blue light. The blue light may have a maximum emission wavelength in a range of, for example, about 430 nm to about 480 nm.

In one or more embodiments, the electron transport region of the light-emitting device may include a hole blocking layer, and the hole blocking layer may include a phosphine oxide-containing compound, a silicon-containing compound, or any combination thereof. For example, the hole blocking layer may directly contact the emission layer.

In one or more embodiments, the light-emitting device may further include a second compound including at least one π electron-deficient nitrogen-containing C₁-C₆₀ heterocyclic group, a third compound including a group represented by Formula 3, a fourth compound capable of emitting delayed fluorescence, or any combination thereof, and
the organometallic compound, the second compound, the third compound, and the fourth compound in the light-emitting device may be different from each other: 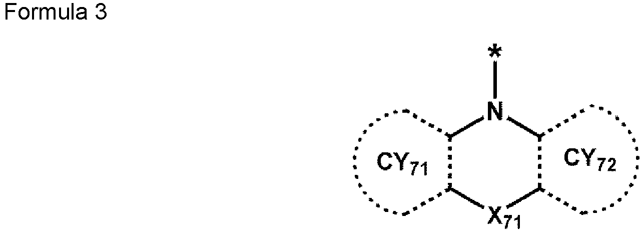
wherein, in Formula 3,
   ring CY₇₁ and ring CY₇₂ may each independently be a π electron-rich C₃-C₆₀ cyclic group or a pyridine group,
   X₇₁ may be a single bond, or a linking group including O, S, N, B, C, Si, or any combination thereof, and
   * indicates a binding site to any atom included in a remaining portion of the third compound other than the group represented by Formula 3.

In one or more embodiments, the organometallic compound may include at least one deuterium.

In one or more embodiments, the second compound to the fourth compound may each include at least one deuterium.

In one or more embodiments, the second compound may include at least one silicon.

In one or more embodiments, the third compound may include at least one silicon.

In one or more embodiments, the light-emitting device may further include a second compound and a third compound, in addition to the organometallic compound represented by Formula 1-1 or Formula 1-2, wherein at least one of the second compound and the third compound may include at least one deuterium, at least one silicon, or a combination thereof.

In one or more embodiments, the light-emitting device (e.g., the emission layer in the light-emitting device) may further include a second compound, in addition to the organometallic compound. At least one of the organometallic compound and the second compound may include at least one deuterium. For example, the light-emitting device (e.g., the emission layer in the light-emitting device) may further include a third compound, a fourth compound, or any combination thereof, in addition to the organometallic compound and the second compound.

In one or more embodiments, the light-emitting device (e.g., the emission layer in the light-emitting device) may further include a third compound, in addition to the organometallic compound. At least one of the organometallic compound and the third compound may include at least one deuterium. For example, the light-emitting device (e.g., the emission layer in the light-emitting device) may further include a second compound, a fourth compound, or any combination thereof, in addition to the organometallic compound and the third compound.

In one or more embodiments, the light-emitting device (e.g., the emission layer in the light-emitting device) may further include a fourth compound, in addition to the organometallic compound. At least one of the organometallic compound and the fourth compound may include at least one deuterium. The fourth compound may serve to improve the color purity, luminescence efficiency, and lifespan characteristics of the light-emitting device. For example, the light-emitting device (e.g., the emission layer in the light-emitting device) may further include a second compound, a third compound, or any combination thereof, in addition to the organometallic compound and the fourth compound.

In one or more embodiments, the light-emitting device (e.g., the emission layer in the light-emitting device) may further include a second compound and a third compound, in addition to the organometallic compound. The second compound and the third compound may form an exciplex. At least one of the organometallic compound, the second compound, and the third compound may include at least one deuterium.

In one or more embodiments, the emission layer of the light-emitting device may include: i) the organometallic compound; and ii) the second compound, the third compound, the fourth compound, or any combination thereof, wherein the emission layer may be to emit (e.g., configured to emit) blue light.

In one or more embodiments, the blue light may have a maximum emission wavelength in a range of about 430 nm to about 480 nm, about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

In one or more embodiments, the second compound may include a pyridine group, a pyrimidine group, a pyrazine group, a pyridazine group, a triazine group, or any combination thereof.

In one or more embodiments, the following compounds may be excluded (e.g., not be included) from the third compound:

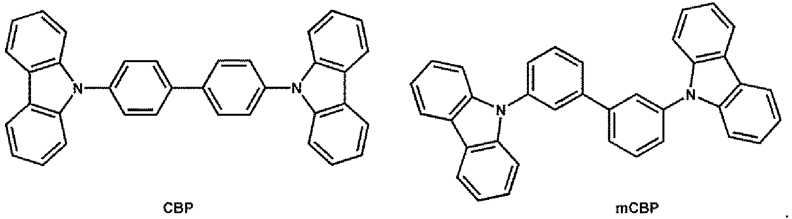

In present invention, "compound(s)" that may "not be included from a 'compound'", "be excluded from a 'compound''', and/or the like refers to that the "compound(s)" not being added, selected or utilized as the "compound" or a component in the composition, but the "excluded" compound(s) of less than a suitable amount may still be included due to other impurities and/or external factors.

In one or more embodiments, a difference between a triplet energy level (electron volt (eV)) of the fourth compound and a singlet energy level (eV) of the fourth compound may be 0 eV or more and 0.5 eV or less (or, 0 eV or more and 0.3 eV or less).

In one or more embodiments, the fourth compound may be a compound including at least one cyclic group including boron (B) and nitrogen (N) as ring-forming atoms.

In one or more embodiments, the fourth compound may be a C₈-C₆₀ polycyclic group-containing compound including at least two condensed cyclic groups that share boron (B).

In one or more embodiments, the fourth compound may include a condensed ring in which at least one third ring is condensed with at least one fourth ring,

the third ring may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norbornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and

the fourth ring may be a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In one or more embodiments, the third compound may not include (e.g., may exclude) a compound represented by Formula 3-1 described herein.

In one or more embodiments, the second compound may include a compound represented by Formula 2: 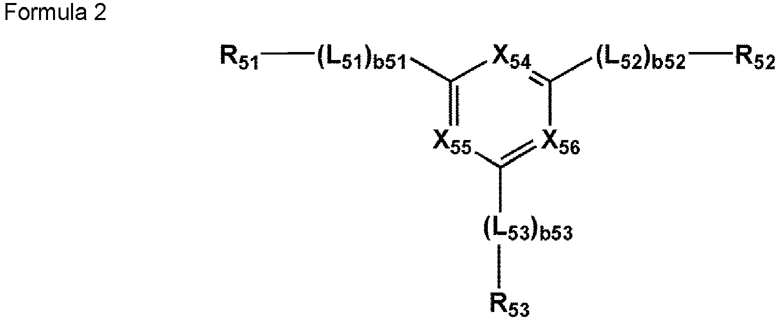 wherein, in Formula 2,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
X₅₄ may be N or C(R₅₄), X₅₅ may be N or C(R₅₅), X₅₆ may be N or C(R₅₆), and at least one of X₅₄ to X₅₆ may be N, and
R₅₁ to R₅₆ and R₁₀ₐ may each be as described herein.

In one or more embodiments, the third compound may include a compound represented by Formula 3-1, a compound represented by Formula 3-2, a compound represented by Formula 3-3, a compound represented by Formula 3-4, a compound represented by Formula 3-5, or any combination thereof: 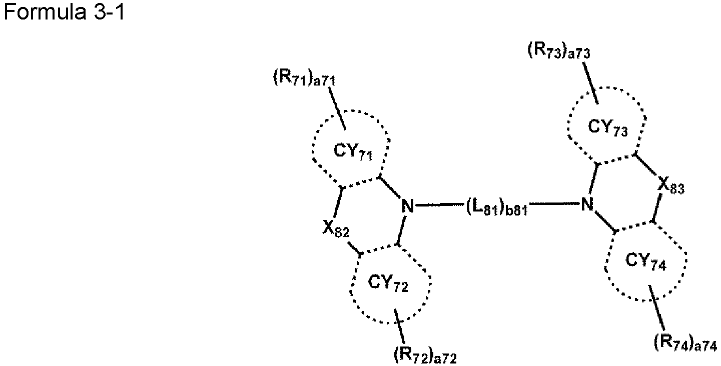 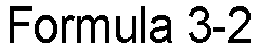 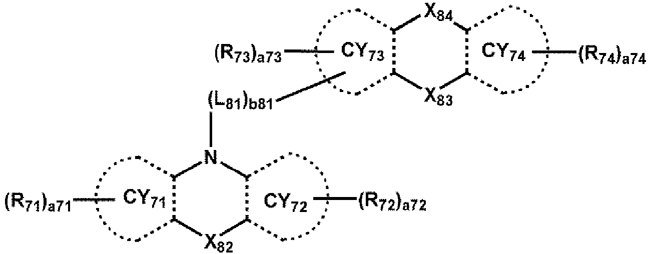 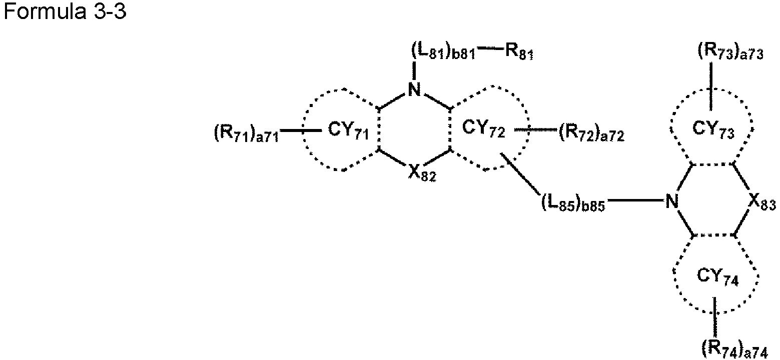 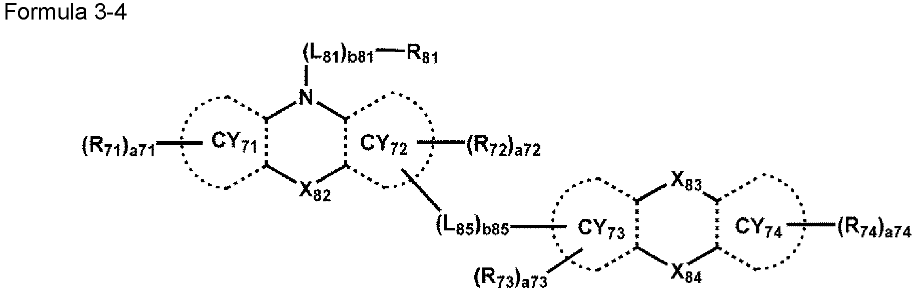 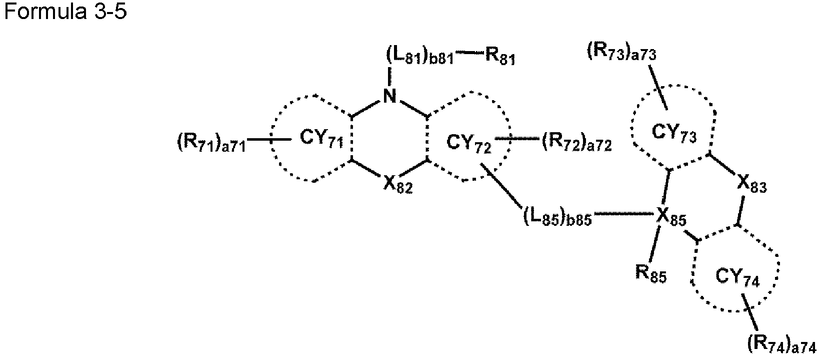 wherein, in Formulae 3-1 to 3-5,
ring CY₇₁ to ring CY₇₄ may each independently be a π electron-rich C₃-C₆₀ cyclic group or a pyridine group,
X₈₂ may be a single bond, O, S, N-[(L₈₂)_{b82}-R₈₂], C(R₃₂ₐ)(R_{32b}), or Si(R₃₂ₐ)(R_{32b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ, wherein Q₄ and Q₅ may each be as described in connection with Q₁,
b81 to b85 may each independently be an integer from 1 to 5,
R₇₁ to R₇₄, R₈₁ to R₃₃, R₃₂ₐ, R_{82b}, R₈₃ₐ, R_{83b}, R₈₄ₐ, and R_{84b} may each be as described herein,
a71 to a74 may each independently be an integer from 0 to 20, and
R₁₀ₐ may be as described herein.

In one or more embodiments, the fourth compound may include a compound represented by Formula 502, a compound represented by Formula 503, or any combination thereof: 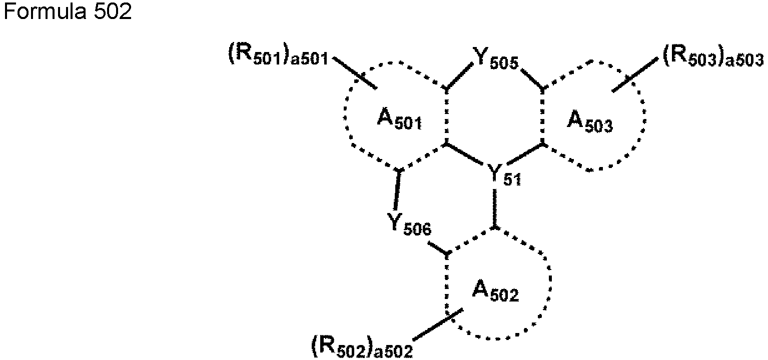 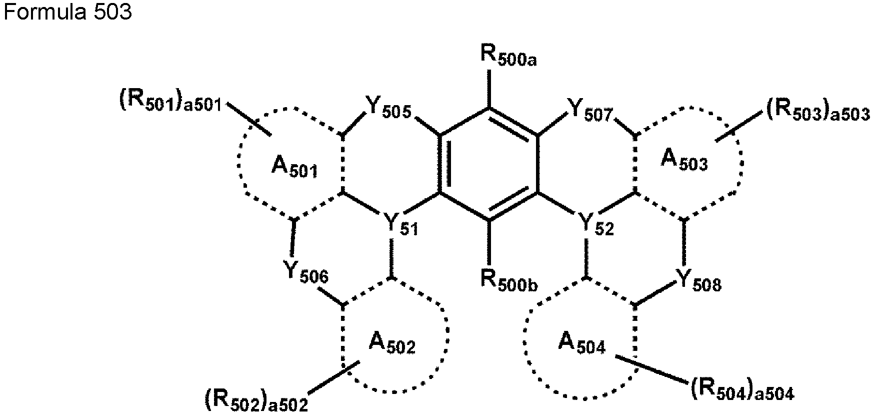 wherein, in Formulae 502 and 503,
ring A₅₀₁ to ring A₅₀₄ may each independently be a C₃-C₆₀ carbocyclic group or a C₁-C₆₀ heterocyclic group,
Y₅₀₅ may be O, S, N(R₅₀₅), B(R₅₀₅), C(R₅₀₅ₐ)(R_{505b}), or Si(R₅₀₅ₐ)(R_{505b}),
Y₅₀₆ may be O, S, N(R₅₀₆), B(R₅₀₆), C(R₅₀₆ₐ)(R_{506b}), or Si(R₅₀₆ₐ)(R_{506b}),
Y₅₀₇ may be O, S, N(R₅₀₇), B(R₅₀₇), C(R₅₀₇ₐ)(R_{507b}), or Si(R₅₀₇ₐ)(R_{507b}),
Y₅₀₈ may be O, S, N(R₅₀₈), B(R₅₀₈), C(R₅₀₈ₐ)(R_{508b}), or Si(R₅₀₈ₐ)(R_{508b}),
Y₅₁ and Y₅₂ may each independently be B, P(=O), or S(=O),
R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} may each be as described herein, and
a501 to a504 may each independently be an integer from 0 to 20.

In one or more embodiments, the light-emitting device may satisfy at least one of (e.g., at least one selected from among) Conditions 1 to 4:

### Condition 1

lowest unoccupied molecular orbital (LUMO) energy level (eV) of third compound > LUMO energy level (eV) of organometallic compound

### Condition 2

LUMO energy level (eV) of organometallic compound > LUMO energy level (eV) of second compound

### Condition 3

highest occupied molecular orbital (HOMO) energy level (eV) of organometallic compound > HOMO energy level (eV) of third compound

### Condition 4

HOMO energy level (eV) of third compound > HOMO energy level (eV) of second compound.

Each of the HOMO energy level and LUMO energy level of each of the organometallic compound, the second compound, and the third compound may be a negative value, and may be measured according to a suitable method.

In one or more embodiments, the absolute value of a difference between the LUMO energy level of the organometallic compound and the LUMO energy level of the second compound may be 0.1 eV or more and 1.0 eV or less or the absolute value of a difference between the LUMO energy level of the organometallic compound and the LUMO energy level of the third compound may be 0.1 eV or more and 1.0 eV or less, and the absolute value of a difference between the HOMO energy level of the organometallic compound and the HOMO energy level of the second compound may be 1.25 eV or less (e.g., 1.25 eV or less and 0.2 eV or more) or the absolute value of a difference between the HOMO energy level of the organometallic compound and the HOMO energy level of the third compound may be 1.25 eV or less (e.g., 1.25 eV or less and 0.2 eV or more).

When the relationships between LUMO energy level and HOMO energy level satisfy the conditions as described, a balance between holes and electrons injected into the emission layer may be achieved.

The light-emitting device may have a structure of a first embodiment or a second embodiment.

### First embodiment

According to the first embodiment, the organometallic compound may be included in the emission layer in the interlayer of the light-emitting device, wherein the emission layer may further include a host, the organometallic compound may be different from the host, and the emission layer may be to emit (e.g., configured to emit) phosphorescence or fluorescence emitted from the organometallic compound. For example, according to the first embodiment, the organometallic compound may be a dopant or an emitter. For example, the organometallic compound may be a phosphorescent dopant or a phosphorescent emitter.

Phosphorescence or fluorescence emitted from the organometallic compound may be blue light.

The emission layer may further include an auxiliary dopant. The auxiliary dopant may serve to improve luminescence efficiency from the organometallic compound by effectively transferring energy to the organometallic compound as a dopant or an emitter.

The auxiliary dopant may be different from the organometallic compound and the host.

In one or more embodiments, the auxiliary dopant may be a delayed fluorescence-emitting compound.

In one or more embodiments, the auxiliary dopant may be a compound including at least one cyclic group including boron (B) and nitrogen (N) as ring-forming atoms.

### Second embodiment

According to the second embodiment, the organometallic compound may be included in the emission layer in the interlayer of the light-emitting device, wherein the emission layer may further include a host and a dopant, the organometallic compound, the host, and the dopant may be different from one another, and the emission layer may be to emit (e.g., configured to emit) phosphorescence or fluorescence (e.g., delayed fluorescence) emitted from the dopant.

In one or more embodiments, the organometallic compound in the second embodiment may serve not as a dopant, but as an auxiliary dopant that transfers energy to a dopant (or emitter).

In one or more embodiments, the organometallic compound in the second embodiment may serve as an emitter and also as an auxiliary dopant that transfers energy to a dopant (or emitter).

For example, phosphorescence or fluorescence emitted from the dopant (or emitter) in the second embodiment may be blue phosphorescence or blue fluorescence (e.g., blue delayed fluorescence).

The dopant (or emitter) in the second embodiment may be a phosphorescent dopant material (e.g., the organometallic compound represented by Formula 1-1 or Formula 1-2 described herein, the organometallic compound represented by Formula 401 described herein, or any combination thereof) or any fluorescent dopant material (e.g., the compound represented by Formula 501 described herein, the compound represented by Formula 502 described herein, the compound represented by Formula 503 described herein, or any combination thereof).

The blue light in the first embodiment and the second embodiment may be blue light having a maximum emission wavelength in a range of about 390 nm to about 500 nm, about 410 nm to about 490 nm, about 430 nm to about 480 nm, about 440 nm to about 475 nm, or about 455 nm to about 470 nm.

The auxiliary dopant in the first embodiment may include, for example, the fourth compound represented by Formula 502 or Formula 503.

The host in the first embodiment and the second embodiment may be any host material (e.g., the compound represented by Formula 301, the compound represented by 301-1, the compound represented by Formula 301-2, or any combination thereof).

In one or more embodiments, the host in the first embodiment and the second embodiment may be the second compound, the third compound, or any combination thereof.

In one or more embodiments, the light-emitting device may further include a capping layer arranged outside the first electrode and/or outside the second electrode.

In one or more embodiments, the light-emitting device may further include at least one of a first capping layer arranged outside the first electrode and a second capping layer arranged outside the second electrode, wherein the organometallic compound represented by Formula 1-1 or Formula 1-2 may be included in at least one of the first capping layer and the second capping layer. The first capping layer and/or the second capping layer may each be as described herein.

In one or more embodiments, the light-emitting device may include:
a first capping layer arranged outside the first electrode and including the organometallic compound represented by Formula 1-1 or Formula 1-2;
a second capping layer arranged outside the second electrode and including the organometallic compound represented by Formula 1-1 or Formula 1-2; or
the first capping layer and the second capping layer.

The expression "(an interlayer and/or a capping layer) includes an organometallic compound represented by Formula 1-1 or Formula 1-2" as utilized herein may be understood as "(an interlayer and/or a capping layer) may include at least one kind of organometallic compound represented by Formula 1-1 or Formula 1-2 or two or more different kinds of organometallic compounds, each represented by Formula 1-1 or Formula 1-2."

In one or more embodiments, the interlayer and/or the capping layer may include Compound 1 only as the organometallic compound. In this regard, Compound 1 may be present in the emission layer of the light-emitting device. In one or more embodiments, the interlayer may include, as the organometallic compound, Compound 1 and Compound 2. In this regard, Compound 1 and Compound 2 may be present in substantially the same layer (e.g., both (e.g., simultaneously)) Compound 1 and Compound 2 may be present in the emission layer), or may be present in different layers (e.g., Compound 1 may be present in the emission layer, and Compound 2 may be present in the electron transport region).

The term "interlayer" as utilized herein refers to a single layer and/or all of multiple layers arranged between the first electrode and the second electrode of the light-emitting device.

Another aspect of the invention provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. The electronic apparatus may further include a color filter, a color conversion layer, a touch screen layer, a polarizing layer, or any combination thereof. More details on the electronic apparatus may be the same as described herein.

Another aspect of the invention provides electronic equipment including the light-emitting device.

For example, the electronic equipment may be at least one selected from among a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, a signboard, and one or more combinations thereof.

Another aspect of the invention provides the organometallic compound represented by Formula 1-1 or Formula 1-2. Details on Formula 1 may be as described herein.

Synthesis methods of the organometallic compound may be recognizable by one of ordinary skill in the art by referring to Synthesis Examples and/or Examples provided.

### Descriptions of Formulae 1-1 and 1-2

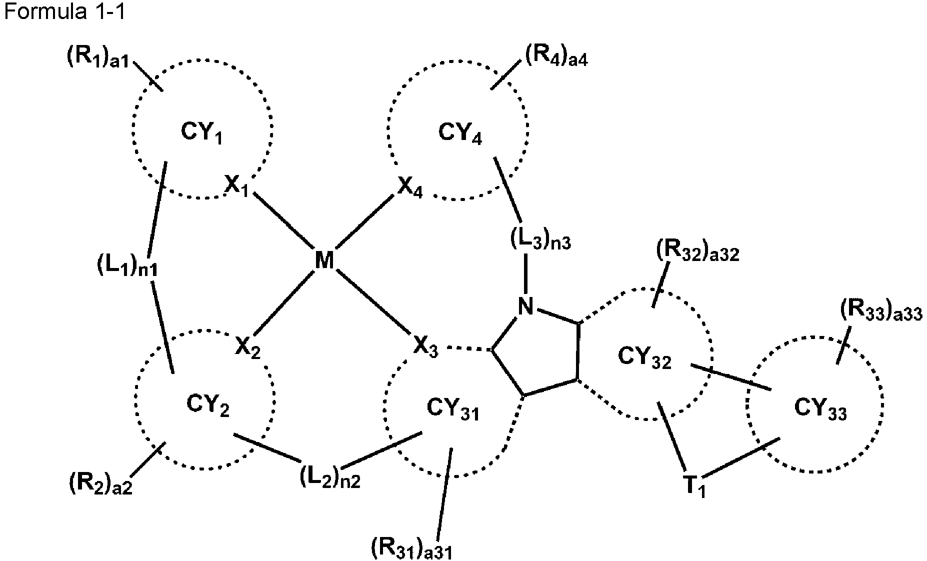

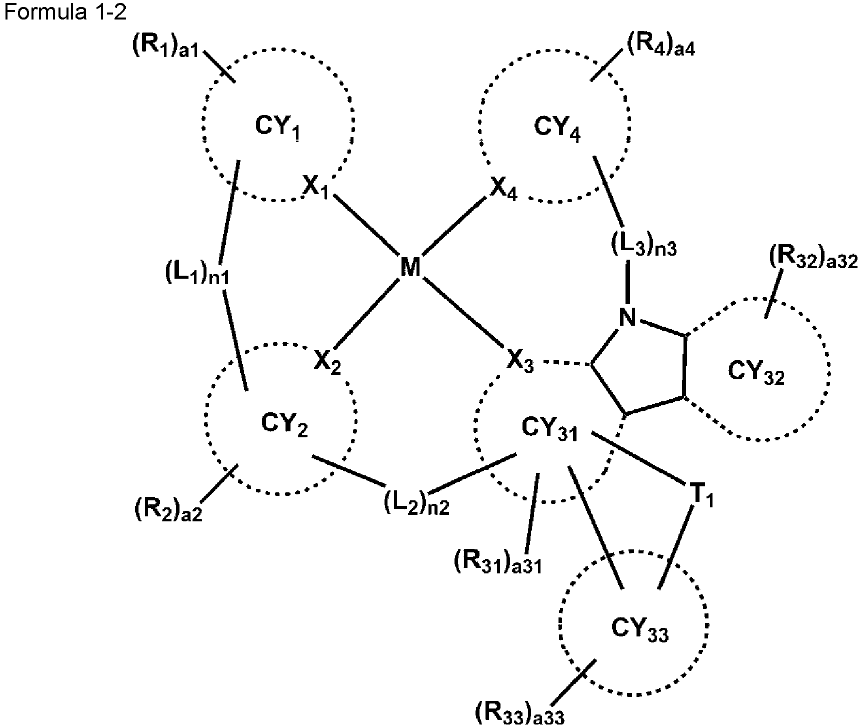

In Formulae 1-1 and 1-2, M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm).

In one or more embodiments, M may be Pt, Pd, or Au.

In one or more embodiments, M may be Pt.

In Formulae 1-1 and 1-2, X₁ to X₄ is each independently C or N.

In one or more embodiments, X₁ may be C.

In one or more embodiments, X₁ may be C, and a bond between X₁ and M may be a coordinate bond.

In one or more embodiments, X₁ may be C of a carbene moiety.

In one or more embodiments, X₂ and X₃ may each be C, and X₄ may be N.

In one or more embodiments, i) a bond between X₁ and M may be a coordinate bond, ii) one of a bond between X₂ and M, a bond between X₃ and M, and a bond between X₄ and M may be a coordinate bond, and the other two may each be a covalent bond.

In one or more embodiments, a bond between X₁ and M and a bond between X₄ and M may each be a coordinate bond, and a bond between X₂ and M and a bond between X₃ and M may each be a covalent bond.

In one or more embodiments, X₁, X₂, and X₃ may each be C, X₄ may be N, a bond between X₁ and M and a bond between X₄ and M may each be a coordinate bond, and a bond between X₂ and M and a bond between X₃ and M may each be a covalent bond.

In Formulae 1-1 and 1-2, ring CY₁, ring CY₂, ring CY₃₁ to ring CY₃₃, and ring CY₄ are each independentlybea C₅-C₃₀ carbocyclic group or a C₁-C₃₀ heterocyclic group.

In one or more embodiments, ring CY₁, ring CY₂, ring CY₃₁ to ring CY₃₃, and ring CY₄ may each independently be

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group.

In one or more embodiments, ring CY₁ may be a nitrogen-containing C₁-C₆₀ heterocyclic group.

In one or more embodiments, ring CY₁ may be an imidazole group, a triazole group, a benzimidazole group, a naphthoimidazole group, or an imidazopyridine group.

In one or more embodiments, X₁ may be C, and
ring CY₁ may be an imidazole group, a triazole group, a benzimidazole group, a naphthoimidazole group, or an imidazopyridine group.

In one or more embodiments, X₁ may be C of a carbene moiety, and
ring CY₁ may be an imidazole group, a triazole group, a benzimidazole group, a naphthoimidazole group, or an imidazopyridine group.

In one or more embodiments, ring CY₂ may be a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenzosilole group, an azadinaphthofuran group, an azadinaphthothiophene group, an azadibenzocarbazole group, an azadibenzofluorene group, or an azadinaphthosilole group.

In one or more embodiments, ring CY₂ may be a benzene group, a pyridine group, a pyrimidine group, a naphthalene group, a dibenzofuran group, a dibenzothiophene group, a carbazole group, a fluorene group, or a dibenzosilole group.

In one or more embodiments, ring CY₃₁ to ring CY₃₃ may each independently be
a benzene group, a pyridine group, a pyrimidine group, a naphthalene group, a dibenzofuran group, a dibenzothiophene group, a carbazole group, a fluorene group, or a dibenzosilole group.

In one or more embodiments, ring CY₄ may be a nitrogen-containing C₁-C₆₀ heterocyclic group.

In one or more embodiments, ring CY₄ may be a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a benzopyrazole group, a benzimidazole group, or a benzothiazole group.

In Formulae 1-1 and 1-2, L₁ to L₃ are each independently be a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*'. * and *' each indicate a binding site to a neighboring atom.

In Formulae 1-1 and 1-2, n1 to n3 indicate the numbers of L₁ to L₃, respectively, and are each independently an integer from 1 to 5. When n1 is 2 or more, two or more of L₁ may be identical to or different from each other, when n2 is 2 or more, two or more of L₂ may be identical to or different from each other, and when n3 is 2 or more, two or more of L₃ may be identical to or different from each other.

In one or more embodiments, L₁ and L₃ may each be a single bond.

In one or more embodiments, L₂ may be *-O-*' or *-S-*', and n2 may be 1.

In one or more embodiments, L₁ and L₃ may each be a single bond, and
L₂ may be *-O-*' or *-S-*', and n2 may be 1.

In Formulae 1-1 and 1-2, R₁ₐ and R_{1b} are each independently hydrogen, deuterium, -F, -Cl, -Br, -I, a hydroxyl group, a cyano group, a nitro group, a C₁-C₆₀ alkyl group unsubstituted or substituted with at least one R₁₀₄, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), - C(=O)(Q₁), -S(=O)₂(Q₁), or -P(=O)(Q₁)(Q₂).

R₁₀ₐ and Q₁ to Q₃ may each be as described herein.

In one or more embodiments, R₁ₐ and R_{1b} may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, - Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), - S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), **-S(=O)2(Q₃₁),** -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂), and
Q₁ to Q₃ and Q₃₁ to Q₃₃ may each independently be: hydrogen, deuterium, -F, -Cl, - Br, -I, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group; or
a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In Formulae 1-1 and 1-2, R₁, R₂, and R₃₁ to R₃₃ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), - C(=O)(Q₁), -S(=O)₂(Q₁), or -P(=O)(Q₁)(Q₂).

R₁₀ₐ and Q₁ to Q₃ may each be as described herein.

In one or more embodiments, R₁, R₂, R₃₁ to R₃₃, and R₄ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, - Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), - S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)2(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂), and
Q₁ to Q₃ and Q₃₁ to Q₃₃ are each independently hydrogen, deuterium, -F, -Cl, - Br, -I, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group; or
a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In one or more embodiments, R₁, R₂, R₃₁ to R₃₃, and R₄ may each independently be:
hydrogen, deuterium, -F, a C₁-C₂₀ alkyl group, or a C₁-C₂₀ alkoxy group;
a C₁-C₂₀ alkyl group or a C₁-C₂₀ alkoxy group, each substituted with deuterium, -F, - CD₃, -CD₂H, -CDH₂, -CF₃, -CF₂H, -CFH₂, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, or a dibenzothiophenyl group, each unsubstituted or substituted with deuterium, -F, -CD₃, -CD₂H, -CDH₂, -CF₃, -CF₂H, -CFH₂, a C₁-C₂₀ alkyl group, a C₁-C₂₀ alkoxy group, a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, a dibenzothiophenyl group, -O(Q₃₁), -S(Q₃₁), -Si(Q₃₁)(Q₃₂)(Q₃₃), -N(Q₃₁)(Q₃₂), or any combination thereof; or
-C(Q₁)(Q₂)(Q₃), -Si(Q₁)(Q₂)(Q₃), or -N(Q₁)(Q₂), and
Q₁ to Q₃ and Q₃₁ to Q₃₃ may each independently be: hydrogen; deuterium; -F; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group; or a C₁-C₆₀ heterocyclic group, each unsubstituted or substituted with deuterium, -F, a C₁-C₆₀ alkyl group, a C₁-C₆₀ alkoxy group, a phenyl group, a biphenyl group, or any combination thereof.

In one or more embodiments, R₁, R₂, R₃₁ to R₃₃, and R₄ may each independently be:
hydrogen, deuterium, or a C₁-C₂₀ alkyl group;
a C₁-C₂₀ alkyl group substituted with deuterium, -CD₃, -CD₂H, -CDH₂, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, or a naphthyl group, each unsubstituted or substituted with deuterium, - CD₃, -CD₂H, -CDH₂, a C₁-C₂₀ alkyl group, a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, - Si(Q₃₁)(Q₃₂)(Q₃₃), or any combination thereof; or
-C(Q₁)(Q₂)(Q₃) or -Si(Q₁)(Q₂)(Q₃), and
Q₁ to Q₃ and Q₃₁ to Q₃₃ may each independently be: hydrogen; deuterium; a C₁-C₆₀ alkyl group; a C₂-C₆₀ alkenyl group; a C₂-C₆₀ alkynyl group; or
a C₃-C₆₀ carbocyclic group unsubstituted or substituted with deuterium, a C₁-C₆₀ alkyl group, a phenyl group, a biphenyl group, or any combination thereof.

At least one R₁ is a group represented by Formula S1: 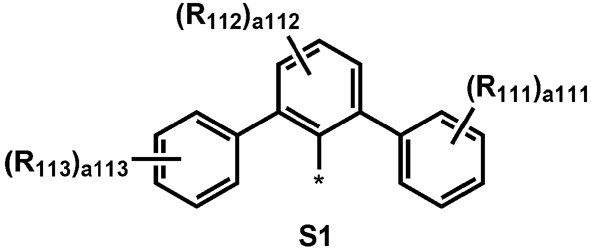 wherein, in Formula S1,
R₁₁₁ to R₁₁₃ are each as described in connection with R₁,
a111 is an integer from 1 to 5,
a112 is an integer from 1 to 3,
a113 is an integer from 1 to 5, and
* indicates a binding site to a neighboring atom.

In Formulae 1-1 and 1-2, a1, a2, a31 to a33, and a4 indicate the numbers of R₁, R₂, R₃₁ to R₃₃, and R₄, respectively, and are each independently an integer from 1 to 20. When a1 is 2 or more, two or more of R₁ may be identical to or different from each other, when a2 is 2 or more, two or more of R₂ may be identical to or different from each other, when a31 is 2 or more, two or more of R₃₁ may be identical to or different from each other, when a32 is 2 or more, two or more of R₃₂ may be identical to or different from each other, when a33 is 2 or more, two or more of R₃₃ may be identical to or different from each other, and when a4 is 2 or more, two or more of R₄ may be identical to or different from each other.

In one or more embodiments, two or more neighboring groups of R₁ in the number of a1, R₂ in the number of a2, R₃₁ in the number of a31, R₃₂ in the number of a32, R₃₃ in the number of a33, and R₄ in the number of a4 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

In one or more embodiments, Z₁ or Z₂ may optionally be bonded to one of R₃₁ to R₃₃ or one of ring CY₃₁ to ring CY₃₃ to form a C₃-C₆₀ carbocyclic group unsubstituted or substituted with at least one R₁₀ₐ or a C₁-C₆₀ heterocyclic group unsubstituted or substituted with at least one R₁₀ₐ.

In Formulae 1-1 and 1-2, a group represented by 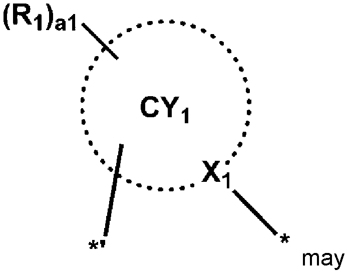 be a group represented by at least one of Formulae CY1(1) to CY1(11): 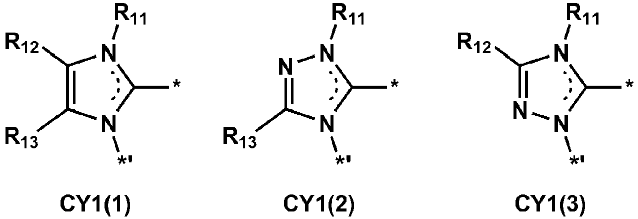 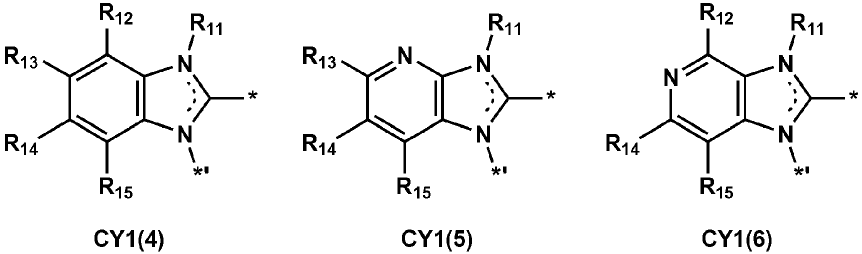 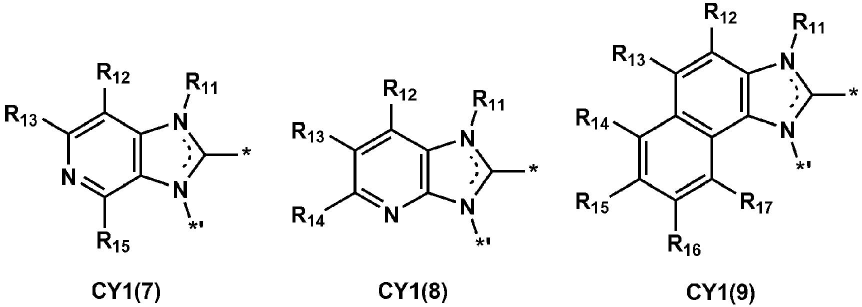 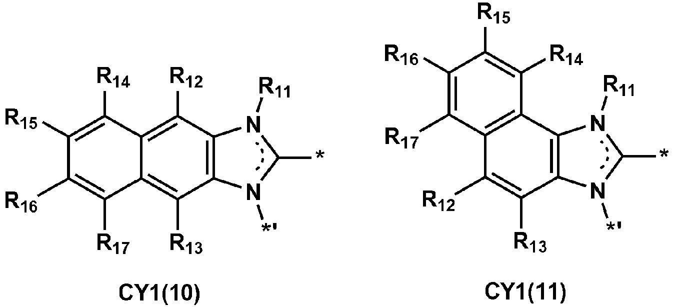 wherein, in Formulae CY1(1) to CY1(11),
R₁₁ to R₁₇ may each be as described in connection with R₁,
* indicates a binding site to M in Formula 1-1 or Formula 1-2, and
*' indicates a binding site to L₁ in Formula 1-1 or Formula 1-2.

In Formulae 1-1 and 1-2, a group represented by 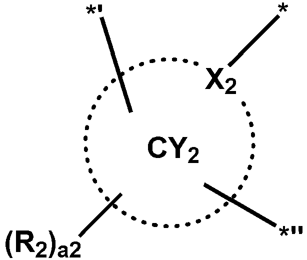 may be a group represented by at least one of Formulae CY2(1) to CY2(13): 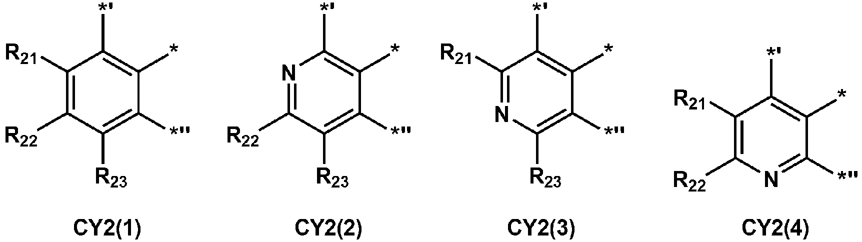 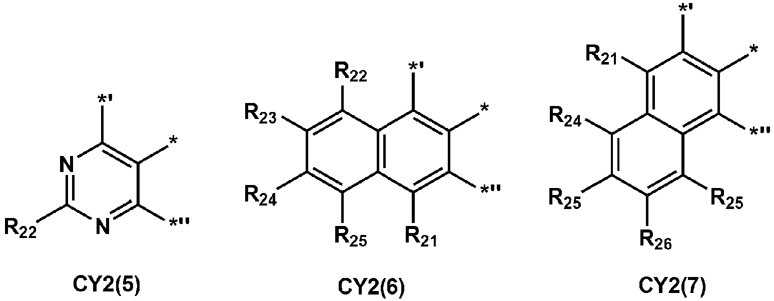 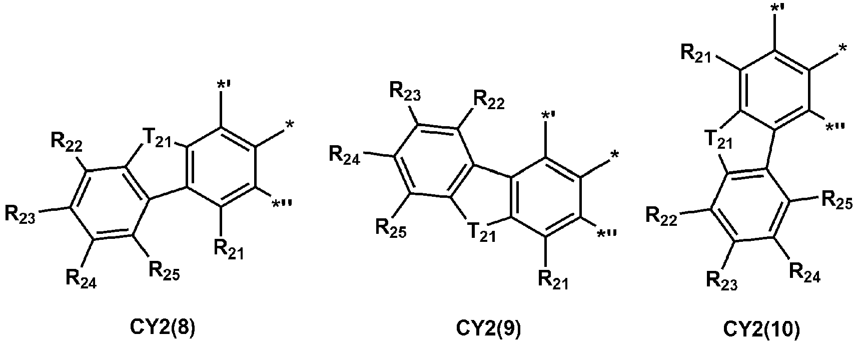 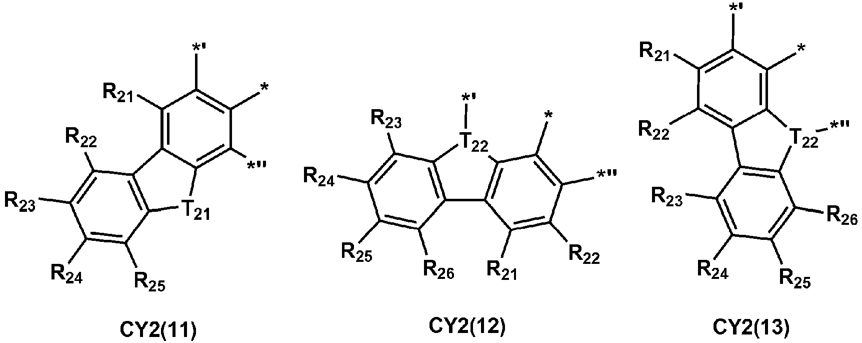 wherein, in Formulae CY2(1) to CY2(13),
T₂₁ may be B(Y₂₁), C(Y₂₁)(Y₂₂), N(Y₂₁), O, S, or Si(Y₂₁)(Y₂₂),
T₂₂ may be C(Y₂₁), N, or Si(Y₂₁),
R₂₁ to R₂₆, Y₂₁, and Y₂₂ may each be as described in connection with R₂,
* indicates a binding site to M in Formula 1-1 or Formula 1-2,
*' indicates a binding site to L₁ in Formula 1-1 or Formula 1-2, and
*" indicates a binding site to L₂ in Formula 1-1 or Formula 1-2.

In Formula 1-1, a group represented by 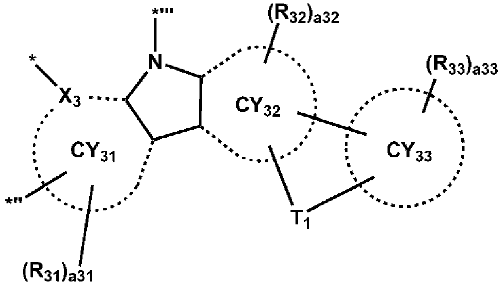 may be a group represented by at least one of Formulae CY3-1(1) to CY3-1(6), and in Formula 1-2, a group represented by 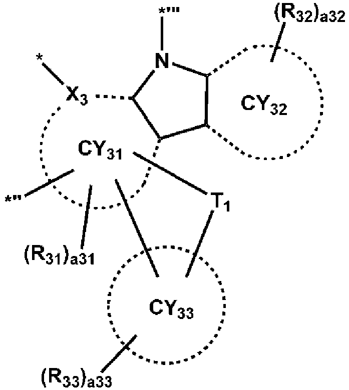 may be a group represented by Formula CY3-2(1) or CY3-2(2): 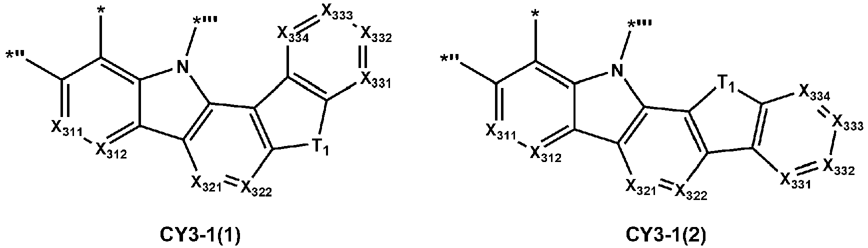 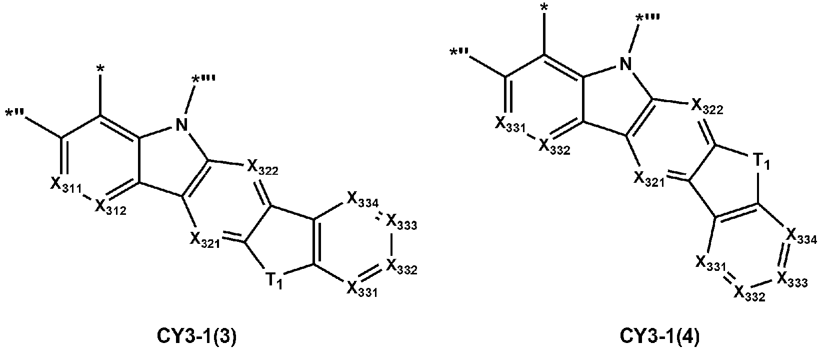 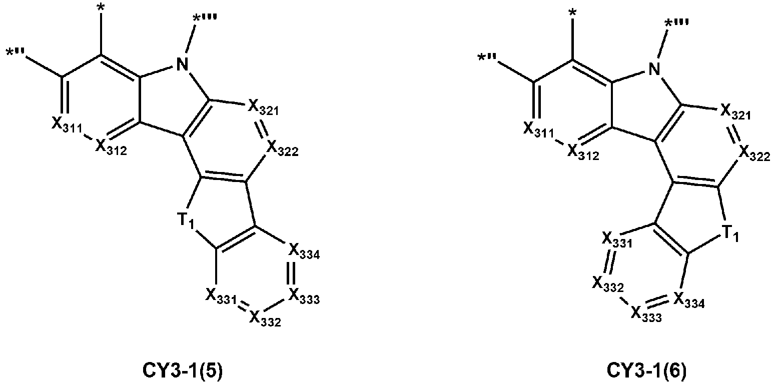 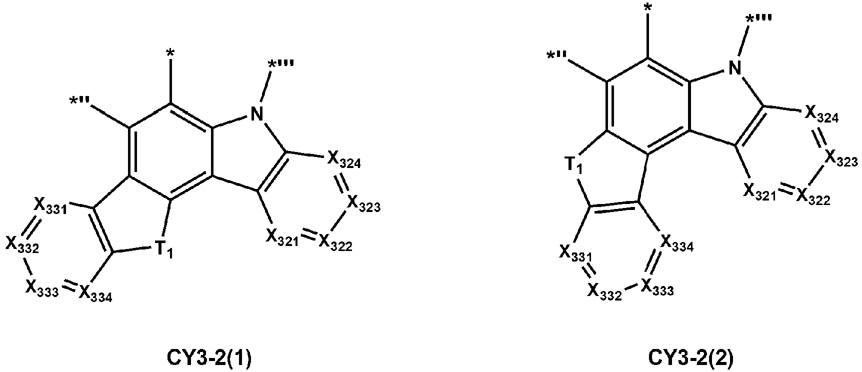 wherein, in Formulae CY3-1(1) to CY3-1(6), CY3-2(1), and CY3-2(2),
X₃₁₁ may be C(R₃₁₁) or N, and X₃₁₂ may be C(R₃₁₂) or N,
X₃₂₁ may be C(R₃₂₁) or N, X₃₂₂ may be C(R₃₂₂) or N, X₃₂₃ may be C(R₃₂₃) or N, and X₃₂₄ may be C(R₃₂₄) or N,
X₃₃₁ may be C(R₃₃₁) or N, X₃₃₂ may be C(R₃₃₂) or N, X₃₃₃ may be C(R₃₃₃) or N, and X₃₃₄ may be C(R₃₃₄) or N,
T₁ may be as described herein,
R₃₁₁ and R₃₁₂ may each be as described in connection with R₃₁,
R₃₂₁ to R₃₂₄ may each be as described in connection with R₃₂,
R₃₃₁ to R₃₃₄ may each be as described in connection with R₃₃,
two or more neighboring groups of R₃₁₁, R₃₁₂, R₃₂₁ to R₃₂₄, and R₃₃₁ to R₃₃₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
* indicates a binding site to M in Formula 1-1 or Formula 1-2,
*" indicates a binding site to L₂ in Formula 1-1 or Formula 1-2, and
*‴ indicates a binding site to L₃ in Formula 1-1 or Formula 1-2.

In Formula 1-1, a group represented by 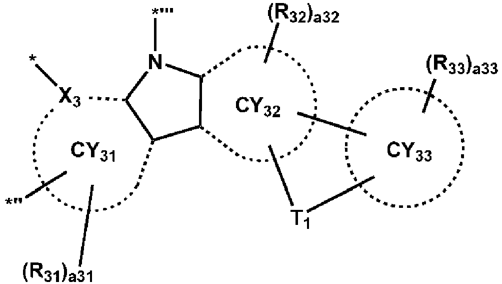 may be a group represented by one at least one of Formulae CY3-1(1A) to CY3-1(6A), and

in Formula 1-2, a group represented by 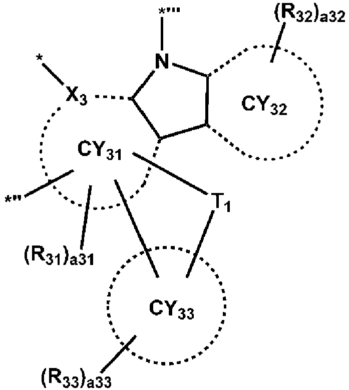 may be a group represented by Formula CY3-2(1A) or CY3-2(2A): 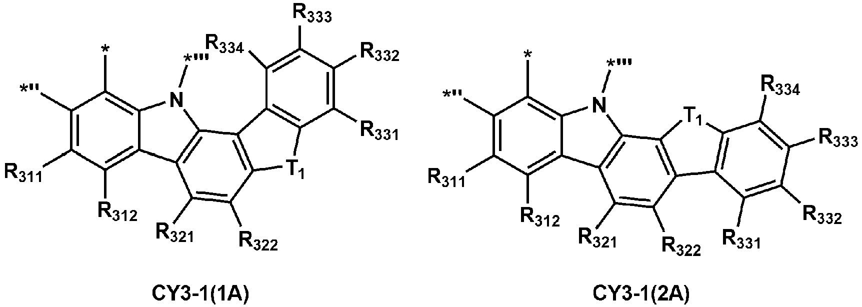 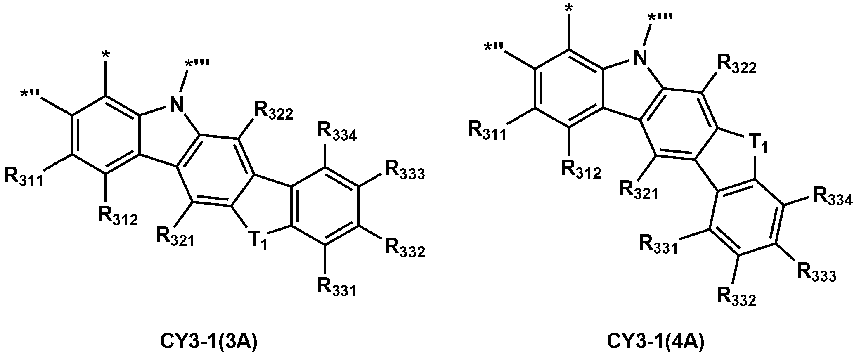 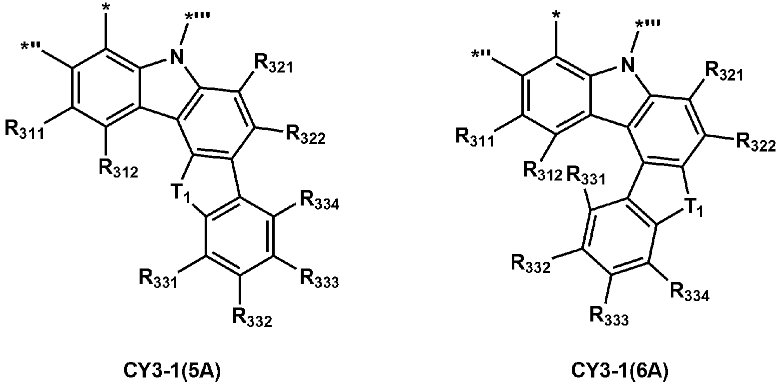 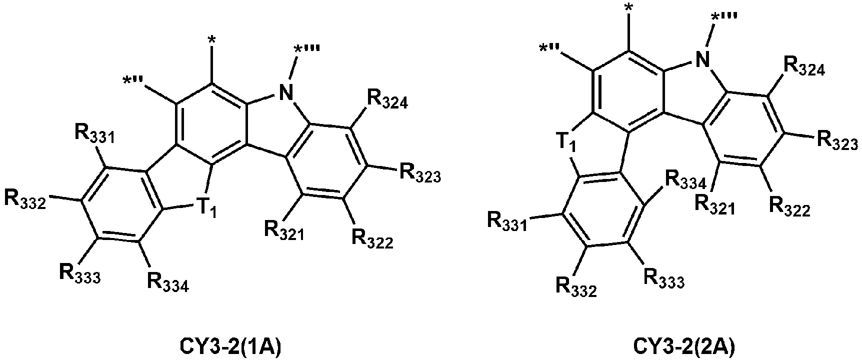 wherein, in Formulae CY3-1(1A) to CY3-1(6A), CY3-2(1A), and CY3-2(2A),
T₁ may be as described herein,
R₃₁₁ and R₃₁₂ may each be as described in connection with R₃₁,
R₃₂₁ to R₃₂₄ may each be as described in connection with R₃₂,
R₃₃₁ to R₃₃₄ may each be as described in connection with R₃₃,
two or more neighboring groups of R₃₁₁, R₃₁₂, R₃₂₁ to R₃₂₄, and R₃₃₁ to R₃₃₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
* indicates a binding site to M in Formula 1-1 or Formula 1-2,
*" indicates a binding site to L₂ in Formula 1-1 or Formula 1-2, and
*‴ indicates a binding site to L₃ in Formula 1-1 or Formula 1-2.

In Formulae 1-1 and 1-2, a group represented by 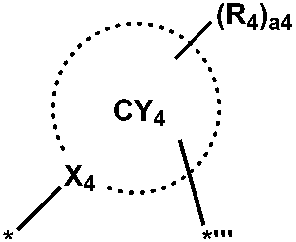 may be a group represented by at least one of Formulae CY4(1) to CY4(29): 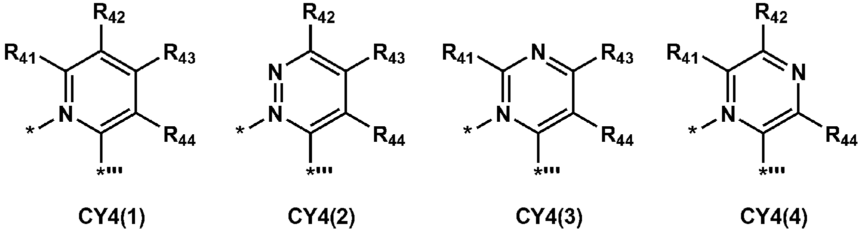 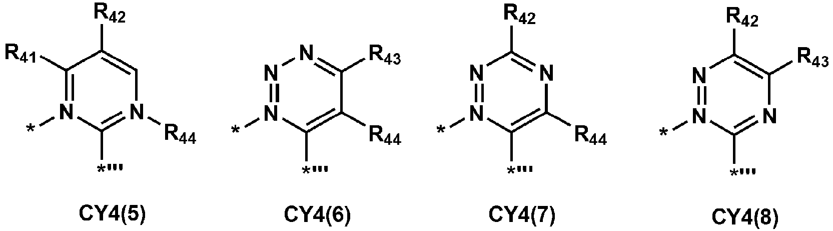 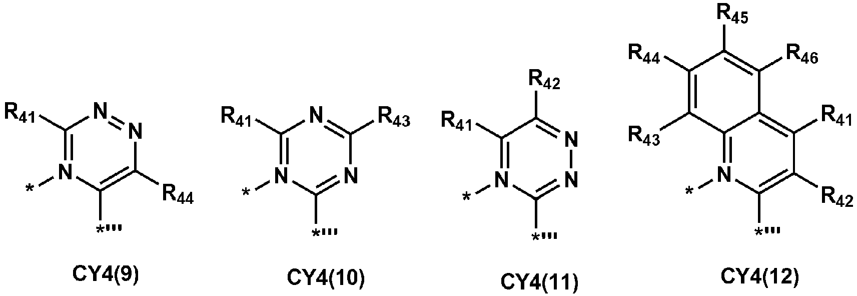 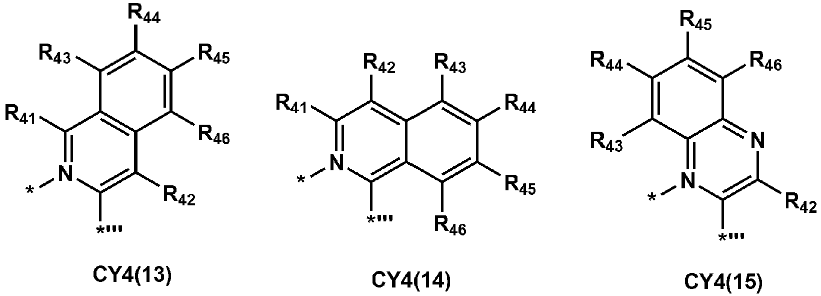 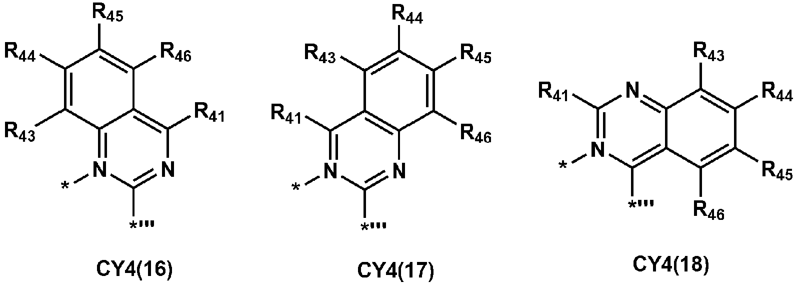 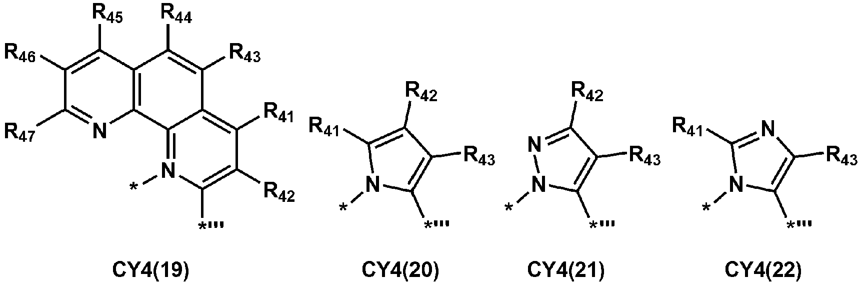 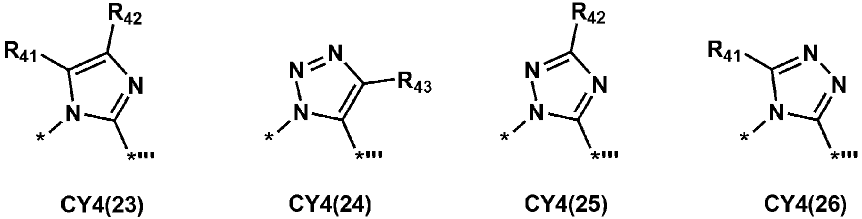 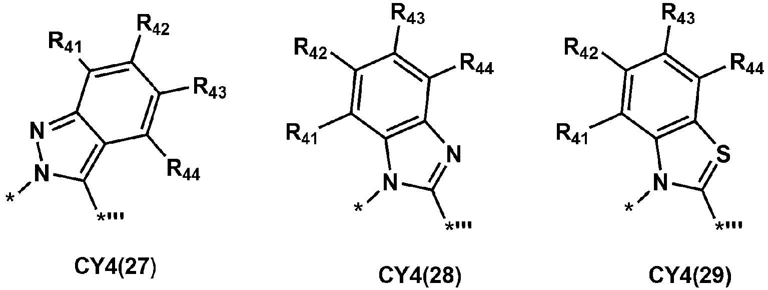 wherein, in Formulae CY4(1) to CY4(29),
R₄₁ to R₄₇ may each be as described in connection with R₄,
* indicates a binding site to M in Formula 1-1 or Formula 1-2, and
*‴ indicates a binding site to L₃ in Formula 1-1 or Formula 1-2.

In Formulae 1-1 and 1-2, T₁ is a group represented by Formula T-1 or T-2: 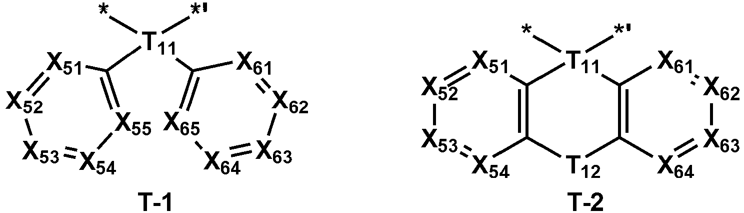 wherein, in Formulae T-1 and T-2,
T₁₁ is C, Si, or Ge,
T₁₂ is a single bond, *-C(Z₃)(Z₄)-*', *-Si(Z₃)(Z₄)-*', or *-Ge(Z₃)(Z₄)-*', wherein * and *' each indicate a binding site to a neighboring atom,
X₅₁ is C(Z₁₁) or N, X₅₂ may be C(Z₁₂) or N, X₅₃ may be C(Z₁₃) or N, X₅₄ may be C(Z₁₄) or N, and X₅₅ may be C(Z₁₅) or N,
X₆₁ is C(Z₂₁) or N, X₆₂ may be C(Z₂₂) or N, X₆₃ may be C(Z₂₃) or N, X₆₄ may be C(Z₂₄) or N, and X₆₅ may be C(Z₂₅) or N,
Z₁₁ to Z₁₅ and Z₃ are each as described in connection with Z₁,
Z₂₁ to Z₂₅ and Z₄ are as described in connection with Z₂,
two or more neighboring groups of Z₁₁ to Z₁₅, Z₂₁ to Z₂₅, Z₃, and Z₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and
* and *' each indicate a binding site to a neighboring atom.

The organometallic compound represented by Formula 1-1 may be a group represented by Formula 1-1(A1) or 1-1(A2), and
the organometallic compound represented by Formula 1-2 may be a group represented by Formula 1-2(A1) or 1-2(A2): 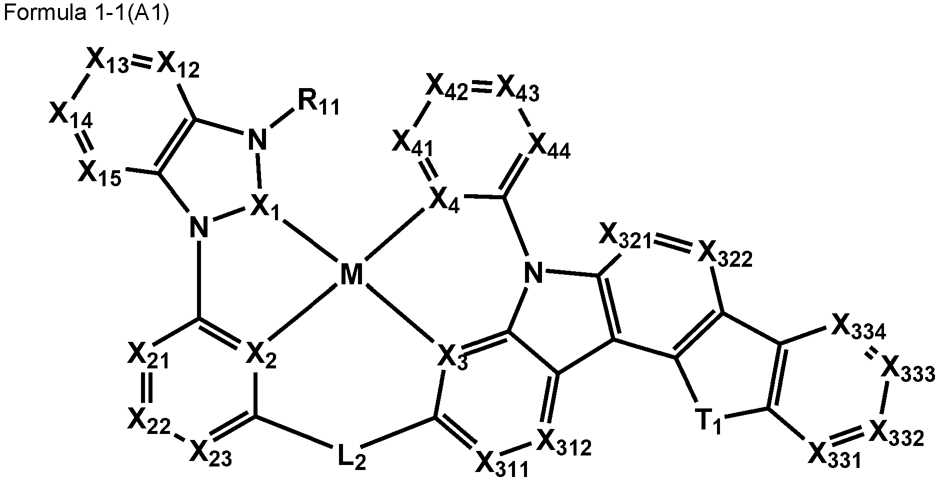 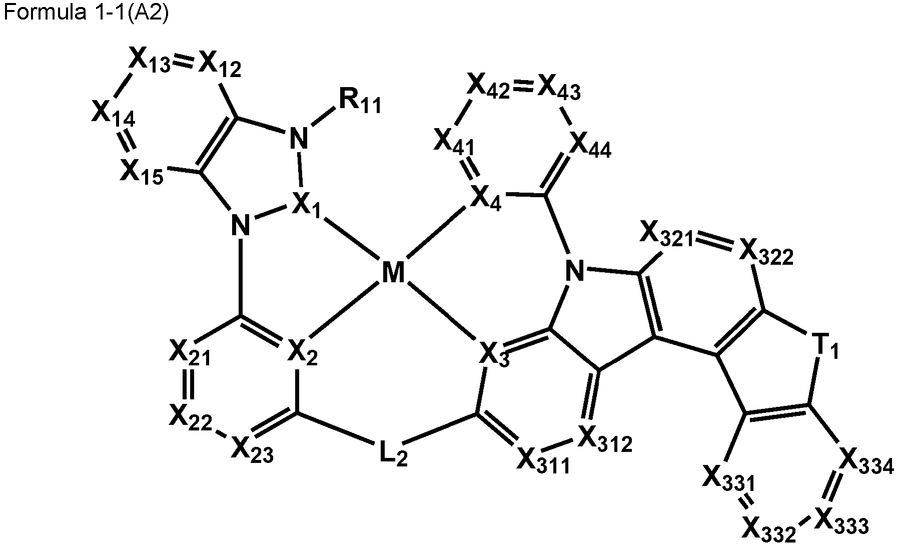 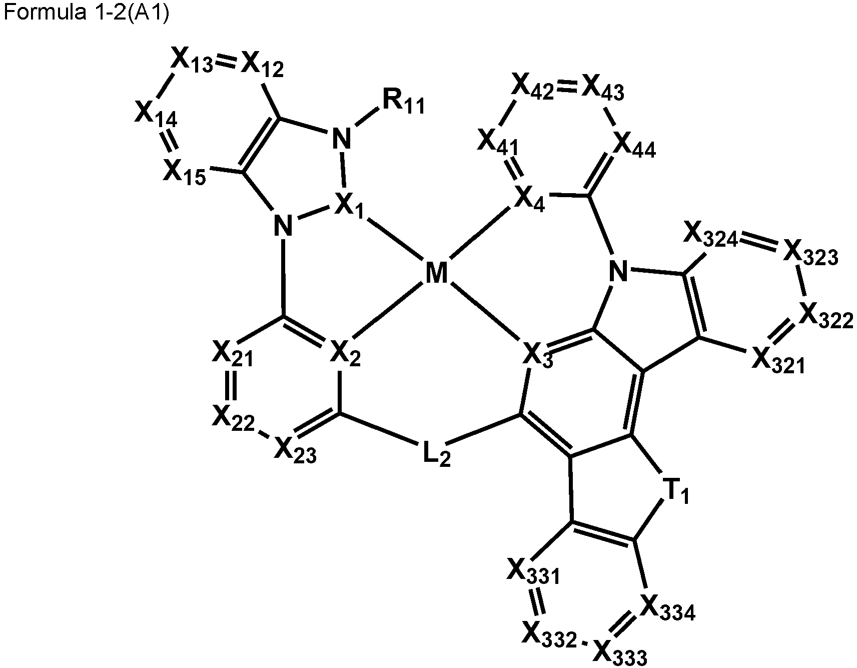 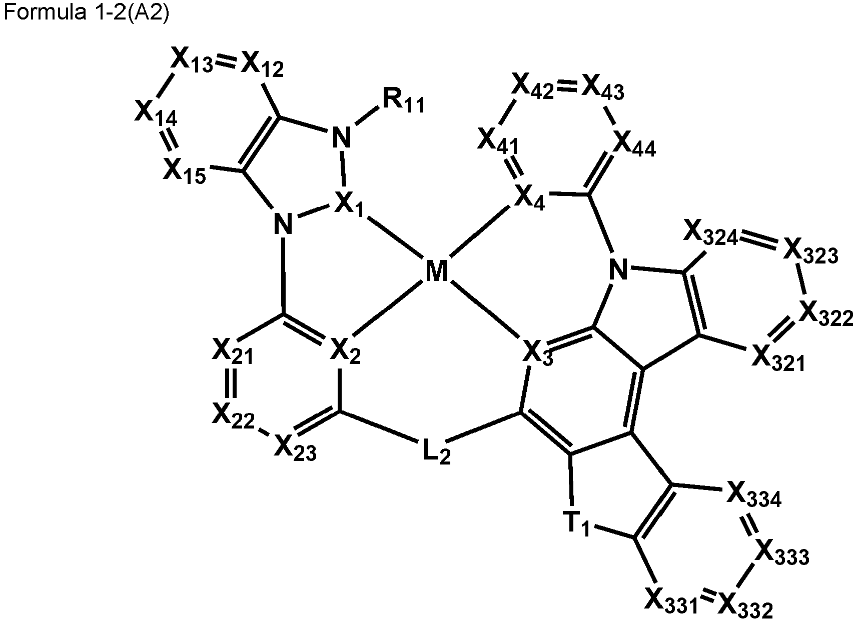
wherein, in Formulae 1-1(A1), 1-1(A2), 1-2(A1), and 1-2(A2),
   M, X₁ to X₄, and T₁ may each be as described herein,
   L₂ may be *-O-*', *-S-*', or *-Se-*',
   X₁₂ may be C(R₁₂) or N, X₁₃ may be C(R₁₃) or N, X₁₄ may be C(R₁₄) or N, and X₁₅ may be C(R₁₅) or N,
   X₂₁ may be C(R₂₁) or N, X₂₂ may be C(R₂₂) or N, and X₂₃ may be C(R₂₃) or N,
   X₃₁₁ may be C(R₃₁₁) or N, X₃₁₂ may be C(R₃₁₂) or N, X₃₂₁ may be C(R₃₂₁) or N, X₃₂₂ may be C(R₃₂₂) or N, X₃₂₃ may be C(R₃₂₃) or N, X₃₂₄ may be C(R₃₂₄) or N, X₃₃₁ may be C(R₃₃₁) or N, X₃₃₂ may be C(R₃₃₂) or N, X₃₃₃ may be C(R₃₃₃) or N, and X₃₃₄ may be C(R₃₃₄) or N,
   X₄₁ may be C(R₄₁) or N, X₄₂ may be C(R₄₂) or N, X₄₃ may be C(R₄₃) or N, and X₄₄ may be C(R₄₄) or N,
   R₁₁ to R₁₅ may each be as described in connection with R₁,
   R₂₁ to R₂₃ may each be as described in connection with R₂,
   R₃₁₁ and R₃₁₂ may each be as described in connection with R₃₁,
   R₃₂₁ to R₃₂₄ may each be as described in connection with R₃₂,
   R₃₃₁ to R₃₃₄ may each be as described in connection with R₃₃,
   R₄₁ to R₄₄ may each be as described in connection with R₄,
   two or more neighboring groups of R₁₁ to R₁₅, R₂₁ to R₂₃, R₃₁₁, R₃₁₂, R₃₂₁ to R₃₂₄, R₃₃₁ to R₃₃₄, R₄₁ to R₄₄, Z₁, and Z₂ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and
   R₁₀ₐ may be as described herein.

In the organometallic compound represented by Formula 1-1 or Formula 1-2, ring CY₃₁ or ring CY₃₂ is linked to ring CY₃₃ via a T₁ linking group represented by *-C(Z₁)(Z₂)-*', *-Si(Z₁)(Z₂)-*', or *-Ge(Z₁)(Z₂)-*'. As a result, the (e.g., steric) bulkiness of the organometallic compound may be increased so that interaction thereof with other compounds (e.g., a boron-based compound) present nearby may be reduced, thereby suppressing DexET energy transfer (a phenomenon in which, when a distance between molecules is short, excited electrons of one molecule are transferred to a triplet energy of another molecule).

In some embodiments, in the organometallic compound represented by Formula 1-1 or Formula 1-2, molecular rigidity may be increased due to the T₁ linking group so that intramolecular movement may be suppressed or reduced, thereby suppressing a non-luminescent process of molecules (reducing Knr components), and a Stoke's shift may be reduced, thereby increasing a photoluminescence quantum yield (PLQY). Also, due to the increase in molecular rigidity, structural deformation between excited and ground states may be reduced.

As such, as DexET energy transfer is suppressed or reduced and molecular rigidity is increased, the organometallic compound represented by Formula 1-1 or Formula 1-2 may improve luminescence efficiency and device lifespan. Accordingly, by utilizing the organometallic compound represented by Formula 1-1 or Formula 1-2, an electronic device (e.g., an organic light-emitting device) having reduced driving voltage, improved color purity and efficiency, and increased lifespan may be implemented.

### Descriptions of other formulae

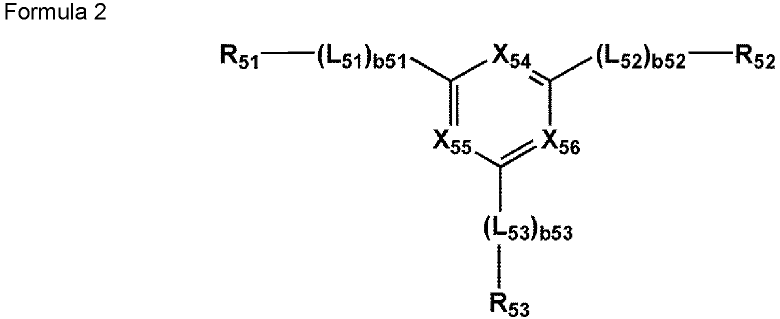

In Formula 2, L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ.

In Formula 2, b51 to b53 indicate the numbers of L₅₁ to L₅₃, respectively, and may each be an integer from 1 to 5. When b51 is 2 or more, two or more of L₅₁ may be identical to or different from each other, when b52 is 2 or more, two or more of L₅₂ may be identical to or different from each other, and when b53 is 2 or more, two or more of L₅₃ may be identical to or different from each other. For example, b51 to b53 may each independently be 1 or 2.

In Formula 2, L₅₁ to L₅₃ may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxacilline group, a dibenzothiacilline group, a dibenzodihydroazacilline group, a dibenzodihydrodicilline group, a dibenzodihydrocilline group, a dibenzodioxane group, a dibenzooxathiene group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof, and
Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, in Formula 2, a bond between L₅₁ and R₅₁, a bond between L₅₂ and R₅₂, a bond between L₅₃ and R₅₃, a bond between two or more of L₅₁, a bond between two or more of L₅₂, a bond between two or more of L₅₃, a bond between L₅₁ and carbon between X₅₄ and X₅₅ in Formula 2, a bond between L₅₂ and carbon between X₅₄ and X₅₆ in Formula 2, and a bond between L₅₃ and carbon between X₅₅ and X₅₆ in Formula 2 may each be a "carbon-carbon single bond."

In Formula 2, X₅₄ may be N or C(R₅₄), X₅₅ may be N or C(R₅₅), X₅₆ may be N or C(R₅₆), and at least one of X₅₄ to X₅₆ may be N. R₅₄ to R₅₆ may each be as described herein. For example, two or three of X₅₄ to X₅₆ may each be N.

In Formula 2, R₅₁ to R₅₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂). Q₁ to Q₃ may each be as described herein.

In Formula 2, R₅₁ to R₅₆ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, - Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof: 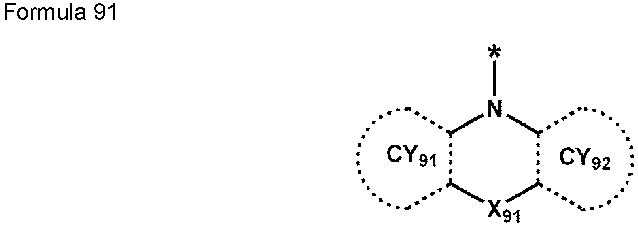
wherein, in Formula 91,
   ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
   X₉₁ may be a single bond, O, S, N(R₉₁), B(R₉₁), C(R₉₁ₐ)(R_{91b}), or Si(R₉₁ₐ)(R_{91b}),
   R₉₁, R₉₁ₐ, and R_{91b} may each be as described in connection with R₈₂, R₈₂ₐ, and R_{82b}, respectively,
   R₁₀ₐ may be as described herein, and
   * indicates a binding site to a neighboring atom.

For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ, and
R₉₁, R₉₁ₐ, and R_{91b} may each independently be:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In Formula 2, a group represented by *-(L₅₁)_{b51}-R₅₁ and a group represented by *-(L₅₂)_{b52}-R₅₂ may each not be a phenyl group.

In one or more embodiments, in Formula 2, a group represented by *-(L₅₁)_{b51}-R₅₁ and a group represented by *-(L₅₂)_{b52}-R₅₂ may be identical to each other.

In one or more embodiments, in Formula 2, a group represented by *-(L₅₁)_{b51}-R₅₁ and a group represented by *-(L₅₂)_{b52}-R₅₂ may be different from each other.

In one or more embodiments, in Formula 2, b51 and b52 may each be 1, 2, or 3, and L₅₁ and L₅₂ may each independently be a benzene group, a pyridine group, a pyrimidine group, a pyridazine group, a pyrazine group, or a triazine group, each unsubstituted or substituted with at least one R₁₀ₐ.

For example, in Formula 2, R₅₁ and R₅₂ may each independently be a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), or -Si(Q₁)(Q₂)(Q₃), and

Q₁ to Q₃ may each independently be a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In one or more embodiments,
a group represented by *-(L₅₁)_{b51}-R₅₁ in Formula 2 may be a group represented by one of Formulae CY51-1 to CY51-26, and/or
a group represented by *-(L₅₂)_{b52}-R₅₂ in Formula 2 may be a group represented by one of Formulae CY52-1 to CY52-26, and/or
a group represented by *-(L₅₃)_{b53}-R₅₃ in Formula 2 may be a group represented by at least one of Formulae CY53-1 to CY53-27, -C(Q₁)(Q₂)(Q₃), and/or -Si(Q₁)(Q₂)(Q₃): 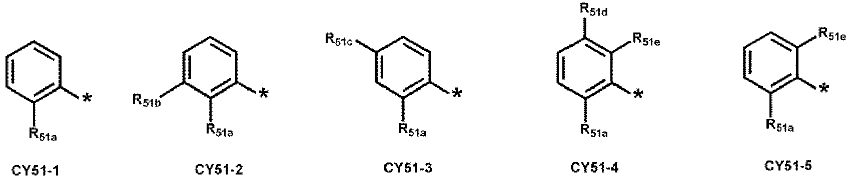 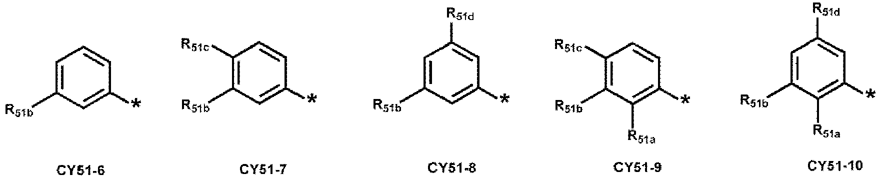 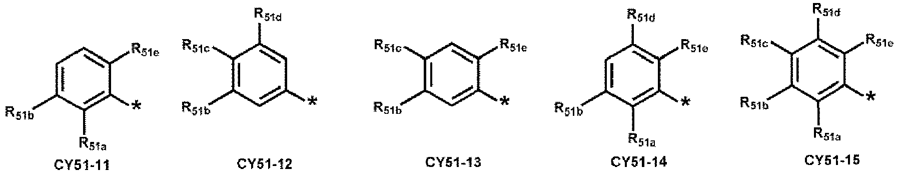 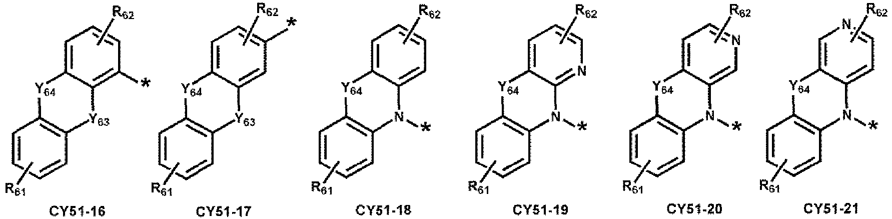 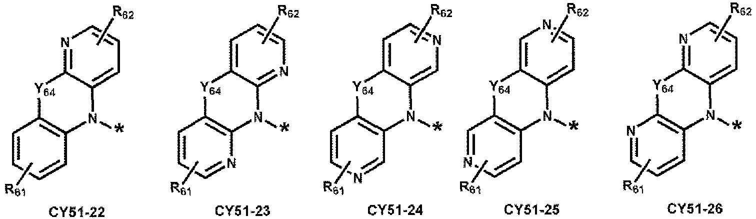 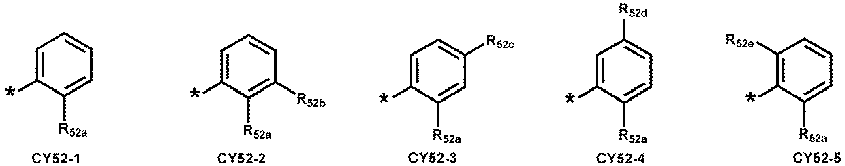 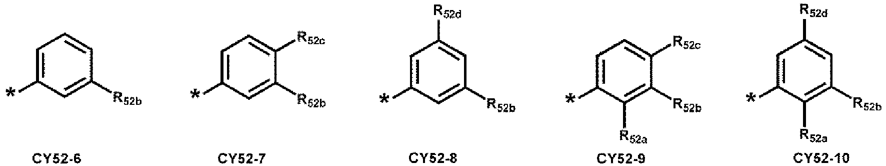 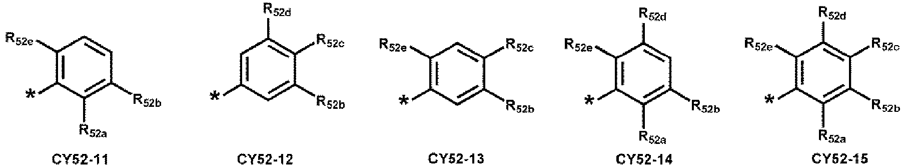 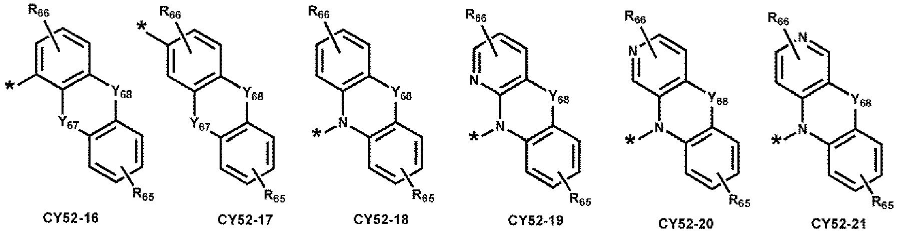 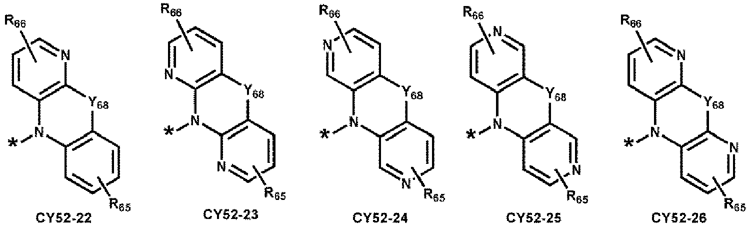 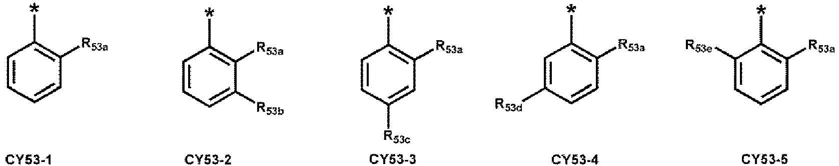 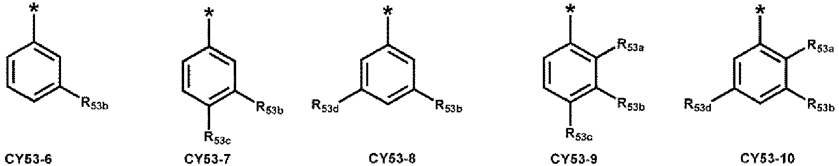 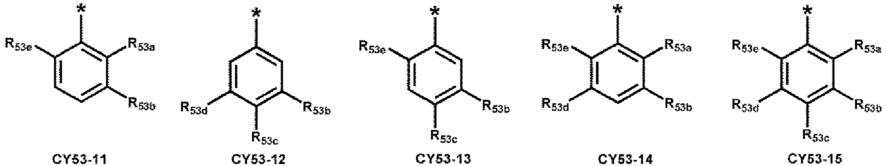 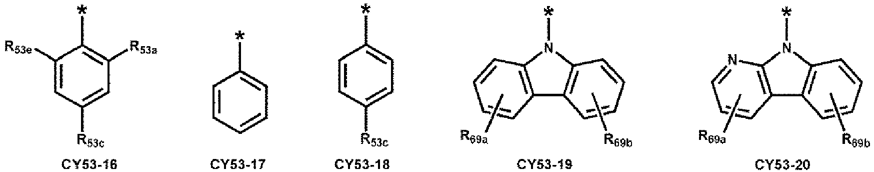 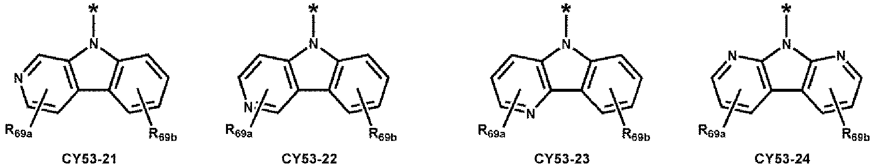 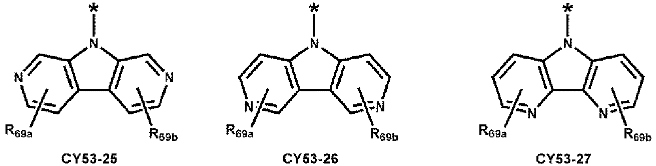
wherein, in Formulae CY51-1 to CY51-26, CY52-1 to CY52-26, and CY53-1 to CY53-27,
   Y₆₃ may be a single bond, O, S, N(R₆₃), B(R₆₃), C(R₆₃ₐ)(R_{63b}), or Si(R₆₃ₐ)(R_{63b}),
   Y₆₄ may be a single bond, O, S, N(R₆₄), B(R₆₄), C(R₆₄ₐ)(R_{64b}), or Si(R₆₄ₐ)(R_{64b}),
   Y₆₇ may be a single bond, O, S, N(R₆₇), B(R₆₇), C(R₆₇ₐ)(R_{67b}), or Si(R₆₇ₐ)(R_{67b}),
   Y₆₈ may be a single bond, O, S, N(R₆₈), B(R₆₈), C(R₆₈ₐ)(R_{68b}), or Si(R₆₈ₐ)(R_{68b}),
   each of Y₆₃ and Y₆₄ in Formulae CY51-16 and CY51-17 may not both (e.g., simultaneously) be a single bond at the same time,
   each of Y₆₇ and Y₆₈ in Formulae CY52-16 and CY52-17 may not both (e.g., simultaneously) be a single bond at the same time,
   R₅₁ₐ to R₅₁ₑ, R₆₁ to R₆₄, R₆₃ₐ, R_{63b}, R₆₄ₐ, and R_{64b} may each be as described in connection with R₅₁, wherein R₅₁ₐ to R₅₁ₑ may not each be hydrogen,
   R₅₂ₐ to R₅₂ₑ, R₆₅ to R₆₈, R₆₇ₐ, R_{67b}, R₆₈ₐ, and R_{68b} may each be as described in connection with R₅₂, wherein R₅₂ₐ to R₅₂ₑ may not each be hydrogen,
   R₅₃, to R₅₃ₑ, R₆₉ₐ, and R_{69b} may each be as described in connection with R₅₃, wherein R₅₃ₐ to R₅₃ₑ may not each be hydrogen, and
   * indicates a binding site to a neighboring atom.

For example,
in Formulae CY51-1 to CY51-26 and CY52-1 to 52-26, R₅₁ₐ to R₅₁ₑ and R₅₂ₐ to R₅₂ₑ may each independently be:
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or
-C(Q₁)(Q₂)(Q₃) or -Si(Q₁)(Q₂)(Q₃),
Q₁ to Q₃ may each independently be a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof,
in Formulae CY51-16 and CY51-17, i) Y₆₃ may be O or S and Y₆₄ may be Si(R₆₄ₐ)(R_{64b}), or ii) Y₆₃ may be Si(R₆₃ₐ)(R_{63b}) and Y₆₄ may be O or S, and
in Formulae CY52-16 and CY52-17, i) Y₆₇ may be O or S and Y₆₈ may be Si(R₆₈ₐ)(R_{68b}), or ii) Y₆₇ may be Si(R₆₇ₐ)(R_{67b}) and Y₆₈ may be O or S.

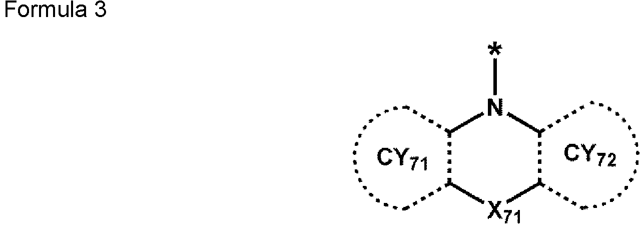

In Formula 3, ring CY₇₁ and ring CY₇₂ may each independently be a π electron-rich C₃-C₆₀ cyclic group or a pyridine group.

In Formula 3, X₇₁ may be a single bond, or a linking group including O, S, N, B, C, Si, or any combination thereof.

In Formula 3, * indicates a binding site to any atom included in a remaining portion of the third compound other than the group represented by Formula 3.

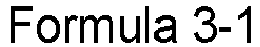

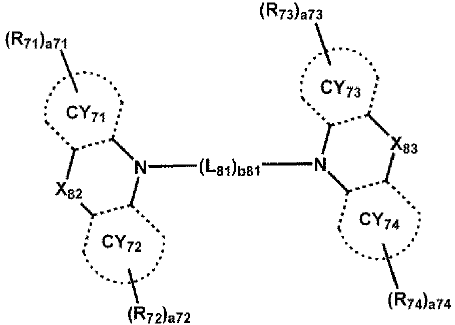

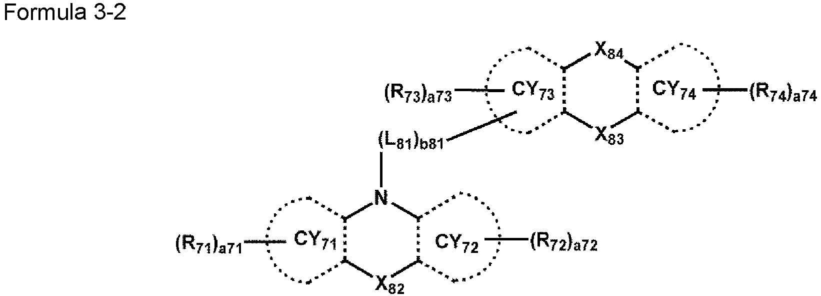

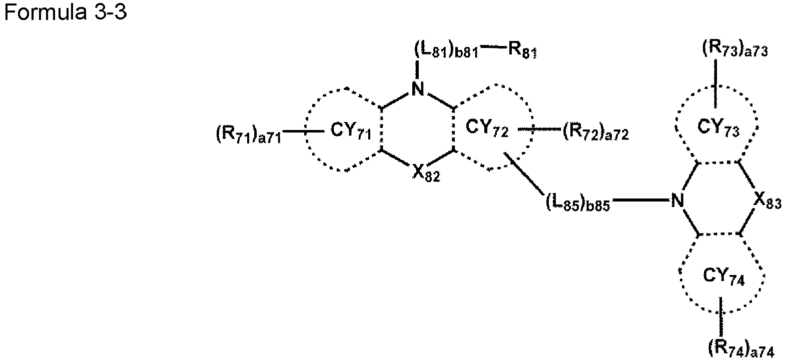

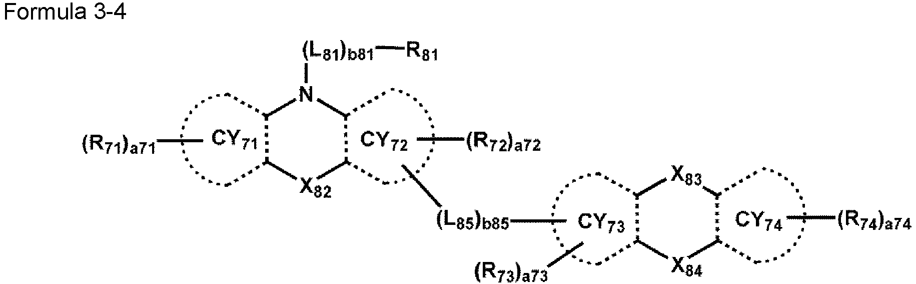

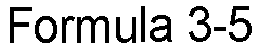

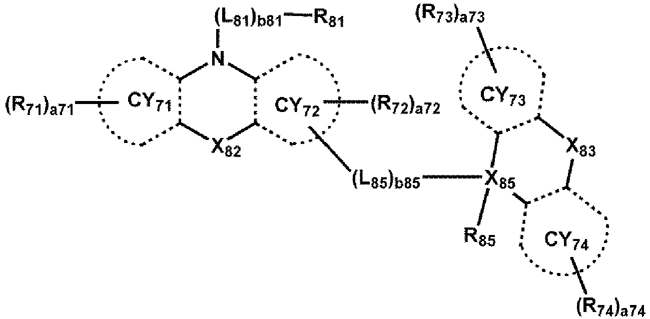

In Formulae 3-1 to 3-5, ring CY₇₁ to ring CY₇₄ may each independently be a π electron-rich C₃-C₆₀ cyclic group or a pyridine group.

In Formulae 3-1 to 3-5, X₈₂ may be a single bond, O, S, N-[(L₈₂)_{b82}-R₈₂], C(R₈₂ₐ)(R_{82b}), or Si(R₈₂ₐ)(R_{82b}).

In Formulae 3-1 to 3-5, X₈₃ may be a single bond, O, S, N-[(L₈₃)_{b83}-R₈₃], C(R₈₃ₐ)(R_{83b}), or Si(R₈₃ₐ)(R_{83b}).

In Formulae 3-1 to 3-5, X₈₄ may be O, S, N-[(L₈₄)_{b84}-R₈₄₁, C(R₈₄ₐ)(R_{84b}), or Si(R₈₄ₐ)(R_{84b}).

In Formulae 3-1 to 3-5, X₈₅ may be C or Si.

In Formulae 3-1 to 3-5, L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ.

Q₄ and Q₅ may each be as described in connection with Q₁.

In Formulae 3-1 to 3-5, b81 to b85 may each independently be an integer from 1 to 5.

In Formulae 3-1 to 3-5, R₇₁ to R₇₄, R₈₁ to R₈₅, R₈₂ₐ, R_{82b}, R₈₃ₐ, R_{83b}, R₈₄ₐ, and R_{84b} may each be as described herein.

In Formulae 3-1 to 3-5, a71 to a74 indicate the numbers of R₇₁ to R₇₄, respectively, and may each independently be an integer from 0 to 20. When a71 is 2 or more, two or more of R₇₁ may be identical to or different from each other, when a72 is 2 or more, two or more of R₇₂ may be identical to or different from each other, when a73 is 2 or more, two or more of R₇₃ may be identical to or different from each other, and when a74 is 2 or more, two or more of R₇₄ may be identical to or different from each other. a71 to a74 may each independently be an integer from 0 to 8.

R₁₀ₐ may be the same as described herein.

In Formulae 3-1 to 3-5, L₈₁ to L₈₅ may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or any combination thereof, and
Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, a group represented by 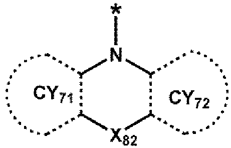 in Formulae 3-1 and 3-2 may be a group represented by at least one of Formulae CY71-1(1) to CY71-1(8), and/or
a group represented by 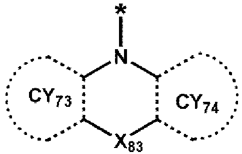 in Formulae 3-1 and 3-3 may be a group represented by at least one of Formulae CY71-2(1) to CY71-2(8), and/or
a group represented by 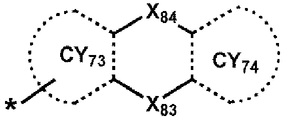 in Formulae 3-2 and 3-4 may be a group represented by at least one of Formulae CY71-3(1) to CY71-3(32), and/or
a group represented by 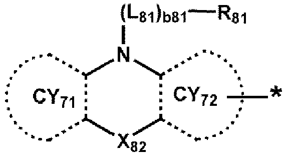 in Formulae 3-3 to 3-5 may be a group represented by at least one of Formulae CY71-4(1) to CY71-4(32), and/or
a group represented by 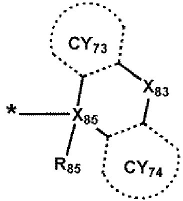 in Formula 3-5 may be a group represented by at least one of Formulae CY71-5(1) to CY71-5(8): 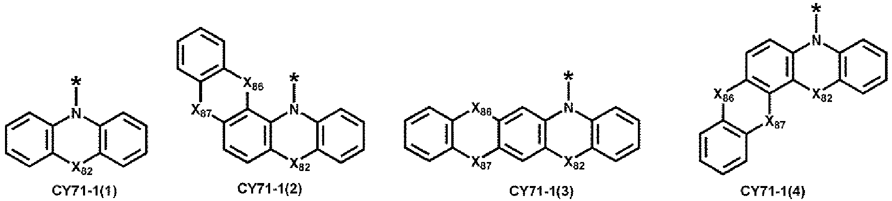 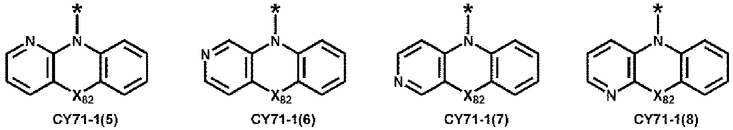 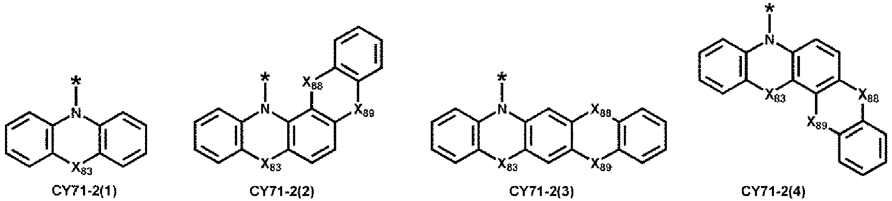 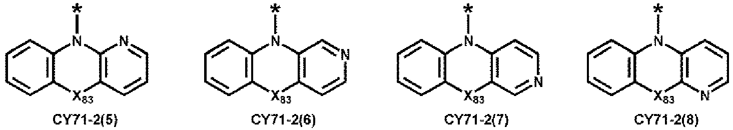 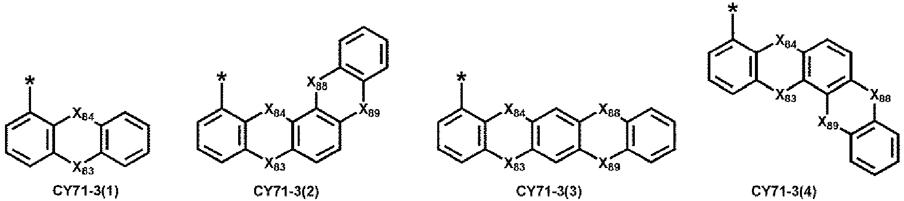 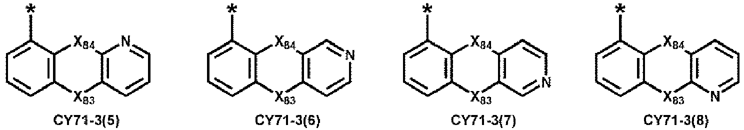 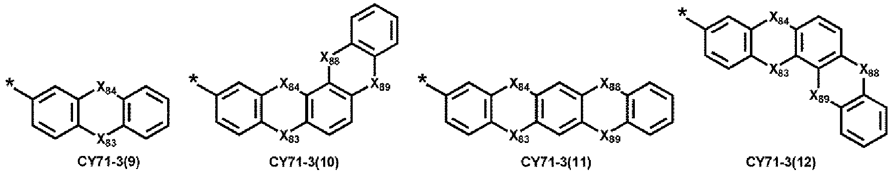 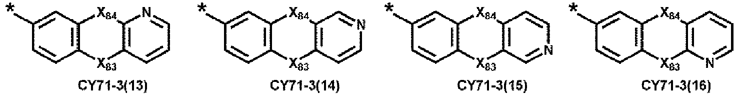 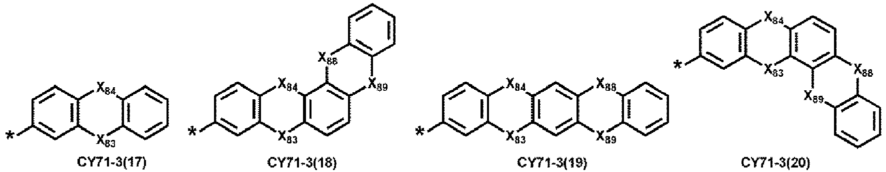 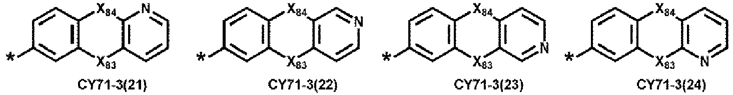 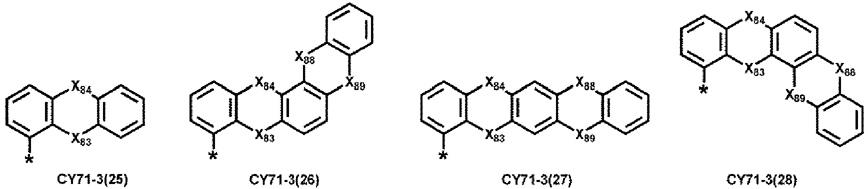 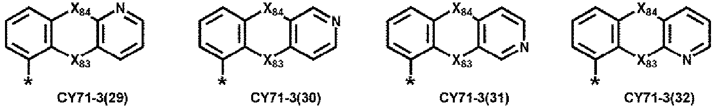 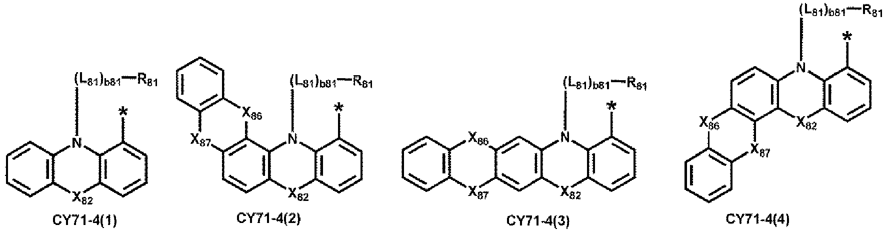 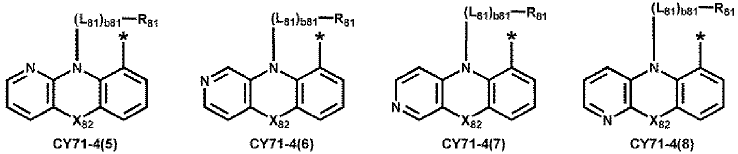 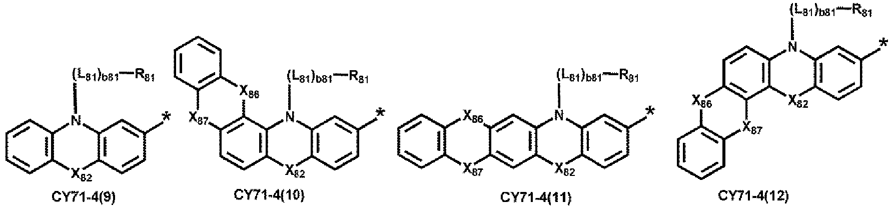 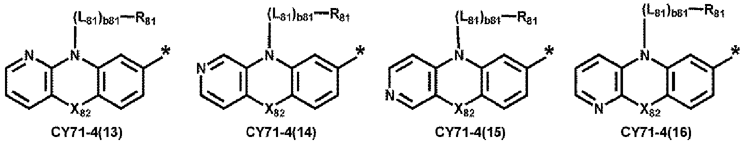 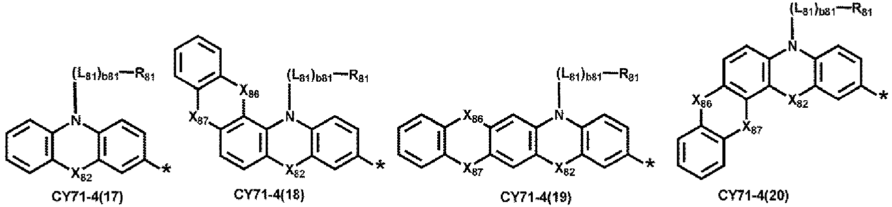 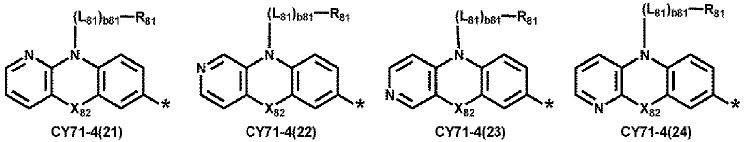 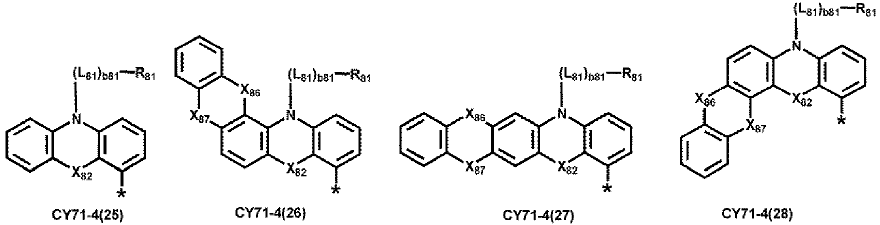 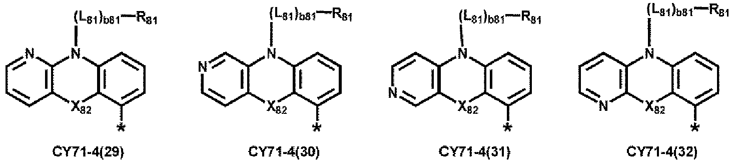 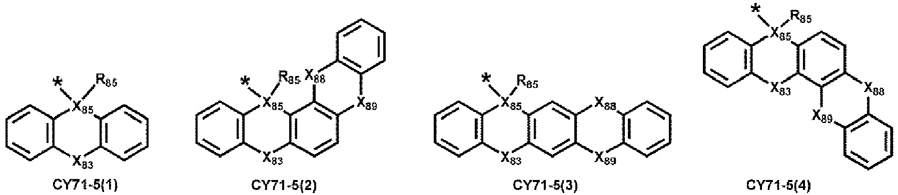 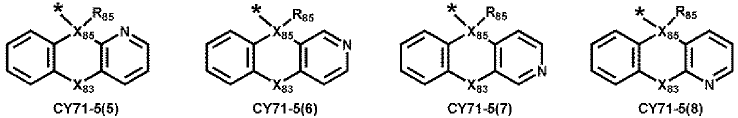
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
   X₈₁ to X₈₅, L₈₁, b81, R₈₁, and R₈₅ may each be as described herein,
   X₈₆ may be a single bond, O, S, N(R₈₆), B(R₈₆), C(R₈₆ₐ)(R_{86b}), or Si(R₈₆ₐ)(R_{86b}),
   X₈₇ may be a single bond, O, S, N(R₈₇), B(R₈₇), C(R₈₇ₐ)(R_{87b}), or Si(R₈₇ₐ)(R_{87b}),
   in Formulae CY71-1(1) to CY71-1(8) and CY71-4(1) to CY71-4(32), each of X₈₆ and X₈₇ may not be a single bond at the same time (e.g., simultaneously),
   X₈₈ may be a single bond, O, S, N(R₈₈), B(R₈₈), C(R₈₈ₐ)(R_{88b}), or Si(R₈₈ₐ)(R_{88b}),
   X₈₉ may be a single bond, O, S, N(R₈₉), B(R₈₉), C(R₈₉ₐ)(R_{89b}), or Si(R₈₉ₐ)(R_{89b}),
   in Formulae CY71-2(1) to CY71-2(8), CY71-3(1) to CY71-3(32), and CY71-5(1) to CY71-5(8), each of X₈₈ and X₈₉ may not be a single bond at the same time (e.g., simultaneously), and
   R₈₆ to R₈₉, R₈₆ₐ, R_{86b}, R₈₇ₐ, R_{87b}, R₈₈ₐ, R_{88b}, R₈₉ₐ, and R_{89b} may each be as described in connection with R₈₁.

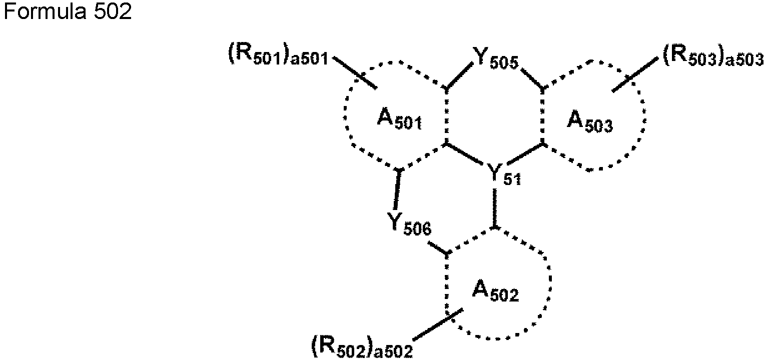

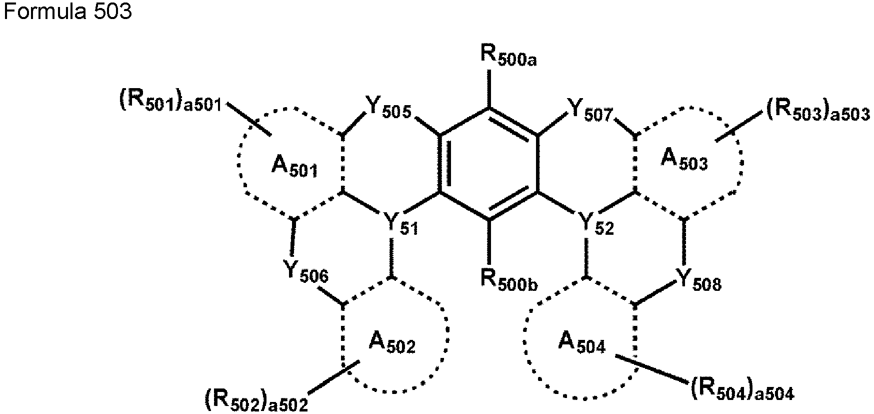

In Formulae 502 and 503, ring A₅₀₁ to ring A₅₀₄ may each independently be a C₃-C₆₀ carbocyclic group or a C₁-C₆₀ heterocyclic group.

In Formulae 502 and 503, Y₅₀₅ may be O, S, N(R₅₀₅), B(R₅₀₅), C(R₅₀₅ₐ)(R_{505b}), or Si(R₅₀₅ₐ)(R_{505b}).

In Formulae 502 and 503, Y₅₀₆ may be O, S, N(R₅₀₆), B(R₅₀₆), C(R₅₀₆ₐ)(R_{506b}), or Si(R₅₀₆ₐ)(R_{506b}).

In Formulae 502 and 503, Y₅₀₇ may be O, S, N(R₅₀₇), B(R₅₀₇), C(R₅₀₇ₐ)(R_{507b}), or Si(R₅₀₇ₐ)(R_{507b}).

In Formulae 502 and 503, Y₅₀₈ may be O, S, N(R₅₀₈), B(R₅₀₈), C(R₅₀₈ₐ)(R_{508b}), or Si(R₅₀₈ₐ)(R_{508b}).

In Formulae 502 and 503, Y₅₁ and Y₅₂ may each independently be B, P(=O), or S(=O).

In Formulae 502 and 503, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} may each be as described herein.

In Formulae 502 and 503, a501 to a504 indicate the numbers of R₅₀₁ to R₅₀₄, respectively, and may each independently be an integer from 0 to 20. When a501 is 2 or more, two or more of R₅₀₁ may be identical to or different from each other, when a502 is 2 or more, two or more of R₅₀₂ may be identical to or different from each other, when a503 is 2 or more, two or more of R₅₀₃ may be identical to or different from each other, and when a504 is 2 or more, two or more of R₅₀₄ may be identical to or different from each other. a501 to a504 may each independently be an integer from 0 to 8.

R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₈ₐ, R_{506b}, R₅₀₇ₐ, R_{507b}, R₅₀₈ₐ, and R_{508b} utilized herein may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂). Q₁ to Q₃ may each be as described herein.

In one or more embodiments, i) R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 2, 3-1 to 3-5, 502, and 503 and ii) R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, - Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂), and
Q₁ to Q₃ and Q₃₁ to Q₃₃ may each independently be:
   -CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, or -CD₂CDH₂; or
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In one or more embodiments, i) R₁, R₂, R₃₁ to R₃₃, and R₄ in Formula 1-1 or Formula 1-2, ii) R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 2, 3-1 to 3-5, 502, and 503, and iii) R₁₀ₐ may each independently be:
hydrogen, deuterium, -F, a cyano group, a nitro group, -CH₃, -CD₃, -CD₂H, -CDH₂, - CF₃, -CF₂H, or -CFH₂;
a group represented by at least one of Formulae 9-1 to 9-19; or
a group represented by at least one of Formulae 10-1 to 10-246, -C(Q₁)(Q₂)(Q₃), - Si(Q₁)(Q₂)(Q₃), and/or -P(=O)(Q₁)(Q₂) (wherein Q₁ to Q₃ may each be as described herein): 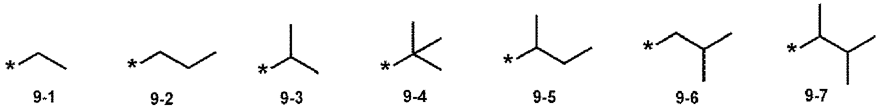 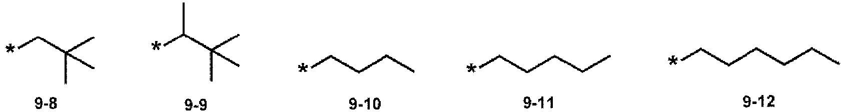 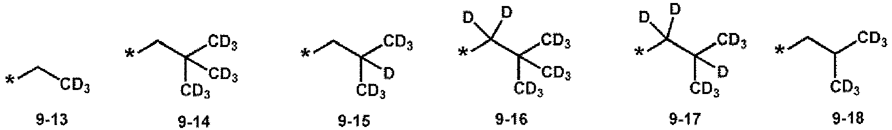 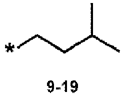 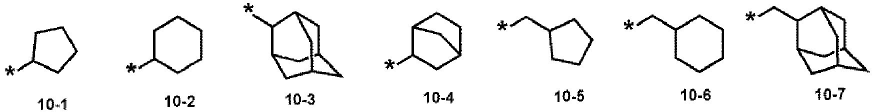 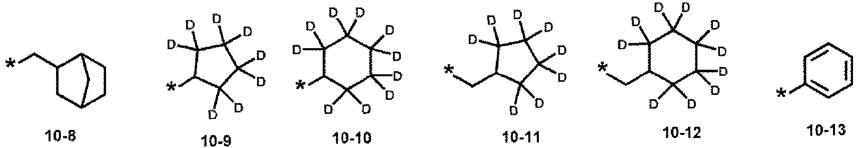 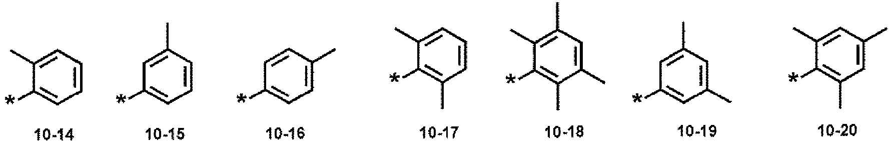 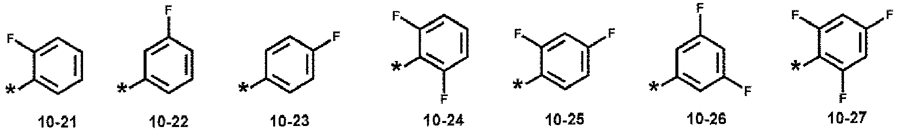 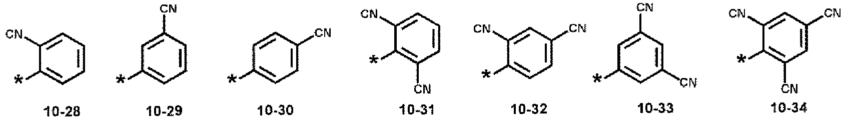 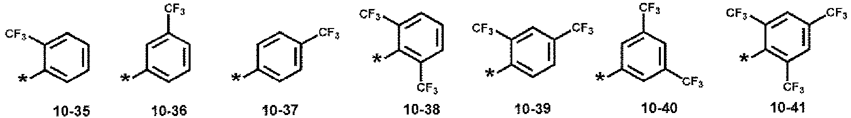 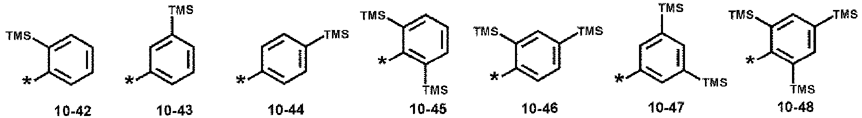 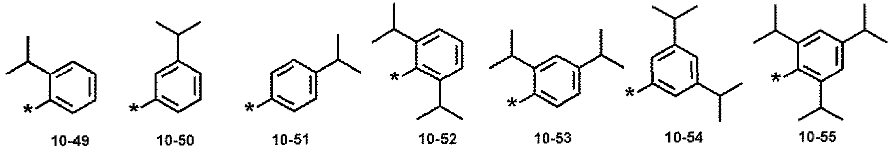 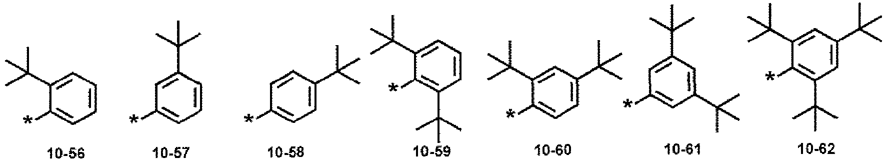 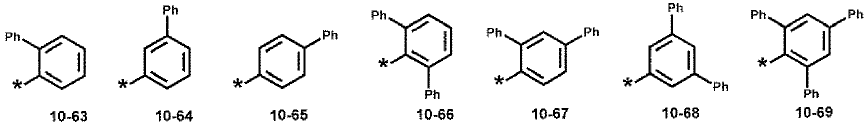 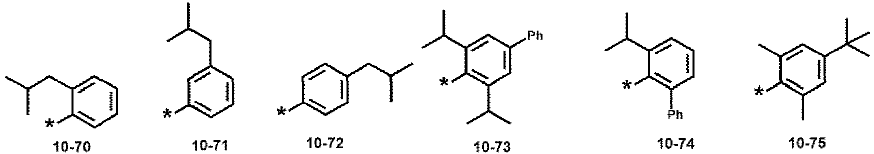 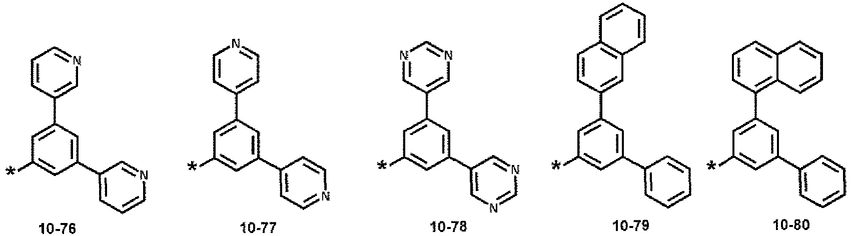 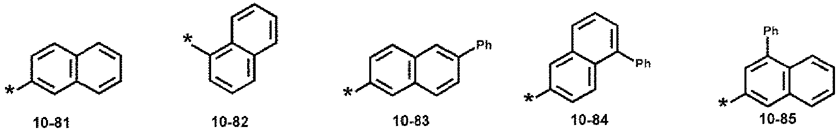 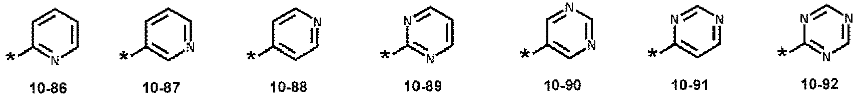 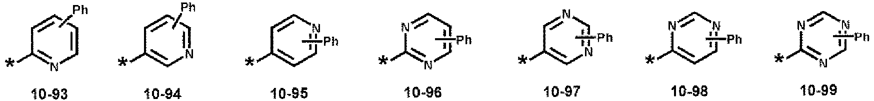 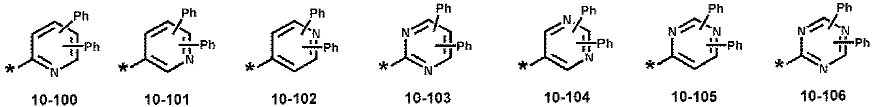 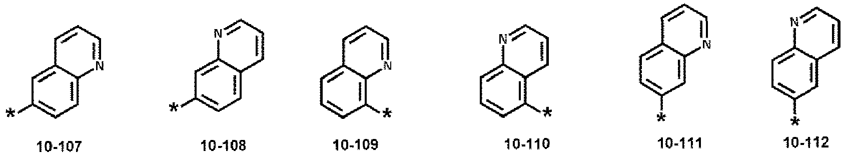 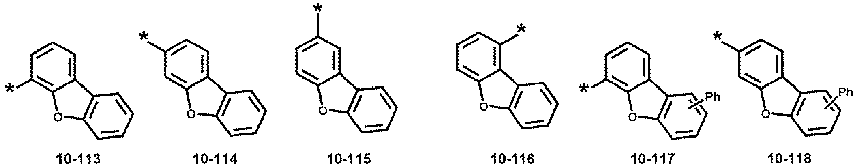 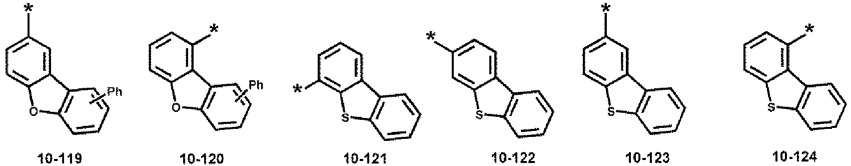 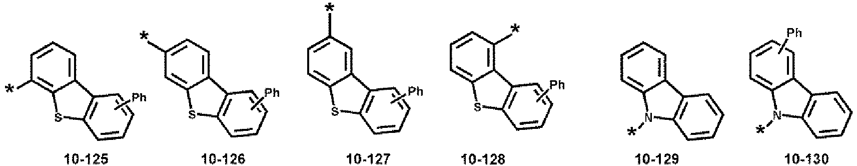 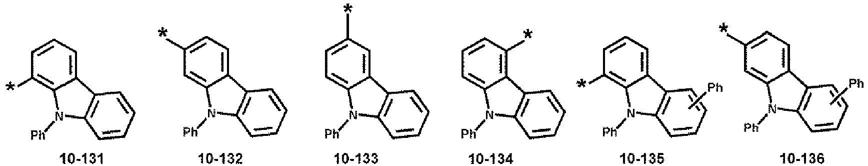 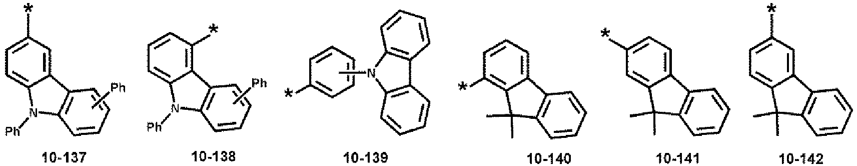 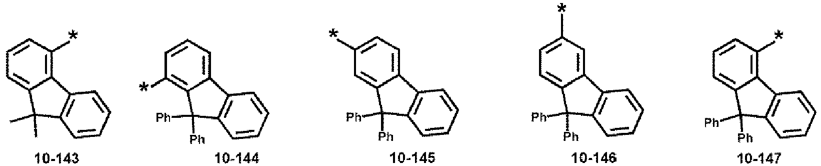 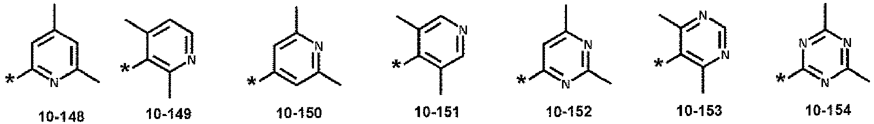 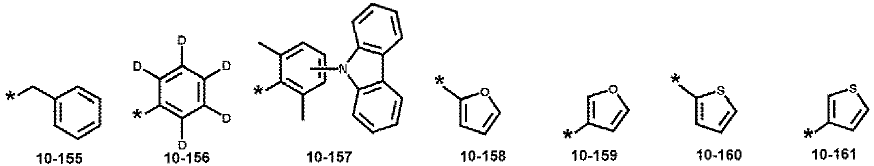 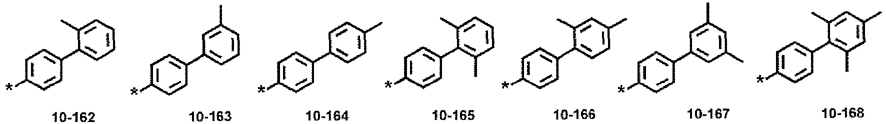 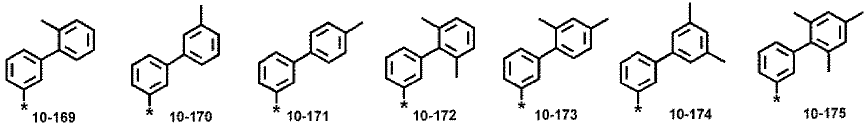 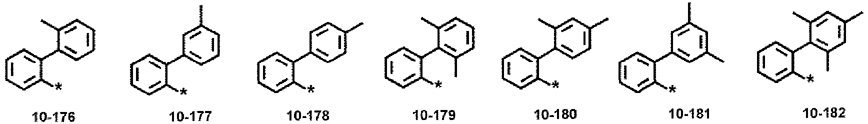 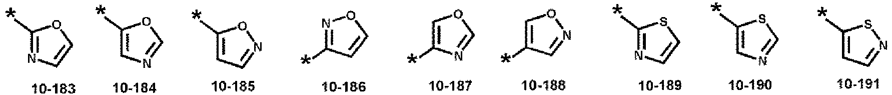 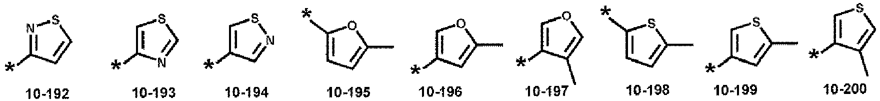 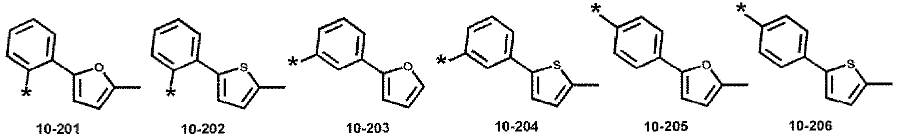 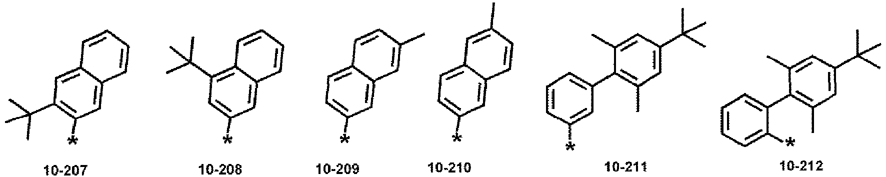 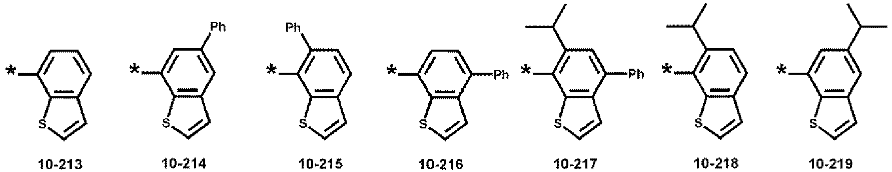 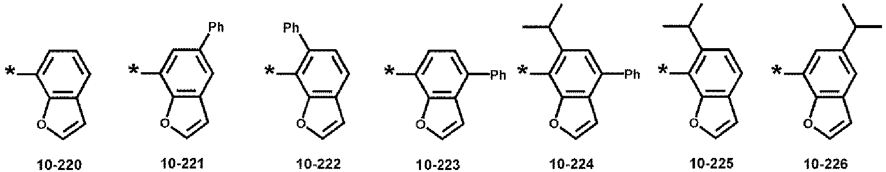 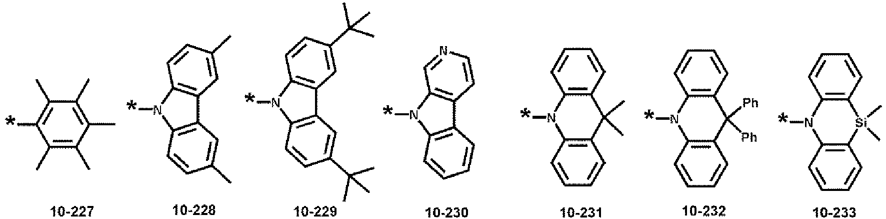 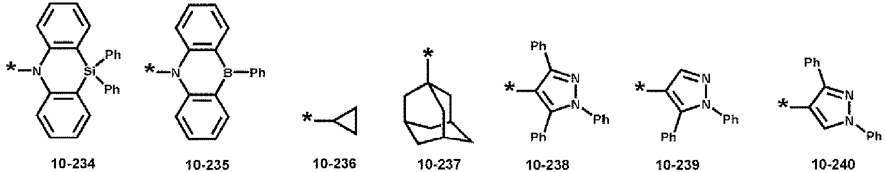 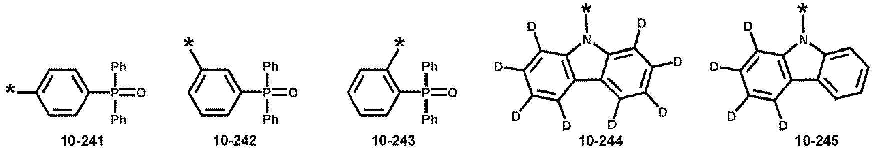 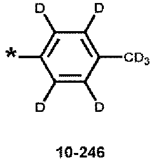
wherein, in Formulae 9-1 to 9-19 and 10-1 to 10-246, * indicates a binding site to a neighboring atom, "Ph" represents a phenyl group, and "TMS" represents a trimethylsilyl group.

### Examples of compounds

In one or more embodiments, the organometallic compound represented by Formula 1-1 or Formula 1-2 may be at least one of Compounds 1 to 72:

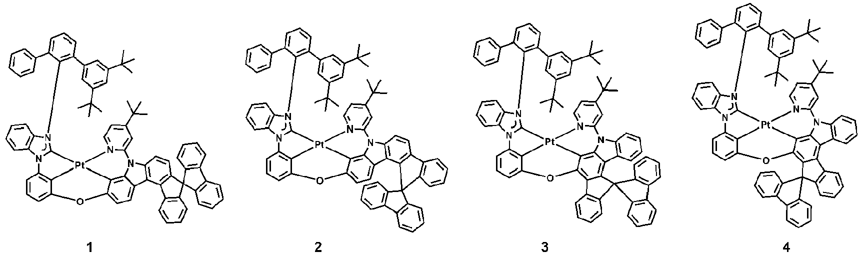

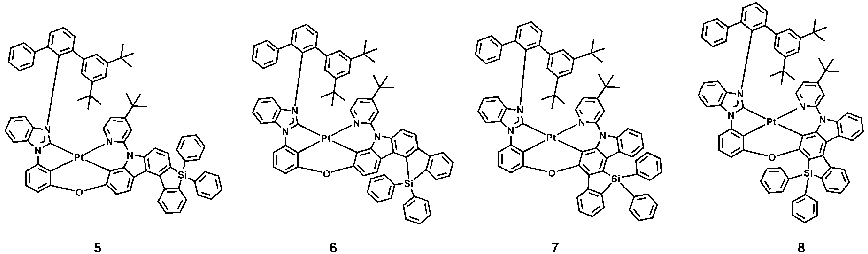

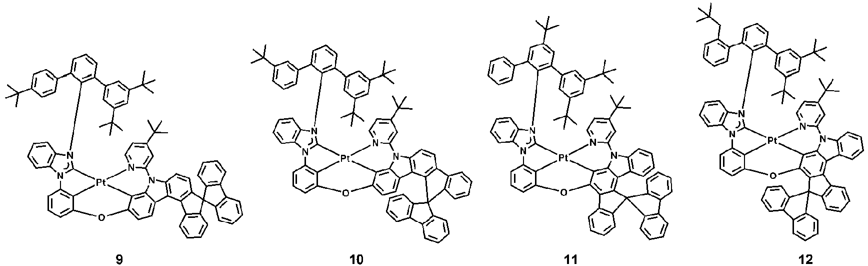

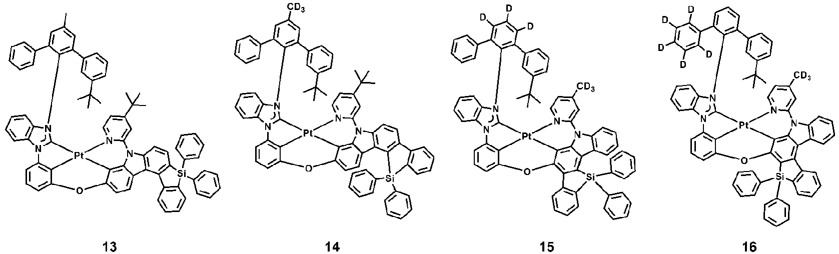

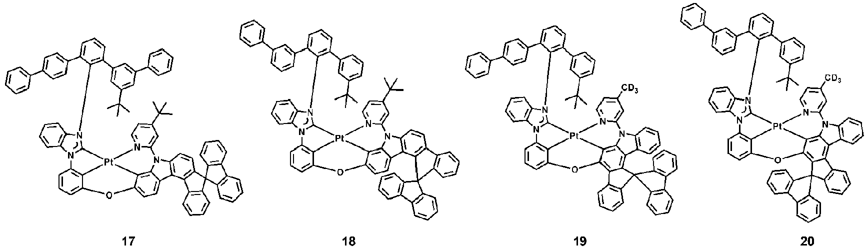

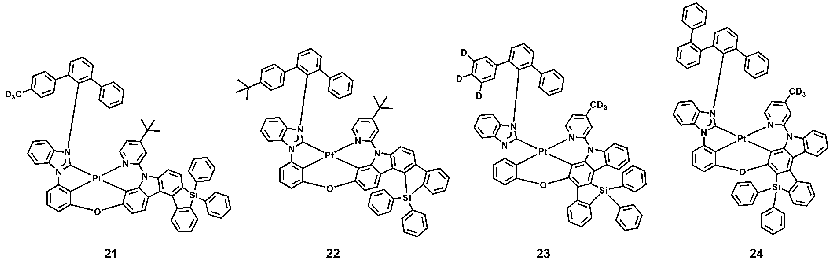

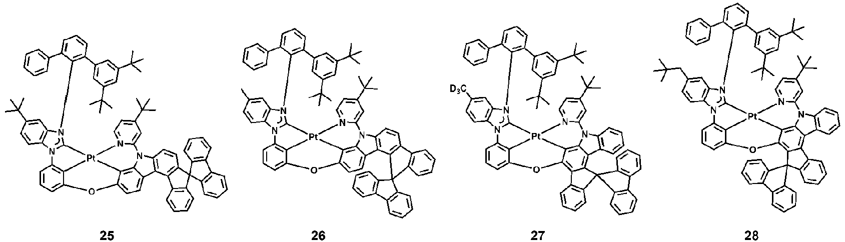

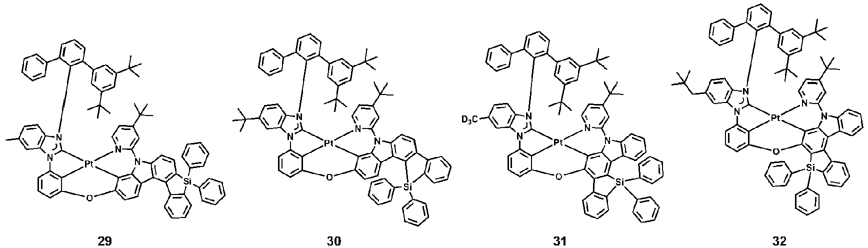

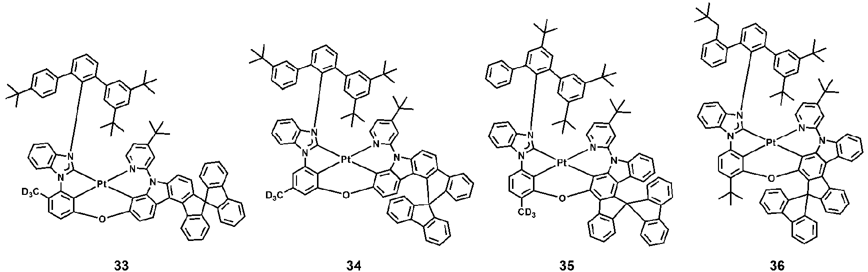

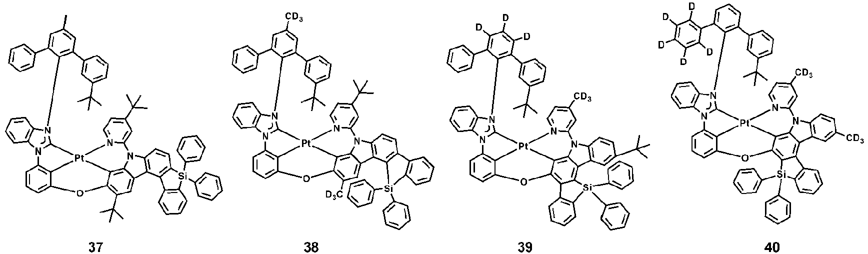

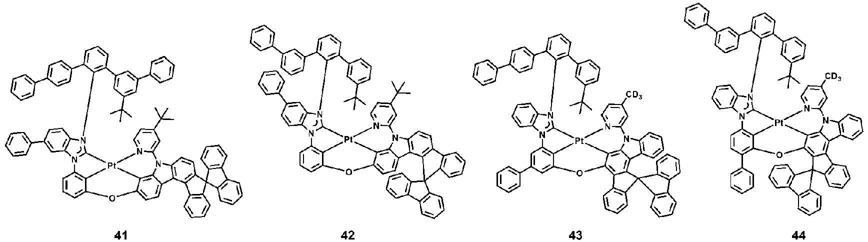

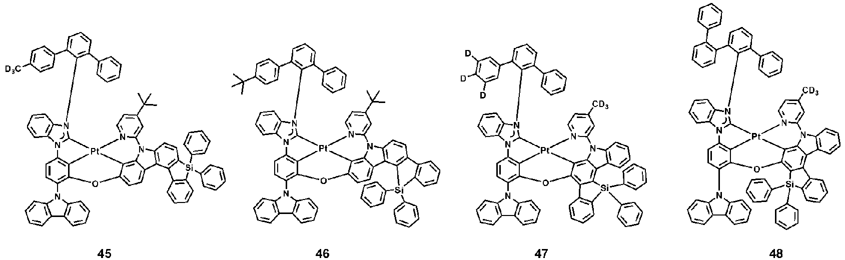

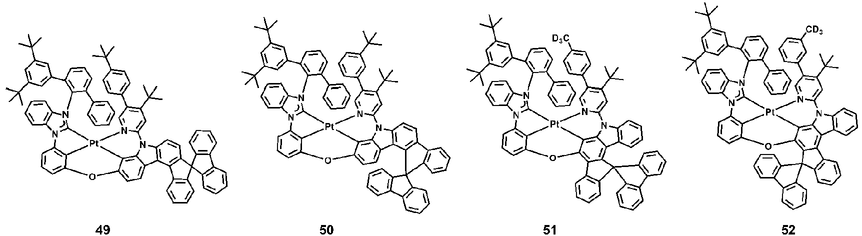

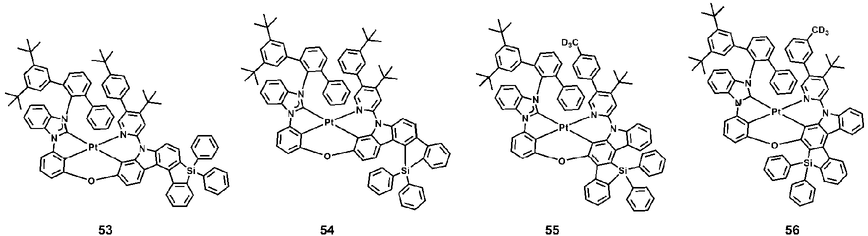

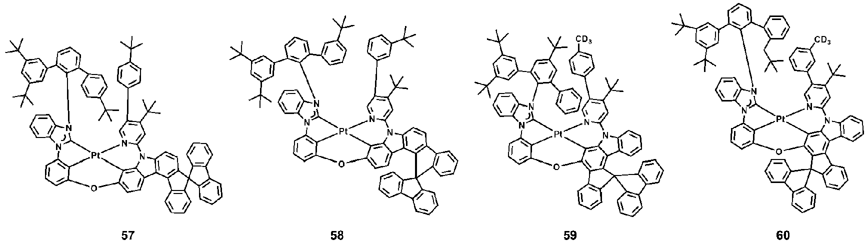

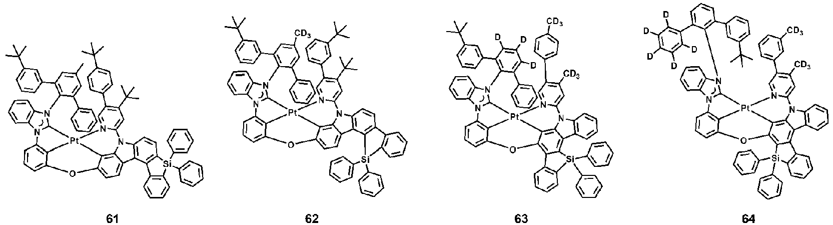

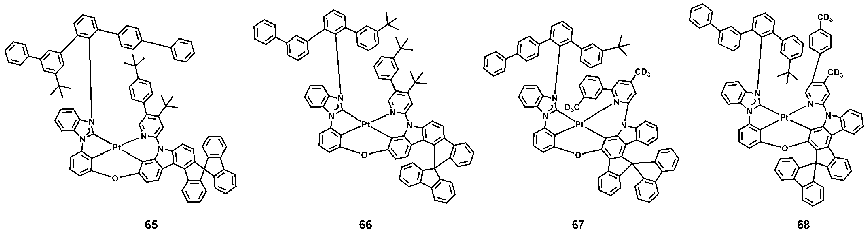

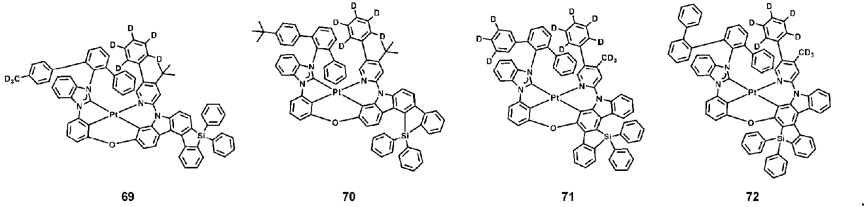

For example, the second compound may be at least one of Compounds ETH1 to ETH100:

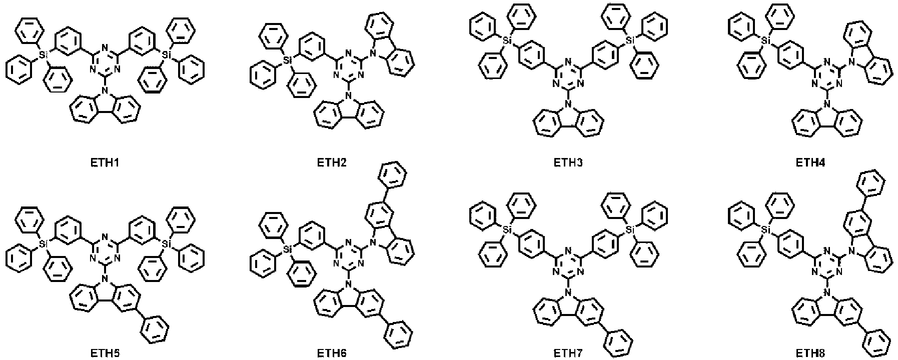

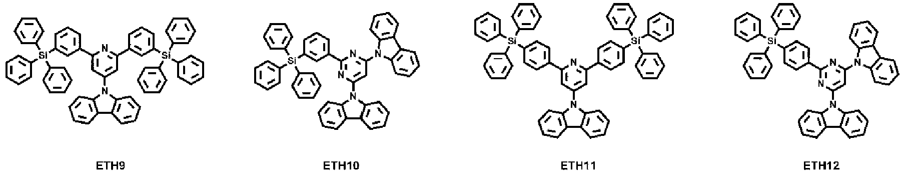

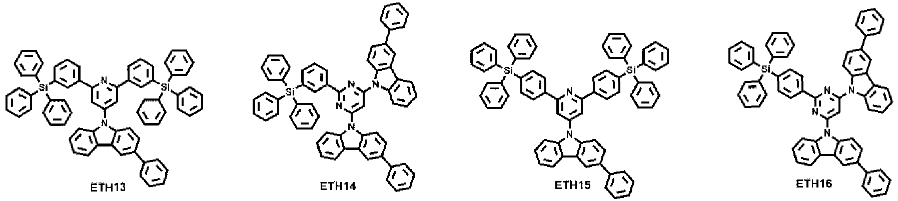

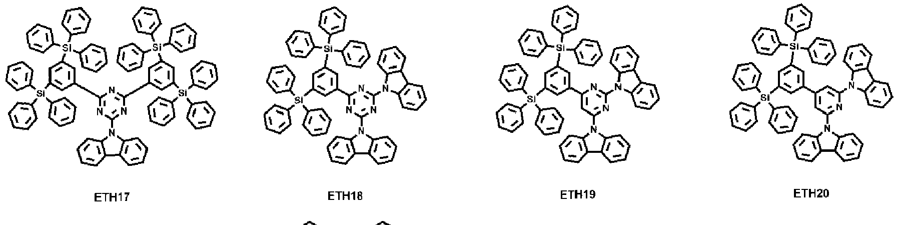

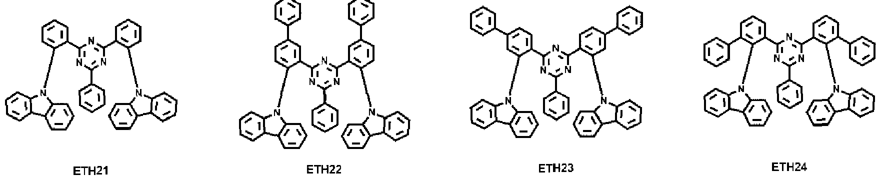

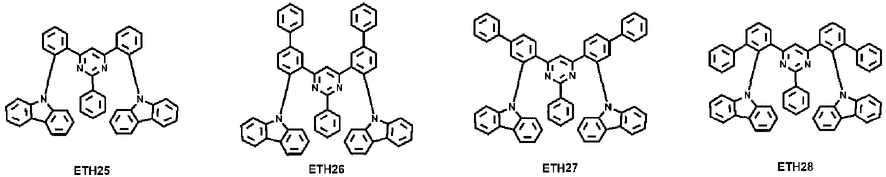

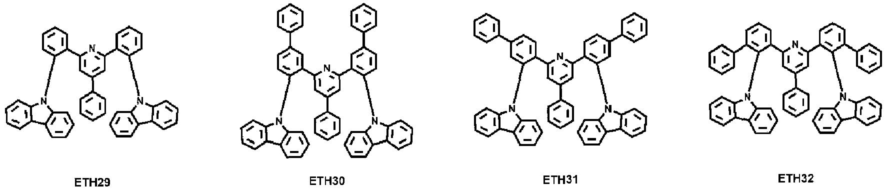

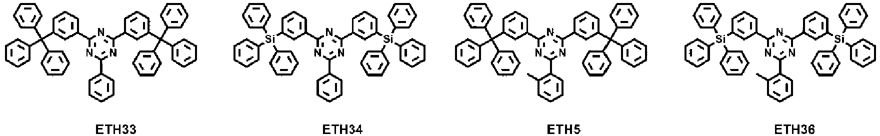

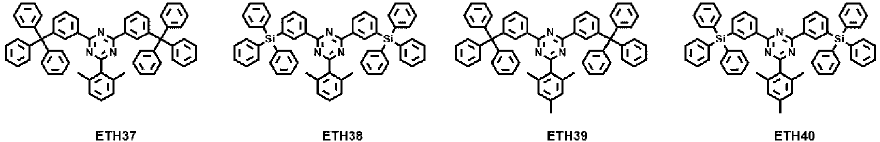

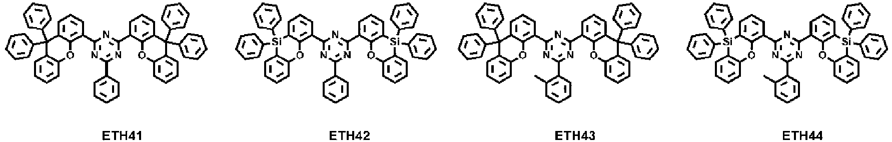

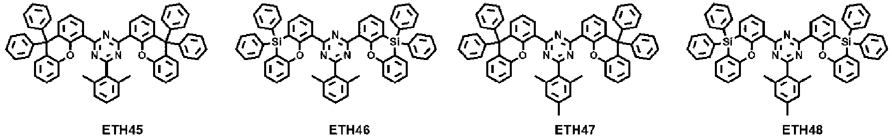

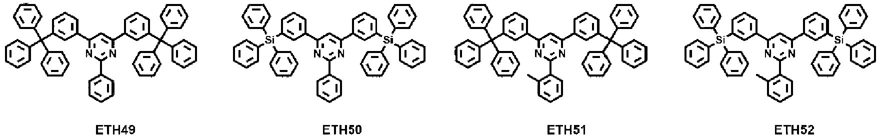

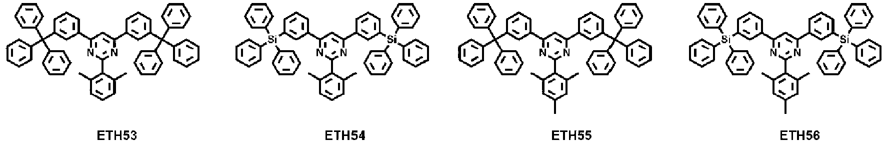

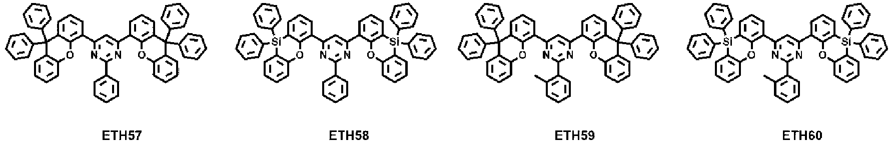

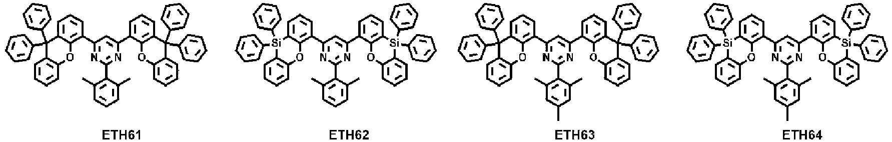

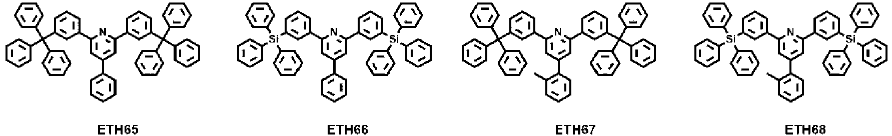

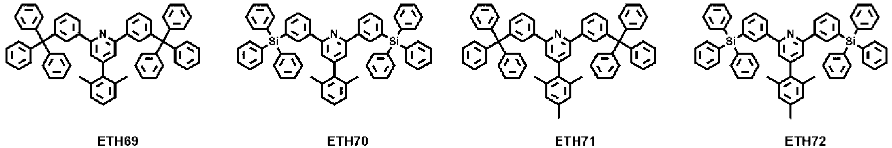

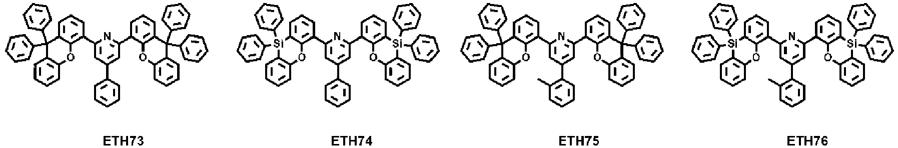

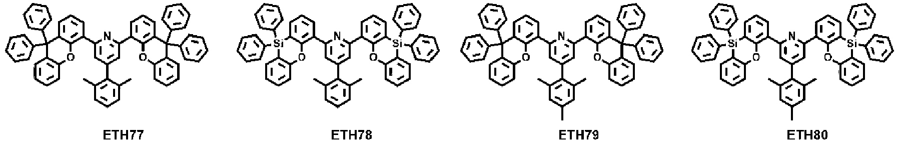

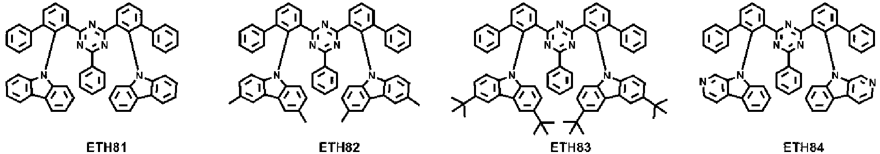

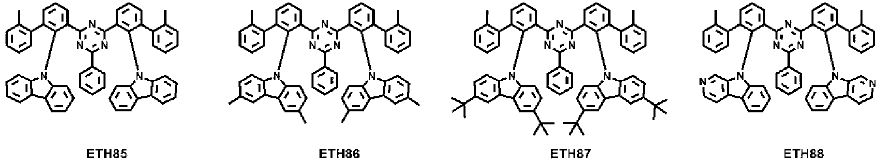

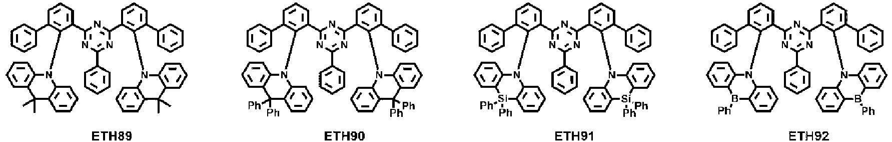

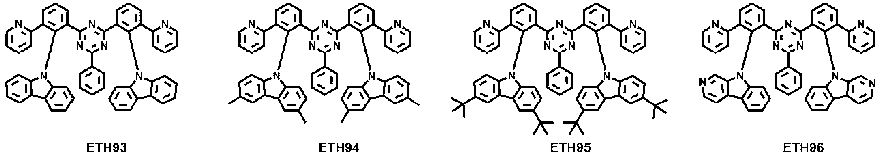

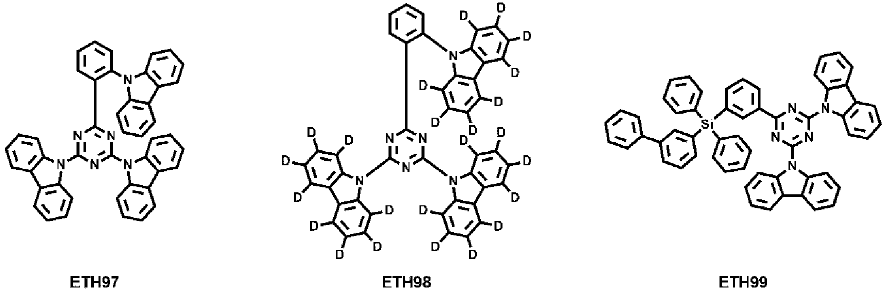

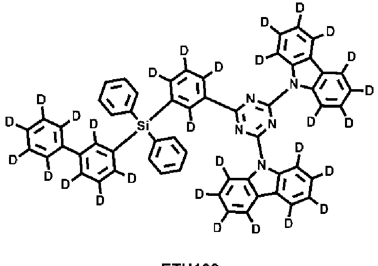

For example, the third compound may be at least one of Compounds HTH1 to HTH40:

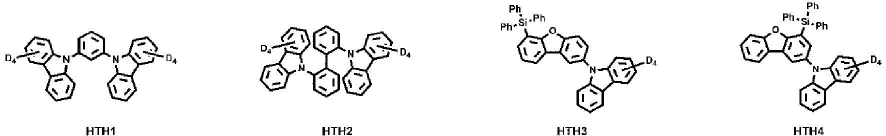

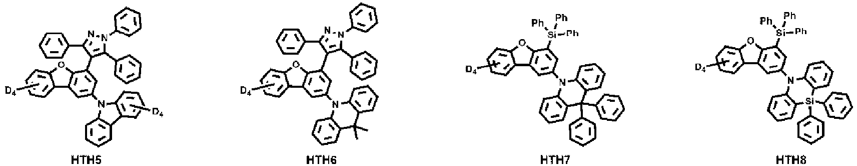

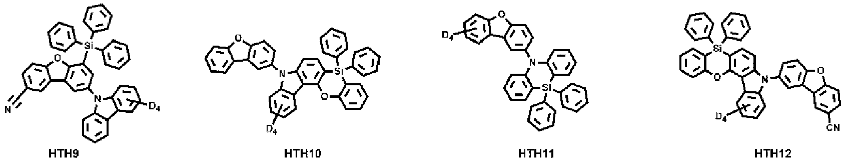

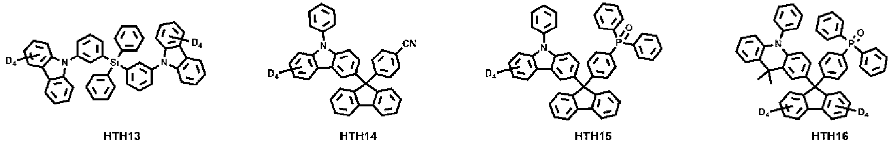

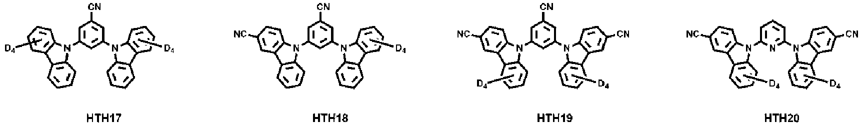

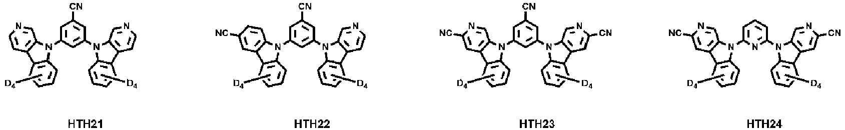

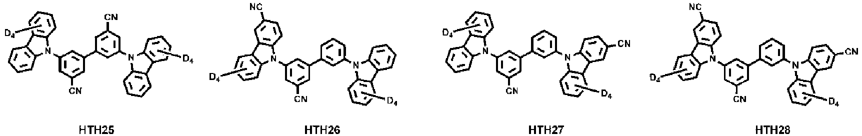

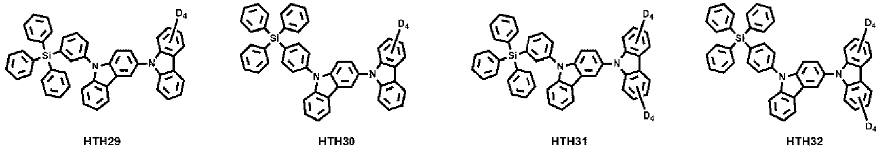

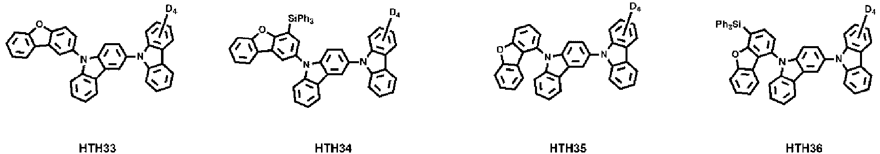

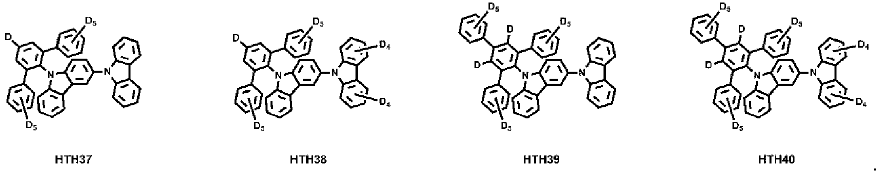

For example, the fourth compound may be at least one of Compounds DFD1 to DFD29:

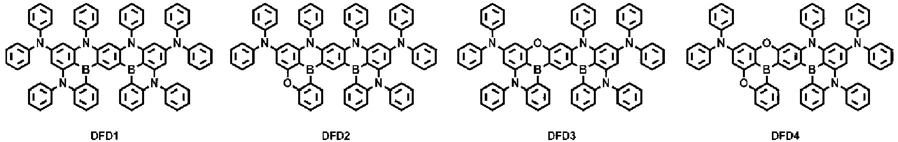

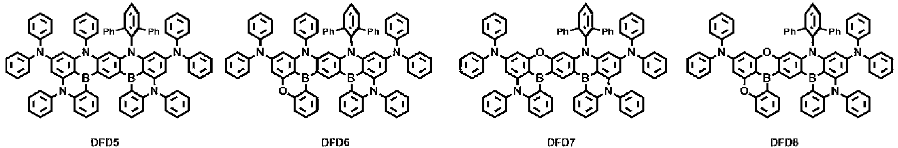

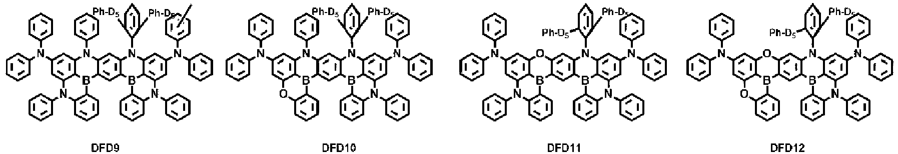

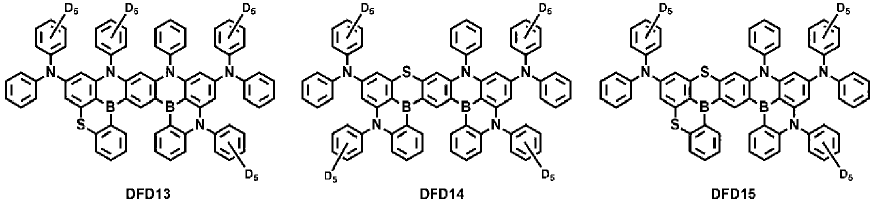

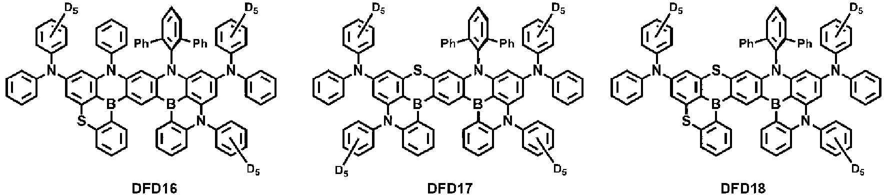

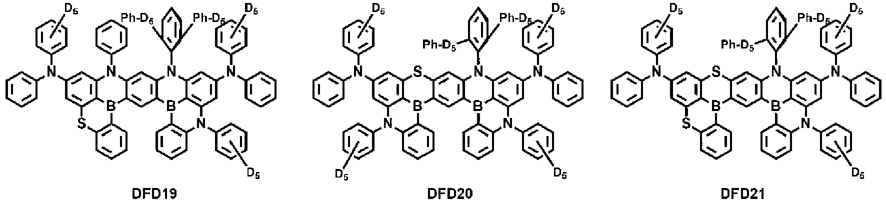

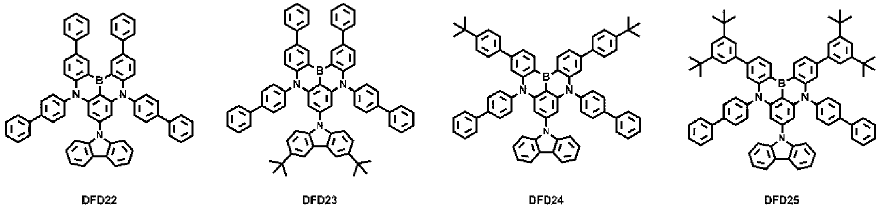

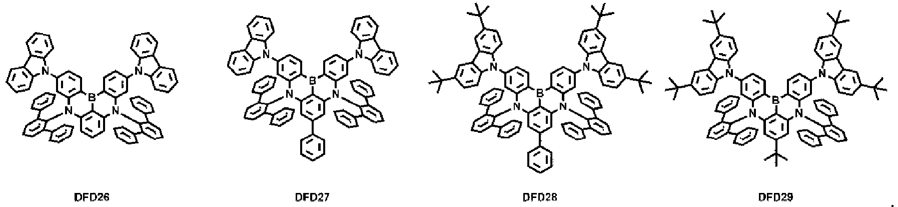

In the compounds described, "Ph" represents a phenyl group, "D₅" represents substitution with five deuterium atoms, and "D₄" represents substitution with four deuterium atoms. For example, a group represented by 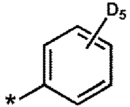 may be identical to a group represented by

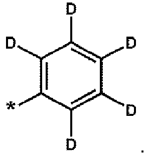

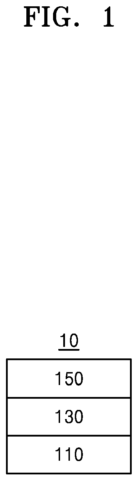

### Description of FIG. 1B

FIG. 1 is a schematic cross-sectional view of a light-emitting device 10 according to one or more embodiments. The light-emitting device 10 includes a first electrode 110, an interlayer 130, and a second electrode 150.

Hereinafter, the structure of the light-emitting device 10 according to one or more embodiments and a method of manufacturing the light-emitting device 10 will be described with reference to FIG. 1.

### First electrode 110

In FIG. 1, a substrate may be additionally arranged under the first electrode 110 or on the second electrode 150. In one or more embodiments, as the substrate, a glass substrate or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene napthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high work-function material that facilitates injection of holes. The "term "high work-function material" as utilized herein refers to a substance (e.g., a metal or metal alloy) that requires a relatively high amount of energy to emit electrons from its surface.

The first electrode 110 may be a reflective electrode, a semi-transmissive electrode, or a transmissive electrode. In one or more embodiments, when the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layer structure consisting of a single layer or a multi-layer structure including multiple layers. For example, the first electrode 110 may have a three-layer structure of ITO/Ag/ITO.

### Interlayer 130

The interlayer 130 is arranged on the first electrode 110. The interlayer 130 may include an emission layer.

The interlayer 130 may further include a hole transport region arranged between the first electrode 110 and the emission layer, and an electron transport region arranged between the emission layer and the second electrode 150.

The interlayer 130 may further include, in addition to one or more suitable organic materials, a metal-containing compound such as an organometallic compound, an inorganic material such as quantum dots, and/or the like.

In one or more embodiments, the interlayer 130 may include, i) two or more emitting units sequentially stacked between the first electrode 110 and the second electrode 150, and ii) a charge generation layer between the two or more emitting units. When the interlayer 130 includes the two or more emitting units and the charge generation layer, the light-emitting device 10 may be a tandem light-emitting device.

### Hole transport region in interlayer 130

The hole transport region may have i) a single-layer structure including (e.g., consisting of) a single layer including (e.g., consisting of) a single material, ii) a single-layer structure including (e.g., consisting of) a single layer including (e.g., consisting of) multiple materials that are different from each other, or iii) a multi-layer structure including multiple layers including multiple materials that are different from each other.

The hole transport region may include a hole injection layer, a hole transport layer, an emission auxiliary layer, an electron blocking layer, or any combination thereof.

For example, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein constituent layers of each structure are stacked sequentially from the first electrode 110.

The hole transport region may include a compound represented by Formula 201, a compound represented by Formula 202, and/or any combination thereof: 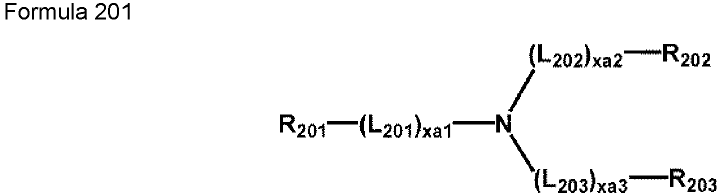 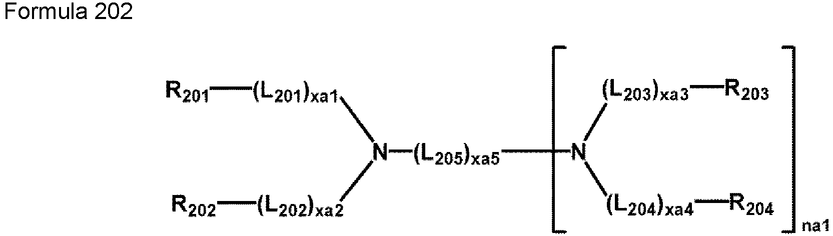 wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
   xa1 to xa4 may each independently be an integer from 0 to 5,
   xa5 may be an integer from 1 to 10,
   R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group (e.g., a carbazole group, and/or the like) unsubstituted or substituted with at least one R₁₀ₐ (e.g., see Compound HT16),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group unsubstituted or substituted with at least one R₁₀ₐ, and
na1 may be an integer from 1 to 4.

For example, each of Formulae 201 and 202 may include at least one selected from among groups represented by Formulae CY201 to CY217: 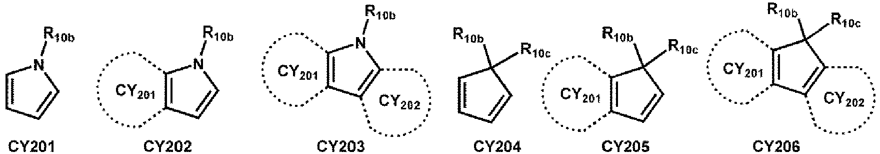 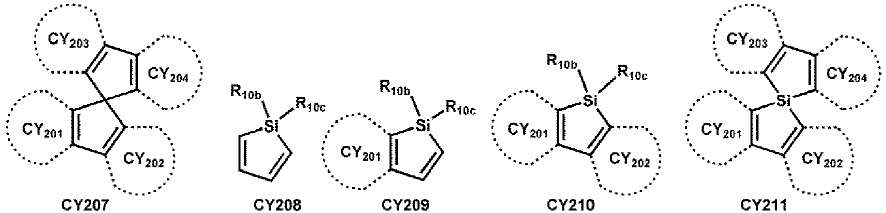 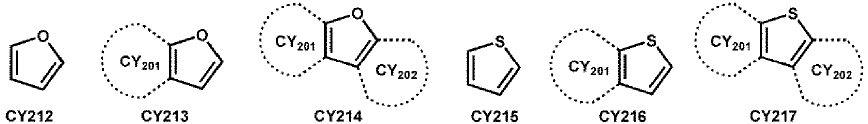 wherein, in Formulae CY201 to CY217, R_{10b} and R_{10c} may each be as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from among groups represented by Formulae CY201 to CY203.

In one or more embodiments, Formula 201 may include at least one selected from among groups represented by Formulae CY201 to CY203 and at least one of the groups represented by Formulae CY204 to CY217.

In one or more embodiments, in Formula 201, xa1 may be 1, R₂₀₁ may be one selected from among groups represented by Formulae CY201 to CY203, xa2 may be 0, and R₂₀₂ may be one of the groups represented by Formulae CY204 to CY207.

In one or more embodiments, each of Formulae 201 and 202 may not include (e.g., may exclude) the groups represented by Formulae CY201 to CY203.

In one or more embodiments, each of Formulae 201 and 202 may not include (e.g., may exclude) the groups represented by Formulae CY201 to CY203, and may include at least one of the groups represented by Formulae CY204 to CY217.

In one or more embodiments, each of Formulae 201 and 202 may not include (e.g., may exclude) the groups represented by Formulae CY201 to CY217.

For example, the hole transport region may include: at least one selected from among Compounds HT1 to HT46; m-MTDATA; TDATA; 2-TNATA; NPB(NPD); β-NPB; TPD; spiro-TPD; spiro-NPB; methylated NPB; TAPC; HMTPD; 4,4',4"-tris(N-carbazolyl)triphenylamine (TCTA); polyaniline/dodecylbenzenesulfonic acid (PANI/DBSA); poly(3,4-ethylenedioxythiophene)/poly(4-styrenesulfonate) (PEDOT/PSS); polyaniline/camphor sulfonic acid (PANI/CSA); polyaniline/poly(4-styrenesulfonate) (PANI/PSS); and/or any combination thereof:

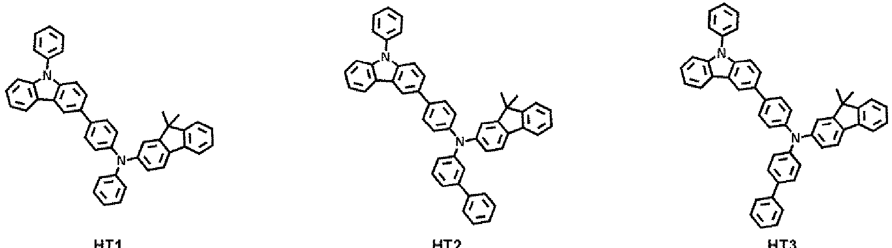

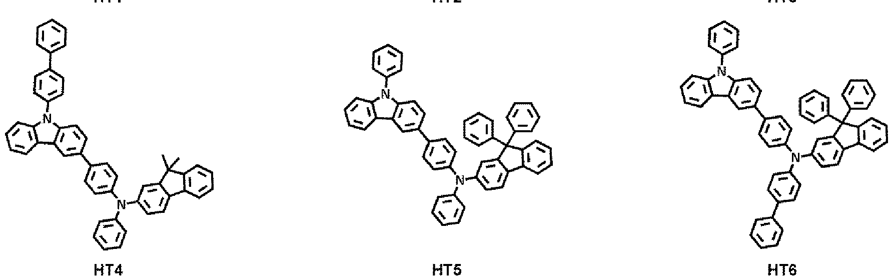

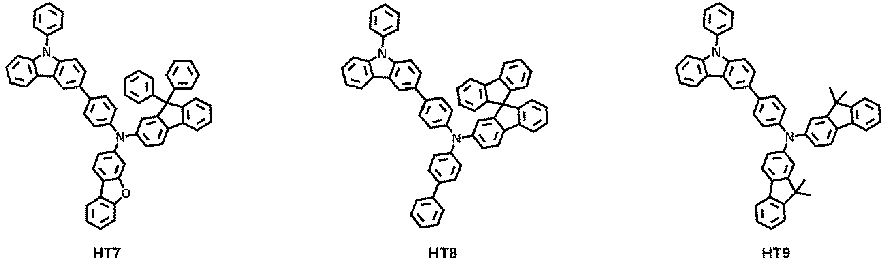

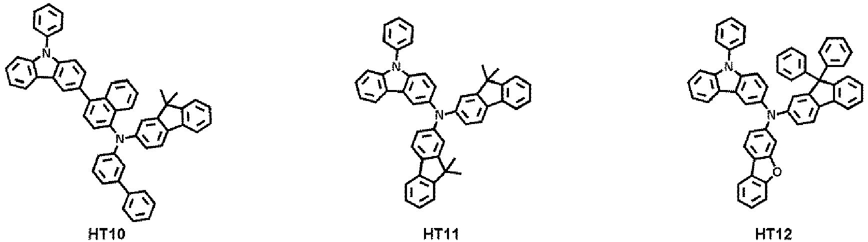

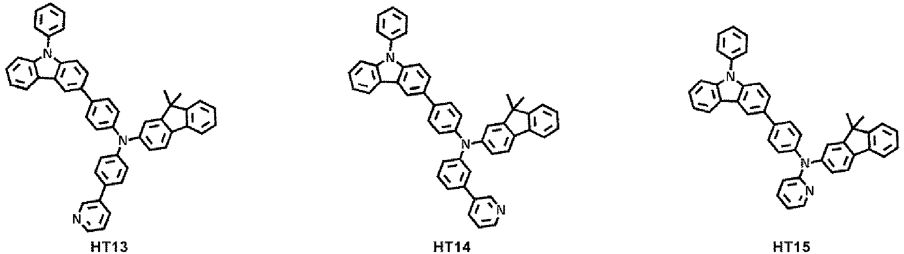

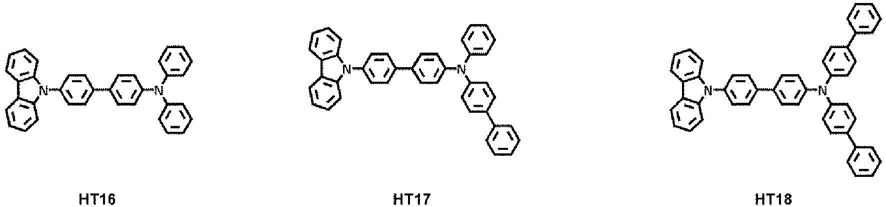

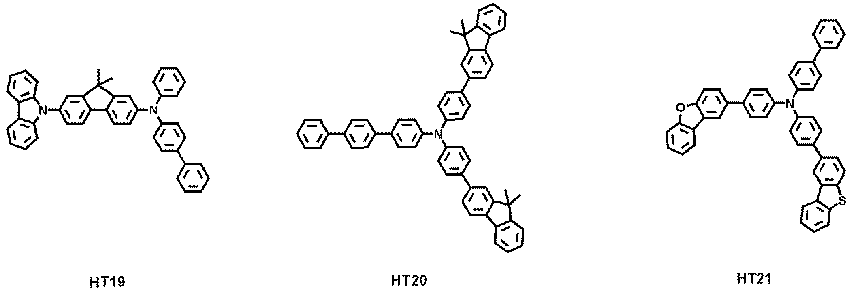

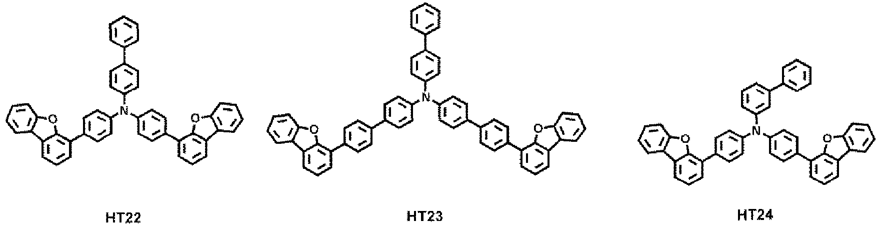

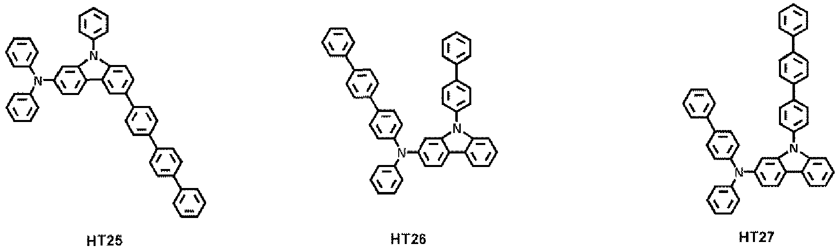

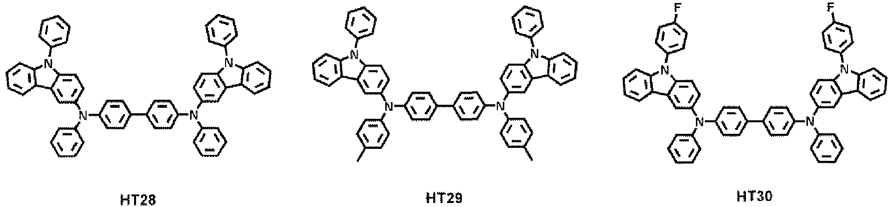

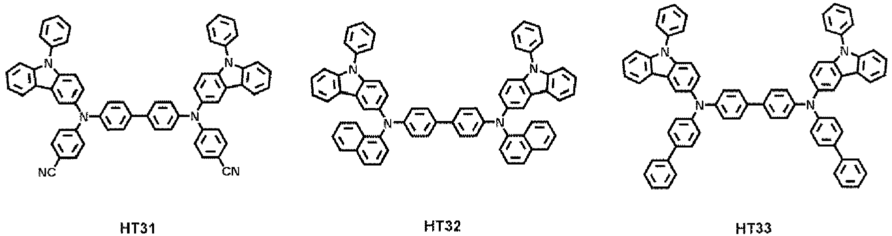

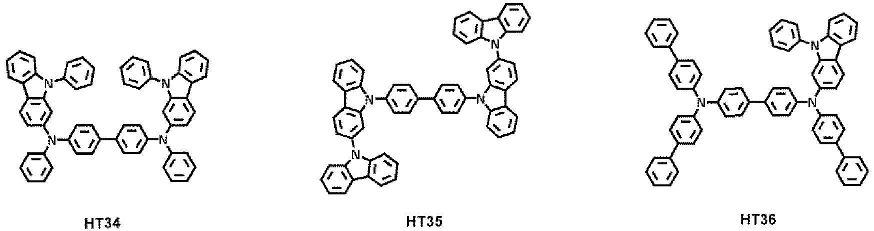

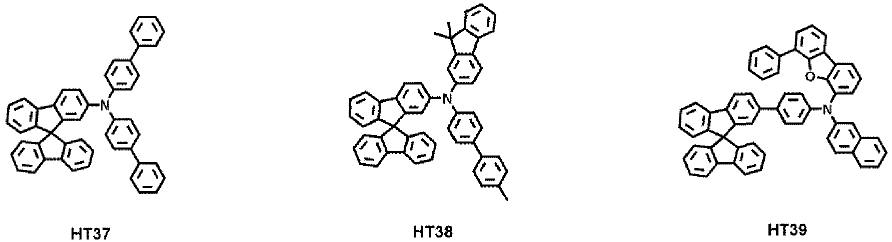

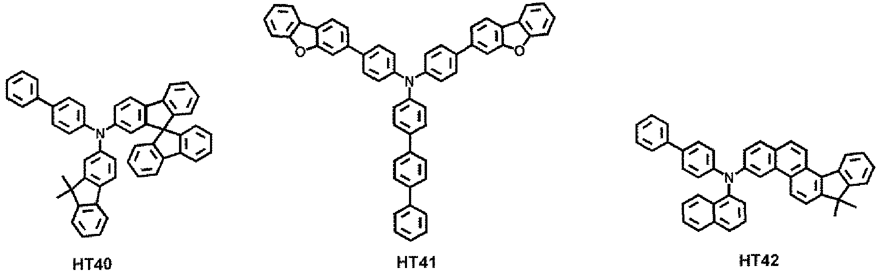

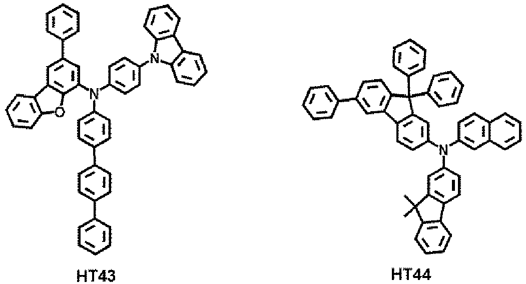

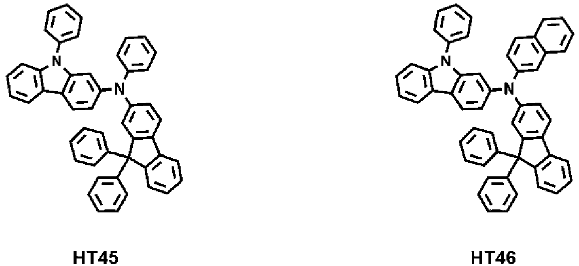

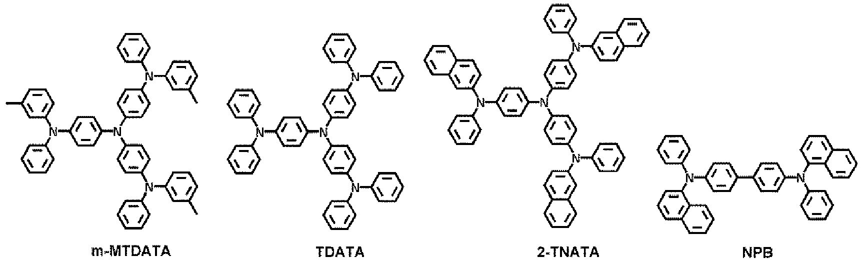

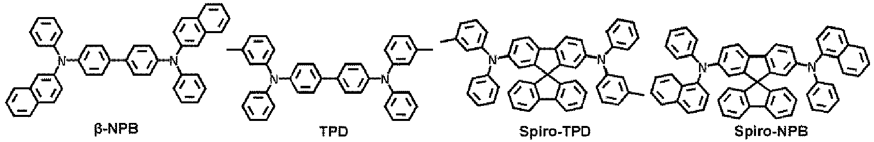

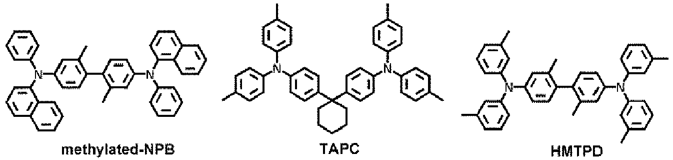

The thickness of the hole transport region may be in a range of about 50 angstrom (Å) to about 10,000 Å, for example, about 100 Å to about 4,000 Å. When the hole transport region includes a hole injection layer, a hole transport layer, or any combination thereof, the thickness of the hole injection layer may be in a range of about 100 Å to about 9,000 Å, for example, about 100 Å to about 1,000 Å, and the thickness of the hole transport layer may be in a range of about 50 Å to about 2,000 Å, for example, about 100 Å to about 1,500 Å. When the thicknesses of the hole transport region, the hole injection layer, and the hole transport layer are within the ranges described, satisfactory hole transporting characteristics may be obtained without a substantial increase in driving voltage.

The emission auxiliary layer may increase light-emission efficiency by compensating for an optical resonance distance according to the wavelength of light emitted by the emission layer, and the electron blocking layer may block or reduce the leakage of electrons from the emission layer to the hole transport region. Materials that may be included in the hole transport region may be included in the emission auxiliary layer and the electron blocking layer.

### p-dopant

The hole transport region may further include, in addition to the materials described, a charge-generation material for the improvement of conductive properties. The charge-generation material may be uniformly or non-uniformly dispersed in the hole transport region (e.g., in the form of a single layer consisting of a charge-generation material).

The charge-generation material may be, for example, a p-dopant.

For example, the p-dopant may have a LUMO energy level of -3.5 eV or less.

In one or more embodiments, the p-dopant may include a quinone derivative, a cyano group-containing compound, a compound including element EL1 and element EL2, or any combination thereof.

Examples of the quinone derivative are TCNQ, F4-TCNQ, and/or the like.

Examples of the cyano group-containing compound are HAT-CN, a compound represented by Formula 221, and/or the like: 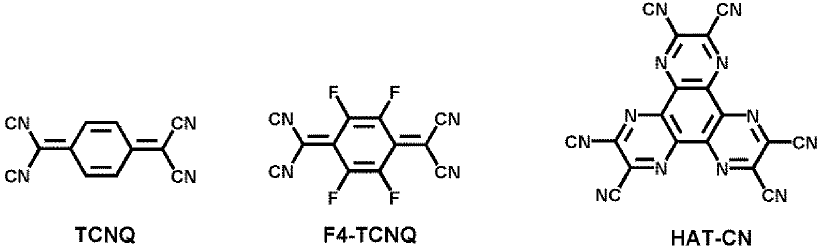 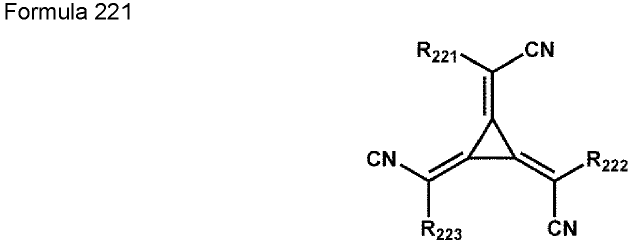 wherein, in Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one selected from among R₂₂₁ to R₂₂₃ may each independently be a C₃-C₆₀ carbocyclic group or a C₁-C₆₀ heterocyclic group, each substituted with: a cyano group; -F; - Cl; -Br; -I; a C₁-C₂₀ alkyl group substituted with a cyano group, -F, -Cl, -Br, -I, or any combination thereof; or any combination thereof.

In the compound including element EL1 and element EL2, element EL1 may be metal, metalloid, or any combination thereof, and element EL2 may be non-metal, metalloid, or any combination thereof.

Examples of the metal are: an alkali metal (e.g., lithium (Li), sodium (Na), potassium (K), rubidium (Rb), cesium (Cs), and/or the like); an alkaline earth metal (e.g., beryllium (Be), magnesium (Mg), calcium (Ca), strontium (Sr), barium (Ba), and/or the like); a transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); a post-transition metal (e.g., zinc (Zn), indium (In), tin (Sn), and/or the like); a lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like); and/or the like.

Examples of the metalloid are silicon (Si), antimony (Sb), tellurium (Te), and/or the like.

Examples of the non-metal are oxygen (O), halogen (e.g., F, Cl, Br, I, and/or the like), and/or the like.

For example, the compound including element EL1 and element EL2 may include metal oxide, metal halide (e.g., metal fluoride, metal chloride, metal bromide, metal iodide, and/or the like), metalloid halide (e.g., metalloid fluoride, metalloid chloride, metalloid bromide, metalloid iodide, and/or the like), metal telluride, or any combination thereof.

Examples of the metal oxide are tungsten oxide (e.g., WO, W₂O₃, WO₂, WO₃, W₂O₅, and/or the like), vanadium oxide (e.g., VO, V₂O₃, VO₂, V₂O₅, and/or the like), molybdenum oxide (e.g., MoO, Mo₂O₃, MoO₂, MoO₃, Mo₂O₅, and/or the like), rhenium oxide (e.g., ReO₃, and/or the like), and/or the like.

Examples of the metal halide are alkali metal halide, alkaline earth metal halide, transition metal halide, post-transition metal halide, lanthanide metal halide, and/or the like.

Examples of the alkali metal halide are LiF, NaF, KF, RbF, CsF, LiCl, NaCl, KCl, RbCl, CsCl, LiBr, NaBr, KBr, RbBr, CsBr, Lil, Nal, KI, Rbl, Csl, and/or the like.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, Bel₂, Mgl₂, Cal₂, Srl₂, Bal₂, and/or the like.

Examples of the transition metal halide are titanium halide (e.g., TiF₄, TiCl₄, TiBr₄, TiI₄, and/or the like), zirconium halide (e.g., ZrF₄, ZrCl₄, ZrBr₄, ZrI₄, and/or the like), hafnium halide (e.g., HfF₄, HfCl₄, HfBr₄, HfI₄, and/or the like), vanadium halide (e.g., VF₃, VCl₃, VBr₃, Vl₃, and/or the like), niobium halide (e.g., NbF₃, NbCl₃, NbBr₃, Nbl₃, and/or the like), tantalum halide (e.g., TaF₃, TaCl₃, TaBr₃, TaI₃, and/or the like), chromium halide (e.g., CrF₃, CrCl₃, CrBr₃, CrI₃, and/or the like), molybdenum halide (e.g., MoF₃, MoCl₃, MoBr₃, MoI₃, and/or the like), tungsten halide (e.g., WF₃, WCl₃, WBr₃, Wl₃, and/or the like), manganese halide (e.g., MnF₂, MnCl₂, MnBr₂, MnI₂, and/or the like), technetium halide (e.g., TcF₂, TcCl₂, TcBr₂, TcI₂, and/or the like), rhenium halide (e.g., ReF₂, ReCl₂, ReBr₂, ReI₂, and/or the like), iron halide (e.g., FeF₂, FeCl₂, FeBr₂, FeI₂, and/or the like), ruthenium halide (e.g., RuF₂, RuCl₂, RuBr₂, RuI₂, and/or the like), osmium halide (e.g., OsF₂, OsCl₂, OsBr₂, OsI₂, and/or the like), cobalt halide (e.g., CoF₂, CoCl₂, CoBr₂, CoI₂, and/or the like), rhodium halide (e.g., RhF₂, RhCl₂, RhBr₂, RhI₂, and/or the like), iridium halide (e.g., IrF₂, IrCl₂, IrBr₂, IrI₂, and/or the like), nickel halide (e.g., NiF₂, NiCl₂, NiBr₂, NiI₂, and/or the like), palladium halide (e.g., PdF₂, PdCl₂, PdBr₂, PdI₂, and/or the like), platinum halide (e.g., PtF₂, PtCl₂, PtBr₂, PtI₂, and/or the like), copper halide (e.g., CuF, CuCl, CuBr, Cul, and/or the like), silver halide (e.g., AgF, AgCl, AgBr, Agl, and/or the like), gold halide (e.g., AuF, AuCl, AuBr, Aul, and/or the like), and/or the like.

Examples of the post-transition metal halide are zinc halide (e.g., ZnF₂, ZnCl₂, ZnBr₂, ZnI₂, and/or the like), indium halide (e.g., InI₃, and/or the like), tin halide (e.g., SnI₂, and/or the like), and/or the like.

Examples of the lanthanide metal halide are YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and/or the like.

Examples of the metalloid halide are antimony halide (e.g., SbCl₅, and/or the like) and/or the like.

Examples of the metal telluride are alkali metal telluride (e.g., Li₂Te, Na₂Te, K₂Te, Rb₂Te, Cs₂Te, and/or the like), alkaline earth metal telluride (e.g., BeTe, MgTe, CaTe, SrTe, BaTe, and/or the like), transition metal telluride (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), post-transition metal telluride (e.g., ZnTe, and/or the like), lanthanide metal telluride (e.g., LaTe, CeTe, PrTe, NdTe, PmTe, EuTe, GdTe, TbTe, DyTe, HoTe, ErTe, TmTe, YbTe, LuTe, and/or the like), and/or the like.

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact each other or are separated from each other, to emit white light. In one or more embodiments, the emission layer may include two or more materials of a red light-emitting material, a green light-emitting material, and a blue light-emitting material, in which the two or more materials are mixed with each other in a single layer, to emit white light.

In one or more embodiments, the emission layer may include a host and a dopant (or emitter). In one or more embodiments, the emission layer may further include an auxiliary dopant that promotes energy transfer to a dopant (or emitter), in addition to the host and the dopant (or emitter). When the emission layer includes the dopant (or emitter) and the auxiliary dopant, the dopant (or emitter) and the auxiliary dopant are different from each other.

The organometallic compound represented by Formula 1-1 or Formula 1-2 described herein may act as the dopant (or emitter) or the auxiliary dopant.

The amount (weight) of the dopant (or emitter) in the emission layer may be in a range of about 0.01 parts by weight to about 15 parts by weight based on 100 parts by weight of the host.

The organometallic compound represented by Formula 1-1 or Formula 1-2 may be included in the emission layer. The amount (weight) of the organometallic compound in the emission layer may be in a range of about 0.01 parts by weight to about 30 parts by weight, about 0.1 parts by weight to about 20 parts by weight, or about 0.1 parts by weight to about 15 parts by weight, based on 100 parts by weight of the emission layer.

In one or more embodiments, the emission layer may include a quantum dot.

In one or more embodiments, the emission layer may include a delayed fluorescence material. The delayed fluorescence material may act as a host or a dopant in the emission layer.

The thickness of the emission layer may be in a range of about 100 Å to about 1,000 Å, for example, about 200 Å to about 600 Å. When the thickness of the emission layer is within the ranges described, excellent or suitable luminescence characteristics may be obtained without a substantial increase in driving voltage.

### Host

The host in the emission layer may include the second compound or the third compound described herein, or any combination thereof.

In one or more embodiments, the host may include a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or - P(=O)(Q₃₀₁)(Q₃₀₂),
xb21 may be an integer from 1 to 5, and
Q₃₀₁ to Q₃₀₃ may each be as described in connection with Q₁.

For example, when xb11 in Formula 301 is 2 or more, two or more of Ar₃₀₁ may be linked to each other via a single bond.

In one or more embodiments, the host may include a compound represented by Formula 301-1, a compound represented by Formula 301-2, or any combination thereof: 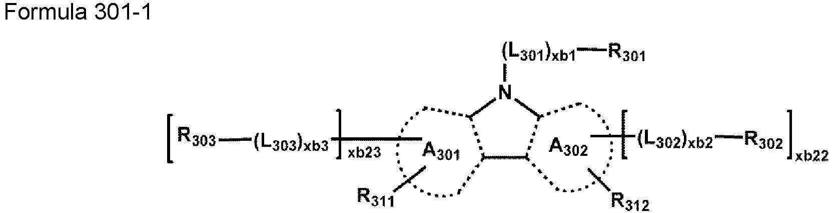 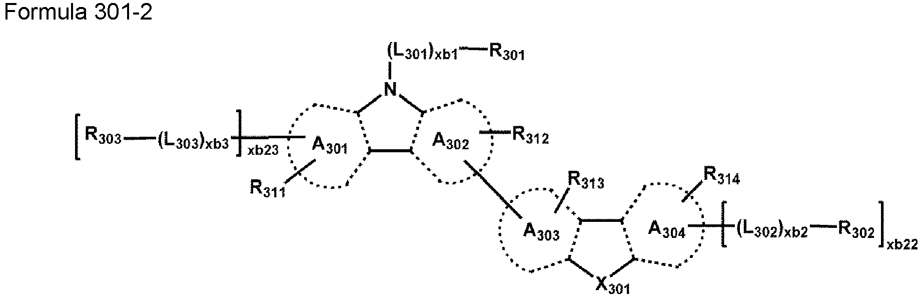 wherein, in Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be as described herein,
L₃₀₂ to L₃₀₄ may each independently be as described in connection with L₃₀₁,
xb2 to xb4 may each independently be as described in connection with xb1, and
R₃₀₂ to R₃₀₅ and R₃₁₁ to R₃₁₄ may each be as described in connection with R₃₀₁.

In one or more embodiments, the host may include an alkali earth metal complex, a post-transition metal complex, or any combination thereof. In one or more embodiments, the host may include a Be complex (e.g., Compound H55), a Mg complex, a Zn complex, or any combination thereof.

In one or more embodiments, the host may include: at least one selected from among Compounds H1 to H128; 9,10-di(2-naphthyl)anthracene (ADN); 2-methyl-9,10-bis(naphthalen-2-yl)anthracene (MADN); 9,10-di(2-naphthyl)-2-t-butyl-anthracene (TBADN); 4,4'-bis(N-carbazolyl)-1,1'-biphenyl (CBP); 1,3-di-9-carbazolylbenzene (mCP); 1,3,5-tri(carbazol-9-yl)benzene (TCP); and/or any combination thereof:

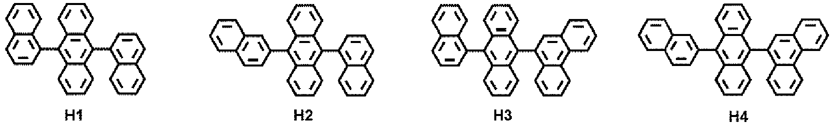

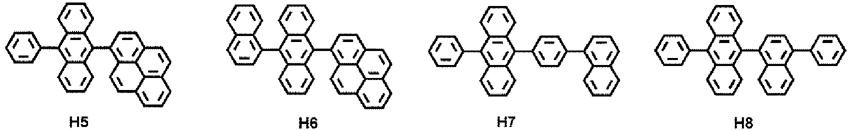

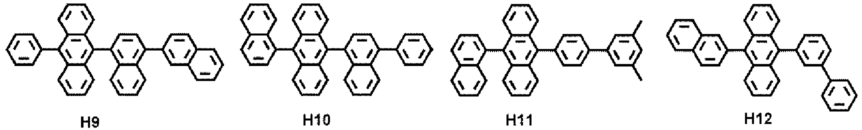

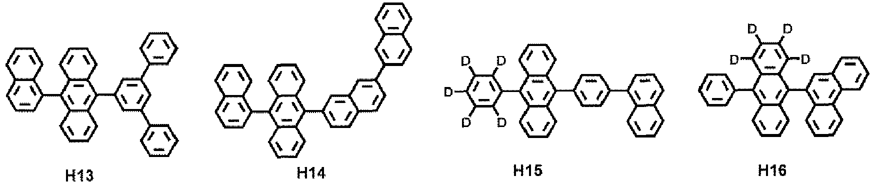

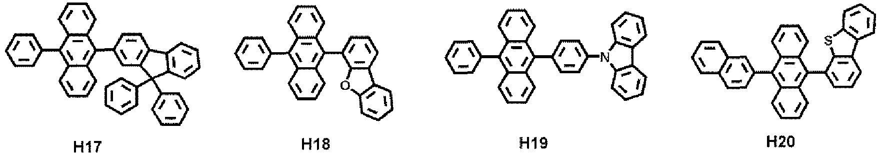

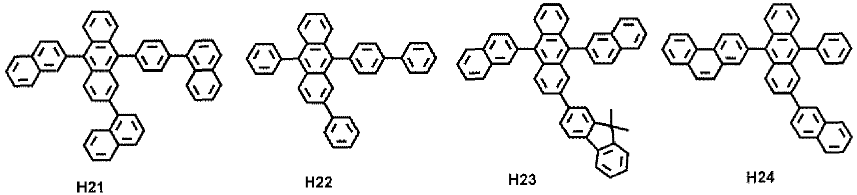

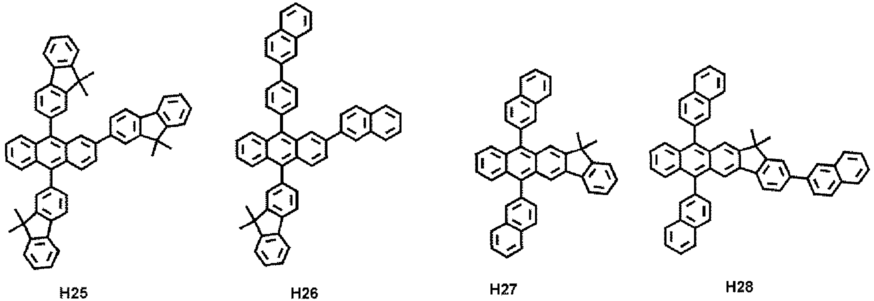

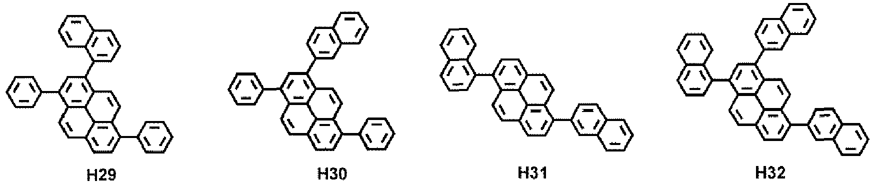

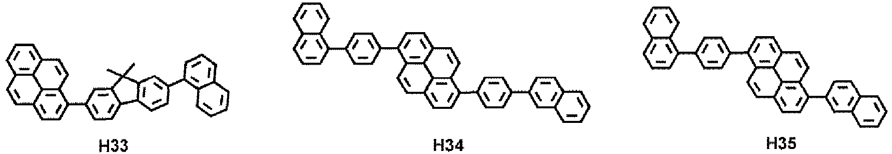

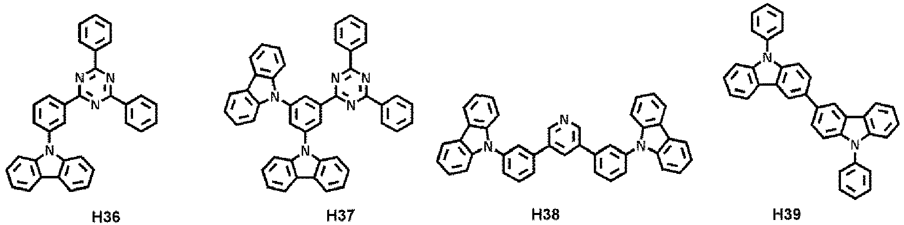

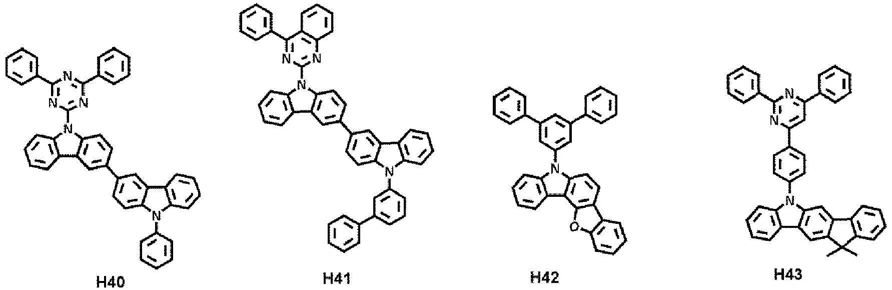

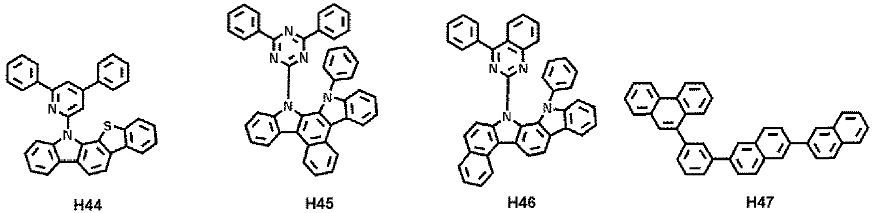

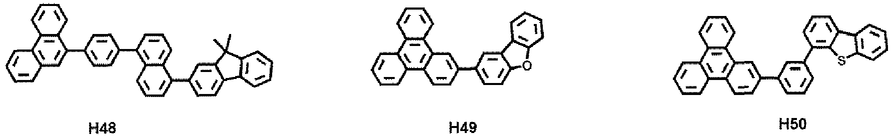

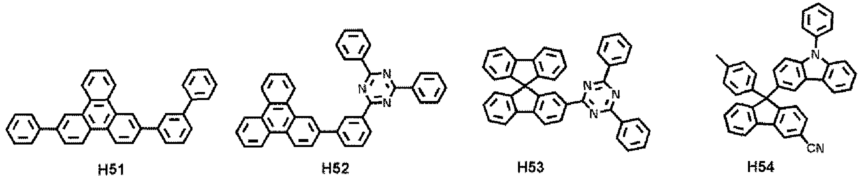

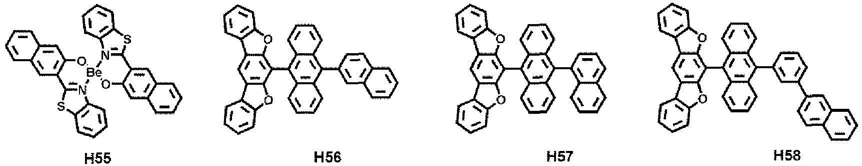

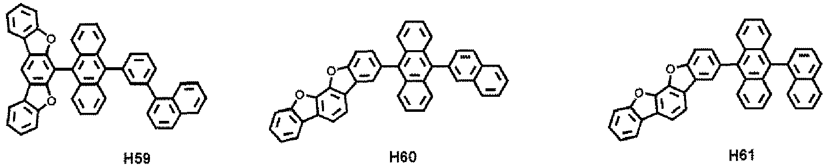

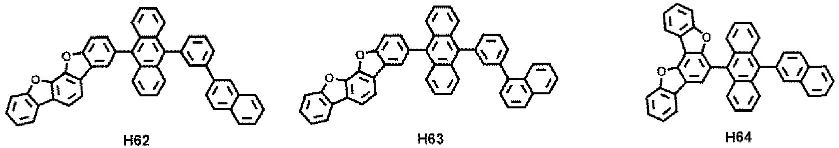

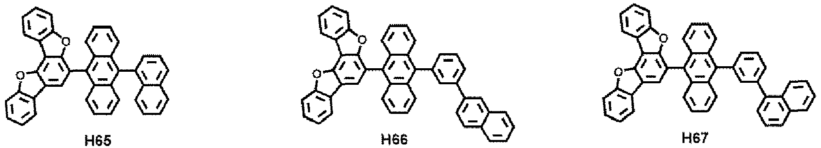

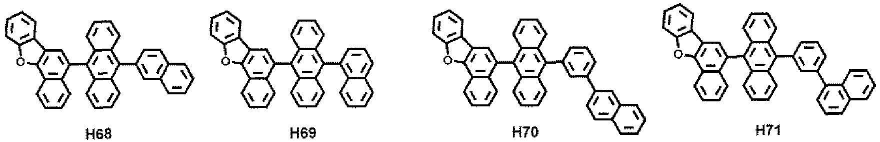

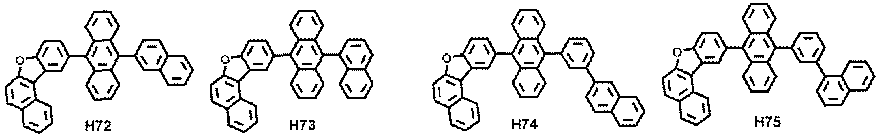

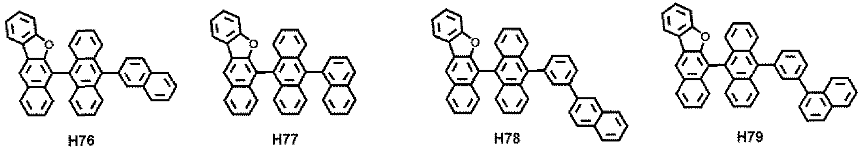

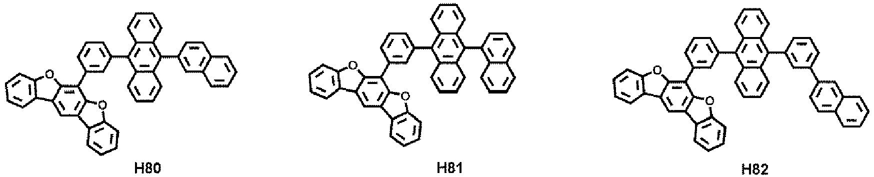

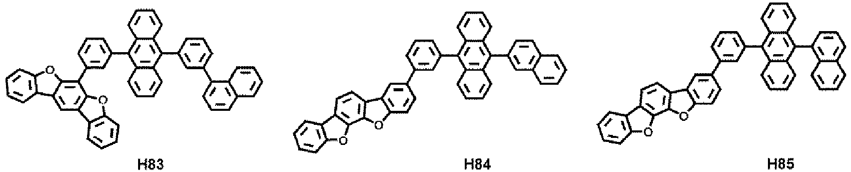

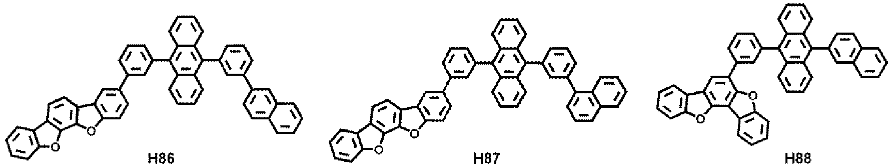

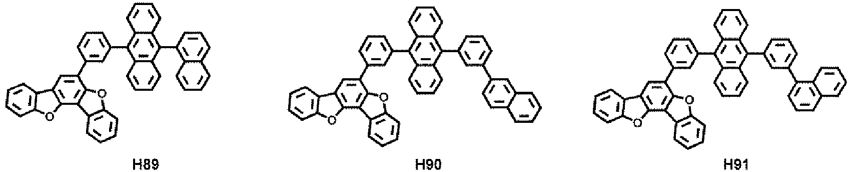

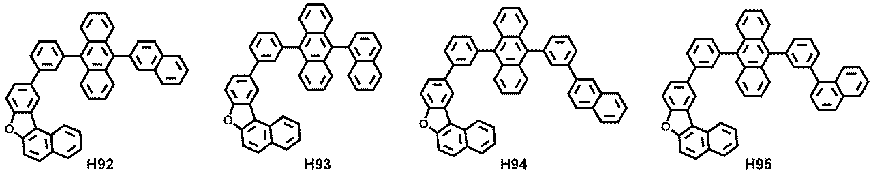

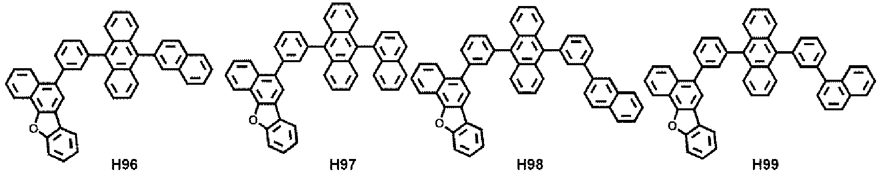

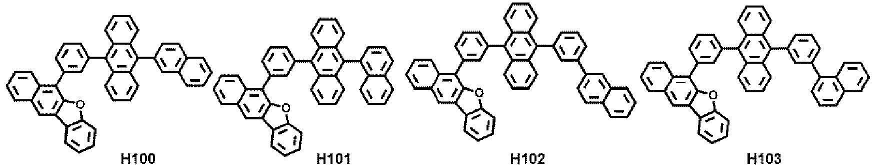

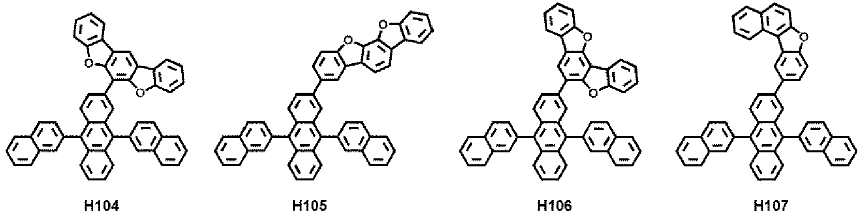

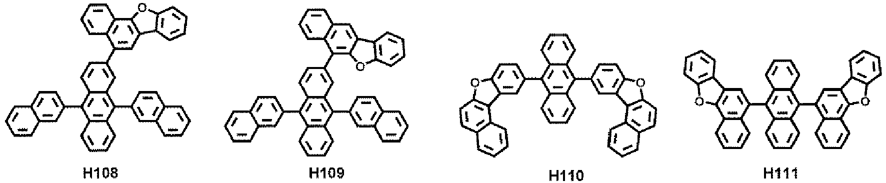

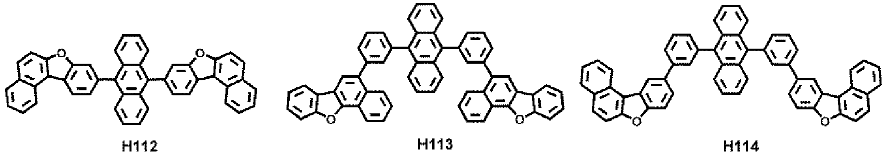

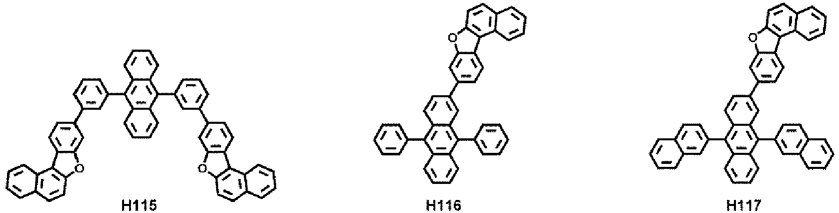

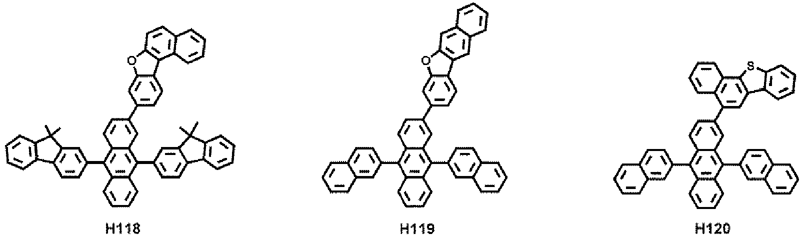

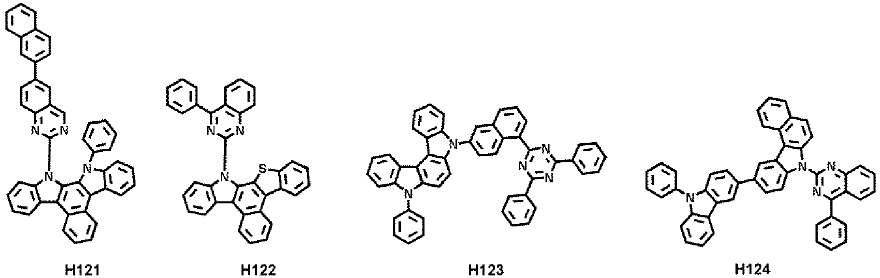

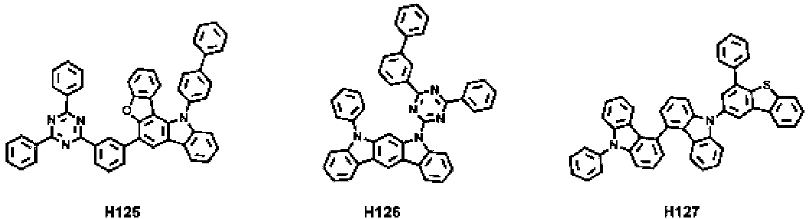

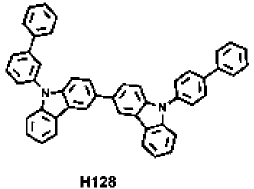

In one or more embodiments, the host may include a silicon-containing compound, a phosphine oxide-containing compound, or any combination thereof.

The host may have one or more suitable modifications. For example, the host may include only one kind of compound, or may include two or more kinds of different compounds.

### Phosphorescent dopant

The emission layer may include, as a phosphorescent dopant, the organometallic compound represented by Formula 1-1 or Formula 1-2 described herein.

In one or more embodiments, when the emission layer includes the organometallic compound represented by Formula 1-1 or Formula 1-2 described herein and the organometallic compound represented by Formula 1-1 or Formula 1-2 described herein acts as an auxiliary dopant, the emission layer may include a phosphorescent dopant.

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

For example, the phosphorescent dopant may include an organometallic compound represented by Formula 401:

Formula 401 M(L₄₀₁)_{xc1}(L₄₀₂)_{xc2}

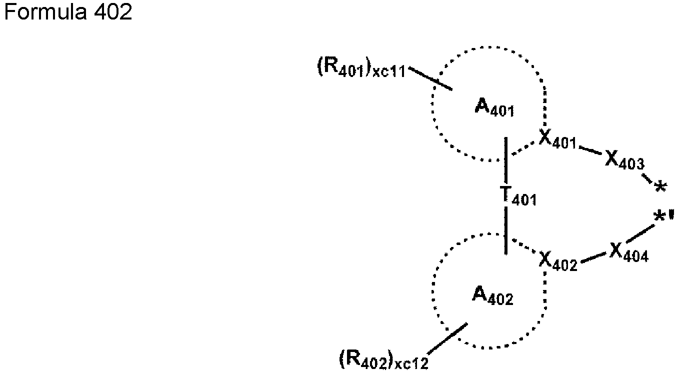

wherein, in Formulae 401 and 402,
M may be a transition metal (e.g., iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is 2 or more, two or more of L₄₀₁ may be identical to or different from each other,
L₄₀₂ may be an organic ligand, and xc2 may be 0, 1, 2, 3, or 4, wherein, when xc2 is 2 or more, two or more of L₄₀₂ may be identical to or different from each other,
X₄₀₁ and X₄₀₂ may each independently be N or C,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*',
X₄₀₃ and X₄₀₄ may each independently be a chemical bond (e.g., a covalent bond or a coordinate bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be as described in connection with Q₁,
R₄₀₁ and R₄₀₂ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or - P(=O)(Q₄₀₁)(Q₄₀₂),
Q₄₀₁ to Q₄₀₃ may each be as described in connection with Q₁,
xc11 and xc12 may each independently be an integer from 0 to 10, and
* and *' in Formula 402 each indicate a binding site to M in Formula 401.

For example, in Formula 402, i) X₄₀₁ may be nitrogen and X₄₀₂ may be carbon, or ii) each of X₄₀₁ and X₄₀₂ may be nitrogen.

In one or more embodiments, when xc1 in Formula 401 is 2 or more, two ring A₄₀₁(s) among two or more selected from L₄₀₁ may optionally be linked to each other via T₄₀₂, which is a linking group, and two ring A₄₀₂(s) among two or more selected from L₄₀₁ may optionally be linked to each other via T₄₀₃, which is a linking group (see Compounds PD1 to PD4 and PD7). T₄₀₂ and T₄₀₃ may each be as described in connection with T₄₀₁.

In Formula 401, L₄₀₂ may be an organic ligand. For example, L₄₀₂ may include a halogen group, a diketone group (e.g., an acetylacetonate group), a carboxylic acid group (e.g., a picolinate group), -C(=O), an isonitrile group, -CN group, a phosphorus group (e.g., a phosphine group, a phosphite group, and/or the like), or any combination thereof.

The phosphorescent dopant may include, for example, one selected from among Compounds PD1 to PD39, or any combination thereof:

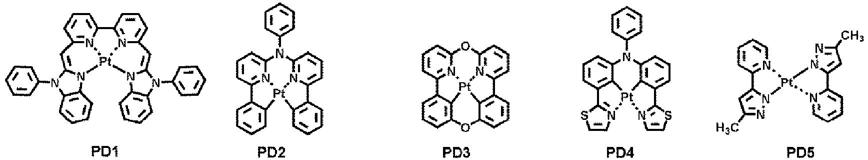

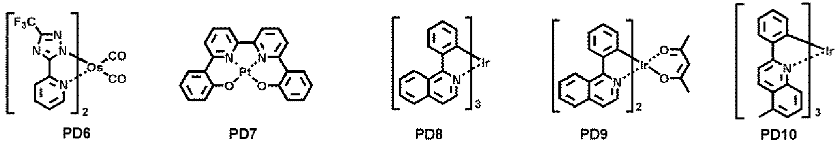

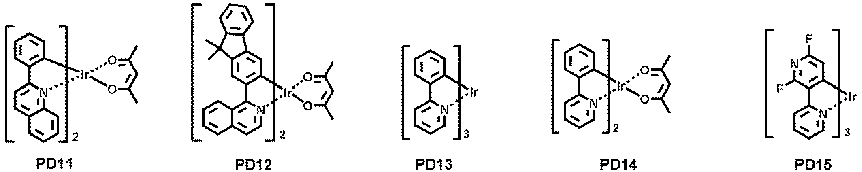

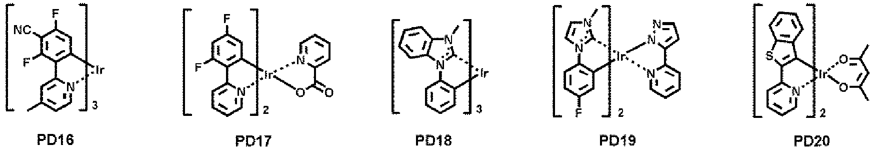

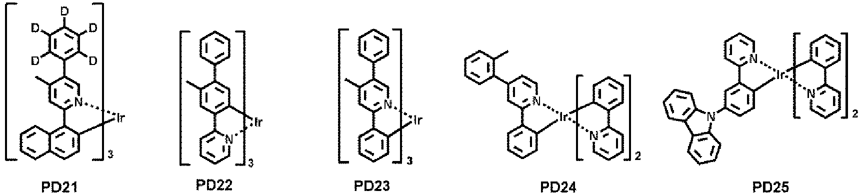

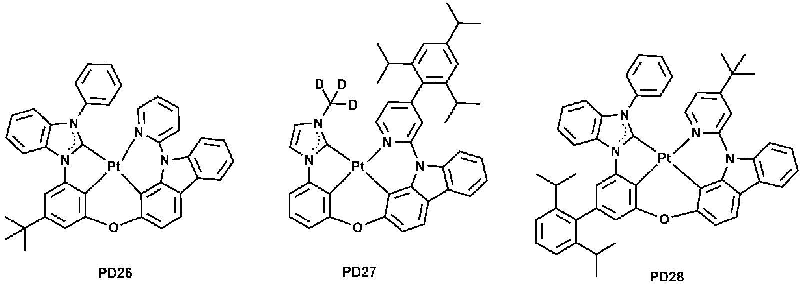

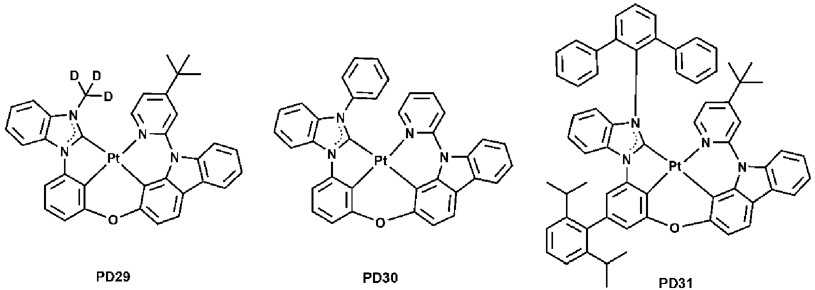

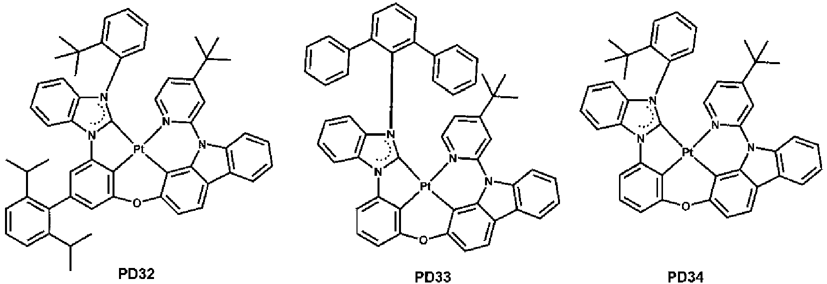

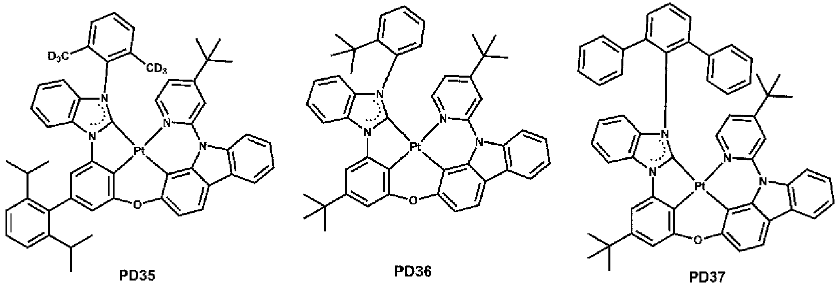

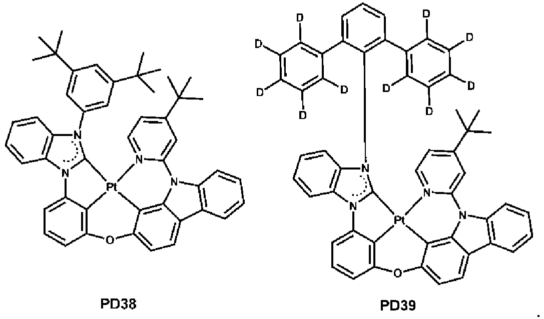

### Fluorescent dopant

In one or more embodiments, when the emission layer includes the organometallic compound represented by Formula 1-1 or Formula 1-2 described herein and the organometallic compound represented by Formula 1-1 or Formula 1-2 described herein acts as an auxiliary dopant, the emission layer may further include a fluorescent dopant.

In one or more embodiments, when the emission layer includes the organometallic compound represented by Formula 1-1 or Formula 1-2 described herein and the organometallic compound represented by Formula 1-1 or Formula 1-2 described herein acts as a phosphorescent dopant, the emission layer may further include an auxiliary dopant.

The fluorescent dopant and the auxiliary dopant may each independently include an arylamine compound, a styrylamine compound, a boron-containing compound, or any combination thereof.

In one or more embodiments, the fluorescent dopant and the auxiliary dopant may each independently include a compound represented by Formula 501: 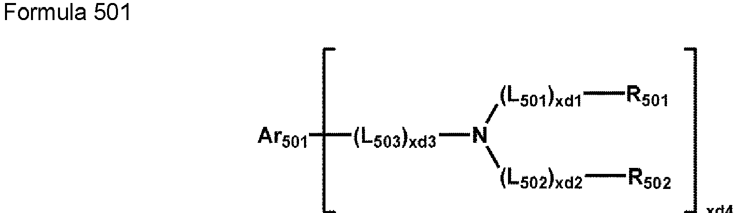 wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In one or more embodiments, Ar₅₀₁ in Formula 501 may be a condensed cyclic group (e.g., an anthracene group, a chrysene group, a pyrene group, and/or the like) in which three or more monocyclic groups are condensed with each other.

In one or more embodiments, xd4 in Formula 501 may be 2.

For example, the fluorescent dopant and the auxiliary dopant may each include: one selected from among Compounds FD1 to FD37; DPVBi; DPAVBi; and/or any combination thereof:

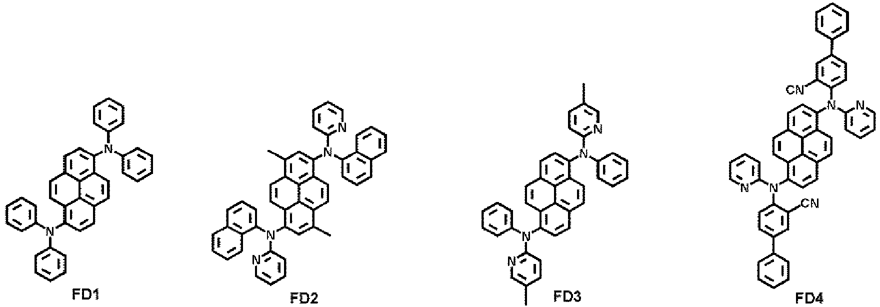

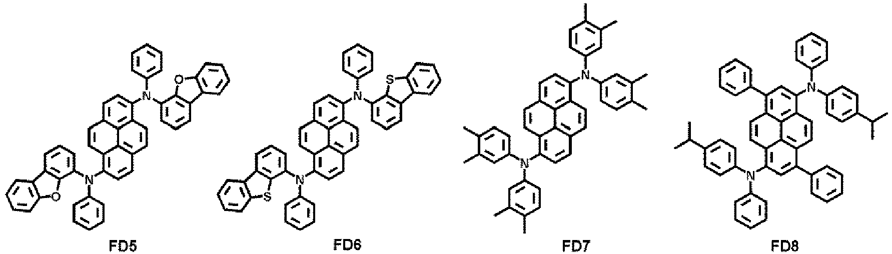

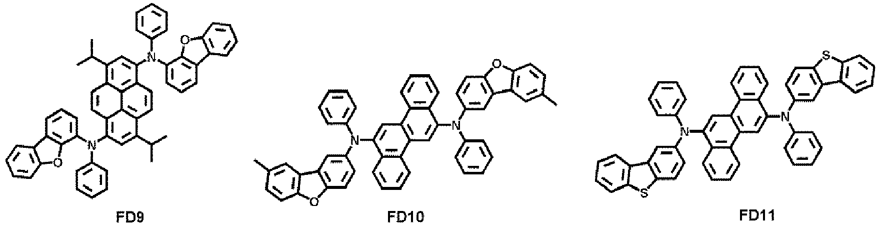

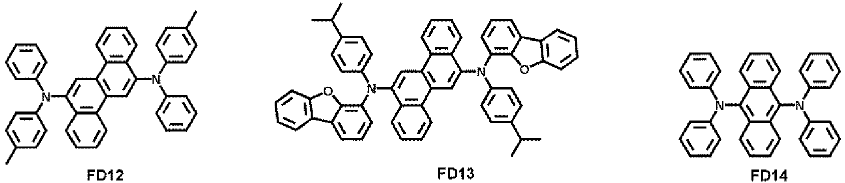

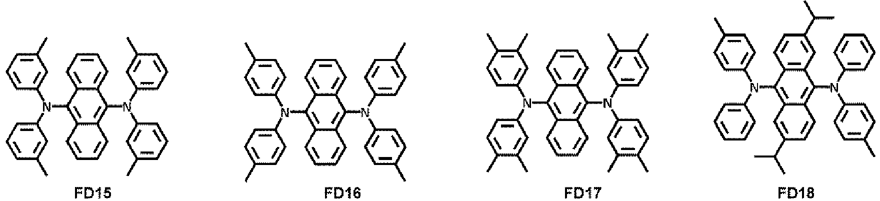

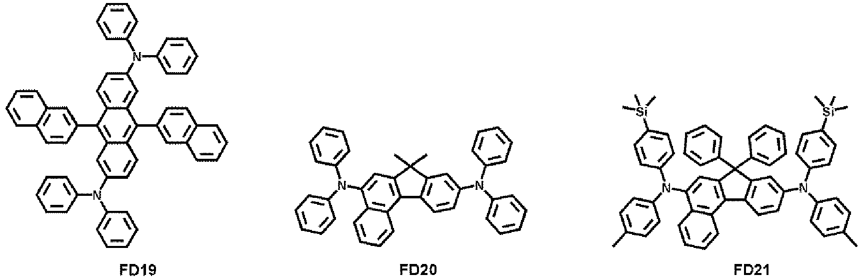

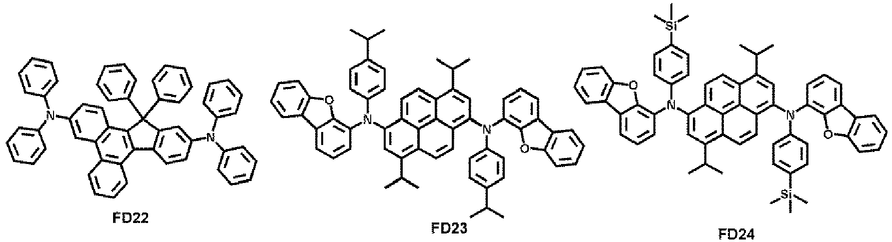

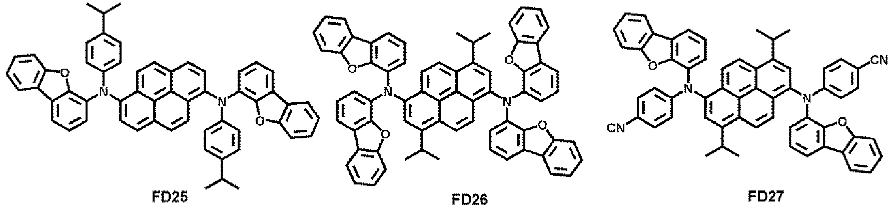

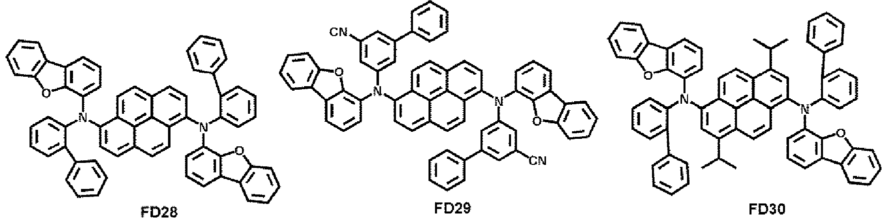

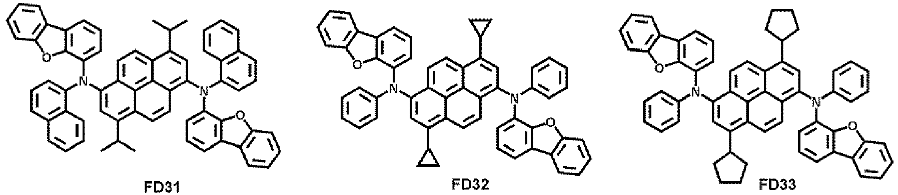

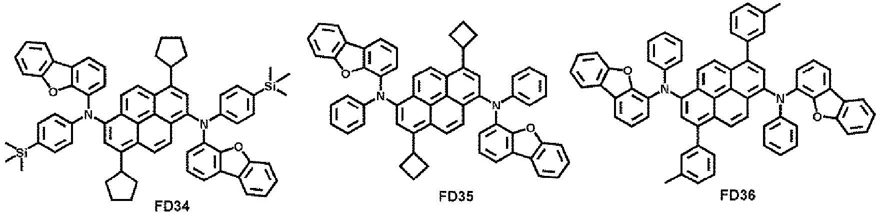

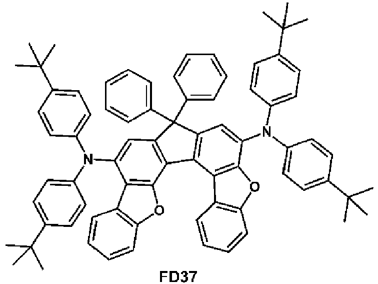

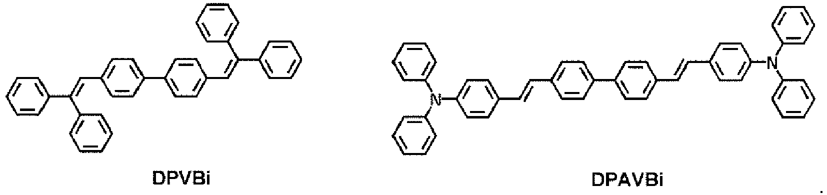

### Delayed fluorescence material

The emission layer may include a delayed fluorescence material.

The delayed fluorescence material described herein may be selected from compounds capable of emitting delayed fluorescence based on a delayed fluorescence emission mechanism.

The delayed fluorescence material may include, for example, the fourth compound described herein.

The delayed fluorescence material included in the emission layer may act as a host or a dopant depending on the type or kind of other materials included in the emission layer.

In one or more embodiments, a difference between a triplet energy level (eV) of the delayed fluorescence material and a singlet energy level (eV) of the delayed fluorescence material may be 0 eV or more and 0.5 eV or less. When the difference between the triplet energy level (eV) of the delayed fluorescence material and the singlet energy level (eV) of the delayed fluorescence material is satisfied within the range described, up-conversion from the triplet state to the singlet state of the delayed fluorescence materials may effectively occur, and thus, the light-emitting device 10 may have improved luminescence efficiency.

For example, the delayed fluorescence material may include i) a material including at least one electron donor (e.g., a π electron-rich C₃-C₆₀ cyclic group, such as a carbazole group, and/or the like) and at least one electron acceptor (e.g., a sulfoxide group, a cyano group, a π electron-deficient nitrogen-containing C₁-C₆₀ cyclic group, and/or the like), and ii) a material including a C₈-C₆₀ polycyclic group in which two or more cyclic groups are condensed while sharing boron (B).

Examples of the delayed fluorescence material may include at least one selected from among Compounds DF1 to DF14:

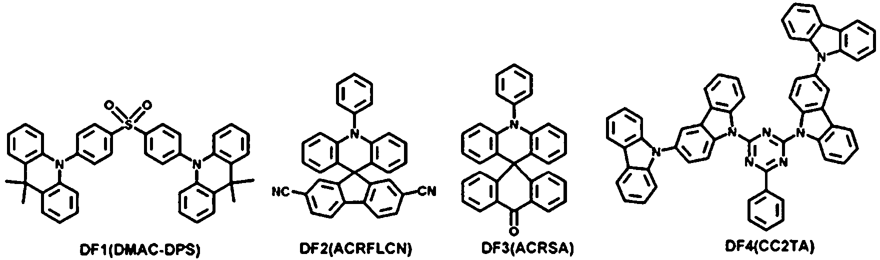

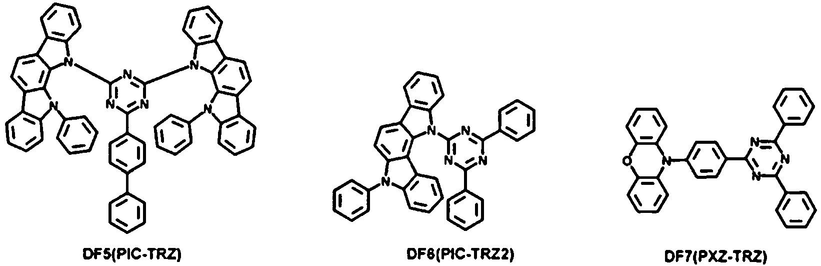

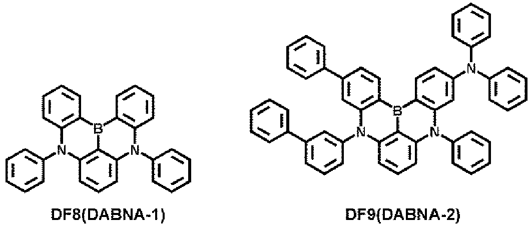

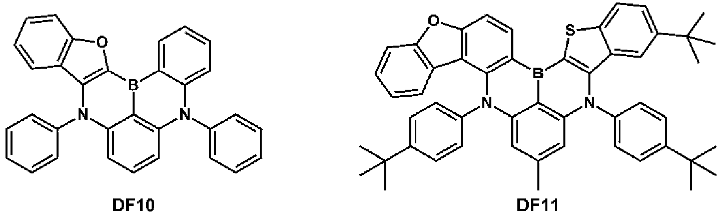

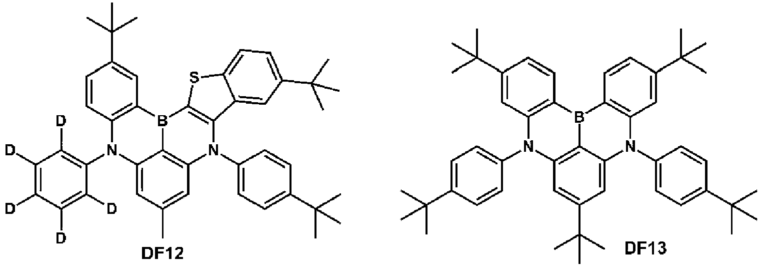

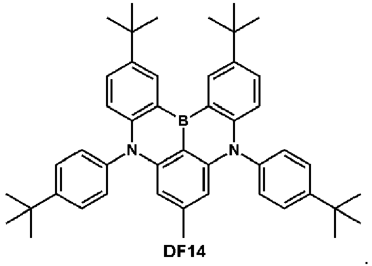

### Quantum dot

The emission layer may include a quantum dot.

The term "quantum dot" as utilized herein refers to a crystal of a semiconductor compound, and may include any material capable of emitting light of one or more suitable emission wavelengths according to the size of the crystal.

The diameter of the quantum dot may be, for example, in a range of about 1 nanometer (nm) to about 10 nm.

The quantum dot may be synthesized by a wet chemical process, a metal organic chemical vapor deposition process, a molecular beam epitaxy process, and/or any process similar thereto.

The wet chemical process is a method including mixing a precursor material with an organic solvent and then growing quantum dot particle crystals. When the crystal grows, the organic solvent naturally acts as a dispersant coordinated on the surface of the quantum dot crystal and controls the growth of the crystal so that the growth of quantum dot particles can be controlled or selected through a process which costs lower, and is easier than vapor deposition methods, such as metal organic chemical vapor deposition (MOCVD) or molecular beam epitaxy (MBE).

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound are: a binary compound, such as CdS, CdSe, CdTe, ZnS, ZnSe, ZnTe, ZnO, HgS, HgSe, HgTe, MgSe, MgS, and/or the like; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and/or the like; a quaternary compound, such as CdZnSeS, CdZnSeTe, CdZnSTe, CdHgSeS, CdHgSeTe, CdHgSTe, HgZnSeS, HgZnSeTe, HgZnSTe, and/or the like; or any combination thereof.

Examples of the Group III-V semiconductor compound are: a binary compound, such as GaN, GaP, GaAs, GaSb, AIN, AlP, AlAs, AlSb, InN, InP, InAs, InSb, and/or the like; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, InPSb, and/or the like; a quaternary compound, such as GaAlNP, GaAINAs, GaAINSb, GaAlPAs, GaAlPSb, GalnNP, GalnNAs, GaInNSb, GalnPAs, GalnPSb, InAlNP, InAlNAs, InAlNSb, InAlPAs, InAlPSb, and/or the like; or any combination thereof. In one or more embodiments, the Group III-V semiconductor compound may further include a Group II element. Examples of the Group III-V semiconductor compound further including the Group II element are InZnP, InGaZnP, InAlZnP, and/or the like.

Examples of the Group III-VI semiconductor compound are: a binary compound, such as GaS, GaSe, Ga₂Se₃, GaTe, InS, InSe, In₂S₃, In₂Se₃, InTe, and/or the like; a ternary compound, such as InGaS₃, InGaSe₃, and/or the like; or any combination thereof.

Examples of the Group I-III-VI semiconductor compound are: a ternary compound, such as AgInS, AgInS₂, CulnS, CuInS₂, CuGaO₂, AgGaO₂, AgAlO₂, and/or the like; or any combination thereof.

Examples of the Group IV-VI semiconductor compound are: a binary compound, such as SnS, SnSe, SnTe, PbS, PbSe, PbTe, and/or the like; a ternary compound, such as SnSeS, SnSeTe, SnSTe, PbSeS, PbSeTe, PbSTe, SnPbS, SnPbSe, SnPbTe, and/or the like; a quaternary compound, such as SnPbSSe, SnPbSeTe, SnPbSTe, and/or the like; or any combination thereof.

Examples of the Group IV element or compound are: a single element compound, such as Si, Ge, and/or the like; a binary compound, such as SiC, SiGe, and/or the like; or any combination thereof.

Each element included in a multi-element compound, such as the binary compound, the ternary compound, and the quaternary compound, may be present at a substantially uniform concentration or non-substantially uniform concentration in a particle.

In one or more embodiments, the quantum dot may have a single structure in which the concentration of each element in the quantum dot is substantially uniform, or may have a core-shell dual structure. For example, a material included in the core and a material included in the shell may be different from each other.

The shell of the quantum dot may act as a protective layer which prevents chemical denaturation of the core to maintain semiconductor characteristics, and/or as a charging layer which imparts electrophoretic characteristics to the quantum dot. The shell may be single-layered or multi-layered. The interface between the core and the shell may have a concentration gradient in which the concentration of an element existing in the shell decreases toward the center of the core.

Examples of the shell of the quantum dot are an oxide of metal, metalloid, or non-metal, a semiconductor compound, and/or a combination thereof. Examples of the oxide of metal, metalloid, or non-metal are: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and/or the like; a ternary compound, such as MgAl₂O₄, CoFe₂O₄, NiFe₂O₄, CoMn₂O₄, and/or the like; or any combination thereof. Examples of the semiconductor compound are: as described herein, a Group II-VI semiconductor compound; a Group III-V semiconductor compound; a Group III-VI semiconductor compound; a Group I-III-VI semiconductor compound; a Group IV-VI semiconductor compound; and/or any combination thereof. Examples of the semiconductor compound are CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

The quantum dot may have a full width at half maximum (FWHM) of an emission wavelength spectrum of about 45 nm or less, about 40 nm or less, or for example, about 30 nm or less. When the FWHM of the quantum dot is within these ranges, the quantum dot may have improved color purity or improved color reproducibility. In some embodiments, because light emitted through the quantum dot is emitted in all directions, the wide viewing angle may be improved.

In some embodiments, the quantum dot may be in the form of a spherical particle, a pyramidal particle, a multi-arm particle, a cubic nanoparticle, a nanotube particle, a nanowire particle, a nanofiber particle, a nanoplate particle, and/or the like.

Because the energy band gap may be adjusted by controlling the size of the quantum dot, light having one or more suitable wavelength bands may be obtained from the quantum dot emission layer. Accordingly, by utilizing quantum dots of different sizes, a light-emitting device that emits light of one or more suitable wavelengths may be implemented. In one or more embodiments, the size of the quantum dot may be selected to emit red light, green light, and/or blue light. In some embodiments, the size of the quantum dot may be configured to emit white light by combination of light of one or more suitable colors.

### Electron transport region in interlayer 130

The electron transport region may have i) a single-layer structure including (e.g., consisting of) a single layer including (e.g., consisting of) a single material, ii) a single-layer structure including (e.g., consisting of) a single layer including (e.g., consisting of) multiple materials that are different from each other, or iii) a multi-layer structure including multiple layers including multiple materials that are different from each other.

The electron transport region may include a buffer layer, a hole blocking layer, an electron control layer, an electron transport layer, an electron injection layer, or any combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer.

The electron transport region (e.g., the buffer layer, the hole blocking layer, the electron control layer, or the electron transport layer in the electron transport region) may include a metal-free compound including at least one π electron-deficient nitrogen-containing C₁-C₆₀ heterocyclic group.

For example, the electron transport region may include a compound represented by Formula 601:

Formula 601 [Ar₆₀₁]ₓₑ₁₁-[(L₆₀₁)ₓₑ₁-R₆₀₁]ₓₑ₂₁.

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, - Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be as described in connection with Q₁,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ heterocyclic group unsubstituted or substituted with at least one R₁₀ₐ.

In one or more embodiments, when xe11 in Formula 601 is 2 or more, two or more of Ar₆₀₁ may be linked to each other via a single bond.

In one or more embodiments, Ar₆₀₁ in Formula 601 may be a substituted or unsubstituted anthracene group.

In one or more embodiments, the electron transport region may include a compound represented by Formula 601-1: 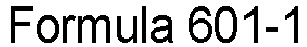 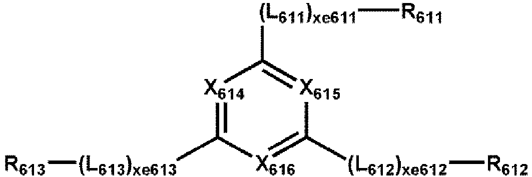 wherein, in Formula 601-1,
X₆₁₄ may be N or C(R₆₁₄), X₆₁₅ may be N or C(R₆₁₅), X₆₁₆ may be N or C(R₆₁₆), and at least one selected from among X₆₁₄ to X₆₁₆ may be N,
L₆₁₁ to L₆₁₃ may each be as described in connection with L₆₀₁,
xe611 to xe613 may each be as described in connection with xe1,
R₆₁₁ to R₆₁₃ may each be as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

The electron transport region may include: at least one selected from among Compounds ET1 to ET45; 2,9-dimethyl-4,7-diphenyl-1,10-phenanthroline (BCP); 4,7-diphenyl-1,10-phenanthroline (Bphen); Alq₃; BAlq; TAZ; NTAZ; and/or any combination thereof:

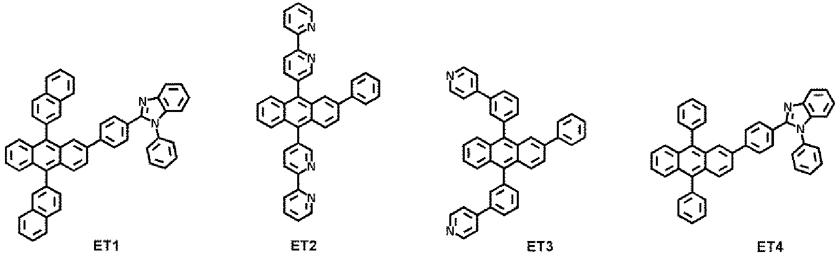

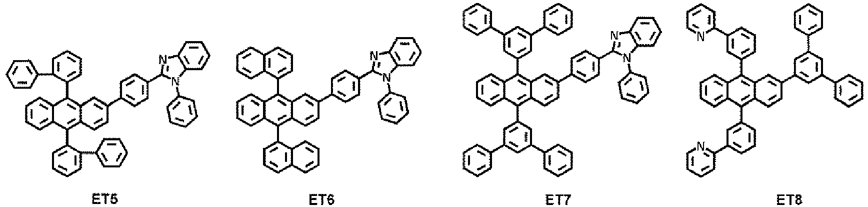

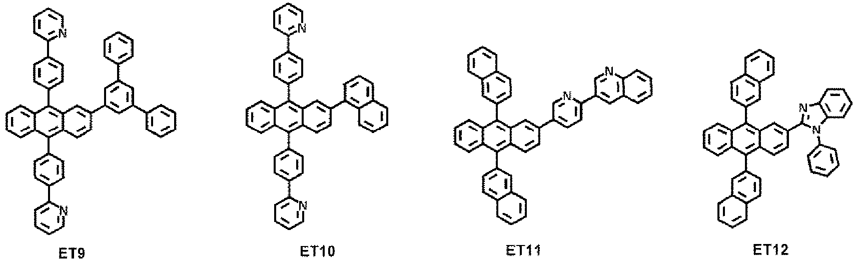

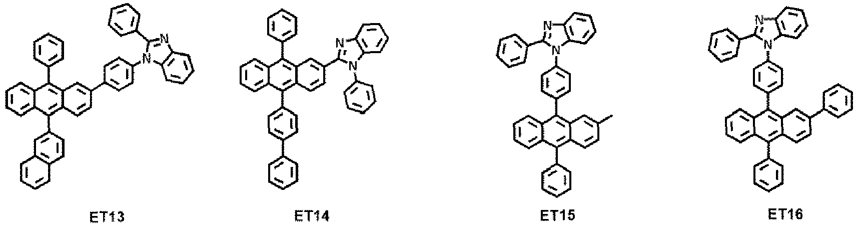

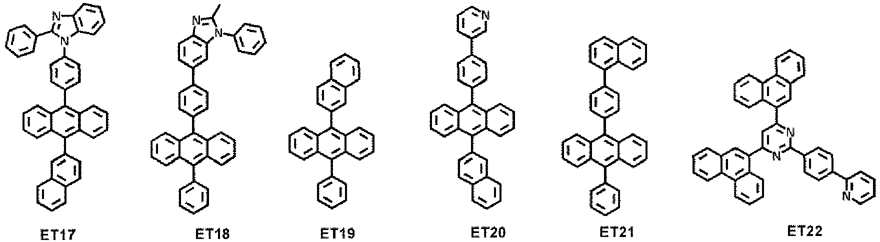

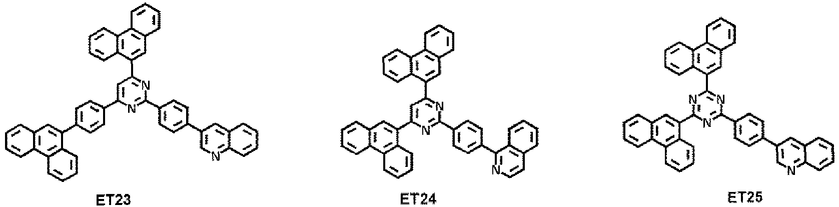

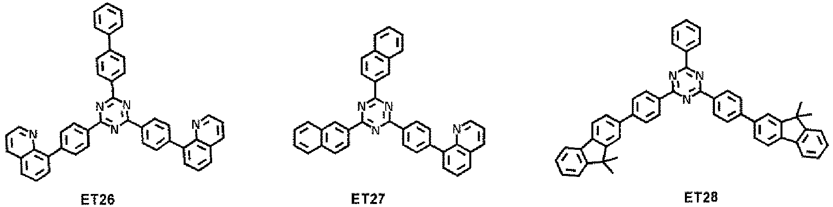

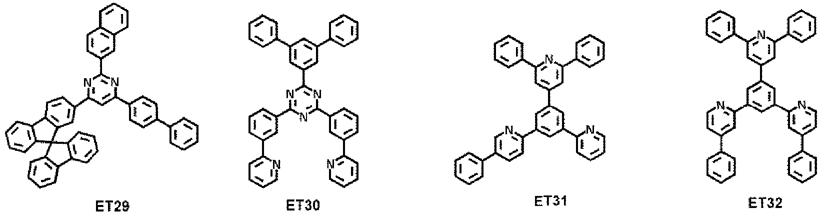

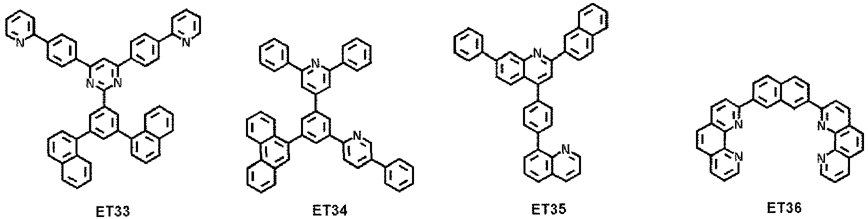

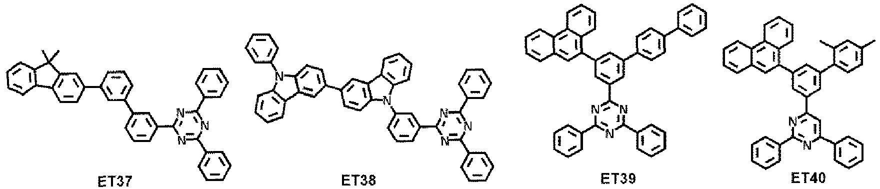

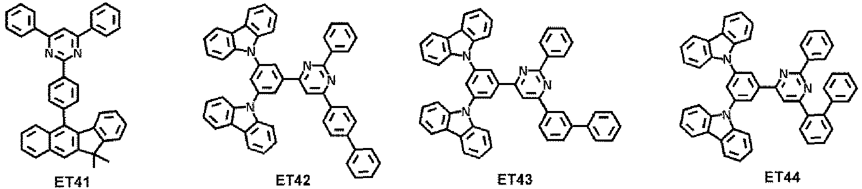

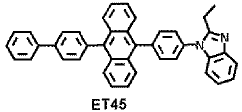

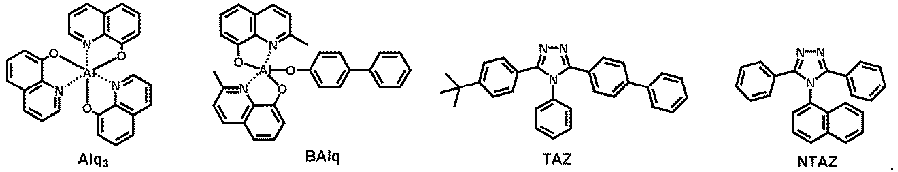

The thickness of the electron transport region may be in a range of about 100 Å to about 5,000 Å, for example, about 160 Å to about 4,000 Å. When the electron transport region includes a buffer layer, a hole blocking layer, an electron control layer, an electron transport layer, or any combination thereof, the thickness of the buffer layer, the hole blocking layer, or the electron control layer may be in a range of about 20 Å to about 1,000 Å, for example, about 30 Å to about 300 Å, and the thickness of the electron transport layer may be in a range of about 100 Å to about 1,000 Å, for example, about 150 Å to about 500 Å. When the thicknesses of the buffer layer, the hole blocking layer, the electron control layer, the electron transport layer, and/or the electron transport region are within the ranges described, satisfactory electron transporting characteristics may be obtained without a substantial increase in driving voltage.

The electron transport region (e.g., the electron transport layer in the electron transport region) may further include, in addition to the materials described, a metal-containing material.

The metal-containing material may include an alkali metal complex, an alkaline earth metal complex, or any combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

For example, the metal-containing material may include a Li complex. The Li complex may include, for example, Compound ET-D1 (LiQ) or ET-D2:

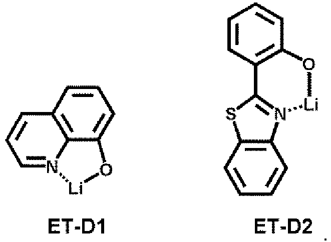

The electron transport region may include an electron injection layer that facilitates the injection of electrons from the second electrode 150. The electron injection layer may directly contact the second electrode 150.

The electron injection layer may have i) a single-layered structure including (e.g., consisting of) a single layer including (e.g., consisting of) a single material, ii) a single-layered structure including (e.g., consisting of) a single layer including (e.g., consisting of) multiple layers that are different from each other, or iii) a multi-layered structure including multiple layers including multiple materials that are different from each other.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (e.g., fluorides, chlorides, bromides, iodides, and/or the like), or tellurides of the alkali metal, the alkaline earth metal, and the rare earth metal, or any combination thereof.

The alkali metal-containing compound may include: alkali metal oxide, such as Li₂O, Cs₂O, K₂O, and/or the like; alkali metal halide, such as LiF, NaF, CsF, KF, Lil, Nal, Csl, KI, Rbl, and/or the like; or any combination thereof. The alkaline earth metal-containing compound may include an alkaline earth metal compound, such as BaO, SrO, CaO, BaₓSr₁₋ₓO (wherein x is a real number satisfying 0<x<1), BaₓCa₁₋ₓO (wherein x is a real number satisfying 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may include i) at least one selected from among metal ions of the alkali metal, the alkaline earth metal, and the rare earth metal and ii), as a ligand bonded to the metal ion (i.e., the selected metal ion), for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

In one or more embodiments, the electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described. In one or more embodiments, the electron injection layer may further include an organic material (e.g., a compound represented by Formula 601).

In one or more embodiments, the electron injection layer may include (e.g., consist of) i) an alkali metal-containing compound (e.g., alkali metal halide), ii) a) an alkali metal-containing compound (e.g., alkali metal halide); and b) an alkali metal, an alkaline earth metal, a rare earth metal, or any combination thereof. For example, the electron injection layer may be a KI:Yb co-deposited layer, an Rbl:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be uniformly or non-uniformly dispersed in a matrix including the organic material.

The thickness of the electron injection layer may be in a range of about 1 Å to about 100 Å, and, for example, about 3 Å to about 90 Å. When the thickness of the electron injection layer is within the ranges described, satisfactory electron injection characteristics may be obtained without a substantial increase in driving voltage.

### Second electrode 150

The second electrode 150 is arranged on the interlayer 130 having a structure as described. The second electrode 150 may be a cathode, which is an electron injection electrode, and as a material for forming the second electrode 150, a metal, an alloy, an electrically conductive compound, or any combination thereof, each having a low work-function, may be utilized. The term "low work-function material" as utilized herein refers to a substance (e.g., a metal or metal alloy) that requires a relatively small, or low, amount of energy to emit electrons from its surface.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layer structure or a multi-layer structure including multiple layers.

### Capping layer

A first capping layer may be arranged outside (and, e.g., on) the first electrode 110, and/or a second capping layer may be arranged outside (and, e.g., on) the second electrode 150. In detail, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110, which is a semi-transmissive electrode or a transmissive electrode, and the first capping layer. Light generated in the emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be enhanced or improved.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from among the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including O, N, S, Se, Si, F, CI, Br, I, or any combination thereof. In one or more embodiments, at least one selected from among the first capping layer and the second capping layer may each independently include an amine group-containing compound.

In one or more embodiments, at least one selected from among the first capping layer and the second capping layer may each independently include a compound represented by Formula 201, a compound represented by Formula 202, or any combination thereof.

In one or more embodiments, at least one selected from among the first capping layer and the second capping layer may each independently include one selected from among Compounds HT28 to HT33, one selected from among Compounds CP1 to CP6, β-NPB, and/or any combination thereof:

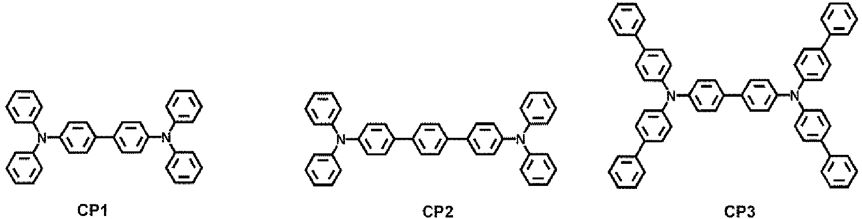

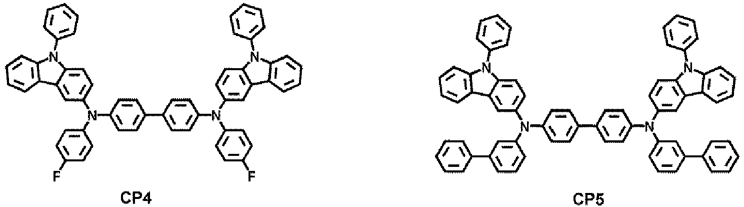

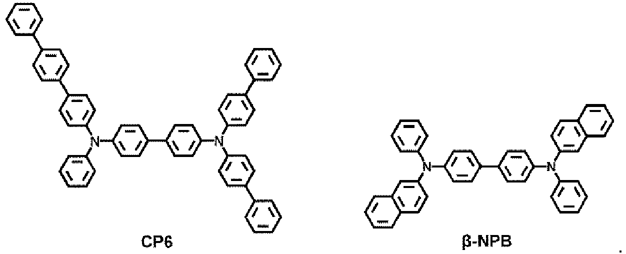

### Film

The organometallic compound represented by Formula 1-1 or Formula 1-2 may be included in one or more suitable films. Accordingly, another aspect of the invention provides a film including the organometallic compound represented by Formula 1-1 or Formula 1-2. The film may be, for example, an optical member (or a light control member or component) (e.g., a color filter, a color conversion member, a capping layer, a light extraction efficiency enhancement layer, a selective light absorbing layer, a polarizing layer, a quantum dot-containing layer, and/or the like), a light blocking member (e.g., a light reflective layer, a light absorbing layer, and/or the like), a protective member (e.g., an insulating layer, a dielectric layer, and/or the like), and/or the like.

### Electronic apparatus

The light-emitting device may be included in one or more suitable electronic apparatuses. For example, the electronic apparatus including the light-emitting device may be a light-emitting apparatus, an authentication apparatus, and/or the like.

The electronic apparatus (e.g., a light-emitting apparatus) may further include, in addition to the light-emitting device, i) a color filter, ii) a color conversion layer, or iii) a color filter and a color conversion layer. The color filter and/or the color conversion layer may be arranged in at least one traveling direction of light emitted from the light-emitting device. For example, light emitted from the light-emitting device may be blue light, green light, or white light. Details on the light-emitting device may be as described herein. In one or more embodiments, the color conversion layer may include a quantum dot.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In detail, the first area may include a red quantum dot, the second area may include a green quantum dot, and the third area may not include (e.g., may exclude) a quantum dot. Details on the quantum dot may be as described herein. The first area, the second area, and/or the third area may each further include a scatter.

For example, the light-emitting device may be to emit (e.g., configured to emit) first light, the first area may be to absorb (e.g., configured to absorb) the first light to emit first-first color light, the second area may be to absorb (e.g., configured to absorb) the first light to emit second-first color light, and the third area may be to absorb (e.g., configured to absorb) the first light to emit third-first color light. In this regard, the first-first color light, the second-first color light, and the third-first color light may have different maximum emission wavelengths. In detail, the first light may be blue light, the first-first color light may be red light, the second-first color light may be green light, and the third-first color light may be blue light.

The electronic apparatus may further include a thin-film transistor, in addition to the light-emitting device as described. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin-film encapsulation layer, the electronic apparatus may be flexible.

Various functional layers may be additionally arranged on the sealing portion, in addition to the color filter and/or the color conversion layer, according to the utilize of the electronic apparatus. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (e.g., fingertips, pupils, and/or the like).

The authentication apparatus may further include, in addition to the light-emitting device as described, a biometric information collector.

The electronic apparatus may be applied to one or more suitable displays, light sources, lighting, personal computers (e.g., a mobile personal computer), mobile phones, digital cameras, electronic organizers, electronic dictionaries, electronic game machines, medical instruments (e.g., electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (e.g., meters for a vehicle, an aircraft, and a vessel), projectors, and/or the like.

### Electronic equipment

The light-emitting device may be included in one or more suitable electronic equipment.

For example, the electronic equipment including the light-emitting device may be at least one selected from among a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a mobile phone, a tablet, a phablet, a PDA, a wearable device, a laptop computer, a digital camera, a camcorder, a viewfinder, a micro display, a 3D display, a virtual reality or augmented reality display, a vehicle, a video wall with multiple displays tiled together, a theater or stadium screen, a phototherapy device, a signboard, and one or more combinations thereof.

The light-emitting device may have excellent or suitable luminescence efficiency and long lifespan, and thus, the electronic equipment including the light-emitting device may have characteristics such as high luminance, high resolution, and low power consumption.

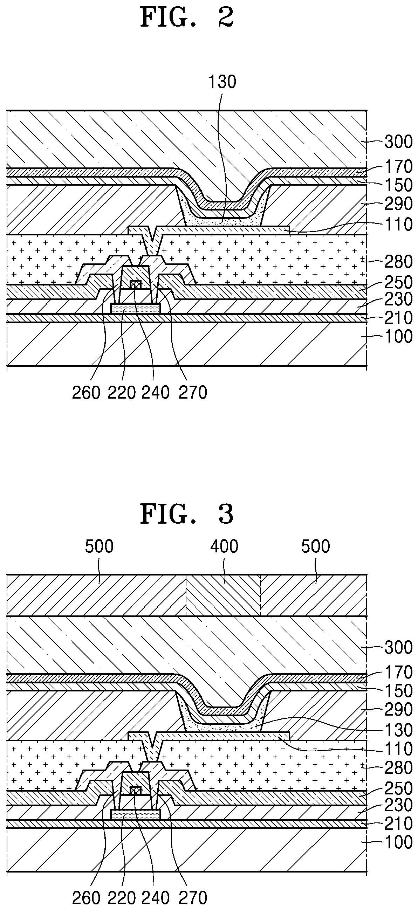

### Descriptions of FIGS. 2 and 3

FIG. 2 is a cross-sectional view of a light-emitting apparatus as an example of the electronic apparatus according to one or more embodiments.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged on the substrate 100. The buffer layer 210 may prevent or reduce penetration of impurities through the substrate 100 and may provide a flat surface on the substrate 100.

The TFT may be arranged on the buffer layer 210. The TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating the activation layer 220 from the gate electrode 240 may be arranged on the activation layer 220, and the gate electrode 240 may be arranged on the gate insulating film 230.

An interlayer insulating film 250 may be arranged on the gate electrode 240. The interlayer insulating film 250 may be arranged between the gate electrode 240 and the source electrode 260 and between the gate electrode 240 and the drain electrode 270, to insulate from one another.

The source electrode 260 and the drain electrode 270 may be arranged on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220.

The TFT may be electrically connected to a light-emitting device to drive the light-emitting device, and may be covered and protected by a passivation layer 280. The passivation layer 280 may include an inorganic insulating film, an organic insulating film, or any combination thereof. A light-emitting device may be provided on the passivation layer 280. The light-emitting device may include the first electrode 110, the interlayer 130, and the second electrode 150.

The first electrode 110 may be arranged on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel defining layer 290 including an insulating material may be arranged on the first electrode 110. The pixel defining layer 290 may expose a certain region of the first electrode 110, and an interlayer 130 may be formed in the exposed region of the first electrode 110. The pixel defining layer 290 may be a polyimide-based organic film or a polyacrylic-based organic film. In one or more embodiments, at least some layers of the interlayer 130 may extend beyond the upper portion of the pixel defining layer 290 to be arranged in the form of a common layer.

The second electrode 150 may be arranged on the interlayer 130, and a second capping layer 170 may be additionally formed on the second electrode 150. The second capping layer 170 may be formed to cover the second electrode 150.

The encapsulation portion 300 may be arranged on the second capping layer 170. The encapsulation portion 300 may be arranged on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (e.g., polymethyl methacrylate, polyacrylic acid, and/or the like), an epoxy-based resin (e.g., aliphatic glycidyl ether (AGE), and/or the like), or any combination thereof; or any combination of the inorganic films and the organic films.

FIG. 3 is a cross-sectional view of a light-emitting apparatus as an example of the electronic apparatus according to another embodiment.

The light-emitting apparatus of FIG. 3 is the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In one or more embodiments, the light-emitting device included in the light-emitting apparatus of FIG. 3 may be a tandem light-emitting device.

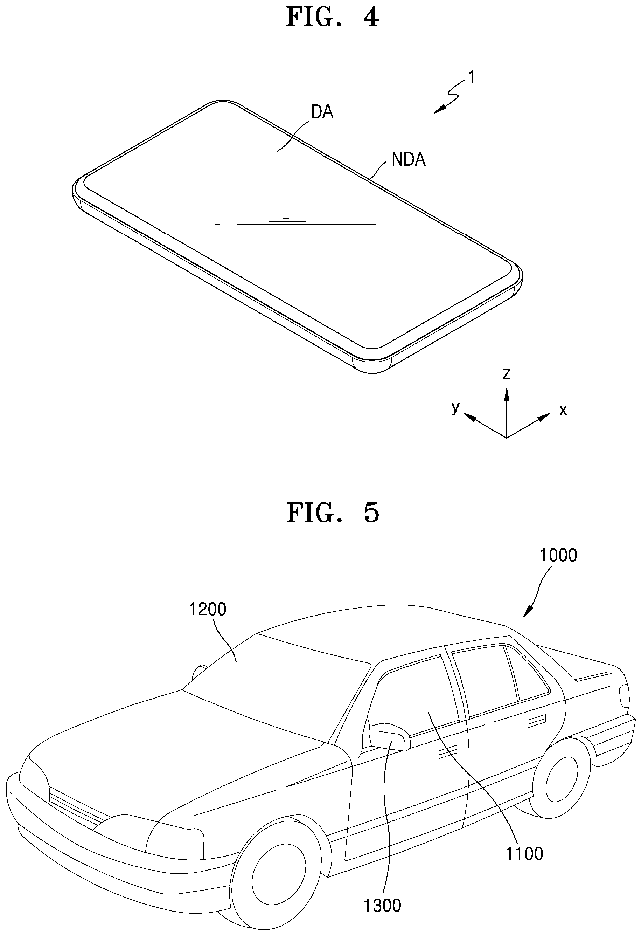

### Description of FIG. 4

FIG. 4 is a schematic perspective view of electronic equipment 1 including a light-emitting device according to one or more embodiments. The electronic equipment 1 may be, as a device that displays a moving image or still image, a portable electronic equipment, such as a mobile phone, a smart phone, a tablet personal computer (PC), a mobile communication terminal, an electronic notebook, an electronic book, a portable multimedia player (PMP), a navigation, or a ultra-mobile PC (UMPC), as well as one or more suitable products, such as a television, a laptop, a monitor, a billboard, or an Internet of things (IOT). The electronic equipment 1 may be such a product as described herein or a part thereof. In some embodiments, the electronic equipment 1 may be a wearable device, such as a smart watch, a watch phone, a glasses-type or kind display, or a head mounted display (HMD), or a part of the wearable device. However, embodiments are not limited thereto. For example, the electronic equipment 1 may include a dashboard of a vehicle, a center fascia of a vehicle, a center information display (CID) arranged on a dashboard of a vehicle, a room mirror display replacing a side mirror of a vehicle, an entertainment display for a rear seat of a vehicle or a display arranged on the back of a front seat, a head up display (HUD) installed in the front of a vehicle or projected on a front window glass, or a computer generated hologram augmented reality head up display (CGH AR HUD). FIG. 4 illustrates a case in which the electronic equipment 1 is a smart phone for convenience of explanation.

The electronic equipment 1 may include a display area DA and a non-display area NDA outside the display area DA. A display device may implement an image through an array of a plurality of pixels that are two-dimensionally arranged in the display area DA.

The non-display area NDA is an area that does not display an image, and may entirely surround the display area DA. On the non-display area NDA, a driver for providing electrical signals or power to display devices arranged on the display area DA may be arranged. On the non-display area NDA, a pad, which is an area to which an electronic element or a printing circuit board, may be electrically connected may be arranged.

In the electronic equipment 1, a length in the x-axis direction and a length in the y-axis direction may be different from each other. In one or more embodiments, as shown in FIG. 4, the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

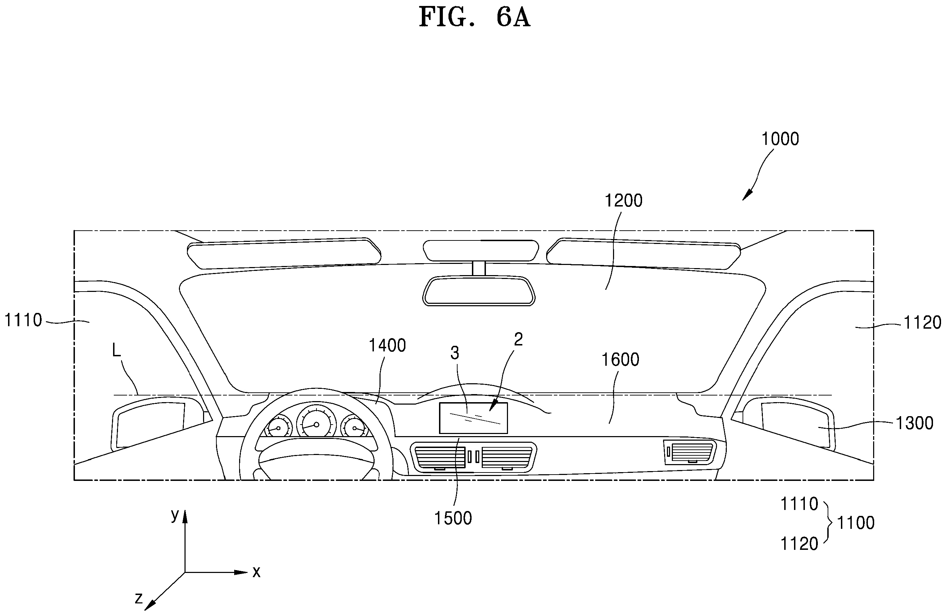

### Descriptions of FIGS. 5 and 6A to 6C

FIG. 5 is a schematic view of the exterior of a vehicle 1000 as electronic equipment including a light-emitting device according to one or more embodiments. FIGS. 6A to 6C are each a schematic view of the interior of the vehicle 1000 according to one or more embodiments.

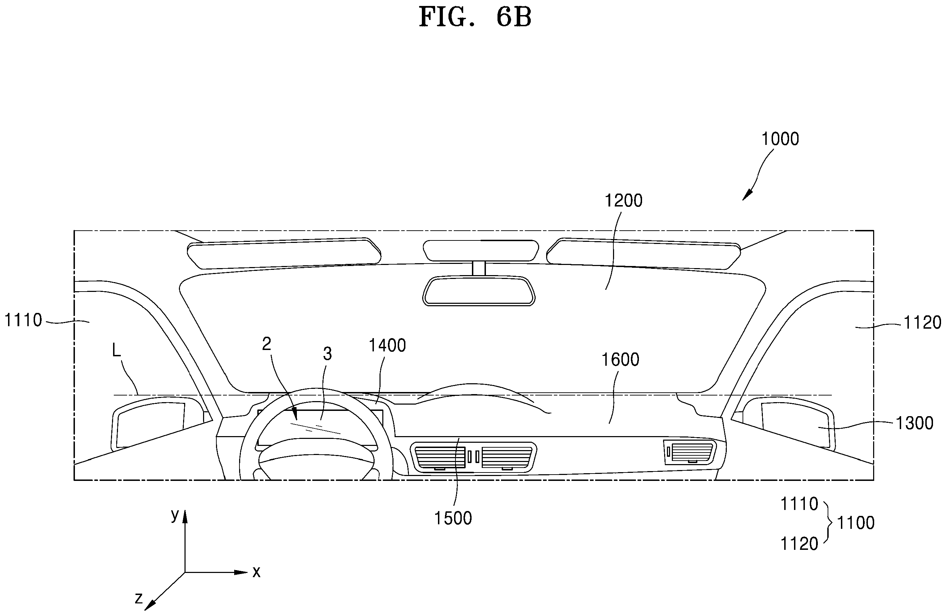

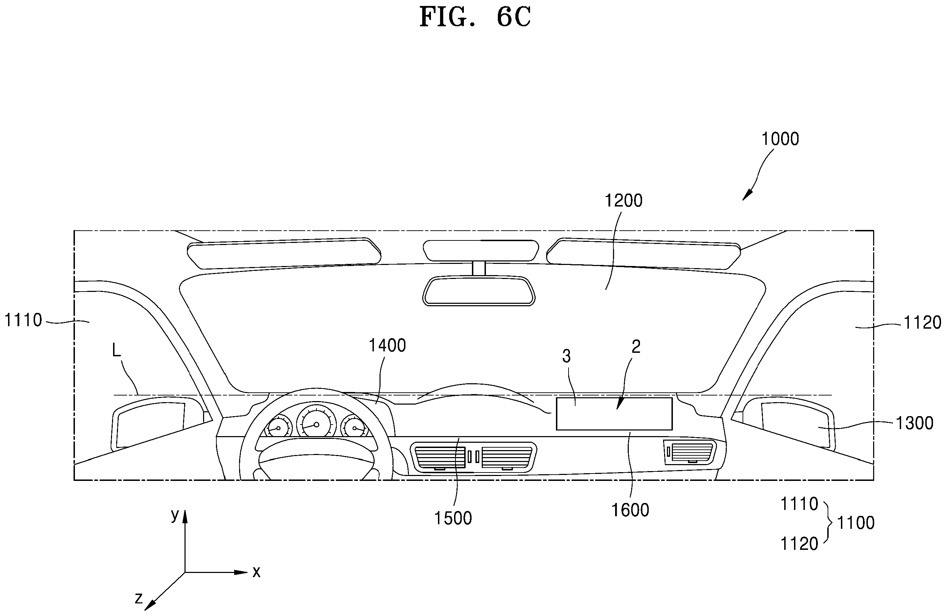

Referring to FIGS. 5, 6A, 6B, and 6C, the vehicle 1000 may refer to one or more suitable apparatuses for moving a subject to be transported, such as a human, an object, or an animal, from a departure point to a destination point. The vehicle 1000 may include a vehicle (e.g., automobile) traveling on a road or track, a vessel moving over the sea or river, an airplane flying in the sky utilizing the action of air, and/or the like.

The vehicle 1000 may travel on a road or a track. The vehicle 1000 may move in a set or predetermined direction according to rotation of at least one wheel. For example, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses necessary for driving are installed as other parts except for the body. The exterior of the body may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear left and right wheels, and/or the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a pillar arranged between the side window glass 1100 and the front window glass 1200.

The side window glass 1100 may be installed on the side of the vehicle 1000. In one or more embodiments, the side window glass 1100 may be installed on a door of the vehicle 1000. A plurality of side window glasses 1100 may be provided and may face each other. In one or more embodiments, the side window glass 1100 may include a first side window glass 1110 and a second side window glass 1120. In one or more embodiments, the first side window glass 1110 may be arranged adjacent to the cluster 1400. The second side window glass 1120 may be arranged adjacent to the passenger seat dashboard 1600.

In one or more embodiments, the side window glasses 1100 may be spaced and/or apart from each other in the x-direction or the -x-direction. For example, the first side window glass 1110 and the second side window glass 1120 may be spaced and/or apart from each other in the x-direction or the -x-direction. In other words, an imaginary straight line L connecting the side window glasses 1100 may extend in the x-direction or the -x-direction. For example, the imaginary straight line L connecting the first side window glass 1110 and the second side window glass 1120 to each other may extend in the x-direction or the -x-direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In one or more embodiments, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning lamp, a seat belt warning lamp, an odometer, an automatic shift selector indicator lamp, a door open warning lamp, an engine oil warning lamp, and/or a low fuel warning light.

The center fascia 1500 may include a control panel on which a plurality of buttons for adjusting an audio device, an air conditioning device, and a heater of a seat are arranged. The center fascia 1500 may be arranged on one side of the cluster 1400.

The passenger seat dashboard 1600 may be spaced and/or apart from the cluster 1400 with the center fascia 1500 arranged therebetween. In one or more embodiments, the cluster 1400 may be arranged to correspond to a driver seat, and the passenger seat dashboard 1600 may be arranged to correspond to a passenger seat. In one or more embodiments, the cluster 1400 may be adjacent to the first side window glass 1110, and the passenger seat dashboard 1600 may be adjacent to the second side window glass 1120.

In one or more embodiments, the display device 2 may include a display panel 3, and the display panel 3 may display an image. The display device 2 may be arranged inside the vehicle 1000. In one or more embodiments, the display device 2 may be arranged between the side window glasses 1100 facing each other. The display device 2 may be arranged on at least one of the cluster 1400, the center fascia 1500, and the passenger seat dashboard 1600.

The display device 2 may include an organic light-emitting display device, an inorganic light-emitting display device, a quantum dot display device, and/or the like. Hereinafter, as the display device 2 according to one or more embodiments of the invention, an organic light-emitting display device including the light-emitting device according to the invention will be described as an example, but one or more suitable types (kinds) of display devices as described may be utilized in embodiments of the invention.

Referring to FIG. 6A, the display device 2 may be arranged on the center fascia 1500. In one or more embodiments, the display device 2 may display navigation information. In one or more embodiments, the display device 2 may display audio, video, or information regarding vehicle settings.

Referring to FIG. 6B, the display device 2 may be arranged on the cluster 1400. When the display device 2 is arranged on the cluster 1400, the cluster 1400 may display driving information and/or the like through the display device 2. For example, the cluster 1400 may be implemented digitally. The digital cluster 1400 may display vehicle information and driving information as images. For example, a needle and a gauge of a tachometer and one or more suitable warning light icons may be displayed by a digital signal.

Referring to FIG. 6C, the display device 2 may be arranged on the passenger seat dashboard 1600. The display device 2 may be embedded in the passenger seat dashboard 1600 or arranged on the passenger seat dashboard 1600. In one or more embodiments, the display device 2 arranged on the passenger seat dashboard 1600 seat may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### Manufacturing method

The layers constituting the hole transport region, the emission layer, and the layers constituting the electron transport region may be formed in a certain region by utilizing one or more suitable methods such as vacuum deposition, spin coating, casting, Langmuir-Blodgett (LB) deposition, ink-jet printing, laser-printing, laser-induced thermal imaging, and/or the like.

When the layers constituting the hole transport region, the emission layer, and the layers constituting the electron transport region are formed by vacuum deposition, the deposition may be performed at a deposition temperature in a range of about 100 °C to about 500 °C, at a vacuum degree in a range of about 10⁻⁸ torr to about 10⁻³ torr, and at a deposition speed in a range of about 0.01 angstrom per second (Å/sec) to about 100 Å/sec, depending on a material to be included in a layer to be formed and the structure of a layer to be formed.

### Definition of terms

The term "C₃-C₆₀ carbocyclic group" as utilized herein refers to a cyclic group consisting of carbon only as a ring-forming atom and having 3 to 60 carbon atoms, and the term "C₁-C₆₀ heterocyclic group" as utilized herein refers to a cyclic group that has 1 to 60 carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the number of ring-forming atoms of the C₁-C₆₀ heterocyclic group may be from 3 to 61.

The "cyclic group" as utilized herein may include both (e.g., simultaneously) the C₃-C₆₀ carbocyclic group and the C₁-C₆₀ heterocyclic group.

The term "π electron-rich C₃-C₆₀ cyclic group" as utilized herein refers to a cyclic group that has 3 to 60 carbon atoms and does not include *-N=*' as a ring-forming moiety, and the term "π electron-deficient nitrogen-containing C₁-C₆₀ heterocyclic group" as utilized herein refers to a heterocyclic group that has 1 to 60 carbon atoms and includes *-N=*' as a ring-forming moiety.

For example,
the C₃-C₆₀ carbocyclic group may be i) Group T1 or ii) a condensed cyclic group in which two or more of Group T1 are condensed with each other (e.g., a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (e.g., a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (e.g., the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like),
the π electron-deficient nitrogen-containing C₁-C₆₀ heterocyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (e.g., a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
   Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
   Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
   Group T3 may be a furan group, a thiophene group, a 1H-pyrrole group, a silole group, or a borole group, and
   Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ heterocyclic group" as utilized herein may refer to a group condensed to any cyclic group, a monovalent group, or a polyvalent group (e.g., a divalent group, a trivalent group, a tetravalent group, and/or the like) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

Depending on context, a divalent group may refer or be a polyvalent group (e.g., trivalent, tetravalent, etc., and not just divalent) per, e.g., the structure of a formula in connection with which of the terms are utilized.

Examples of the monovalent C₃-C₆₀ carbocyclic group and the monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the divalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group that has 1 to 60 carbon atoms, and examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, and/or the like. The term "C₁-C₆₀ alkylene group" as utilized herein refers to a divalent group having the same structure as the C₁-C₆₀ alkyl group.

The term "C₂-C₆₀ alkenyl group" as utilized herein refers to a monovalent hydrocarbon group having at least one carbon-carbon double bond in the middle or at the terminus of the C₂-C₆₀ alkyl group, and examples thereof are an ethenyl group, a propenyl group, a butenyl group, and/or the like. The term "C₂-C₆₀ alkenylene group" as utilized herein refers to a divalent group having the same structure as the C₂-C₆₀ alkenyl group.

The term "C₂-C₆₀ alkynyl group" as utilized herein refers to a monovalent hydrocarbon group having at least one carbon-carbon triple bond in the middle or at the terminus of the C₂-C₆₀ alkyl group, and examples thereof are an ethynyl group, a propynyl group, and/or the like. The term "C₂-C₆₀ alkynylene group" as utilized herein refers to a divalent group having the same structure as the C₂-C₆₀ alkynyl group.

The term "C₁-C₆₀ alkoxy group" as utilized herein refers to a monovalent group represented by -OA₁₀₁ (wherein A₁₀₁ is the C₁-C₆₀ alkyl group), and examples thereof are a methoxy group, an ethoxy group, an isopropyloxy group, and/or the like.

The term "C₃-C₁₀ cycloalkyl group" as utilized herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and/or the like. The term "C₃-C₁₀ cycloalkylene group" as utilized herein refers to a divalent group having the same structure as the C₃-C₁₀ cycloalkyl group.

The term "C₁-C₁₀ heterocycloalkyl group" as utilized herein refers to a monovalent cyclic group of 1 to 10 carbon atoms, further including, in addition to carbon atoms, at least one heteroatom, as ring-forming atoms, and examples thereof are a 1,2,3,4-oxatriazolidinyl group, a tetrahydrofuranyl group, a tetrahydrothiophenyl group, and/or the like. The term "C₁-C₁₀ heterocycloalkylene group" as utilized herein refers to a divalent group having the same structure as the C₁-C₁₀ heterocycloalkyl group.

The term "C₃-C₁₀ cycloalkenyl group" as utilized herein refers to a monovalent cyclic group that has three to ten carbon atoms and at least one carbon-carbon double bond in the ring thereof and no aromaticity, and examples thereof are a cyclopentenyl group, a cyclohexenyl group, a cycloheptenyl group, and/or the like. The term "C₃-C₁₀ cycloalkenylene group" as utilized herein refers to a divalent group having the same structure as the C₃-C₁₀ cycloalkenyl group.

The term "C₁-C₁₀ heterocycloalkenyl group" as utilized herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group are a 4,5-dihydro-1,2,3,4-oxatriazolyl group, a 2,3-dihydrofuranyl group, a 2,3-dihydrothiophenyl group, and/or the like. The term "C₁-C₁₀ heterocycloalkenylene group" as utilized herein refers to a divalent group having the same structure as the C₁-C₁₀ heterocycloalkenyl group.

The term "C₆-C₆₀ aryl group" as utilized herein refers to a monovalent group having a carbocyclic aromatic system of 6 to 60 carbon atoms, and the term "C₆-C₆₀ arylene group" as utilized herein refers to a divalent group having a carbocyclic aromatic system of 6 to 60 carbon atoms. Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and/or the like. When the C₆-C₆₀ aryl group and the C₆-C₆₀ arylene group each include two or more rings, the rings may be condensed with each other.

The term "C₁-C₆₀ heteroaryl group" as utilized herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, and/or the like. When the C₁-C₆₀ heteroaryl group and the C₁-C₆₀ heteroarylene group each include two or more rings, the rings may be condensed with each other.

The term "monovalent non-aromatic condensed polycyclic group" as utilized herein refers to a monovalent group (e.g., having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, a fluorenyl group, a spiro-bifluorenyl group, a benzofluorenyl group, an indenophenanthrenyl group, an indeno anthracenyl group, and/or the like. The term "divalent non-aromatic condensed polycyclic group" as utilized herein refers to a divalent group having the same structure as the monovalent non-aromatic condensed polycyclic group.

The term "monovalent non-aromatic condensed heteropolycyclic group" as utilized herein refers to a monovalent group (e.g., having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group are a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, and/or the like. The term "divalent non-aromatic condensed heteropolycyclic group" as utilized herein refers to a divalent group having the same structure as the monovalent non-aromatic condensed heteropolycyclic group.

The term "C₆-C₆₀ aryloxy group" as utilized herein refers to -OA₁₀₂ (wherein A₁₀₂ is the C₆-C₆₀ aryl group), and the term "C₆-C₆₀ arylthio group" as utilized herein refers to -SA₁₀₃ (wherein A₁₀₃ is the C₆-C₆₀ aryl group).

The term "C₇-C₆₀ arylalkyl group" as utilized herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as utilized herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as utilized herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ utilized herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ arylalkyl group; or a C₂-C₆₀ heteroarylalkyl group.

The term "heteroatom" as utilized herein refers to any atom other than a carbon atom. Examples of the heteroatom are O, S, N, P, Si, B, Ge, Se, and any combination thereof.

The term "third-row transition metal" as utilized herein includes Hf, Ta, W, Re, Os, Ir, Pt, Au, and/or the like.

"Ph" as utilized herein refers to a phenyl group, "Me" as utilized herein refers to a methyl group, "Et" as utilized herein refers to an ethyl group, "ter-Bu" or "Bu^{t}" as utilized herein refers to a tert-butyl group, and "OMe" as utilized herein refers to a methoxy group.

The term "biphenyl group" as utilized herein refers to "a phenyl group substituted with a phenyl group." In other words, the "biphenyl group" may be a substituted phenyl group having a C₆-C₆₀ aryl group as a substituent.

The term "terphenyl group" as utilized herein refers to "a phenyl group substituted with a biphenyl group." In other words, the "terphenyl group" may be a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

The x-axis, y-axis, and z-axis utilized herein are not limited to three axes in an orthogonal coordinate system, and may be interpreted in a broad sense including these axes. For example, the x-axis, y-axis, and z-axis may refer to those orthogonal to each other, or may refer to those in different directions that are not orthogonal to each other.

Hereinafter, compounds according to embodiments and light-emitting devices according to embodiments will be described in more detail with reference to Synthesis Examples and Examples. The wording "B was utilized instead of A" utilized in describing Synthesis Examples refers to that an identical molar equivalent of B was utilized in place of A.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein include and are intended to disclose all subsumed sub-ranges of the same numerical precision. For example, a range of "1.0 to 10.0" includes all subranges having a minimum value equal to or greater than 1.0 and a maximum value equal to or less than 10.0, such as, for example, 2.4 to 7.6. Applicant therefore reserves the right to amend this specification, including the claims, to expressly recite any sub-range subsumed within the ranges expressly recited herein.

The light emitting device and/or any other relevant devices or components according to embodiments of the present invention described herein may be implemented utilizing any suitable hardware, firmware (e.g., an application-specific integrated circuit), software, or a combination of software, firmware, and hardware. For example, the various components of the light emitting device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present invention.

In the present invention, when particles are spherical, "diameter" indicates an average particle diameter, and when the particles are non-spherical, the "diameter" indicates a major axis length. The diameter (or size) of the particles may be measured by particle size analysis, dynamic light scattering, scanning electron microscopy, and/or transmission electron microscope photography. When the size of the particles is measured utilizing a particle size analyzer, the average particle diameter (or size) may be referred to as D50. The term "D50" as utilized herein refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size. Particle size analysis may be performed with a HORIBA LA-950 laser particle size analyzer.

### Examples

### Synthesis Example 1: Synthesis of Compound 4

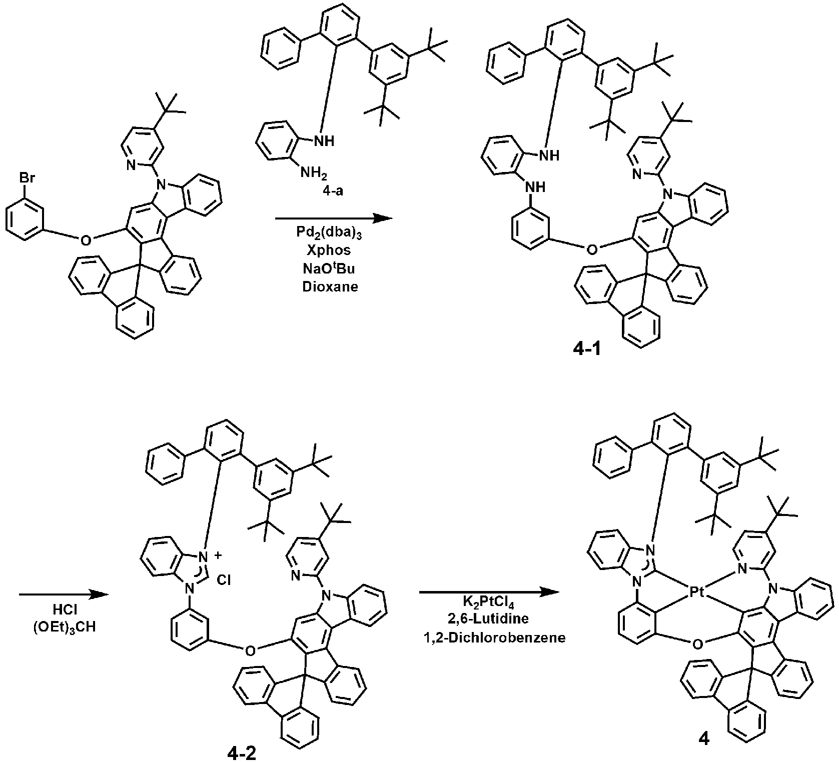

### 1) Synthesis of Intermediate 4-1

7'-(3-bromophenoxy)-5'-(4-(tert-butyl)pyridin-2-yl)-5'H-spiro[fluorene-9,8'-indeno[2,1-c]carbazole] (1.0 eq), Compound 4-a (1.0 eq), Pd₂(dba)₃ (5 mol%), Xphos (7 mol%), and sodium tert-butoxide (2.0 eq) were dissolved in dioxane (0.1 M) and stirred at 110 °C for 3 hours to prepare a reaction mixture. After the reaction mixture was cooled at room temperature, the solvent was removed therefrom by distillation under reduced pressure at 8 millibar (mbar), the mixture was diluted with water and an extraction process was performed thereon three times by utilizing dichloromethane (MC) to obtain an organic layer. The obtained organic layer was dried by utilizing magnesium sulfate and concentrated, and column chromatography (MC:hexane) was utilized to obtain Intermediate 4-1 (yield: 75 %).

### 2) Synthesis of Intermediate 4-2

Intermediate 4-1 (1.0 eq) was dissolved in triethyl orthoformate (30 eq), and 37 % HCl (1.5 eq) was added thereto, followed by stirring at 80 °C for 18 hours to prepare a reaction mixture. After the reaction mixture was cooled at room temperature, triethyl orthoformate therein was concentrated, the mixture was diluted with water and an extraction process was performed thereon three times by utilizing MC to obtain an organic layer. The obtained organic layer was dried by utilizing magnesium sulfate and concentrated, and column chromatography (MC:methanol) was utilized to obtain Intermediate 4-2 (yield: 87 %).

### 3) Synthesis of Compound 4

Intermediate 4-2 (1.0 eq), potassium platinum (II) chloride (1.1 eq), and 2,6-lutidine (4.0 eq) were dissolved in 1,2-dichlorobenzene (0.05 M) and stirred at 120 °C for 3 days in the nitrogen condition to prepare a reaction mixture. After the reaction mixture was cooled at room temperature, 1,2-dichlorobenzene therein was concentrated and removed, the mixture was diluted with water and an extraction process was performed thereon three times by utilizing dichloromethane to obtain an organic layer. The obtained organic layer was dried by utilizing magnesium sulfate and concentrated, and column chromatography (MC:hexane) was utilized to obtain Compound 4 (yield: 46 %).
ESI-LCMS: [M]+: C80H69N4OPt, 1297.9

### Synthesis Example 2: Synthesis of Compound 3

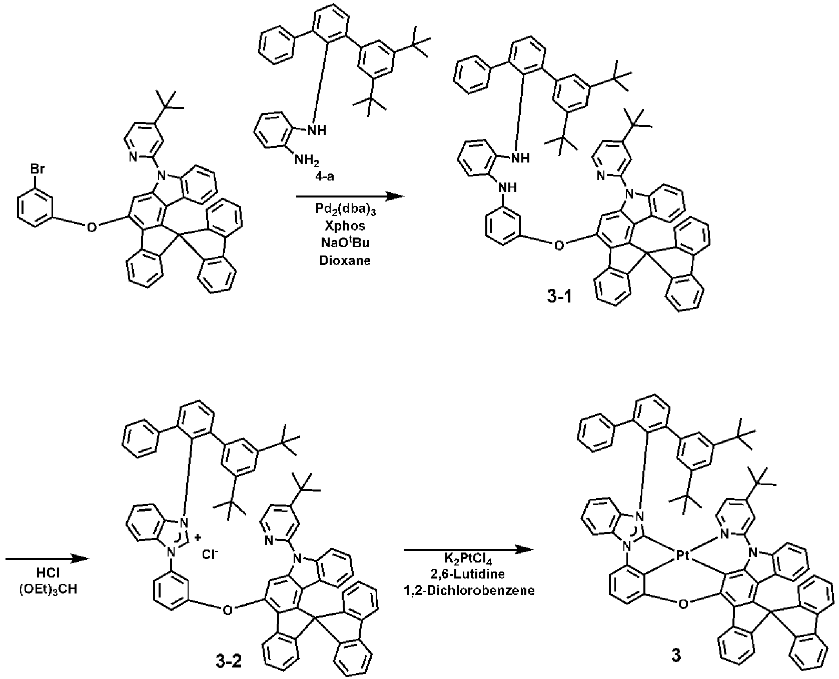

Compound 3 was synthesized in substantially the same manner as utilized to synthesize Intermediate 4-1, Intermediate 4-2, and Compound 4, except that 7'-(3-bromophenoxy)-5'-(4-(tert-butyl)pyridin-2-yl)-5'H-spiro[fluorene-9,12'-indeno[1,2-c]carbazole] was utilized instead of 7'-(3-bromophenoxy)-5'-(4-(tert-butyl)pyridin-2-yl)-5'H-spiro[fluorene-9,8'-indeno[2,1-c]carbazole].
ESI-LCMS: [M]+: C80H69N4OPt, 1297.7

### Synthesis Example 3: Synthesis of Compound 34

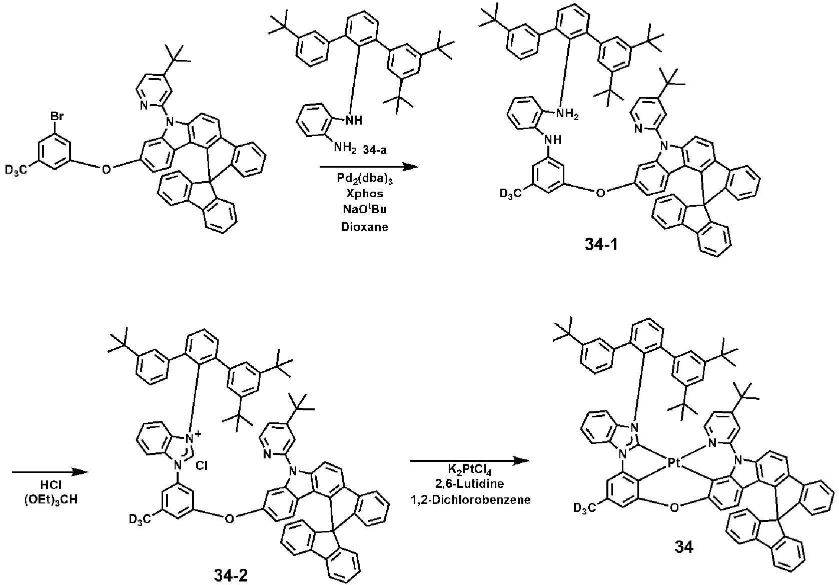

Compound 34 was synthesized in substantially the same manner as utilized to synthesize Intermediate 4-1, Intermediate 4-2, and Compound 4, except that 3'-(3-bromo-5-(methyl-d3)phenoxy)-5'-(4-(tert-butyl)pyridin-2-yl)-5'H-spiro[fluorene-9,12'-indeno[1,2-c]carbazole] was utilized instead of 7'-(3-bromophenoxy)-5'-(4-(tert-butyl)pyridin-2-yl)-5'H-spiro[fluorene-9,8'-indeno[2,1-c]carbazole], and Compound 34-a was utilized instead of Compound 4-a.
ESI-LCMS: [M]+: C84H72D3N4OPt, 1354.2

### Synthesis Example 4: Synthesis of Compound 35

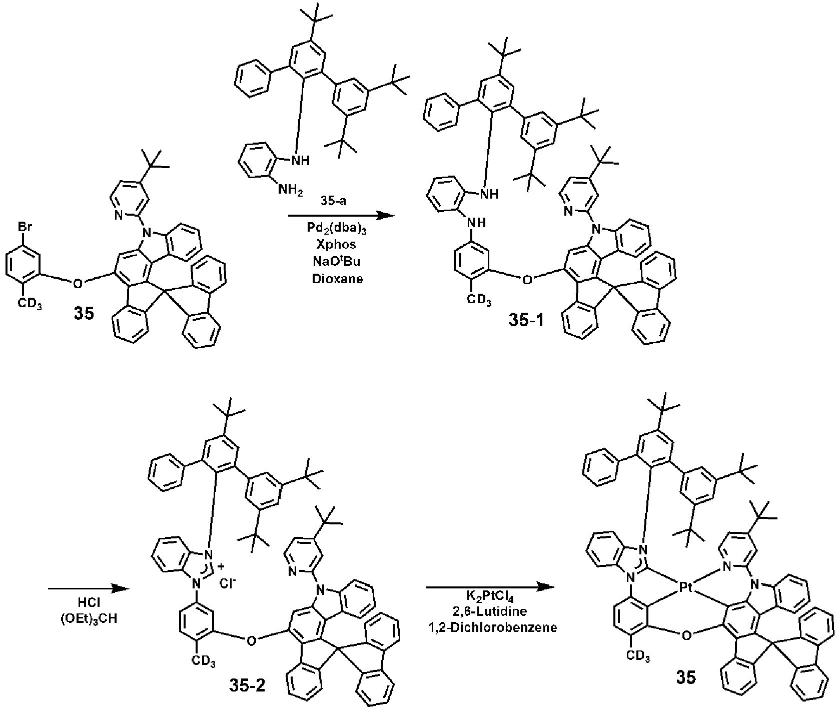

Compound 35 was synthesized in substantially the same manner as utilized to synthesize Intermediate 4-1, Intermediate 4-2, and Compound 4, except that 7'-(5-bromo-2-(methyl-d3)phenoxy)-5'-(4-(tert-butyl)pyridin-2-yl)-5'H-spiro[fluorene-9,12'-indeno[1,2-c]carbazole] was utilized instead of 7'-(3-bromophenoxy)-5'-(4-(tert-butyl)pyridin-2-yl)-5'H-spiro[fluorene-9,8'-indeno[2,1-c]carbazole], and Compound 35-a was utilized instead of Compound 4-a.
ESI-LCMS: [M]+: C85H76D3N4OPt, 1370.4

### Synthesis Example 5: Synthesis of Compound 63

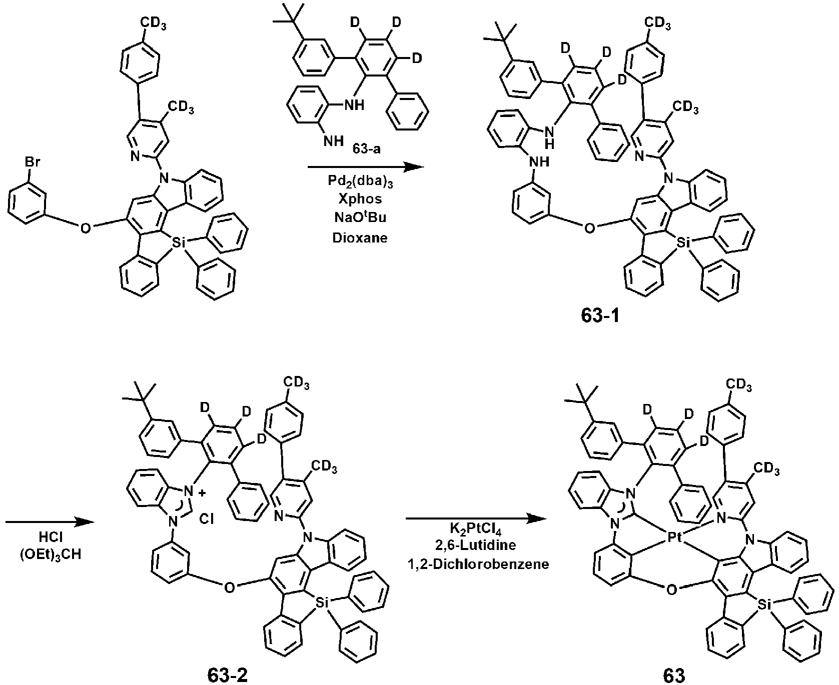

Compound 63 was synthesized in substantially the same manner as utilized to synthesize Intermediate 4-1, Intermediate 4-2, and Compound 4, except that 7-(3-bromophenoxy)-5-(4-(methyl-d3)-5-(4-(methyl-d3)phenyl)pyridin-2-yl)-12,12-diphenyl-5,12-dihydrobenzo[4,5]silolo[3,2-c]carbazole was utilized instead of 7'-(3-bromophenoxy)-5'-(4-(tert-butyl)pyridin-2-yl)-5'H-spiro[fluorene-9,8'-indeno[2,1-c]carbazole], and Compound 63-a was utilized instead of Compound 4-a.
ESI-LCMS: [M]+: C79H54D9N4OptSi, 1316.1

### Synthesis Example 6: Synthesis of Compound 70

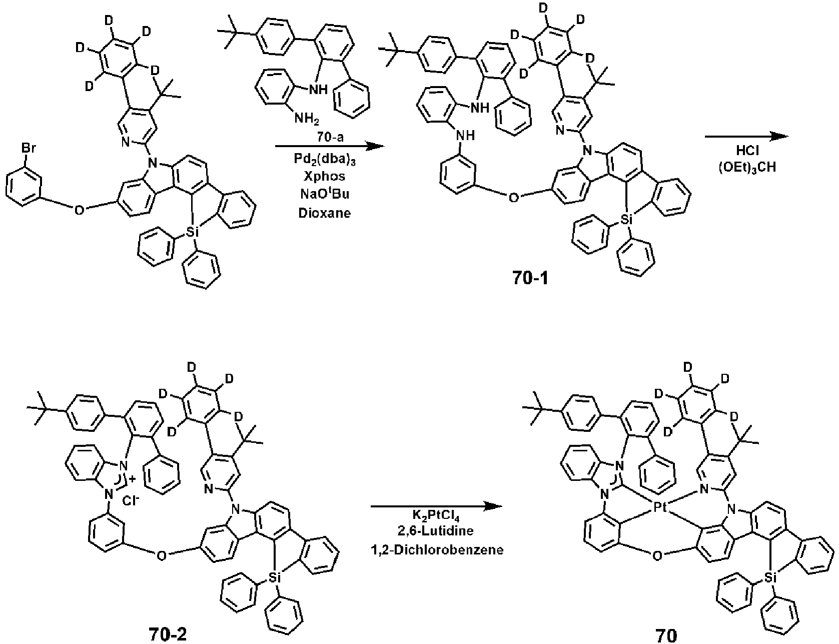

Compound 70 was synthesized in substantially the same manner as utilized to synthesize Intermediate 4-1, Intermediate 4-2, and Compound 4, except that 3-(3-bromophenoxy)-5-(4-(tert-butyl)-5-(phenyl-d5)pyridin-2-yl)-12,12-diphenyl-5,12-dihydrobenzo[4,5]silolo[3,2-c]carbazole was utilized instead of 7'-(3-bromophenoxy)-5'-(4-(tert-butyl)pyridin-2-yl)-5'H-spiro[fluorene-9,8'-indeno[2,1-c]carbazole], and Compound 70-a was utilized instead of Compound 4-a.
ESI-LCMS: [M]+: C80H58D5N4OPtSi, 1324.3

LC/MS of the compounds synthesized in Synthesis Examples are shown in Table 1. Synthesis methods of compounds other than the compounds synthesized in Synthesis Examples may be easily recognized by those skilled in the art by referring to the synthesis paths and source materials.

**Table 1**

| Compound No. | LC/MS | |
|---|---|---|
| | found | calc. |
| 3 | 1297.9 | 1297.54 |
| 4 | 1297.7 | 1297.54 |
| 34 | 1354.2 | 1354.65 |
| 35 | 1370.4 | 1370.70 |
| 63 | 1316.1 | 1316.62 |
| 70 | 1324.3 | 1324.61 |

### Example 1

As an anode, a glass substrate (product of Corning Inc.) with a 15 ohm per square centimeter (Ω/cm²) (1,200 angstrom (Å)) ITO electrode formed thereon was cut to a size of 50 millimeter (mm) x 50 mm x 0.7 mm, sonicated by utilizing isopropyl alcohol and pure water each for 5 minutes, cleaned by irradiation of ultraviolet rays and exposure of ozone thereto for 30 minutes, and then mounted on a vacuum deposition apparatus.

NPD was deposited on the anode to form a hole injection layer having a thickness of 300 Å, HT3 was deposited on the hole injection layer to form a hole transport layer having a thickness of 200 Å, and CzSi was deposited on the hole transport layer to form an emission auxiliary layer having a thickness of 100 Å.

A pre-mixed host of HT-2 and ET-2, Compound 3, and Compound DF9 were co-deposited at a weight ratio of 85:14:1 on the emission auxiliary layer to form an emission layer having a thickness of 200 Å, TSPO1 was deposited on the emission layer to form a hole blocking layer having a thickness of 200 Å, TPBI was deposited on the hole blocking layer to form an electron transport layer having a thickness of 300 Å, LiF was deposited on the electron transport layer to form an electron injection layer having a thickness of 10 Å, and Al was deposited on the electron injection layer to form a cathode having a thickness of 3,000 Å, thereby completing the manufacture of a light-emitting device.

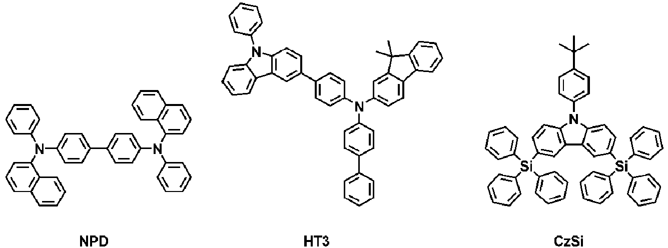

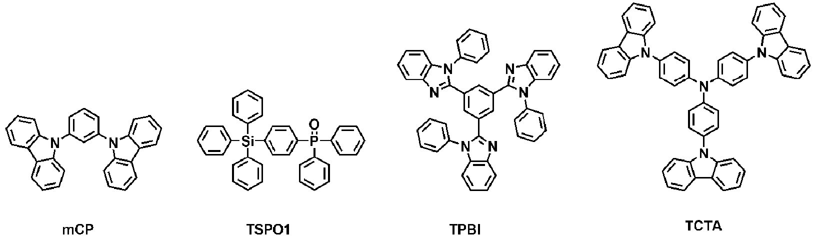

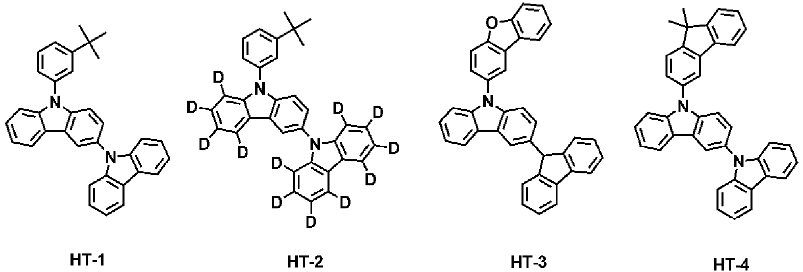

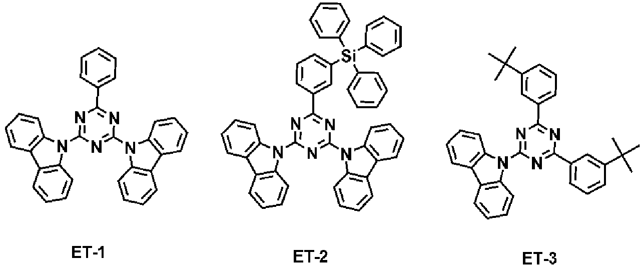

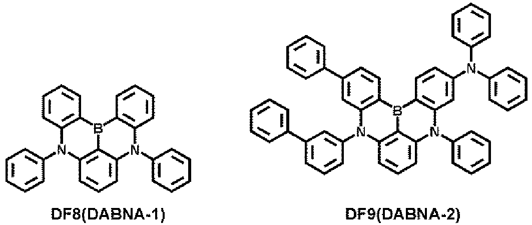

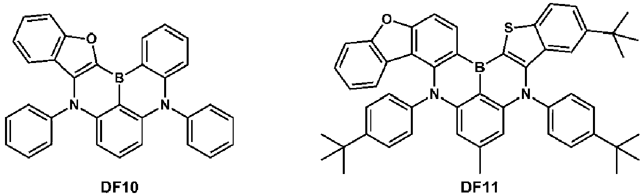

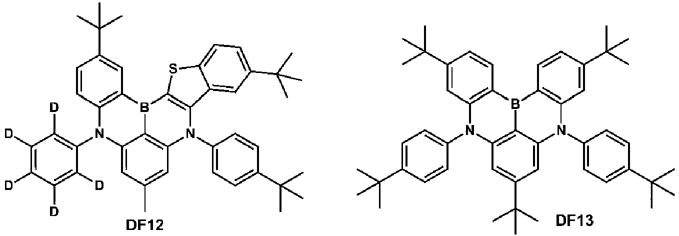

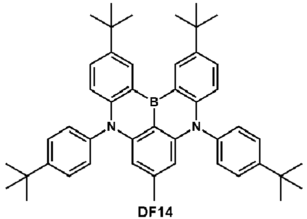

### Examples 2 to 6 and Comparative Examples 1 and 2

Light-emitting devices were manufactured in substantially the same manner as in Example 1, except that the compound utilized in forming the emission layer was changed as shown in Table 2.

### Evaluation Example 1

The driving voltage (V) at the luminance of 1,000 (candela per square meter (cd/m²)), efficiency (candela per ampere (cd/A)), maximum emission wavelength (nanometer (nm)), and device lifespan (hours (h)) of each of the light-emitting devices manufactured in Examples 1 to 6 and Comparative Examples 1 and 2 were measured by utilizing Keithley SMU 236 and luminance meter PR650, and the results are shown in Table 2. In Table 2, the device lifespan (T₉₅) is a measure of the time (h) taken until the luminance declines to 95 % of the initial luminance.

**Table 2**

| | Exciplex host (HT:ET=5:5) | Phosphorescent auxiliary dopant | Boron dopant | Driving voltage (V) | Efficiency (cd/A) | Emission color | Device lifespan (T₉₅, % relative to ref) |
|---|---|---|---|---|---|---|---|
| Example 1 | HT-2/ET-2 | 3 | DF9 | 4.3 | 26.8 | Blue | 199 |
| Example 2 | HT-2/ET-2 | 4 | DF9 | 4.2 | 25.9 | Blue | 202 |
| Example 3 | HT-2/ET-2 | 34 | DF9 | 4.3 | 24.3 | Blue | 193 |
| Example 4 | HT-2/ET-2 | 35 | DF9 | 4.2 | 24.8 | Blue | 185 |
| Example 5 | HT-2/ET-2 | 63 | DF9 | 4.2 | 26.2 | Blue | 188 |
| Example 6 | HT-2/ET-2 | 70 | DF9 | 4.4 | 25.4 | Blue | 194 |
| Comparative Example 1 | HT-2/ET-2 | CE1 | DF9 | 4.6 | 22.3 | Blue | 100 (ref) |
| Comparative Example 2 | HT-2/ET-2 | CE2 | DF9 | 4.8 | 19.8 | Blue | 150 |

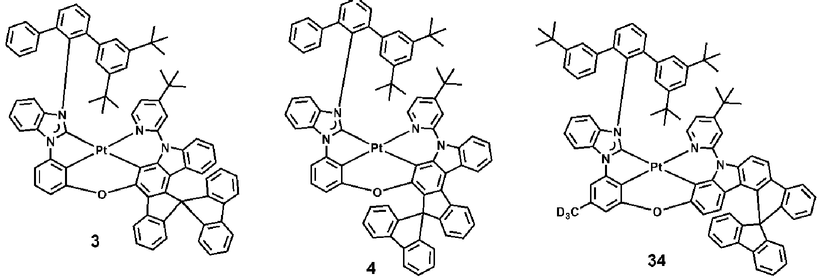

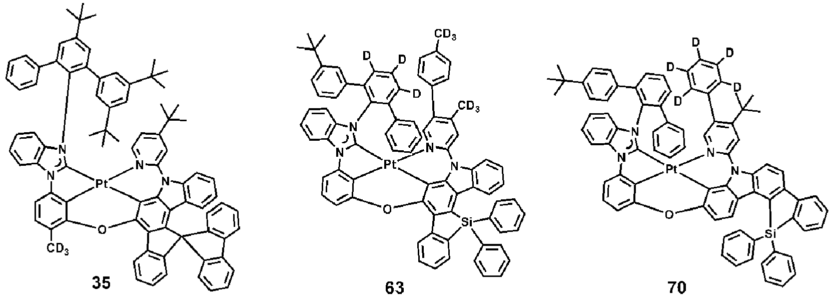

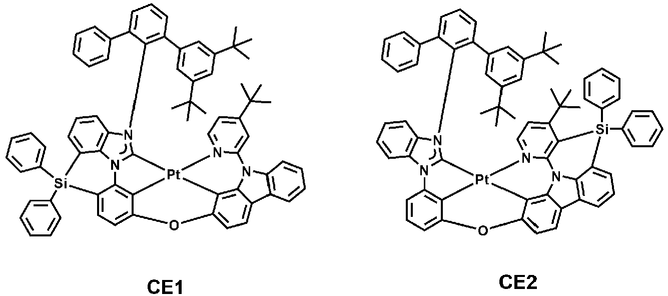

From Table 2, it was confirmed that the light-emitting devices according to Examples 1 to 6 had superior driving voltage, luminescence efficiency, and device lifespan to those of the light-emitting devices according to Comparative Examples 1 and 2.

According to the one or more embodiments, by utilizing an organometallic compound, a light-emitting device having reduced driving voltage, improved color purity and efficiency, and increased lifespan and a high-quality electronic apparatus including the light-emitting device may be manufactured.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope as defined by the following claims.

## Claims

1. An organometallic compound represented by Formula 1-1 or Formula 1-2: 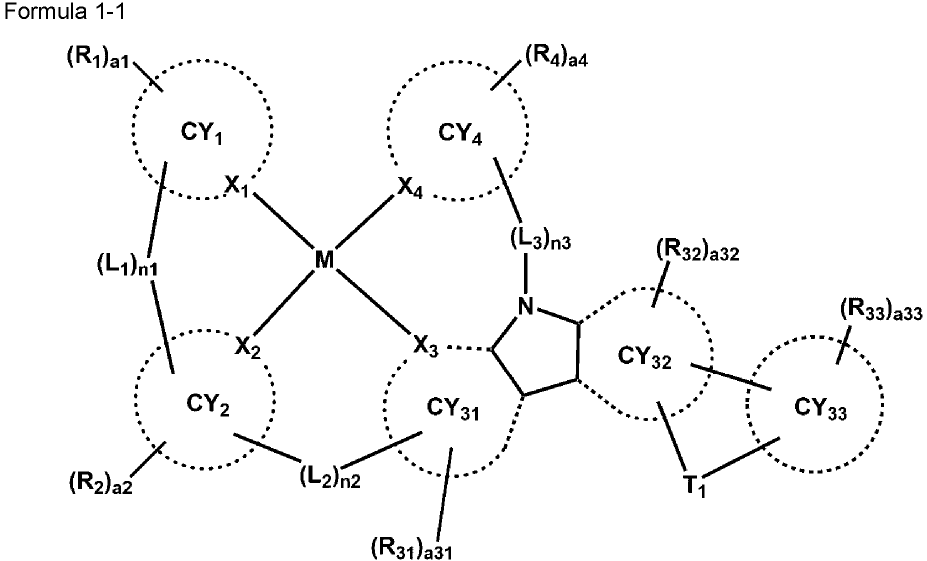 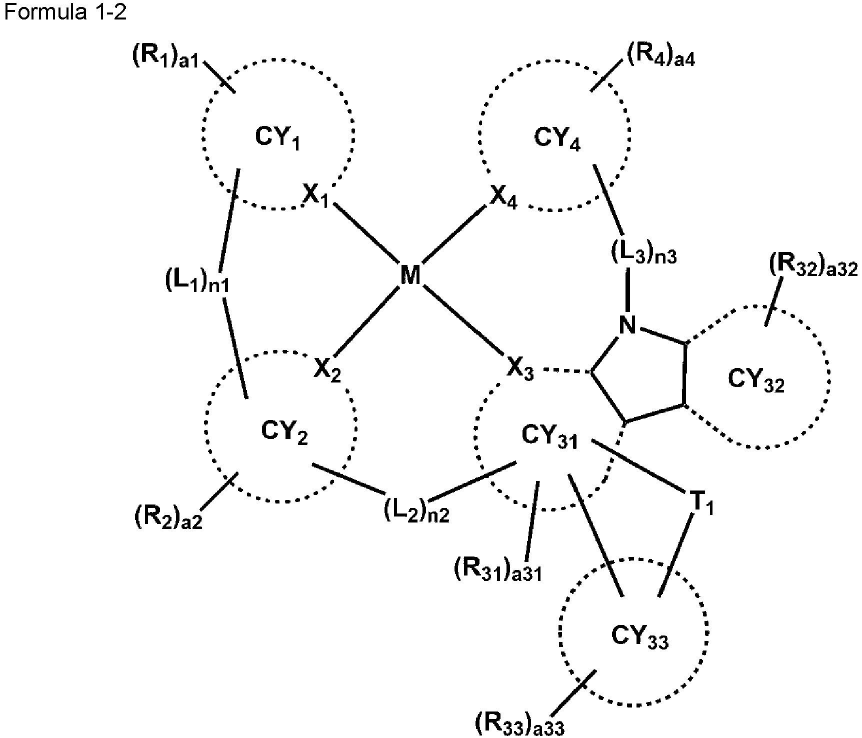 wherein, in Formulae 1-1 and 1-2,
M is platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm),
X₁ to X₄ are each independently C or N,
ring CY₁, ring CY₂, ring CY₃₁ to ring CY₃₃, and ring CY₄ are each independently a C₅-C₃₀ carbocyclic group or a C₁-C₃₀ heterocyclic group,
L₁ to L₃ are each independently a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*, *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', wherein * and *' each indicate a binding site to a neighboring atom,
n1 to n3 are each independently an integer from 1 to 5,
in Formulae 1-1 and 1-2, T₁ is a group represented by Formula T-1 or T-2: 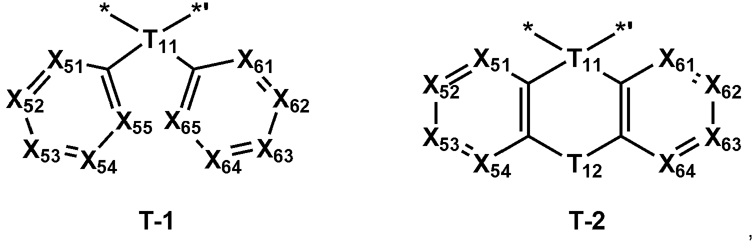 and
wherein, in Formulae T-1 and T-2,
T₁₁ is C, Si, or Ge,
T₁₂ is a single bond, *-C(Z₃)(Z₄)-*', *-Si(Z₃)(Z₄)-*', or *-Ge(Z₃)(Z₄)-*', wherein * and *' each indicate a binding site to a neighboring atom,
X₅₁ is C(Z₁₁) or N, X₅₂ is C(Z₁₂) or N, X₅₃ is C(Z₁₃) or N, X₅₄ is C(Z₁₄) or N, and X₅₅ is C(Z₁₅) or N,
X₆₁ is C(Z₂₁) or N, X₆₂ is C(Z₂₂) or N, X₆₃ is C(Z₂₃) or N, X₆₄ is C(Z₂₄) or N, and X₆₅ is C(Z₂₅) or N,
Z₁₁ to Z₁₅ and Z₃, Z₂₁ to Z₂₅ and Z₄ are each independently a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ,a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, - **C(Q₁)(Q₂)(Q₃),** -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
two or more neighboring groups of Z₁₁ to Z₁₅, Z₂₁ to Z₂₅, Z₃, and Z₄ are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and
* and *' each indicate a binding site to a neighboring atom,
R₁, R₂, R₃₁ to R₃₃, R₄, R₁ₐ, and R_{1b} are each independently hydrogen, deuterium, -F, -Cl, - Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
at least one R₁ is a group represented by Formula S1: 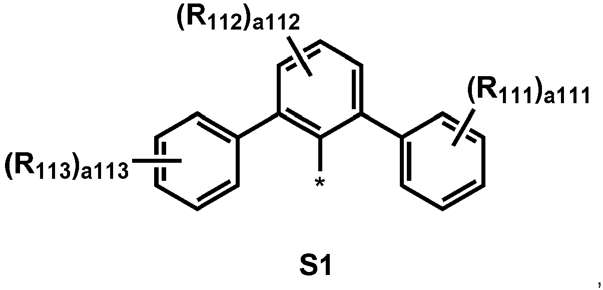 and
wherein, in Formula S1,
R₁₁₁ to R₁₁₃ are each defined as in connection with R₁ in Formula 1-1 or Formula 1-2,
a111 is an integer from 1 to 5,
a112 is an integer from 1 to 3,
a113 is an integer from 1 to 5, and
* indicates a binding site to a neighboring atom,
a1, a2, a31 to a33, and a4 are each independently an integer from 1 to 20,
R₂ in the number of a2, R₃₁ in the number of a31, R₃₂ in the number of a32, R₃₃ in the number of a33, and R₄ in the number of a4 are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ is:
hydrogen, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group; or
a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

2. The organometallic compound of claim 1, wherein X₁, X₂, and X₃ are each C, and X₄ is N,
a bond between X₁ and M and a bond between X₄ and M are each a coordinate bond, and
a bond between X₂ and M and a bond between X₃ and M are each a covalent bond.

3. The organometallic compound of claim 1, wherein ring CY₁, ring CY₂, ring CY₃₁ to ring CY₃₃, and ring CY₄ are each independently a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group.

4. The organometallic compound of claim 1, wherein R₁, R₂, R₃₁ to R₃₃, and R₄ are each independently:
hydrogen, deuterium, -F, a C₁-C₂₀ alkyl group, or a C₁-C₂₀ alkoxy group;
a C₁-C₂₀ alkyl group or a C₁-C₂₀ alkoxy group, each substituted with deuterium, -F, -CD₃, -CD₂H, -CDH₂, -CF₃, -CF₂H, -CFH₂, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, or a dibenzothiophenyl group, each unsubstituted or substituted with deuterium, -F, -CD₃, -CD₂H, -CDH₂, -CF₃, -CF₂H, -CFH₂, a C₁-C₂₀ alkyl group, a C₁-C₂₀ alkoxy group, a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, a dibenzothiophenyl group, -O(Q₃₁), -S(Q₃₁), -Si(Q₃₁)(Q₃₂)(Q₃₃), - N(Q₃₁)(Q₃₂), or any combination thereof; or
-C(Q₁)(Q₂)(Q₃), -Si(Q₁)(Q₂)(Q₃), or -N(Q₁)(Q₂), and
Q₁ to Q₃ and Q₃₁ to Q₃₃ are each independently: hydrogen, deuterium, -F, a C₁-C₆₀ alkyl group, a C₂-C₆₀ alkenyl group, a C₂-C₆₀ alkynyl group, or a C₁-C₆₀ alkoxy group; or
a C₃-C₆₀ carbocyclic group or a C₁-C₆₀ heterocyclic group, each unsubstituted or substituted with deuterium, -F, a C₁-C₆₀ alkyl group, a C₁-C₆₀ alkoxy group, a phenyl group, a biphenyl group, or any combination thereof.

5. The organometallic compound of claim 1, wherein Z₁ and Z₂ are each independently:
a C₁-C₂₀ alkyl group or a C₁-C₂₀ alkoxy group;
a C₁-C₂₀ alkyl group or a C₁-C₂₀ alkoxy group, each substituted with deuterium, -F, -CD₃, -CD₂H, -CDH₂, -CF₃, -CF₂H, -CFH₂, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, or a dibenzothiophenyl group, each unsubstituted or substituted with deuterium, -F, -CD₃, -CD₂H, -CDH₂, -CF₃, -CF₂H, -CFH₂, a C₁-C₂₀ alkyl group, a C₁-C₂₀ alkoxy group, a cyclopentyl group, a cyclohexyl group, a cycloheptyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a benzimidazolyl group, a benzofuranyl group, a benzothiophenyl group, a dibenzofuranyl group, a dibenzothiophenyl group, -O(Q₃₁), -S(Q₃₁), -Si(Q₃₁)(Q₃₂)(Q₃₃),-N(Q₃₁)(Q₃₂), or any combination thereof; or
-C(Q₁)(Q₂)(Q₃), -Si(Q₁)(Q₂)(Q₃), or -N(Q₁)(Q₂), and
Q₁ to Q₃ and Q₃₁ to Q₃₃ are each independently: hydrogen, deuterium, -F, a C₁-C₆₀ alkyl group, a C₂-C₆₀ alkenyl group, a C₂-C₆₀ alkynyl group, or a C₁-C₆₀ alkoxy group; or a C₃-C₆₀ carbocyclic group or a C₁-C₆₀ heterocyclic group, each unsubstituted or substituted with deuterium, -F, a C₁-C₆₀ alkyl group, a C₁-C₆₀ alkoxy group, a phenyl group, a biphenyl group, or any combination thereof.

6. The organometallic compound of claim 1, wherein a group represented by 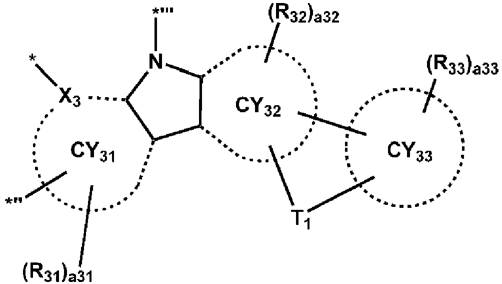 in Formula 1-1 is a group represented by one of Formulae CY3-1(1) to CY3-1(6), and
a group represented by 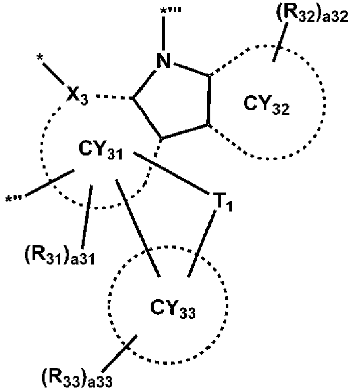 in Formula 1-2 is a group represented by Formula CY3-2(1) or CY3-2(2): 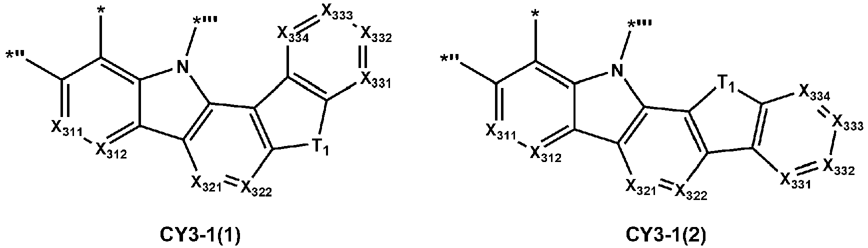 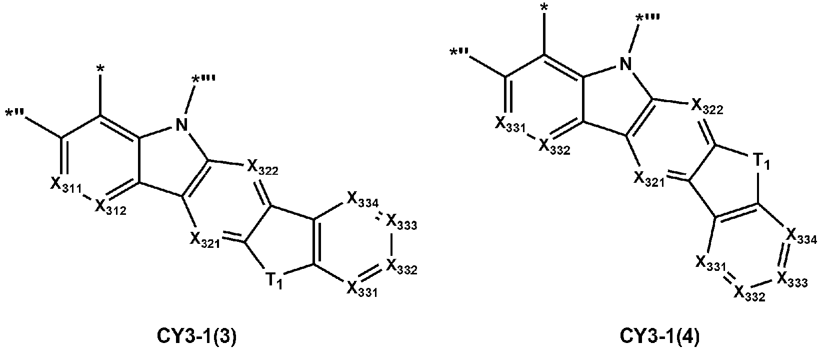 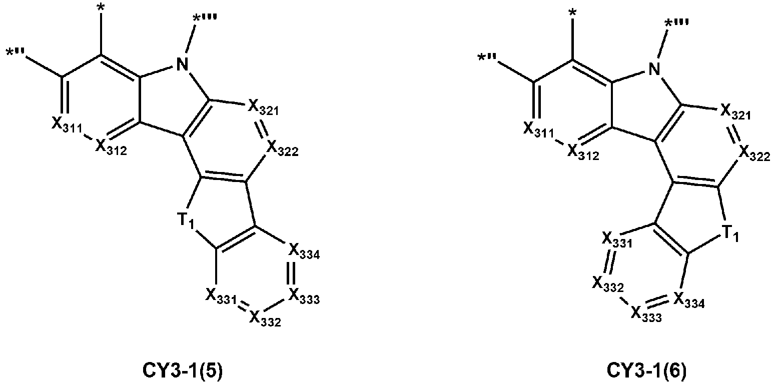 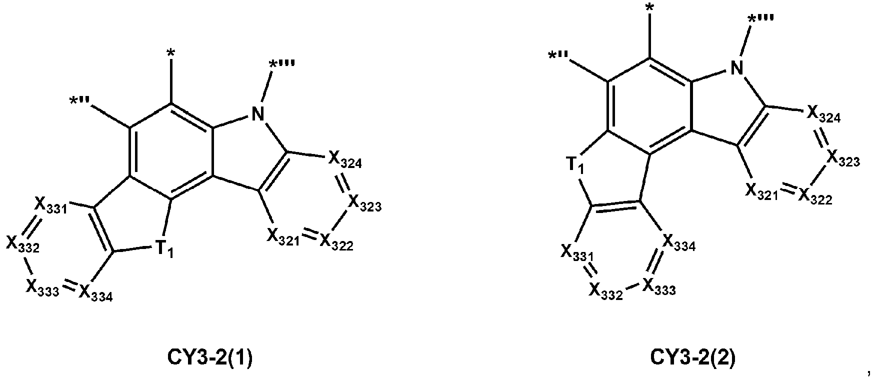 and
wherein, in Formulae CY3-1(1) to CY3-1(6), CY3-2(1), and CY3-2(2),
X₃₁₁ is C(R₃₁₁) or N, and X₃₁₂ is C(R₃₁₂) or N,
X₃₂₁ is C(R₃₂₁) or N, X₃₂₂ is C(R₃₂₂) or N, X₃₂₃ is C(R₃₂₃) or N, and X₃₂₄ is C(R₃₂₄) or N,
X₃₃₁ is C(R₃₃₁) or N, X₃₃₂ is C(R₃₃₂) or N, X₃₃₃ is C(R₃₃₃) or N, and X₃₃₄ is C(R₃₃₄) or N,
T₁ is as defined in Formula 1-1 or Formula 1-2,
R₃₁₁ and R₃₁₂ are each defined as in connection with R₃₁ in Formula 1-1 or Formula 1-2,
R₃₂₁ to R₃₂₄ are each defined as in connection with R₃₂ in Formula 1-1 or Formula 1-2,
R₃₃₁ to R₃₃₄ are each defined as in connection with R₃₃ in Formula 1-1 or Formula 1-2,
two or more neighboring groups of R₃₁₁, R₃₁₂, R₃₂₁ to R₃₂₄, and R₃₃₁ to R₃₃₄ are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
* indicates a binding site to M in Formula 1-1 or Formula 1-2,
*" indicates a binding site to L₂ in Formula 1-1 or Formula 1-2, and
*"' indicates a binding site to L₃ in Formula 1-1 or Formula 1-2.

7. The organometallic compound of claim 1, wherein,
in Formulae 1-1 and 1-2,
a group represented by 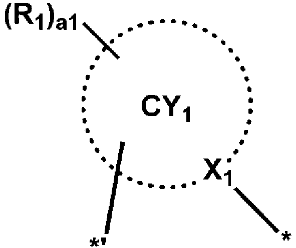 is a group represented by one of Formulae CY1(1) to CY1(11),
a group represented by 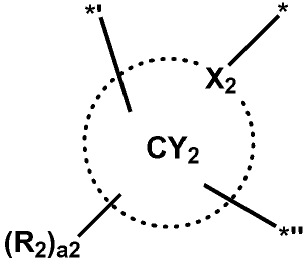 is a group represented by one of Formulae CY2(1) to CY2(13), and
a group represented by 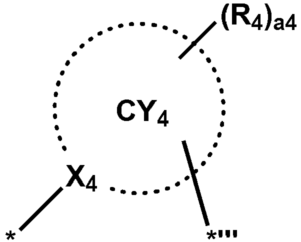 is a group represented by one of Formulae CY4(1) to CY4(29): 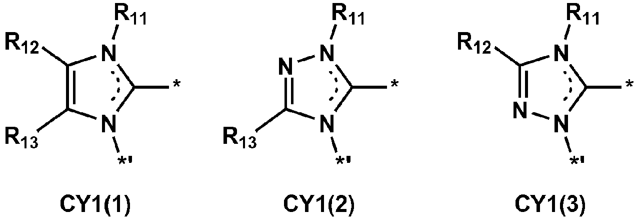 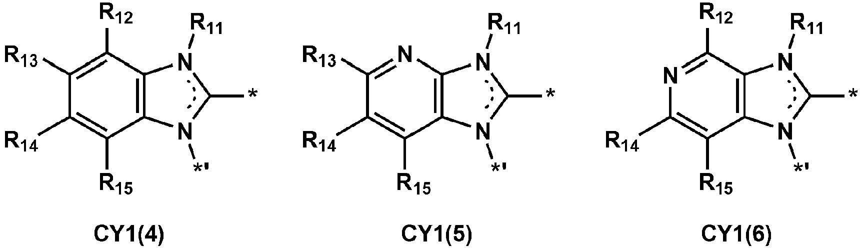 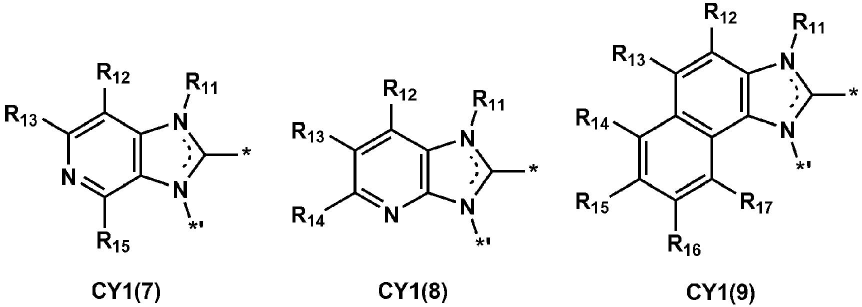 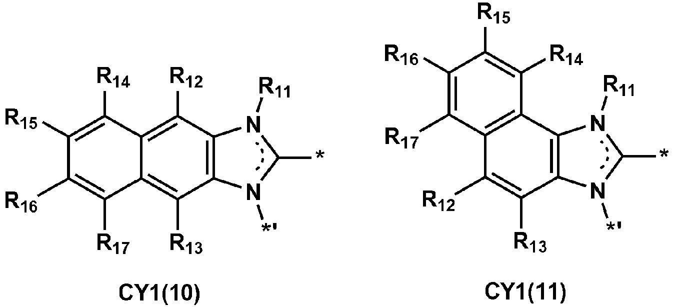 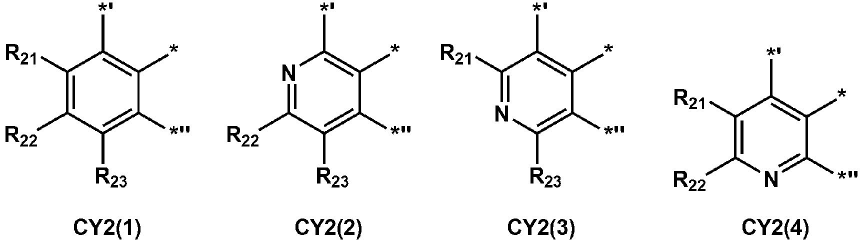 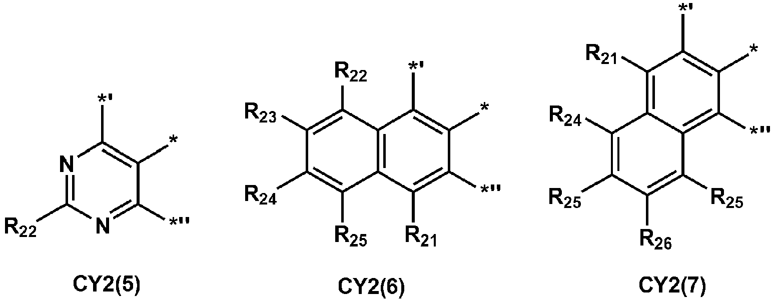 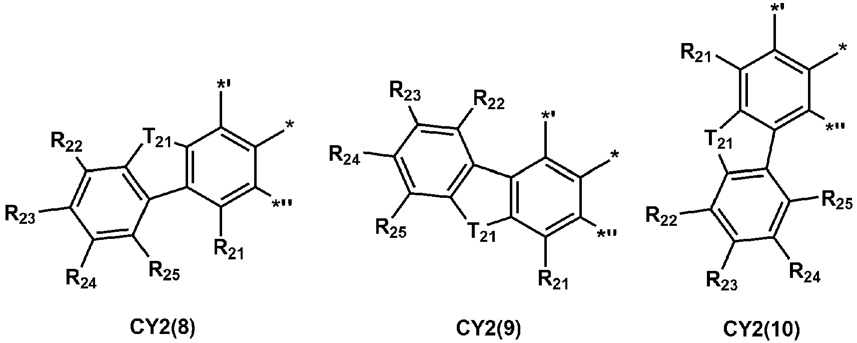 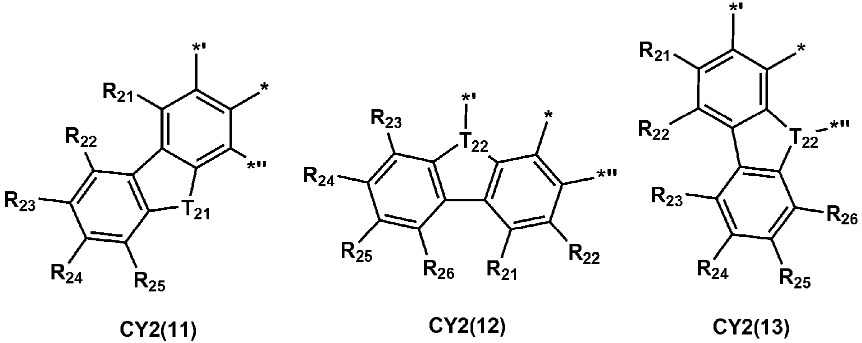 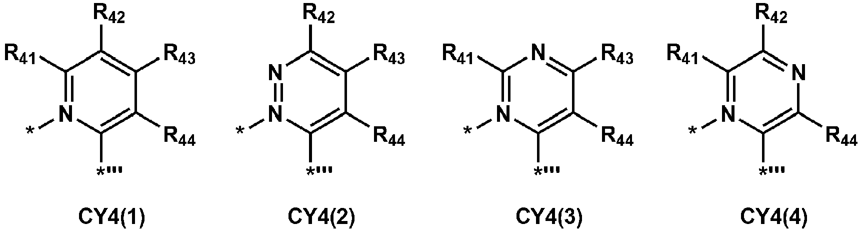 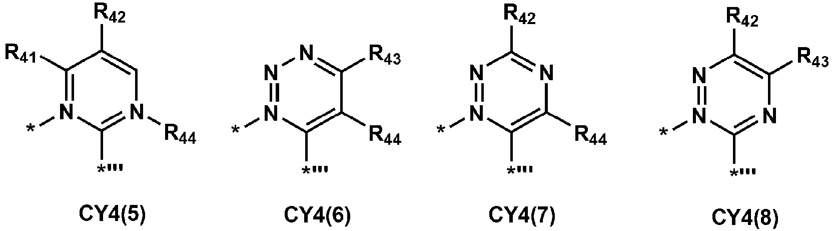 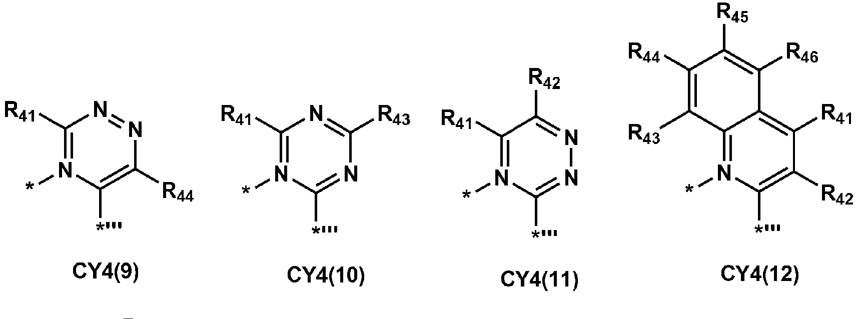 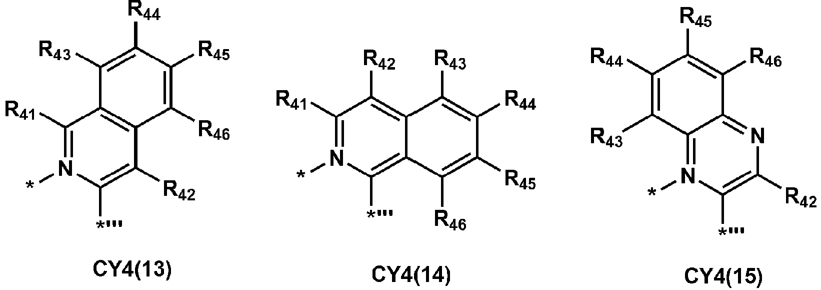 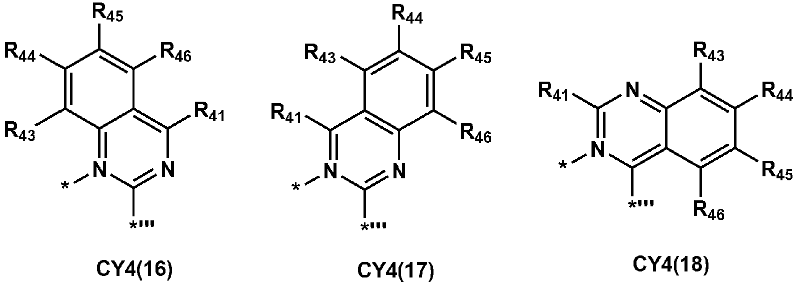 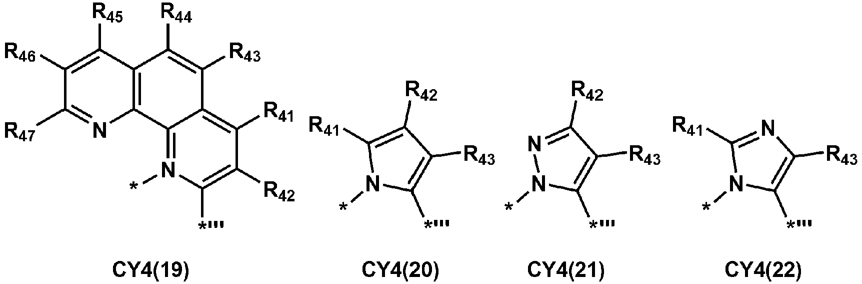 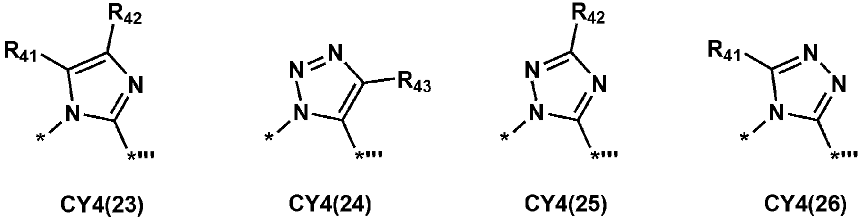 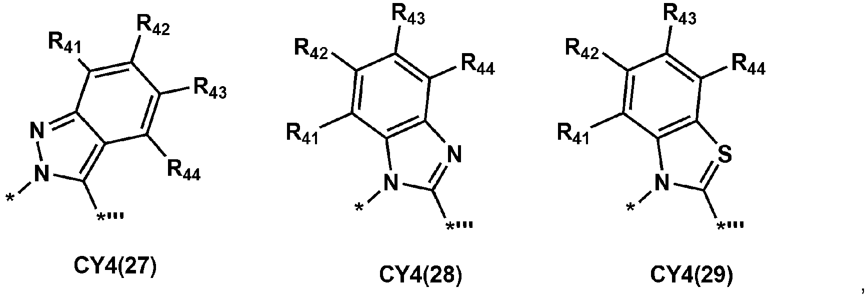 and
wherein, in Formulae CY1(1) to CY1(11), CY2(1) to CY2(13), and CY4(1) to CY4(29),
T₂₁ is B(Y₂₁), C(Y₂₁)(Y₂₂), N(Y₂₁), O, S, or Si(Y₂₁)(Y₂₂),
T₂₂ is C(Y₂₁), N, or Si(Y₂₁),
R₁₁ to R₁₇ are each defined as in connection with R₁ in Formula 1-1 or Formula 1-2,
R₂₁ to R₂₆, Y₂₁, and Y₂₂ are each defined as in connection with R₂ in Formula 1-1 or Formula 1-2, R₄₁ to R₄₇ are each defined as in connection with R₄ in Formula 1-1 or Formula 1-2,* indicates a binding site to M in Formula 1-1 or Formula 1-2,
*' indicates a binding site to L₁ in Formula 1-1 or Formula 1-2,
*" indicates a binding site to L₂ in Formula 1-1 or Formula 1-2, and
*"' indicates a binding site to L₃ in Formula 1-1 or Formula 1-2.

8. The organometallic compound of claim 1, wherein the organometallic compound represented by Formula 1-1 is a group represented by Formula 1-1(A1) or 1-1(A2), or
the organometallic compound represented by Formula 1-2 is a group represented by Formula 1-2(A1) or 1-2(A2): 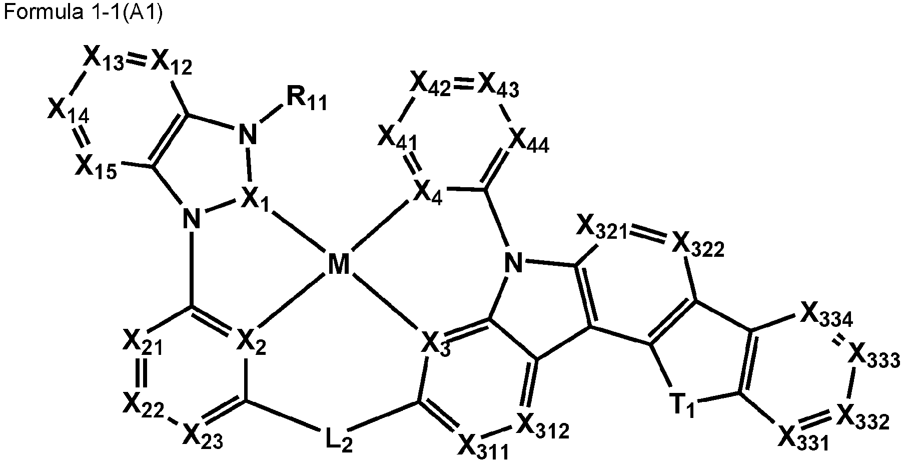 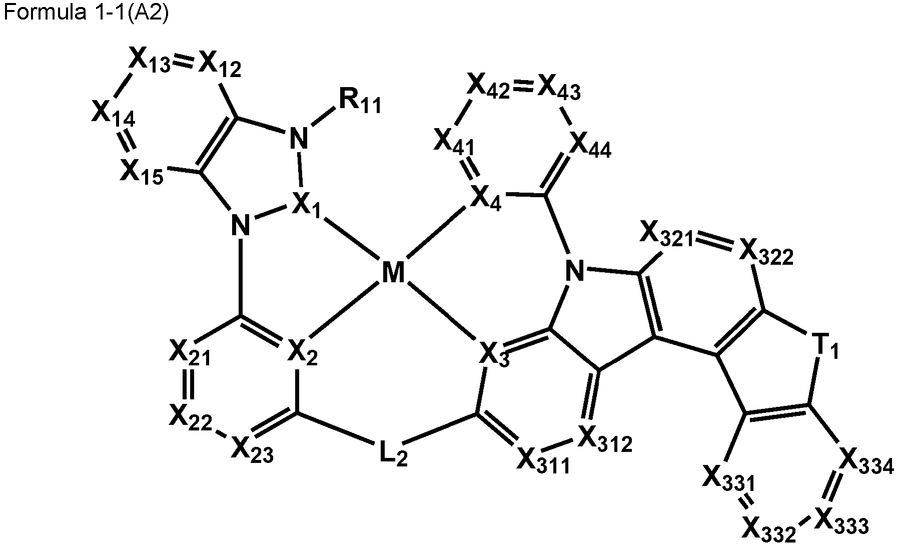 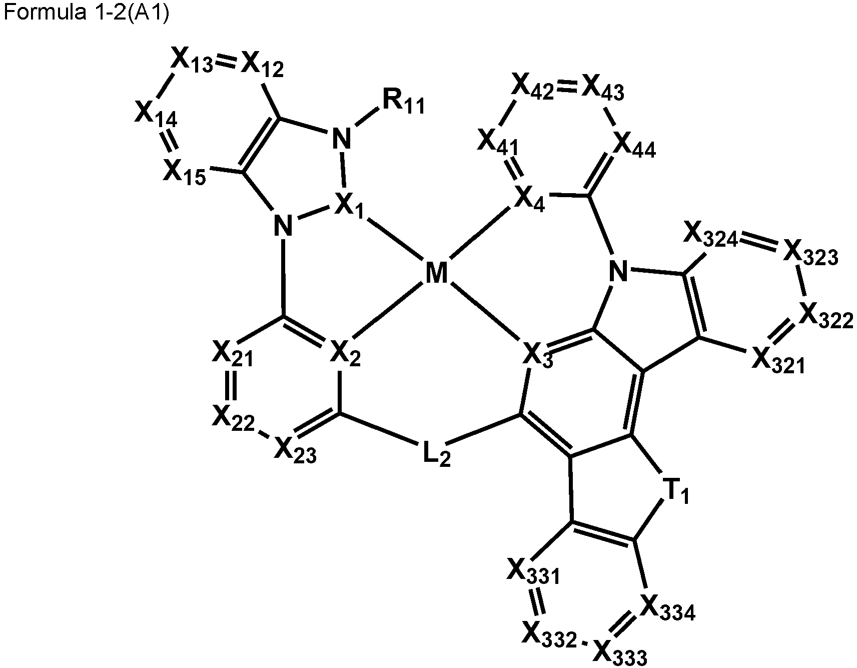 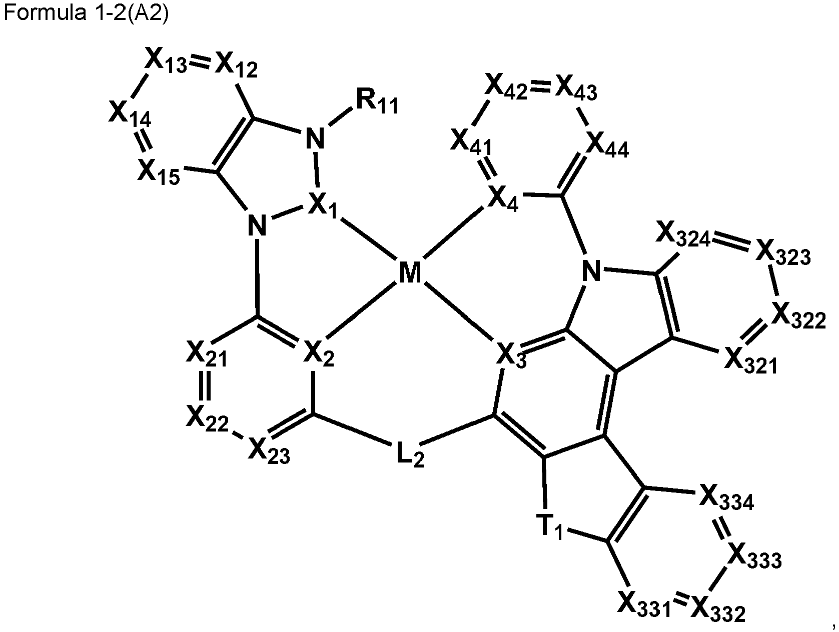 and
wherein, in Formulae 1-1(A1), 1-1(A2), 1-2(A1), and 1-2(A2),
M, X₁ to X₄, and T₁ are each as defined in Formula 1-1 or Formula 1-2,
L₂ is *-O-*', *-S-*', or *-Se-*',
X₁₂ is C(R₁₂) or N, X₁₃ is C(R₁₃) or N, X₁₄ is C(R₁₄) or N, and X₁₅ is C(R₁₅) or N,
X₂₁ is C(R₂₁) or N, X₂₂ is C(R₂₂) or N, and X₂₃ is C(R₂₃) or N,
X₃₁₁ is C(R₃₁₁) or N, X₃₁₂ is C(R₃₁₂) or N, X₃₂₁ is C(R₃₂₁) or N, X₃₂₂ is C(R₃₂₂) or N, X₃₂₃ is C(R₃₂₃) or N, X₃₂₄ is C(R₃₂₄) or N, X₃₃₁ is C(R₃₃₁) or N, X₃₃₂ is C(R₃₃₂) or N, X₃₃₃ is C(R₃₃₃) or N, and X₃₃₄ is C(R₃₃₄) or N,
X41 is C(R₄₁) or N, X₄₂ is C(R₄₂) or N, X₄₃ is C(R₄₃) or N, and X₄₄ is C(R₄₄) or N,
R₁₁ to R₁₅ are each defined as in connection with R₁ in Formula 1-1 or Formula 1-2,
R₂₁ to R₂₃ are each defined as in connection with R₂ in Formula 1-1 or Formula 1-2,
R₃₁₁ and R₃₁₂ are each defined as in connection with R₃₁ in Formula 1-1 or Formula 1-2,
R₃₂₁ to R₃₂₄ are each defined as in connection with R₃₂ in Formula 1-1 or Formula 1-2,
R₃₃₁ to R₃₃₄ are each defined as in connection with R₃₃ in Formula 1-1 or Formula 1-2,
R₄₁ to R₄₄ are each defined as in connection with R₄ in Formula 1-1 or Formula 1-2,
two or more neighboring groups of R₁₁ to R₁₅, R₂₁ to R₂₃, R₃₁₁, R₃₁₂, R₃₂₁ to R₃₂₄, R₃₃₁ to R₃₃₄, R₄₁ to R₄₄, Z₁, and Z₂ are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and
R₁₀ₐ is as defined in Formula 1-1 or Formula 1-2.

9. The organometallic compound of claim 1, wherein the organometallic compound is selected from among Compounds 1 to 72:

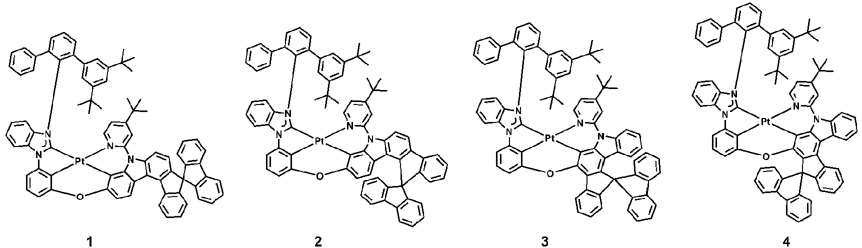

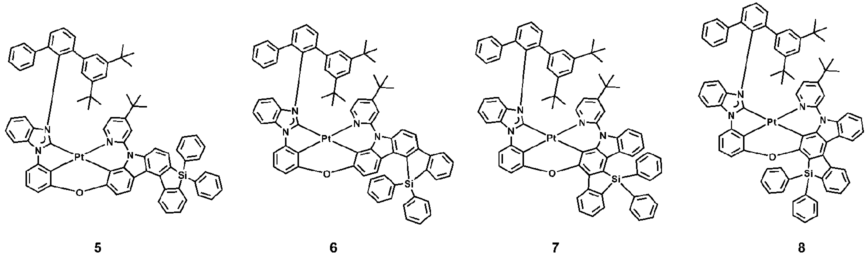

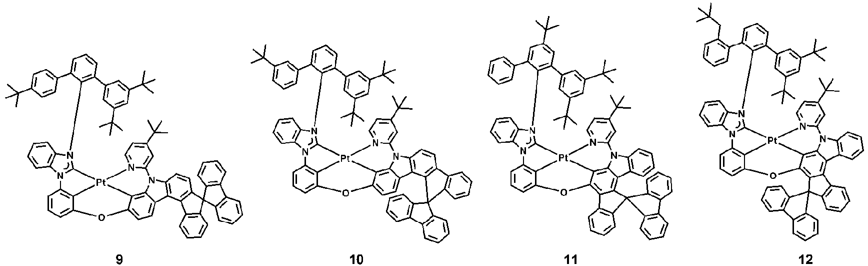

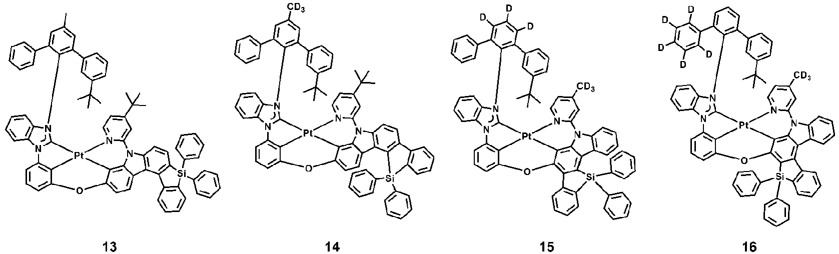

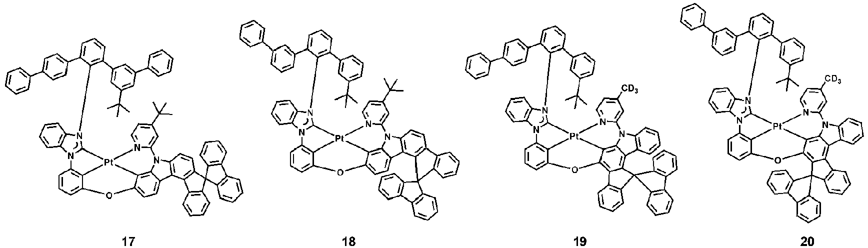

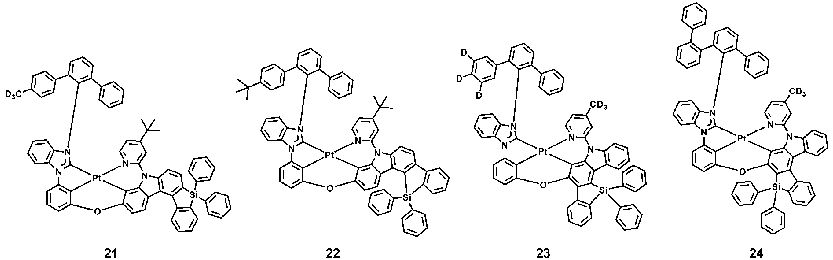

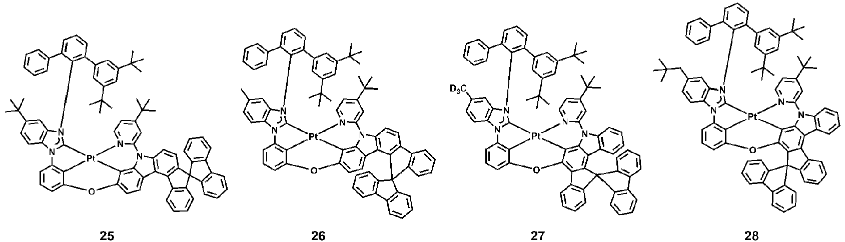

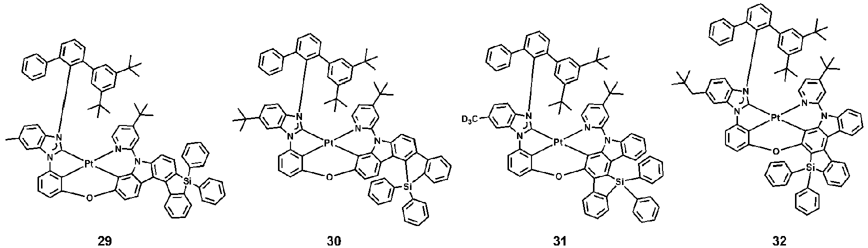

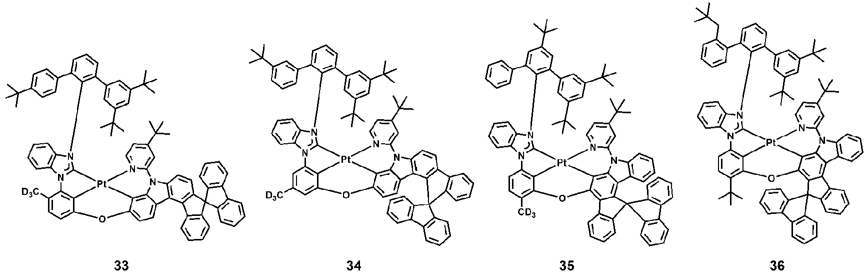

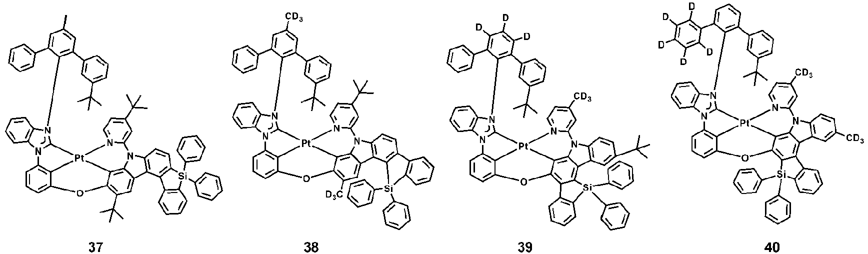

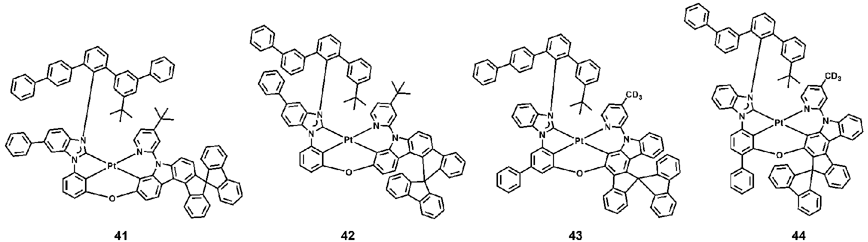

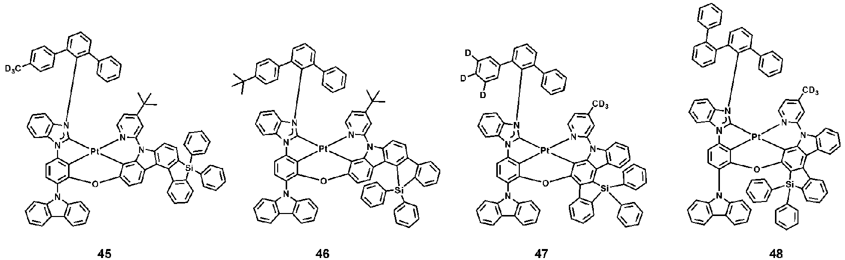

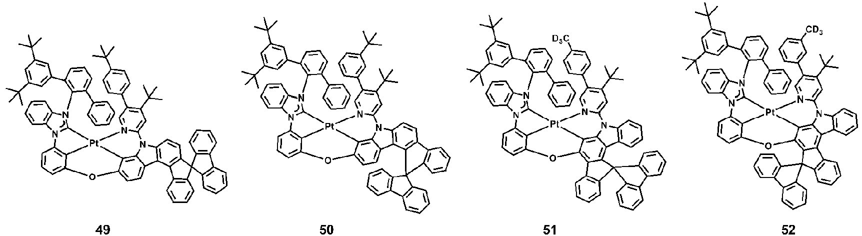

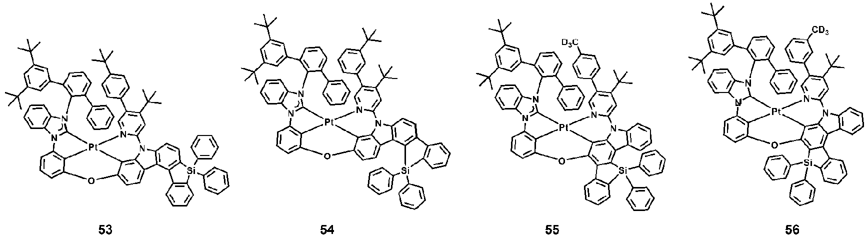

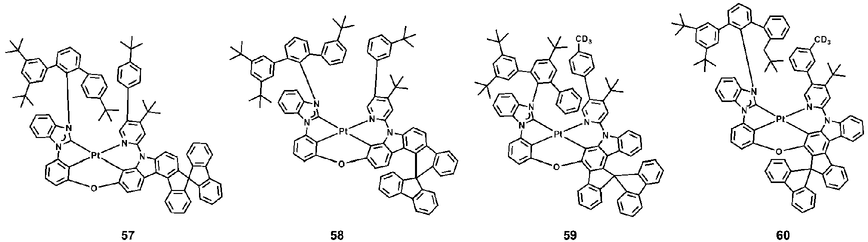

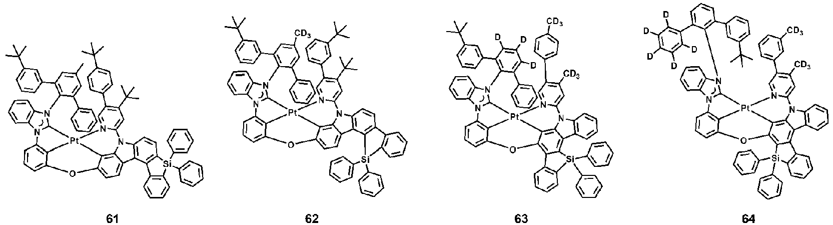

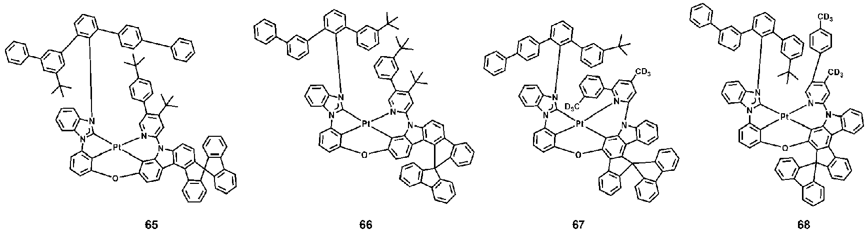

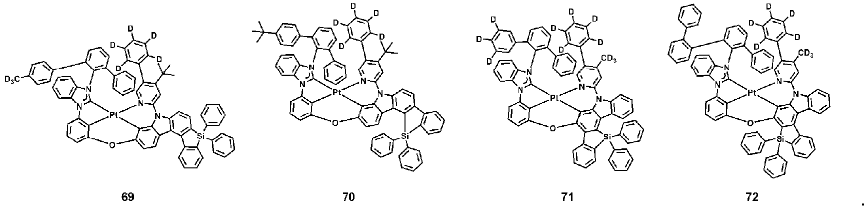

10. A light-emitting device (10) comprising:
a first electrode (110);
a second electrode (150) facing the first electrode (110);
an interlayer (130) between the first electrode (110) and the second electrode (150) and comprising an emission layer; **characterized in that** the light-emitting device (10) comprises
an organometallic compound of claim 1.

11. The light-emitting device (10) of claim 10, wherein the emission layer comprises a host and a dopant, and
the dopant comprises the organometallic compound.

12. The light-emitting device (10) of claim 10 or 11, further comprising a second compound comprising at least one heterocyclic group having 1 to 60 carbon atoms and including *-N=*' as a ring-forming moiety, a third compound comprising a group represented by Formula 3, a fourth compound to emit delayed fluorescence, or any combination thereof,
wherein the organometallic compound, the second compound, the third compound, and the fourth compound are different from each other: 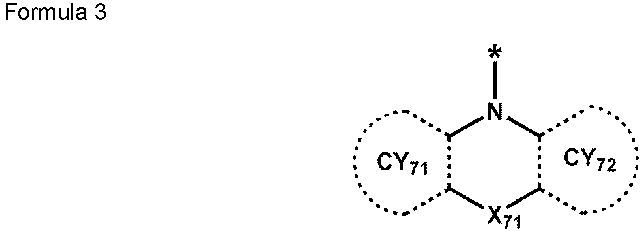
wherein, in Formula 3,
ring CY₇₁ and ring CY₇₂ are each independently a cyclic group having 3 to 60 carbon atoms and not including *-N=*' as a ring-forming moiety or a pyridine group,
X₇₁ is a single bond, or a linking group comprising O, S, N, B, C, Si, or any combination thereof, and
* indicates a binding site to any atom included in a remaining portion of the third compound other than the group represented by Formula 3.

13. The light-emitting device (10) of claim 12, wherein the second compound comprises a pyridine group, a pyrimidine group, a pyrazine group, a pyridazine group, a triazine group, or any combination thereof, and
the fourth compound is a compound comprising a cyclic group comprising boron (B) and nitrogen (N) as ring-forming atoms.

14. The light-emitting device (10) of claim 12, wherein the emission layer comprises:
i) the organometallic compound; and
ii) the second compound, the third compound, the fourth compound, or any combination thereof, and
the emission layer is configured to emit blue light.

15. An electronic apparatus comprising the light-emitting device (10) of claim 10.

16. The electronic apparatus of claim 15, further comprising a thin-film transistor (TFT),
wherein the thin-film transistor (TFT) comprises a source electrode (260) and a drain electrode (270), and
the first electrode (110) of the light-emitting device (10) is electrically connected to the source electrode (260) or the drain electrode (270) of the thin-film transistor (TFT).

17. The electronic apparatus of claim 15, further comprising a color filter, a color-conversion layer, a touch screen layer, a polarizing layer, or any combination thereof.

18. An electronic equipment comprising the light-emitting device (10) of claim 10.

19. The electronic equipment of claim 18, wherein the electronic equipment is at least one selected from among a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, a signboard, and combinations thereof.

## Patentansprüche

1. Organometallische Verbindung, dargestellt durch Formel 1-1 oder Formel 1-2: 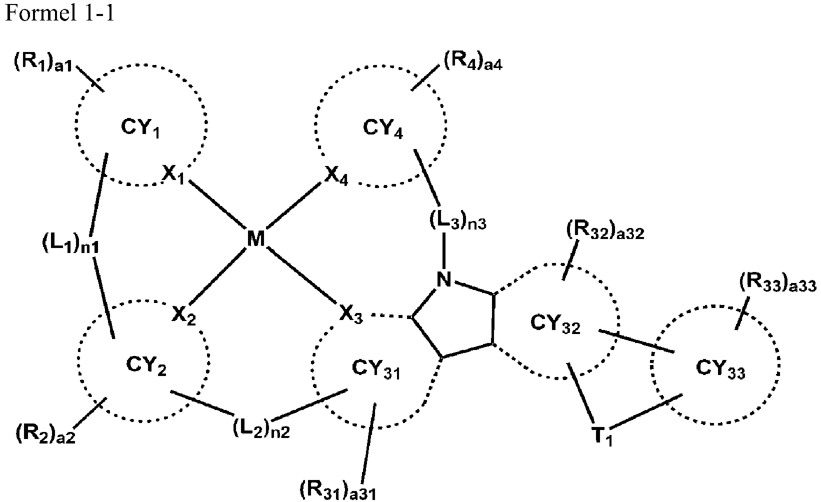 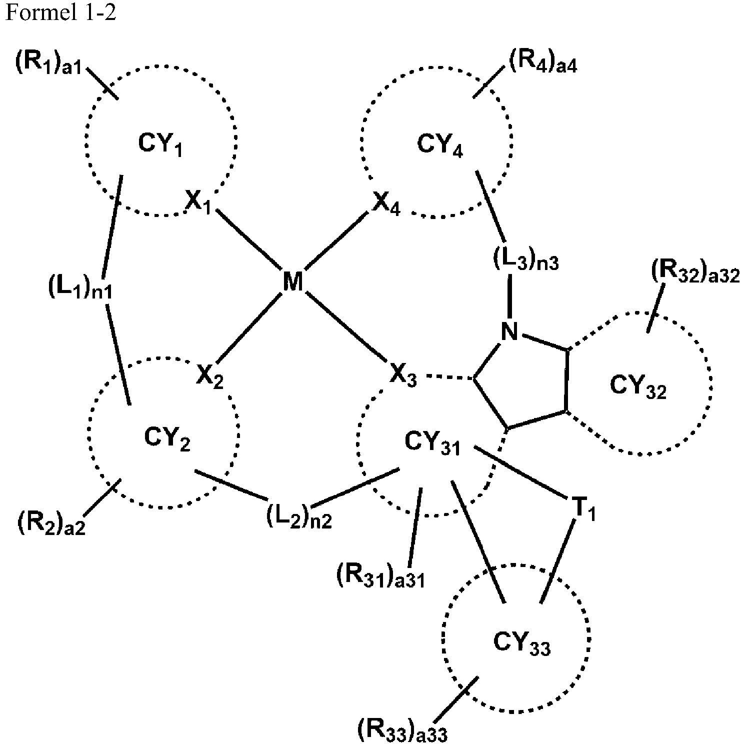 wobei in den Formeln 1-1 und 1-2
M Platin (Pt), Palladium (Pd), Kupfer (Cu), Silber (Ag), Gold (Au), Rhodium (Rh), Ruthenium (Ru), Osmium (Os), Titan (Ti), Zirconium (Zr), Hafnium (Hf), Europium (Eu), Terbium (Tb) oder Thulium (Tm) ist,
X₁ bis X₄ jeweils unabhängig C oder N sind,
Ring CY₁, Ring CY₂, Ring CY₃₁ bis Ring CY₃₃ und Ring CY₄ jeweils unabhängig eine carbocyclische C₃-C₃₀-Gruppe oder eine heterocyclische C₁-C₃₀-Gruppe sind,
L₁ bis L₃ jeweils unabhängig eine Einfachbindung, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Al(R₁ₐ)-*', *-Si(R₁ₐ)(R_{1b})-*', *-P(=O)(R₁ₐ)-*', *-S-*', *-S(=O)-*', *-S(=O)₂-*' oder *-Ge(R₁ₐ)(R_{1b})-*' sind, wobei * und *' jeweils eine Bindungsstelle an ein benachbartes Atom angeben,
n1 bis n3 jeweils unabhängig eine ganze Zahl von 1 bis 5 sind,
in den Formeln 1-1 und 1-2 T₁ eine Gruppe ist, dargestellt durch Formel T-1 oder T-2: 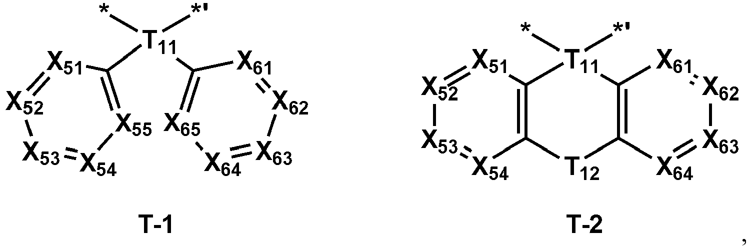 und
wobei in den Formeln T-1 und T-2
T₁₁ C, Si oder Ge ist,
T₁₂ eine Einfachbindung, *-C(Z₃)(Z₄)-*', *-Si(Z₃)(Z₄)-*' oder *-Ge(Z₃)(Z₄)-*' ist, wobei * und *' jeweils eine Bindungsstelle an ein benachbartes Atom angeben,
X₅₁ C(Z₁₁) oder N ist, X₅₂ C(Z₁₂) oder N ist, X₅₃ C(Z₁₃) oder N ist, X₅₄ C(Z₁₄) oder N ist und X₅₅ C(Z₁₅) oder N ist,
X₆₁ C(Z₂₁) oder N ist, X₆₂ C(Z₂₂) oder N ist, X₆₃ C(Z₂₃) oder N ist, X₆₄ C(Z₂₄) oder N ist und X₆₅ C(Z₂₅) oder N ist,
Z₁₁ bis Z₁₅ und Z₃, Z₂₁ bis Z₂₅ und Z₄ jeweils unabhängig eine C₁-C₆₀-Alkylgruppe, unsubstituiert oder mit mindestens einem R₁₀ₐ substituiert, eine C₂-C₆₀-Alkenylgruppe, unsubstituiert oder mit mindestens einem R₁₀ₐ substituiert, eine C₂-C₆₀-Alkinylgruppe, unsubstituiert oder mit mindestens einem R₁₀ₐ substituiert, eine C₁-C₆₀-Alkoxygruppe, unsubstituiert oder mit mindestens einem R₁₀ₐ substituiert, eine C₁-C₆₀-Alkylthiogruppe, unsubstituiert oder mit mindestens einem R₁₀ₐ substituiert, eine carbocyclische C₃-C₆₀-Gruppe, unsubstituiert oder mit mindestens einem R₁₀ₐ substituiert, eine heterocyclische C₁-C₆₀-Gruppe, unsubstituiert oder mit mindestens einem R₁₀ₐ substituiert, eine C₆-C₆₀-Aryloxygruppe, unsubstituiert oder mit mindestens einem R₁₀ₐ substituiert, eine C₆-C₆₀-Arylthiogruppe, unsubstituiert oder mit mindestens einem R₁₀ₐ substituiert, -C(Q₁)(Q₂)(Q₃),-Si(Q₁)(Q₂)(Q₃), -N(Q₁)(Q₂), -B(Q₁)(Q₂), -C(=O)(Q₁), -S(=O)₂(Q₁) oder -P(=O)(Q₁)(Q₂) SIND,
zwei oder mehr benachbarte Gruppen von Z₁₁ bis Z₁₅, Z₂₁ bis Z₂₅, Z₃ und Z₄ optional miteinander verbunden sind, um eine carbocyclische C₃-C₆₀-Gruppe, unsubstituiert oder mit mindestens einem R₁₀ₐ substituiert, oder eine heterocyclische C₁-C₆₀-Gruppe, unsubstituiert oder mit mindestens einem R₁₀ₐ substituiert, zu bilden, und
* und *' jeweils eine Bindungsstelle an ein benachbartes Atom angeben,
R₁, R₂, R₃₁ bis R₃₃, R₄, R₁ₐ und R_{1b} jeweils unabhängig Wasserstoff, Deuterium, -F, -Cl,-Br, -I, eine Hydroxylgruppe, eine Cyanogruppe, eine Nitrogruppe, eine C₁-C₆₀-Alkylgruppe, unsubstituiert oder mit mindestens einem R₁₀ₐ substituiert, eine C₂-C₆₀-Alkenylgruppe, unsubstituiert oder mit mindestens einem R₁₀ₐ substituiert, eine C₂-C₆₀-Alkinylgruppe, unsubstituiert oder mit mindestens einem R₁₀ₐ substituiert, eine C₁-C₆₀-Alkoxygruppe, unsubstituiert oder mit mindestens einem R₁₀ₐ substituiert, eine C₁-C₆₀-Alkylthiogruppe, unsubstituiert oder mit mindestens einem R₁₀ₐ substituiert, eine carbocyclische C₃-C₆₀-Gruppe, unsubstituiert oder mit mindestens einem R₁₀ₐ substituiert, eine heterocyclische C₁-C₆₀-Gruppe, unsubstituiert oder mit mindestens einem R₁₀ₐ substituiert, eine C₆-C₆₀-Aryloxygruppe, unsubstituiert oder mit mindestens einem R₁₀ₐ substituiert, eine C₆-C₆₀-Arylthiogruppe, unsubstituiert oder mit mindestens einem R₁₀ₐ substituiert, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁) oder -P(=O)(Q₁)(Q₂) SIND,
mindestens ein R₁ eine Gruppe ist, dargestellt durch Formel S1: 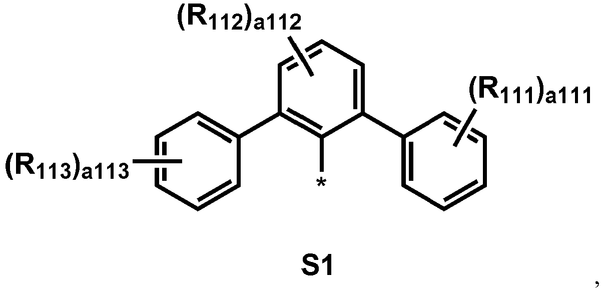 und
wobei in Formel S1
R₁₁₁ bis R₁₁₃ jeweils wie in Verbindung mit R₁ in Formel 1-1 oder Formel 1-2 definiert sind,
a111 eine ganze Zahl von 1 bis 5 ist,
a112 eine ganze Zahl von 1 bis 3 ist,
a113 eine ganze Zahl von 1 bis 5 ist und
* eine Bindungsstelle an ein benachbartes Atom angibt,
a1, a2, a31 bis a33 und a4 jeweils unabhängig eine ganze Zahl von 1 bis 20 sind,
R₂ in der Anzahl von a2, R₃₁ in der Anzahl von a31, R₃₂ in der Anzahl von a32, R₃₃ in der Anzahl von a33 und R₄ in der Anzahl von a4 optional miteinander verbunden sind, um eine carbocyclische C₃-C₆₀-Gruppe, unsubstituiert oder mit mindestens einem R₁₀ₐ substituiert, oder eine heterocyclische C₁-C₆₀-Gruppe, unsubstituiert oder mit mindestens einem R₁₀ₐ substituiert, zu bilden,
R₁₀ₐ Folgendes ist:
Wasserstoff, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils unsubstituiert oder substituiert mit Deuterium, -F, -Cl, -Br, -I, einer Hydroxylgruppe, einer Cyanogruppe, einer Nitrogruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁),-P(=O)(Q₁₁)(Q₁₂) oder jeder Kombination davon;
eine carbocyclische C₃-C₆₀-Gruppe, eine heterocyclische C₁-C₆₀-Gruppe, eine C₆-C₆₀-Aryloxygruppe oder eine C₆-C₆₀-Arylthiogruppe, jeweils unsubstituiert oder substituiert mit Deuterium, -F, -Cl, -Br, -I, einer Hydroxylgruppe, einer Cyanogruppe, einer Nitrogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer carbocyclischen C₃-C₆₀-Gruppe, einer heterocyclischen C₁-C₆₀-Gruppe, einer C₆-C₆₀-Aryloxygruppe, einer C₆-C₆₀-Arylthiogruppe, -Si(Q₂₁)(Q₂₂)(Q₂₃), -N(Q₂₁)(Q₂₂),-B(Q₂₁)(Q₂₂), - C(=O)(Q₂₁), -S(=O)₂(Q₂₁), -P(=O)(Q₂₁)(Q₂₂) oder jeder Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder-P(=O)(Q₃₁)(Q₃₂), und
Q₁ bis Q₃, Q₁₁ bis Q₁₃, Q₂₁ bis Q₂₃ und Q₃₁ bis Q₃₃ jeweils unabhängig Folgendes sind: Wasserstoff, Deuterium, -F, -Cl, -Br, -I, eine Hydroxylgruppe, eine Cyanogruppe, eine Nitrogruppe, eine C₁-C₆₀-Alkylgruppe, eine C₂-C₆₀-Alkenylgruppe, eine C₂-C₆₀-Alkinylgruppe oder eine C₁-C₆₀-Alkoxygruppe; oder
eine carbocyclische C₃-C₆₀-Gruppe oder eine heterocyclische C₁-C₆₀-Gruppe, jeweils unsubstituiert oder substituiert mit Deuterium, -F, einer Cyanogruppe, einer C₁-C₆₀-Alkylgruppe, einer C₁-C₆₀-Alkoxygruppe, einer Phenylgruppe, einer Biphenylgruppe oder jeder Kombination davon.

2. Organometallische Verbindung nach Anspruch 1, wobei X₁, X₂ und X₃ jeweils C sind und X₄ N ist,
eine Bindung zwischen X₁ und M und eine Bindung zwischen X₄ und M jeweils eine koordinative Bindung sind und
eine Bindung zwischen X₂ und M und eine Bindung zwischen X₃ und M jeweils eine kovalente Bindung sind.

3. Organometallische Verbindung nach Anspruch 1, wobei Ring CY₁, Ring CY₂, Ring CY₃₁ bis Ring CY₃₃ und Ring CY₄ jeweils unabhängig eine Benzolgruppe, eine Naphthalingruppe, eine Anthracengruppe, eine Phenanthrengruppe, eine Triphenylengruppe, eine Pyrengruppe, eine Chrysengruppe, eine Cyclopentadiengruppe, eine Furangruppe, eine Thiophengruppe, eine Silolgruppe, eine Indengruppe, eine Fluorengruppe, eine Indolgruppe, eine Carbazolgruppe, eine Benzofurangruppe, eine Dibenzofurangruppe, eine Benzothiophengruppe, eine Dibenzothiophengruppe, eine Benzosilolgruppe, eine Dibenzosilolgruppe, eine Azafluorengruppe, eine Azacarbazolgruppe, eine Azadibenzofurangruppe, eine Azadibenzothiophengruppe, eine Azadibenzosilolgruppe, eine Pyridingruppe, eine Pyrimidingruppe, eine Pyrazingruppe, eine Pyridazingruppe, eine Triazingruppe, eine Chinolingruppe, eine Isochinolingruppe, eine Chinoxalingruppe, eine Chinazolingruppe, eine Phenanthrolingruppe, eine Pyrrolgruppe, eine Pyrazolgruppe, eine Imidazolgruppe, eine Triazolgruppe, eine Oxazolgruppe, eine Isoxazolgruppe, eine Thiazolgruppe, eine Isothiazolgruppe, eine Oxadiazolgruppe, eine Thiadiazolgruppe, eine Benzopyrazolgruppe, eine Benzimidazolgruppe, eine Benzoxazolgruppe, eine Benzothiazolgruppe, eine Benzoxadiazolgruppe, eine Benzothiadiazolgruppe, eine Dibenzooxasilingruppe, eine Dibenzothiasilingruppe, eine Dibenzodihydroazasilingruppe, eine Dibenzodihydrodisilingruppe, eine Dibenzodihydrosilingruppe, eine Dibenzodioxingruppe, eine Dibenzooxathiingruppe, eine Dibenzooxazingruppe, eine Dibenzopyrangruppe, eine Dibenzodithiingruppe, eine Dibenzothiazingruppe, eine Dibenzothiopyrangruppe, eine Dibenzocyclohexadiengruppe, eine Dibenzodihydropyridingruppe oder eine Dibenzodihydropyrazingruppe sind.

4. Organometallische Verbindung nach Anspruch 1, wobei R₁, R₂, R₃₁ bis R₃₃ und R₄ jeweils unabhängig Folgendes sind:
Wasserstoff, Deuterium, -F, eine C₁-C₂₀-Alkylgruppe oder eine C₁-C₂₀-Alkoxygruppe;
eine C₁-C₂₀-Alkylgruppe oder eine C₁-C₂₀-Alkoxygruppe, jeweils substituiert mit Deuterium, -F, -CD₃, -CD₂H, -CDH₂, -CF₃, -CF₂H, -CFH₂, einer C₁-C₁₀-Alkylgruppe, einer Cyclopentylgruppe, einer Cyclohexylgruppe, einer Cycloheptylgruppe, einer Cyclopentenylgruppe, einer Cyclohexenylgruppe, einer Cycloheptenylgruppe, einer Phenylgruppe, einer Biphenylgruppe, einer Naphthylgruppe, einer Pyridinylgruppe, einer Pyrimidinylgruppe oder jeder Kombination davon;
eine Cyclopentylgruppe, eine Cyclohexylgruppe, eine Cycloheptylgruppe, eine Cyclopentenylgruppe, eine Cyclohexenylgruppe, eine Cycloheptenylgruppe, eine Phenylgruppe, eine Biphenylgruppe, eine C₁-C₁₀-Alkylphenylgruppe, eine Naphthylgruppe, eine Fluorenylgruppe, eine Phenanthrenylgruppe, eine Anthracenylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalingruppe, eine Chinazolinylgruppe, eine Cinnolinylgruppe, eine Carbazolylgruppe, eine Benzimidazolylgruppe, eine Benzofuranylgruppe, eine Benzothiophenylgruppe, eine Dibenzofuranylgruppe oder eine Dibenzothiophenylgruppe, jeweils unsubstituiert oder substituiert mit Deuterium, -F, -CD₃, -CD₂H, -CDH₂, -CF₃, -CF₂H, -CFH₂, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Cycloheptenylgruppe, einer Phenylgruppe, einer Biphenylgruppe, einer C₁-C₁₀-Alkylphenylgruppe, einer Naphthylgruppe, einer Fluorenylgruppe, einer Phenanthrenylgruppe, einer Anthracenylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Benzimidazolylgruppe, einer Benzofuranylgruppe, einer Benzothiophenylgruppe, einer Dibenzofuranylgruppe, einer Dibenzothiophenylgruppe, -O(Q₃₁), -S(Q₃₁), -Si(Q₃₁)(Q₃₂)(Q₃₃), -N(Q₃₁)(Q₃₂) oder jeder Kombination davon; oder
-C(Q₁)(Q₂)(Q₃), -Si(Q₁)(Q₂)(Q₃) oder -N(Q₁)(Q₂), und
Q₁ bis Q₃ und Q₃₁ bis Q₃₃ jeweils unabhängig Folgendes sind: Wasserstoff, Deuterium,-F, eine C₁-C₆₀-Alkylgruppe, eine C₂-C₆₀-Alkenylgruppe, eine C₂-C₆₀-Alkinylgruppe oder eine C₁-C₆₀-Alkoxygruppe; oder
eine carbocyclische C₃-C₆₀-Gruppe oder eine heterocyclische C₁-C₆₀-Gruppe, jeweils unsubstituiert oder substituiert mit Deuterium, -F, einer C₁-C₆₀-Alkylgruppe, einer C₁-C₆₀-Alkoxygruppe, einer Phenylgruppe, einer Biphenylgruppe oder jeder Kombination davon.

5. Organometallische Verbindung nach Anspruch 1, wobei Z₁ und Z₂ jeweils unabhängig Folgendes sind:
eine C₁-C₂₀-Alkylgruppe oder eine C₁-C₂₀-Alkoxygruppe;
eine C₁-C₂₀-Alkylgruppe oder eine C₁-C₂₀-Alkoxygruppe, jeweils substituiert mit Deuterium, -F, -CD₃, -CD₂H, -CDH₂, -CF₃, -CF₂H, -CFH₂, einer C₁-C₁₀-Alkylgruppe, einer Cyclopentylgruppe, einer Cyclohexylgruppe, einer Cycloheptylgruppe, einer Cyclopentenylgruppe, einer Cyclohexenylgruppe, einer Cycloheptenylgruppe, einer Phenylgruppe, einer Biphenylgruppe, einer Naphthylgruppe, einer Pyridinylgruppe, einer Pyrimidinylgruppe oder jeder Kombination davon;
eine Cyclopentylgruppe, eine Cyclohexylgruppe, eine Cycloheptylgruppe, eine Cyclopentenylgruppe, eine Cyclohexenylgruppe, eine Cycloheptenylgruppe, eine Phenylgruppe, eine Biphenylgruppe, eine C₁-C₁₀-Alkylphenylgruppe, eine Naphthylgruppe, eine Fluorenylgruppe, eine Phenanthrenylgruppe, eine Anthracenylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Benzimidazolylgruppe, eine Benzofuranylgruppe, eine Benzothiophenylgruppe, eine Dibenzofuranylgruppe oder eine Dibenzothiophenylgruppe, jeweils unsubstituiert oder substituiert mit Deuterium, -F, -CD₃, -CD₂H, -CDH₂, -CF₃, -CF₂H, -CFH₂, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Cycloheptenylgruppe, einer Phenylgruppe, einer Biphenylgruppe, einer C₁-C₁₀-Alkylphenylgruppe, einer Naphthylgruppe, einer Fluorenylgruppe, einer Phenanthrenylgruppe, einer Anthracenylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Benzimidazolylgruppe, einer Benzofuranylgruppe, einer Benzothiophenylgruppe, einer Dibenzofuranylgruppe, einer Dibenzothiophenylgruppe, -O(Q₃₁), -S(Q₃₁), -Si(Q₃₁)(Q₃₂)(Q₃₃), -N(Q₃₁)(Q₃₂) oder jeder Kombination davon; oder
-C(Q₁)(Q₂)(Q₃), -Si(Q₁)(Q₂)(Q₃) oder -N(Q₁)(Q₂), und
Q₁ bis Q₃ und Q₃₁ bis Q₃₃ jeweils unabhängig Folgendes sind: Wasserstoff, Deuterium,-F, eine C₁-C₆₀-Alkylgruppe, eine C₂-C₆₀-Alkenylgruppe, eine C₂-C₆₀-Alkinylgruppe oder eine C₁-C₆₀-Alkoxygruppe; oder eine carbocyclische C₃-C₆₀-Gruppe oder eine heterocyclische C₁-C₆₀-Gruppe, jeweils unsubstituiert oder substituiert mit Deuterium, -F, einer C₁-C₆₀-Alkylgruppe, einer C₁-C₆₀-Alkoxygruppe, einer Phenylgruppe, einer Biphenylgruppe oder jeder Kombination davon.

6. Organometallische Verbindung nach Anspruch 1, wobei eine durch 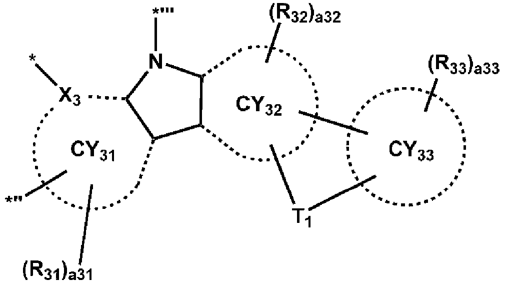 dargestellte Gruppe in Formel 1-1 eine Gruppe ist, dargestellt durch eine der Formeln CY3-1(1) bis CY3-1(6), und
eine durch 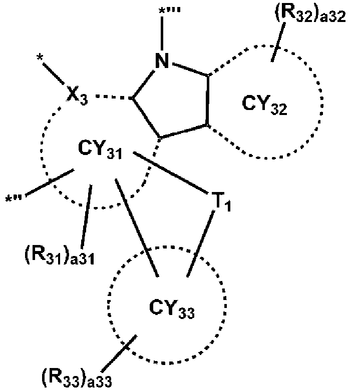 dargestellte Gruppe in Formel 1-2 eine Gruppe ist, dargestellt durch Formel CY3-2(1) oder CY3-2(2): 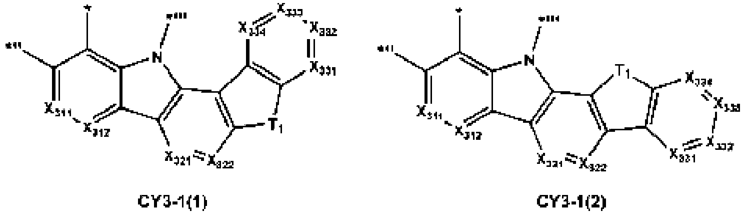 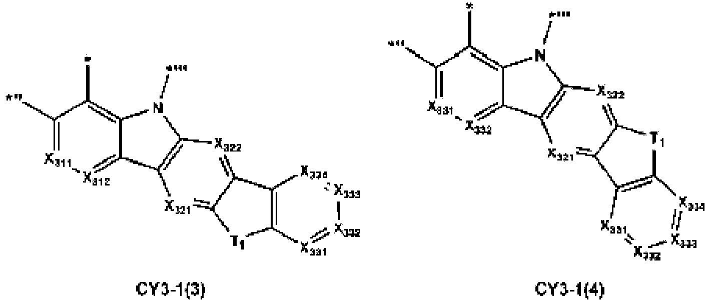 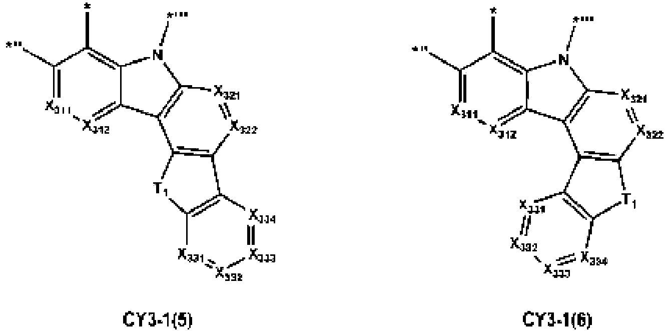 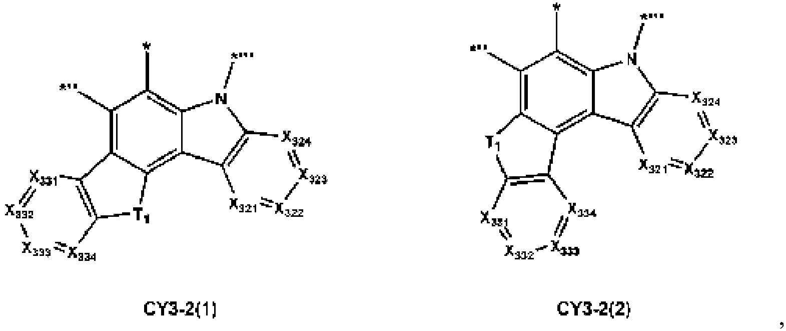 und
wobei in den Formeln CY3-1(1) bis CY3-1(6), CY3-2(1) und CY3-2(2)
X₃₁₁ C(R₃₁₁) oder N ist und X₃₁₂ C(R₃₁₂) oder N ist,
X₃₂₁ C(R₃₂₁) oder N ist, X₃₂₂ C(R₃₂₂) oder N ist, X₃₂₃ C(R₃₂₃) oder N ist und X₃₂₄ C(R₃₂₄) oder N ist,
X₃₃₁ C(R₃₃₁) oder N ist, X₃₃₂ C(R₃₃₂) oder N ist, X₃₃₃ C(R₃₃₃) oder N ist und X₃₃₄ C(R₃₃₄) oder N ist,
T₁ wie in Formel 1-1 oder Formel 1-2 definiert ist,
R₃₁₁ und R₃₁₂ jeweils wie in Verbindung mit R₃₁ in Formel 1-1 oder Formel 1-2 definiert sind,
R₃₂₁ bis R₃₂₄ jeweils wie in Verbindung mit R₃₂ in Formel 1-1 oder Formel 1-2 definiert sind,
R₃₃₁ bis R₃₃₄ jeweils wie in Verbindung mit R₃₃ in Formel 1-1 oder Formel 1-2 definiert sind,
zwei oder mehr benachbarte Gruppen von R₃₁₁, R₃₁₂, R₃₂₁ bis R₃₂₄ und R₃₃₁ bis R₃₃₄ optional miteinander verbunden sind, um eine carbocyclische C₃-C₆₀-Gruppe, unsubstituiert oder mit mindestens einem R₁₀ₐ substituiert, oder eine heterocyclische C₁-C₆₀-Gruppe, unsubstituiert oder mit mindestens einem R₁₀ₐ substituiert, zu bilden,
* eine Bindungsstelle an M in Formel 1-1 oder Formel 1-2 angibt,
*" eine Bindungsstelle an L₂ in Formel 1-1 oder Formel 1-2 angibt und
*'" eine Bindungsstelle an L₃ in Formel 1-1 oder Formel 1-2 angibt.

7. Organometallische Verbindung nach Anspruch 1, wobei
in den Formeln 1-1 und 1-2
eine durch 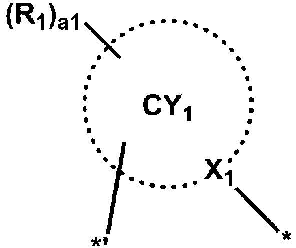 dargestellte Gruppe eine Gruppe ist, dargestellt durch eine der Formeln CY1(1) bis CY1(11),
eine durch 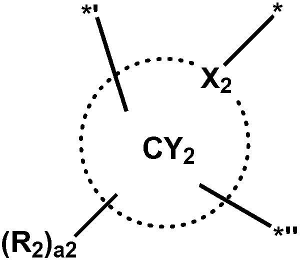 dargestellte Gruppe eine Gruppe ist, dargestellt durch eine der Formeln CY2(1) bis CY2(13), und
eine durch 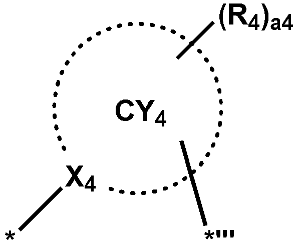 dargestellte Gruppe eine Gruppe ist, dargestellt durch eine der Formeln CY4(1) bis CY4(29): 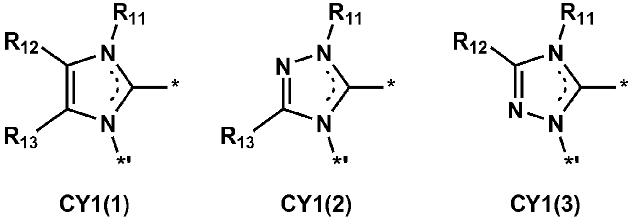 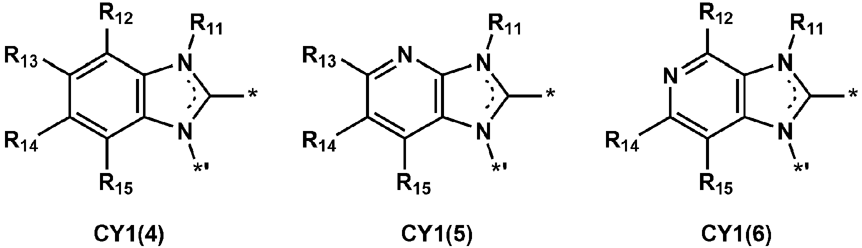 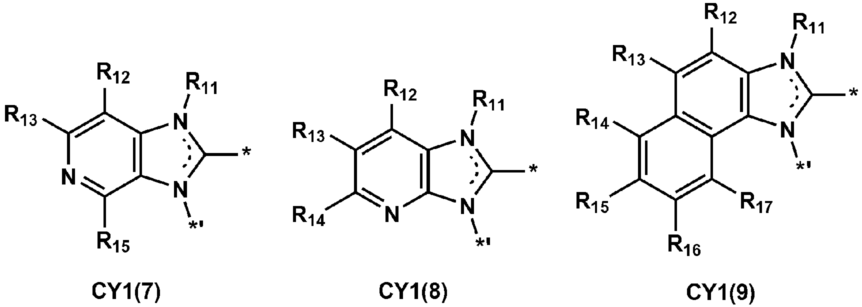 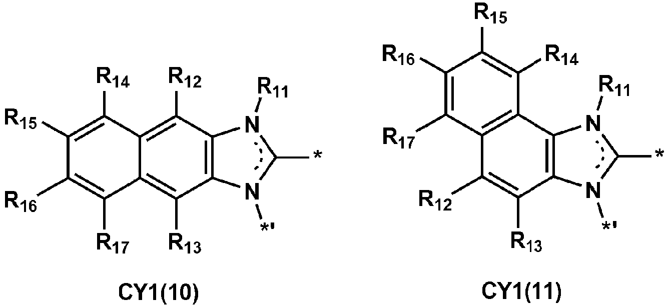 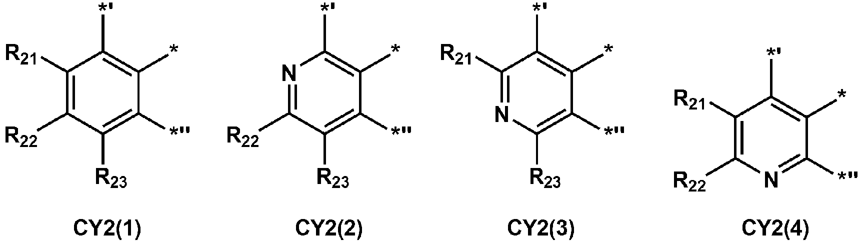 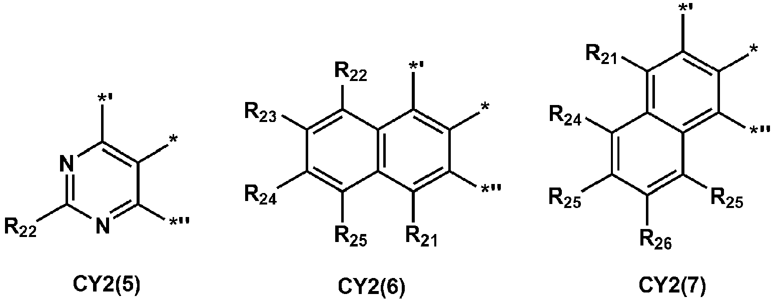 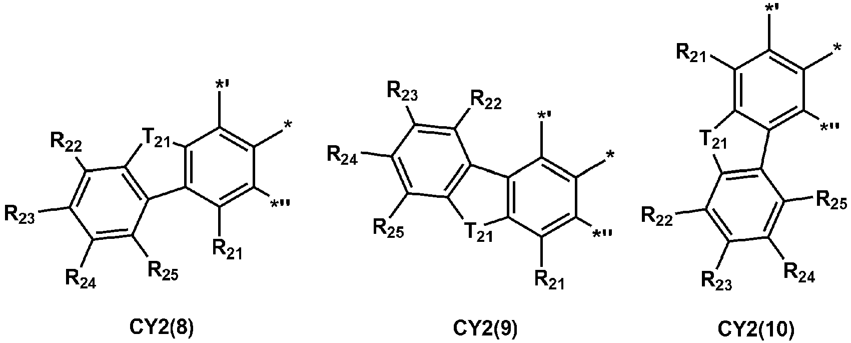 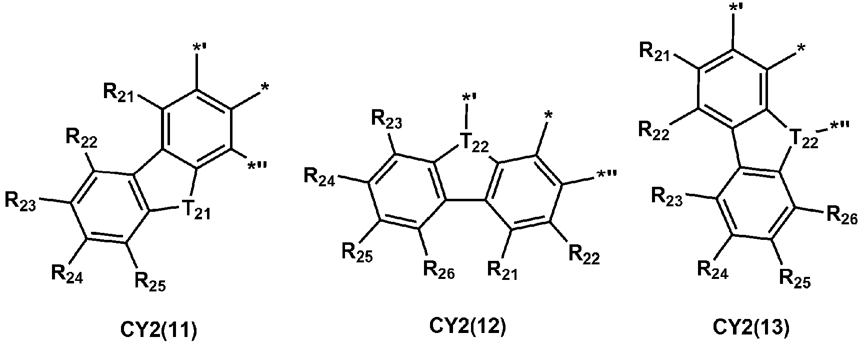 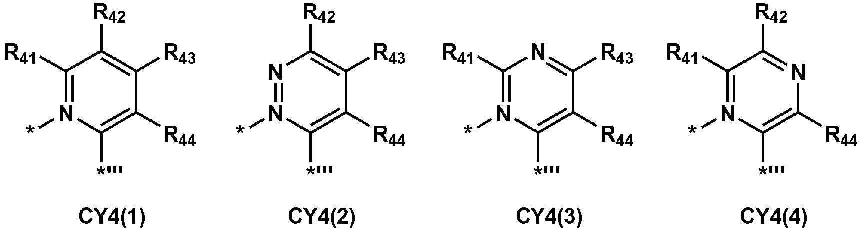 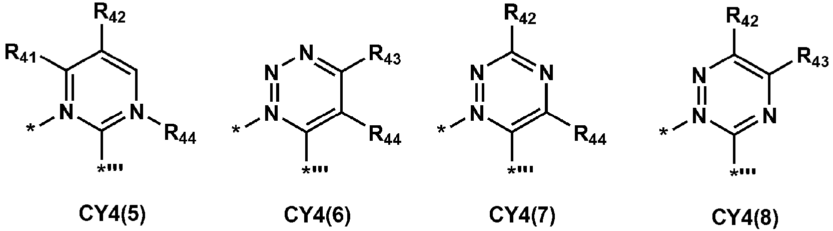 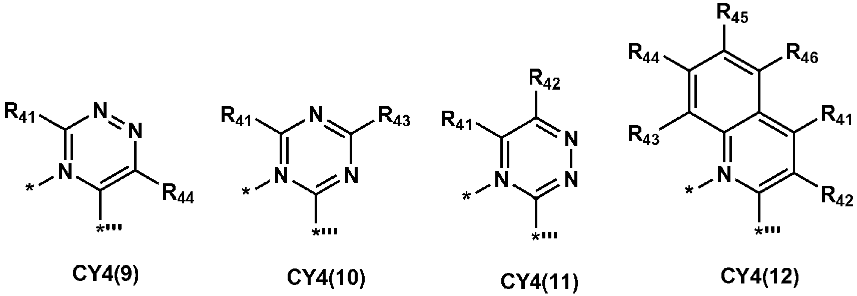 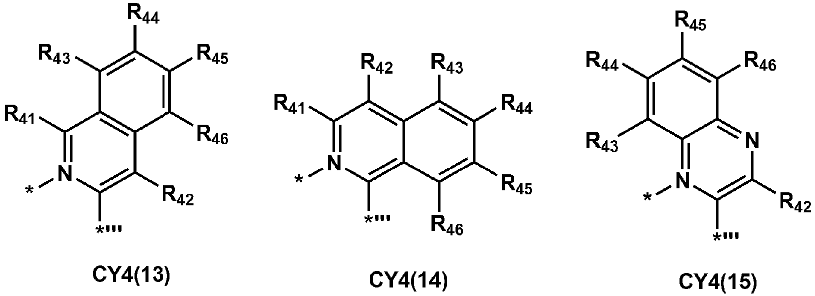 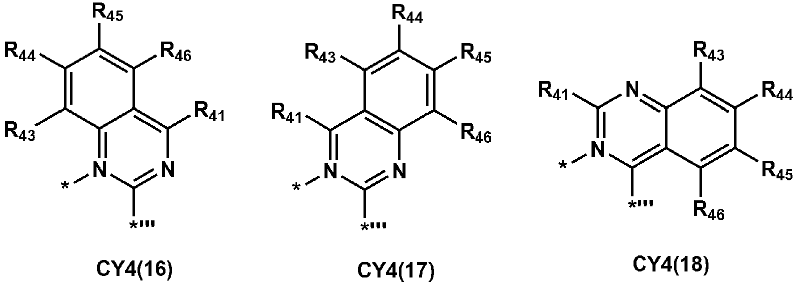 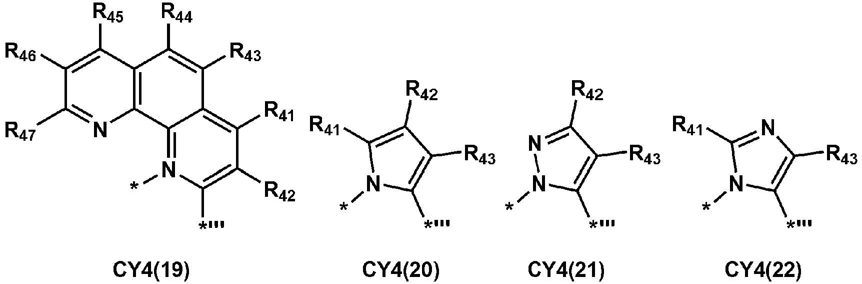 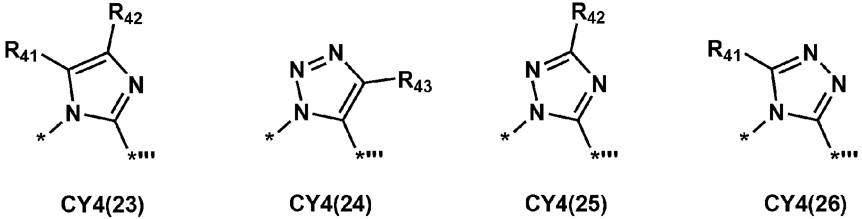 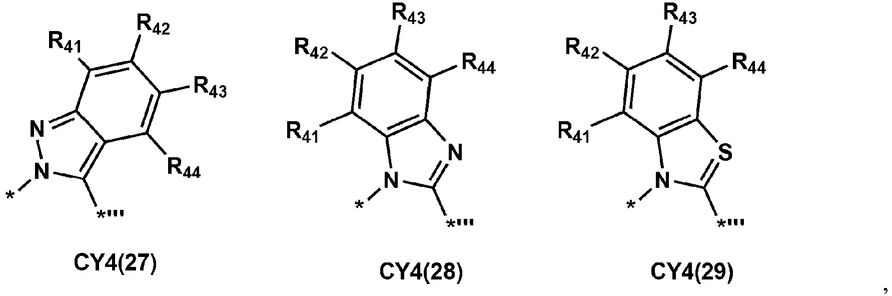 und
wobei in den Formeln CY1(1) bis CY1(11), CY2(1) bis CY2(13) und CY4(1) bis CY4(29)
T₂₁ B(Y₂₁), C(Y₂₁)(Y₂₂), N(Y₂₁), O, S oder Si(Y₂₁)(Y₂₂) ist,
T₂₂ C(Y₂₁), N oder Si(Y₂₁) ist,
R₁₁ bis R₁₇ jeweils wie in Verbindung mit R₁ in Formel 1-1 oder Formel 1-2 definiert sind,
R₂₁ bis R₂₆, Y₂₁ und Y₂₂ jeweils wie in Verbindung mit R₂ in Formel 1-1 oder Formel 1-2 definiert sind, R₄₁ bis R₄₇ jeweils wie in Verbindung mit R₄ in Formel 1-1 oder Formel 1-2 definiert sind,
* eine Bindungsstelle an M in Formel 1-1 oder Formel 1-2 angibt,
*' eine Bindungsstelle an L₁ in Formel 1-1 oder Formel 1-2 angibt,
*" eine Bindungsstelle an L₂ in Formel 1-1 oder Formel 1-2 angibt und
*"' eine Bindungsstelle an L₃ in Formel 1-1 oder Formel 1-2 angibt.

8. Organometallische Verbindung nach Anspruch 1, wobei die durch Formel 1-1 dargestellte organometallische Verbindung eine Gruppe ist, dargestellt durch Formel 1-1(A1) oder 1-1(A2), oder
die durch Formel 1-2 dargestellte organometallische Verbindung eine Gruppe ist, dargestellt durch Formel 1-2(A1) oder 1-2(A2): 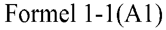 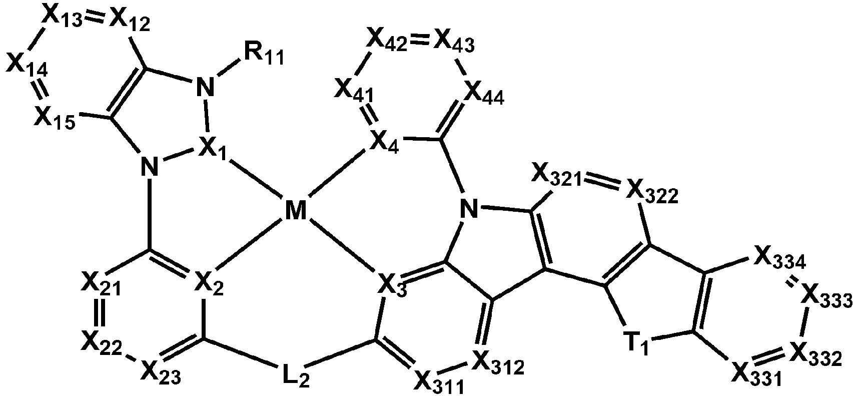 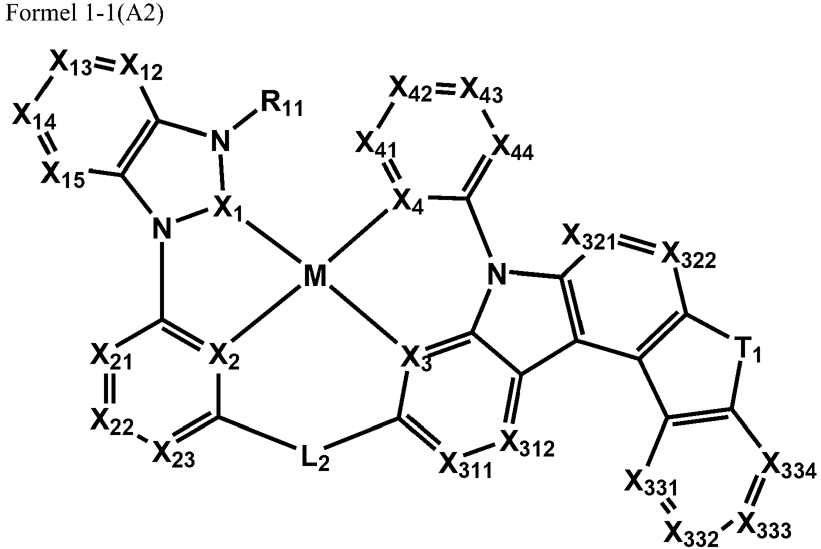 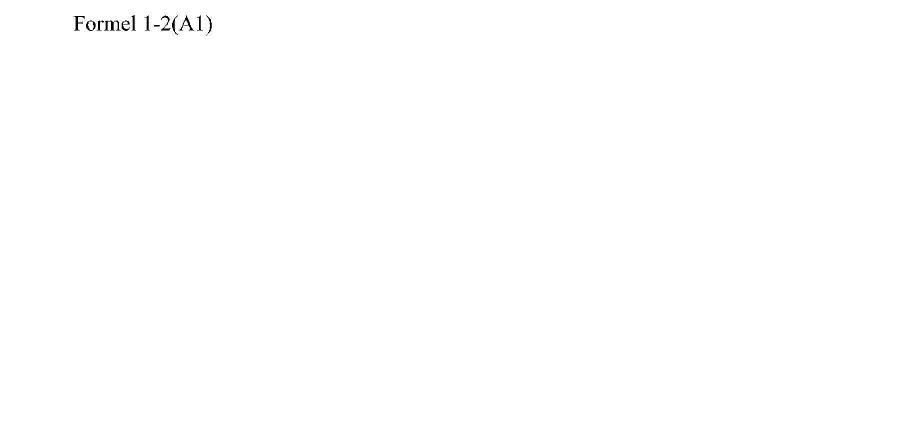 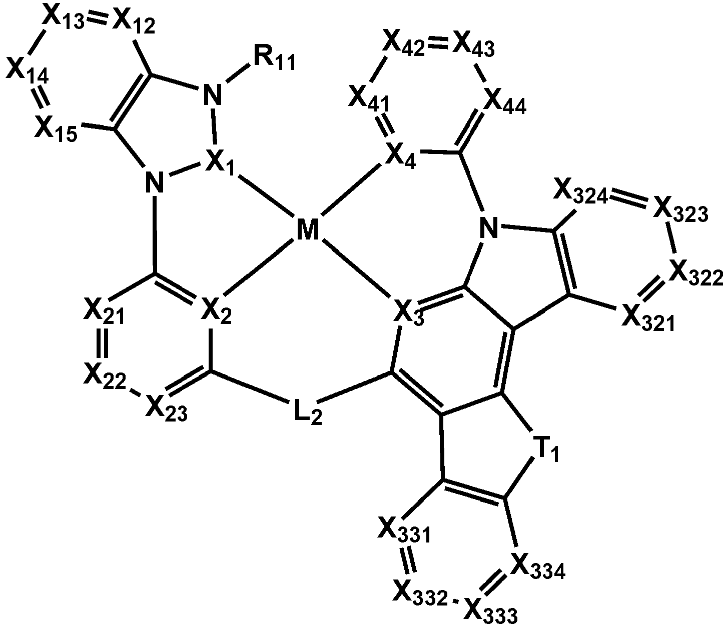 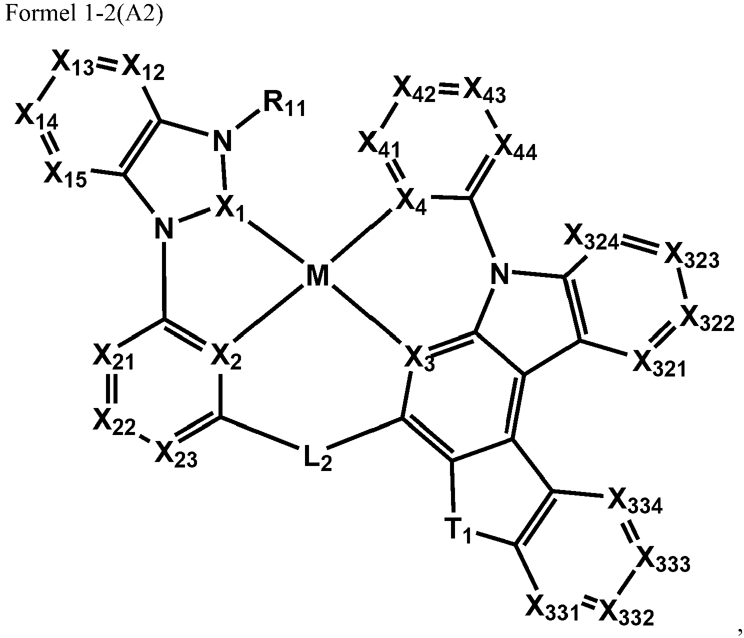 und
wobei in den Formeln 1-1(A1), 1-1(A2), 1-2(A1) und 1-2(A2)
M, X₁ bis X₄ und T₁ jeweils wie in Formel 1-1 oder Formel 1-2 definiert sind,
L₂ *-O-*', *-S-*' oder *-Se-*' ist,
X₁₂ C(R₁₂) oder N ist, X₁₃ C(R₁₃) oder N ist, X₁₄ C(R₁₄) oder N ist und X₁₅ C(R₁₅) oder N ist,
X₂₁ C(R₂₁) oder N ist, X₂₂ C(R₂₂) oder N ist und X₂₃ C(R₂₃) oder N ist,
X₃₁₁ C(R₃₁₁) oder N ist, X₃₁₂ C(R₃₁₂) oder N ist, X₃₂₁ C(R₃₂₁) oder N ist, X₃₂₂ C(R₃₂₂) oder N ist, X₃₂₃ C(R₃₂₃) oder N ist, X₃₂₄ C(R₃₂₄) oder N ist, X₃₃₁ C(R₃₃₁) oder N ist, X₃₃₂ C(R₃₃₂) oder N ist, X₃₃₃ C(R₃₃₃) oder N ist und X₃₃₄ C(R₃₃₄) oder N ist,
X₄₁ C(R₄₁) oder N ist, X₄₂ C(R₄₂) oder N ist, X₄₃ C(R₄₃) oder N ist und X₄₄ C(R₄₄) oder N ist,
R₁₁ bis R₁₅ jeweils wie in Verbindung mit R₁ in Formel 1-1 oder Formel 1-2 definiert sind,
R₂₁ bis R₂₃ jeweils wie in Verbindung mit R₂ in Formel 1-1 oder Formel 1-2 definiert sind,
R₃₁₁ und R₃₁₂ jeweils wie in Verbindung mit R₃₁ in Formel 1-1 oder Formel 1-2 definiert sind,
R₃₂₁ bis R₃₂₄ jeweils wie in Verbindung mit R₃₂ in Formel 1-1 oder Formel 1-2 definiert sind,
R₃₃₁ bis R₃₃₄ jeweils wie in Verbindung mit R₃₃ in Formel 1-1 oder Formel 1-2 definiert sind,
R₄₁ bis R₄₄ jeweils wie in Verbindung mit R₄ in Formel 1-1 oder Formel 1-2 definiert sind,
zwei oder mehr benachbarte Gruppen von R₁₁ bis R₁₅, R₂₁ bis R₂₃, R₃₁₁, R₃₁₂, R₃₂₁ bis R₃₂₄, R₃₃₁ bis R₃₃₄, R₄₁ bis R₄₄, Z₁ und Z₂ optional miteinander verbunden sind, um eine carbocyclische C₃-C₆₀-Gruppe, unsubstituiert oder mit mindestens einem R₁₀ₐ substituiert, oder eine heterocyclische C₁-C₆₀-Gruppe, unsubstituiert oder mit mindestens einem R₁₀ₐ substituiert, zu bilden, und
R₁₀ₐ wie in Formel 1-1 oder Formel 1-2 definiert ist.

9. Organometallische Verbindung nach Anspruch 1, wobei die organometallische Verbindung aus Verbindungen 1 bis 72 ausgewählt ist:

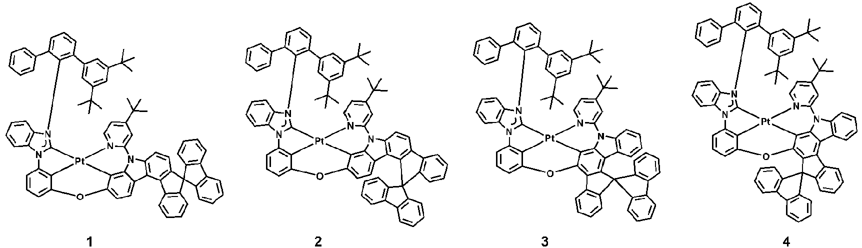

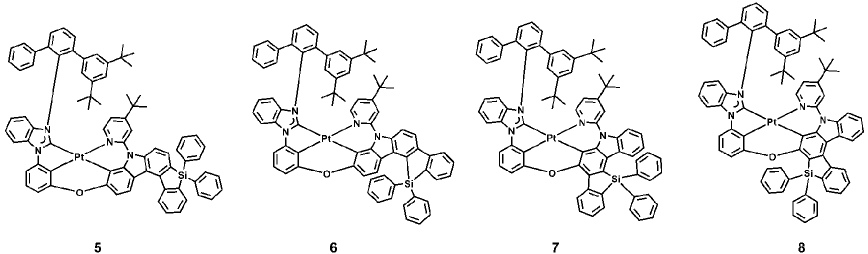

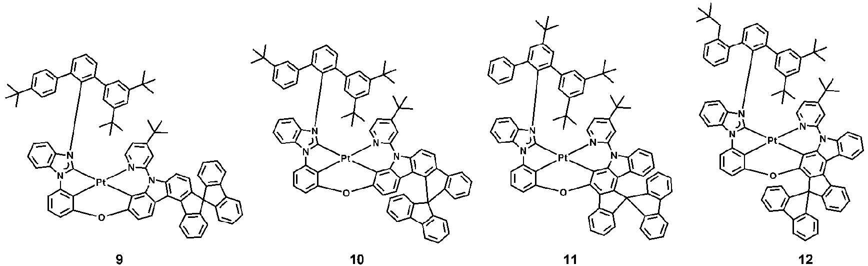

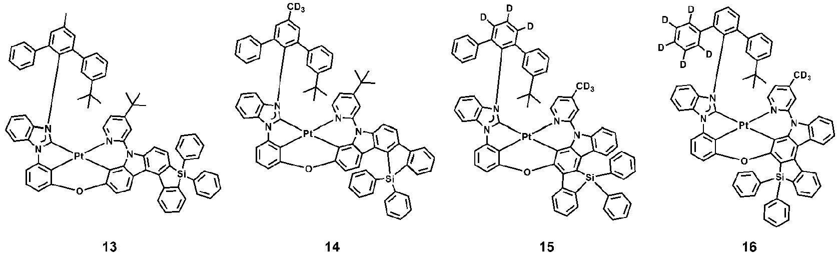

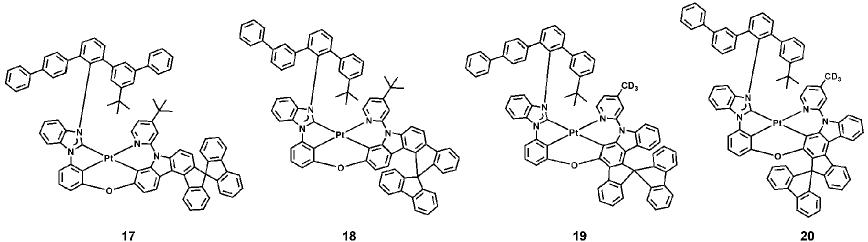

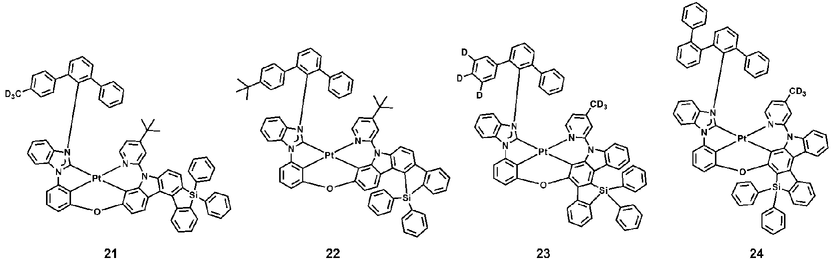

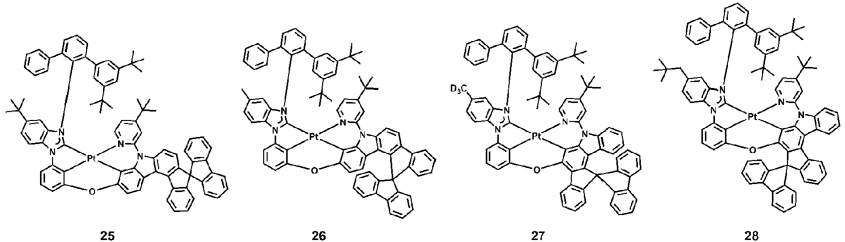

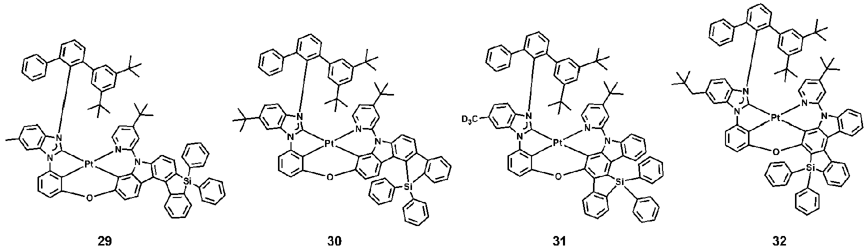

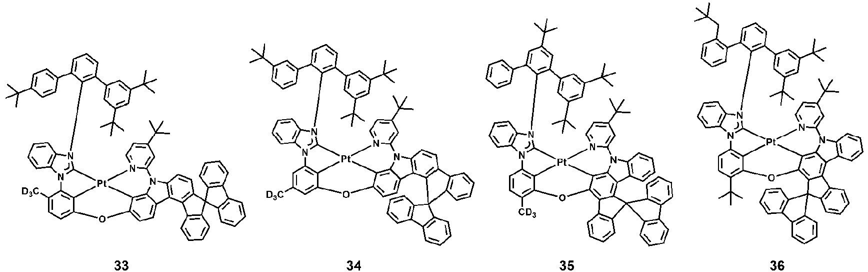

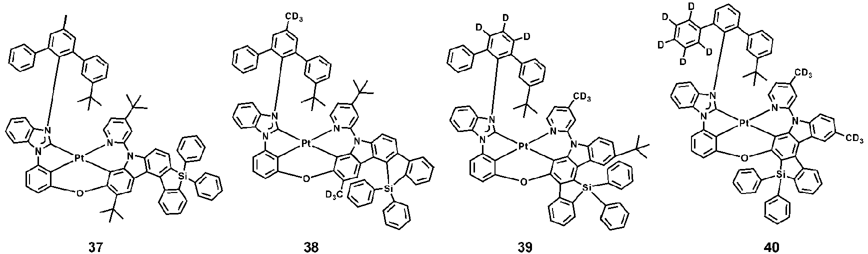

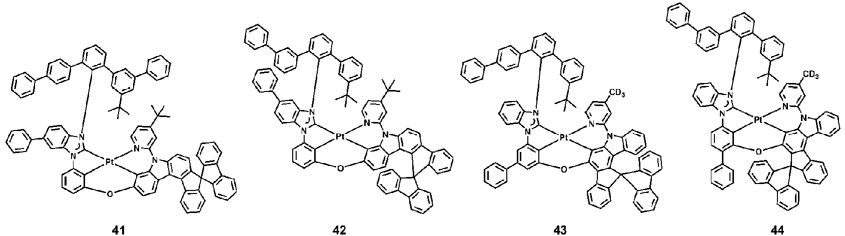

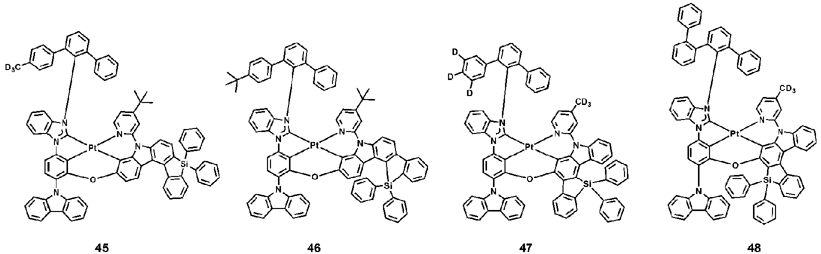

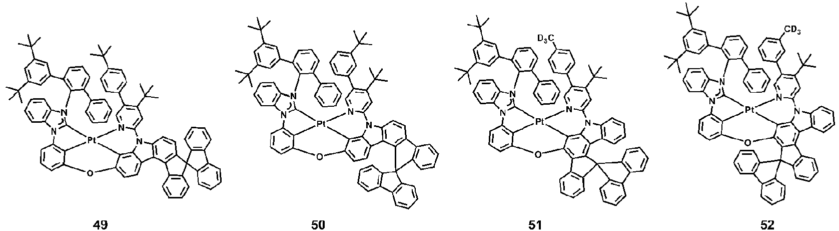

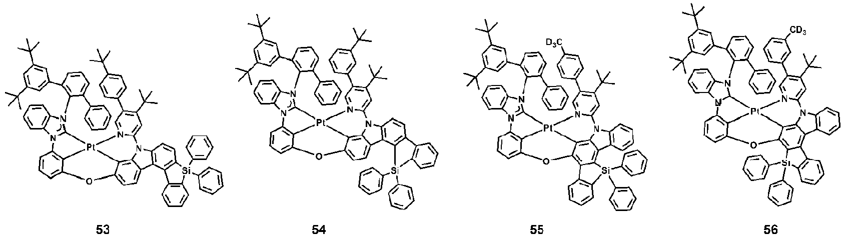

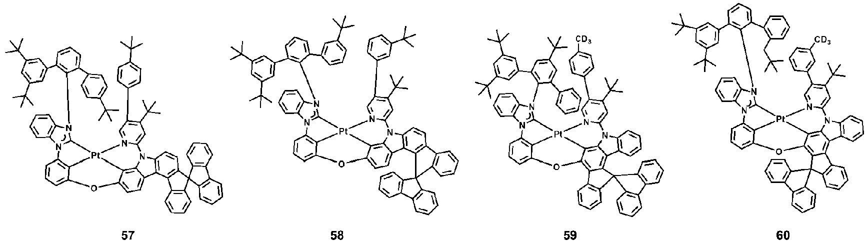

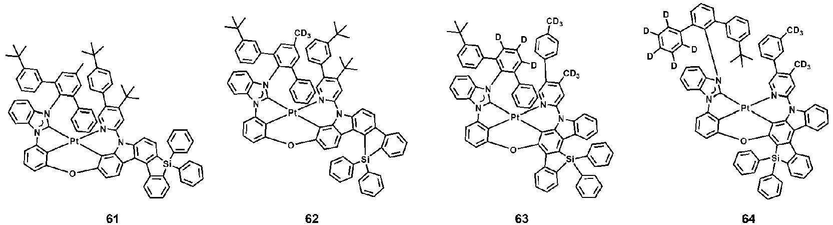

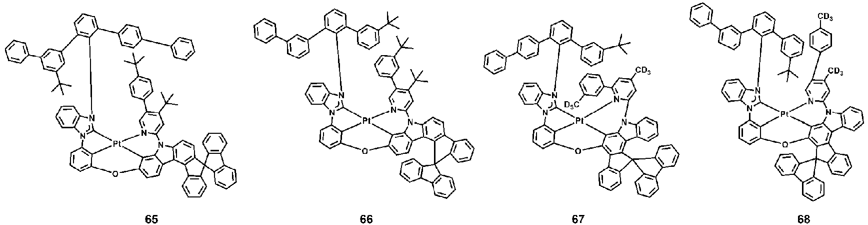

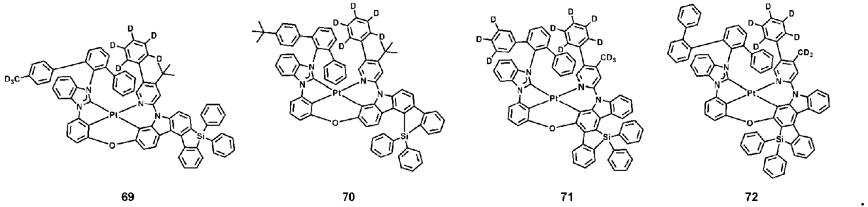

10. Lichtemittierende Vorrichtung (10), umfassend:
eine erste Elektrode (110);
eine der ersten Elektrode (110) gegenüberliegende zweite Elektrode (150);
eine Zwischenschicht (130) zwischen der ersten Elektrode (110) und der zweiten Elektrode (150) und umfassend eine Emissionsschicht; **dadurch gekennzeichnet, dass** die lichtemittierende Vorrichtung (10)
eine organometallische Verbindung nach Anspruch 1 umfasst.

11. Lichtemittierende Vorrichtung (10) nach Anspruch 10, wobei die Emissionsschicht einen Wirt und einen Dotierstoff umfasst und
der Dotierstoff die organometallische Verbindung umfasst.

12. Lichtemittierende Vorrichtung (10) nach Anspruch 10 oder 11, ferner umfassend eine zweite Verbindung, umfassend mindestens eine heterocyclische Gruppe, die 1 bis 60 Kohlenstoffatome aufweist und *-N=*' als eine ringbildende Einheit enthält, eine dritte Verbindung, umfassend eine durch Formel 3 dargestellte Gruppe, eine vierte Verbindung, um verzögerte Fluoreszenz zu emittieren, oder jede Kombination davon,
wobei die organometallische Verbindung, die zweite Verbindung, die dritte Verbindung und die vierte Verbindung voneinander verschieden sind: 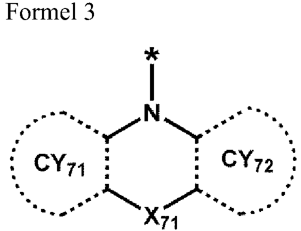
wobei in Formel 3
Ring CY₇₁ und Ring CY₇₂ jeweils unabhängig eine cyclische Gruppe, die 3 bis 60 Kohlenstoffatome aufweist und *-N=*' als eine ringbildende Einheit nicht enthält, oder eine Pyridingruppe sind,
X₇₁ eine Einfachbindung oder eine Verbindungsgruppe, umfassend O, S, N, B, C, Si oder jede Kombination davon, ist, und
* eine Bindungsstelle an ein beliebiges Atom angibt, das in einem verbleibenden Teil der dritten Verbindung außer der durch Formel 3 dargestellten Gruppe enthalten ist.

13. Lichtemittierende Vorrichtung (10) nach Anspruch 12, wobei die zweite Verbindung eine Pyridingruppe, eine Pyrimidingruppe, eine Pyrazingruppe, eine Pyridazingruppe, eine Triazingruppe oder jede Kombination davon umfasst und
die vierte Verbindung eine Verbindung ist, umfassend eine cyclische Gruppe, umfassend Bor (B) und Stickstoff (N) als ringbildende Atome.

14. Lichtemittierende Vorrichtung (10) nach Anspruch 12, wobei die Emissionsschicht Folgendes umfasst:
i) die organometallische Verbindung; und
ii) die zweite Verbindung, die dritte Verbindung, die vierte Verbindung oder jede Kombination davon, und
die Emissionsschicht eingerichtet ist, blaues Licht zu emittieren.

15. Elektronische Vorrichtung, umfassend die lichtemittierende Vorrichtung (10) nach Anspruch 10.

16. Elektronische Vorrichtung nach Anspruch 15, ferner umfassend einen Dünnschichttransistor (TFT),
wobei der Dünnschichttransistor (TFT) eine Source-Elektrode (260) und eine Drain-Elektrode (270) umfasst und
die erste Elektrode (110) der lichtemittierenden Vorrichtung (10) mit der Source-Elektrode (260) oder der Drain-Elektrode (270) des Dünnschichttransistors (TFT) elektrisch verbunden ist.

17. Elektronische Vorrichtung nach Anspruch 15, ferner umfassend einen Farbfilter, eine Farbkonversionsschicht, eine Berührungsbildschirmschicht, eine Polarisationsschicht oder jede Kombination davon.

18. Elektronisches Gerät, umfassend die lichtemittierende Vorrichtung (10) nach Anspruch 10.

19. Elektronisches Gerät nach Anspruch 18, wobei das elektronische Gerät mindestens eines ist, ausgewählt aus einem Flachbildschirm, einer gekrümmten Anzeige, einem Computermonitor, einem medizinischen Monitor, einem Fernseher, einer Werbetafel, einer Innen- oder Außenbeleuchtung und/oder Signalleuchte, einem Head-up-Display, einer vollständig oder teilweise transparenten Anzeige, einer flexiblen Anzeige, einer aufrollbaren Anzeige, einer faltbaren Anzeige, einer dehnbaren Anzeige, einem Laserdrucker, einem Telefon, einem Mobiltelefon, einem Tablet, einem Phablet, einem Personal Digital Assistant (PDA), einer tragbaren Vorrichtung, einem Laptop-Computer, einer Digitalkamera, einem Camcorder, einem Sucher, einer Mikroanzeige, einer dreidimensionalen (3D) Anzeige, einer Virtual-Reality- oder Augmented-Reality-Anzeige, einem Fahrzeug, einer Videowand mit mehreren aneinandergereihten Anzeigen, einem Theater- oder Stadionbildschirm, einer Phototherapievorrichtung, einem Schild und Kombinationen davon.

## Revendications

1. Composé organométallique représenté par la formule 1-1 ou la formule 1-2 : 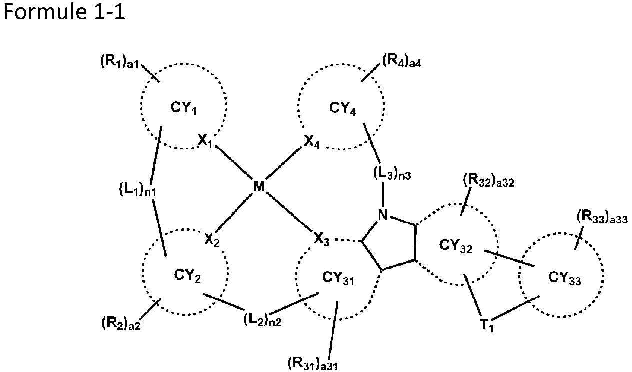 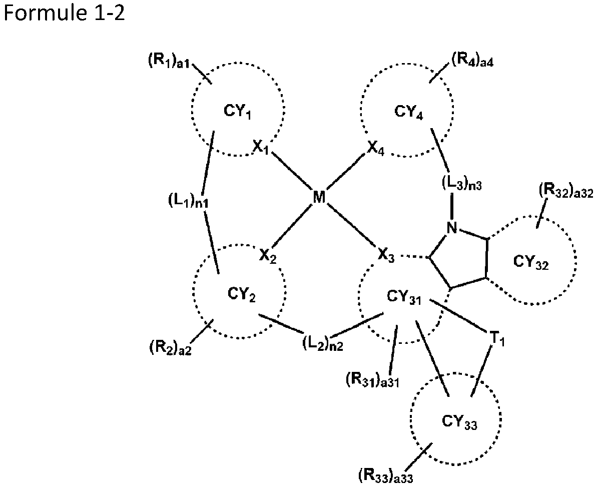 dans lequel, dans les formules 1-1 et 1-2,
M est platine (Pt), palladium (Pd), cuivre (Cu), argent (Ag), or (Au), rhodium (Rh), ruthénium (Ru), osmium (Os), titane (Ti), zirconium (Zr), hafnium (Hf), europium (Eu), terbium (Tb), ou thulium (Tm),
X₁ à X₄ sont chacun indépendamment C ou N,
le cycle CY₁, le cycle CY₂, le cycle CY₃₁ au cycle CY₃₃, et le cycle CY₄ sont chacun indépendamment un groupe carbocyclique en C₅-C₃₀ ou un groupe hétérocyclique en C₁-C₃₀,
L₁ à L₃ sont chacun indépendamment une liaison simple, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-AI(R₁ₐ)-*, *-Si(R₁ₐ)(R_{1b})-*', *-P(=O)(R₁ₐ)-*', *-S-*', *-S(=O)-*', *-S(=O)₂-*', ou *-Ge(R₁ₐ)(R_{1b})-*', dans lequel * et *' indiquent chacun un site de liaison à un atome voisin,
n1 à n3 sont chacun indépendamment un nombre entier de 1 à 5,
dans les formules 1-1 et 1-2, T₁ est un groupe représenté par la formule T-1 ou T-2 : 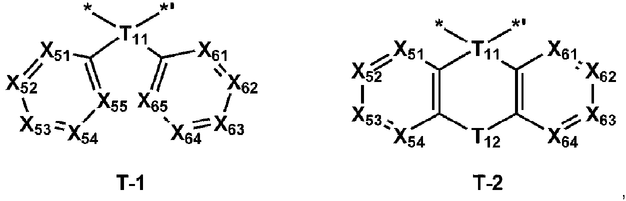 et
dans lequel, dans les formules T-1 et T-2,
T₁₁ est C, Si ou Ge,
T₁₂ est une liaison simple, *-C(Z₃)(Z₄)-*', *-Si(Z₃)(Z₄)-*', ou *-Ge(Z₃)(Z₄)-*', dans lequel * et *' indiquent chacun un site de liaison à un atome voisin,
X₅₁ est C(Z₁₁) ou N, X₅₂ est C(Z₁₂) ou N, X₅₃ est C(Z₁₃) ou N, X₅₄ est C(Z₁₄) ou N, et X₅₅ est C(Z₁₅) ou N,
X₆₁ est C(Z₂₁) ou N, X₆₂ est C(Z₂₂) ou N, X₆₃ est C(Z₂₃) ou N, X₆₄ est C(Z₂₄) ou N, et X₆₅ est C(Z₂₅) ou N,
Z₁₁ à Z₁₅ et Z₃, Z₂₁ à Z₂₅ et Z₄ sont chacun indépendamment un groupe alkyle en C₁-C₆₀ non substitué ou substitué avec au moins un R₁₀ₐ, un groupe alcényle en C₂-C₆₀ non substitué ou substitué avec au moins un R₁₀ₐ, un groupe alcynyle en C₂-C₆₀ non substitué ou substitué avec au moins un R₁₀ₐ, un groupe alcoxy en C₁-C₆₀ non substitué ou substitué avec au moins un R₁₀ₐ, un groupe alkythio en C₁-C₆₀ non substitué ou substitué avec au moins un R₁₀ₐ, un groupe carbocyclique en C₃-C₆₀ non substitué ou substitué avec au moins un R₁₀ₐ, un groupe hétérocyclique en C₁-C₆₀ non substitué ou substitué avec au moins un R₁₀ₐ, un groupe aryloxy en C₆-C₆₀ non substitué ou substitué avec au moins un R₁₀ₐ, un groupe arylthio en C₆-C₆₀ non substitué ou substitué avec au moins un R₁₀ₐ, -C(Q₁)(Q₂)(Q₃), -Si(Q₁)(Q₂)(Q₃),-N(Q₁)(Q₂), -B(Q₁)(Q₂), -C(=O)(Q₁), -S(=O)₂(Q₁), ou -P(=O)(Q₁)(Q₂),
deux groupes voisins ou plus parmi Z₁₁ à Z₁₅, Z₂₁ à Z₂₅, Z₃, et Z₄ sont facultativement liés les uns aux autres pour former un groupe carbocyclique en C₃-C₆₀ non substitué ou substitué avec au moins un R₁₀ₐ ou un groupe hétérocyclique en C₁-C₆₀ non substitué ou substitué avec au moins un R₁₀ₐ, et
* et *' indiquent chacun un site de liaison à un atome voisin,
R₁, R₂, R₃₁ à R₃₃, R₄, R₁ₐ, et R_{1b} sont chacun indépendamment un hydrogène, un deutérium, -F, -CI, -Br, -I, un groupe hydroxyle, un groupe cyano, un groupe nitro, un groupe alkyle en C₁-C₆₀ non substitué ou substitué avec au moins un R₁₀ₐ, un groupe alcényle en C₂-C₆₀ non substitué ou substitué avec au moins un R₁₀ₐ, un groupe alcynyle en C₂-C₆₀ non substitué ou substitué avec au moins un R₁₀ₐ, un groupe alcoxy en C₁-C₆₀ non substitué ou substitué avec au moins un R₁₀ₐ, un groupe alkylthio en C₁-C₆₀ non substitué ou substitué avec au moins un R₁₀ₐ, un groupe carbocyclique en C₃-C₆₀ non substitué ou substitué avec au moins un R₁₀ₐ, un groupe hétérocyclique en C₁-C₆₀ non substitué ou substitué avec au moins un R₁₀ₐ, un groupe aryloxy en C₆-C₆₀ non substitué ou substitué avec au moins un R₁₀ₐ, un groupe arylthio en C₆-C₆₀ non substitué ou substitué avec au moins un R₁₀ₐ,-C(Q₁)(Q₂)(Q3), -Si(Q1)(Q₂)(Q₃), -N(Q₁)(Q₂), -B(Q₁)(Q₂), -C(=O)(Q₁), -S(=O)₂(Q₁), ou-P(=O)(Q₁)(Q₂),
au moins un R₁ est un groupe représenté par la formule S1 : 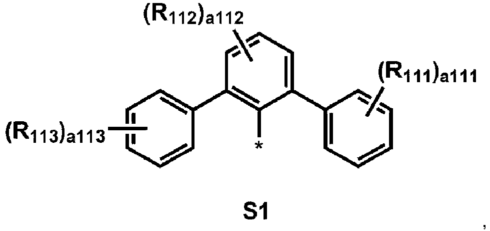 et
dans lequel, dans la formule S1,
R₁₁₁ à R₁₁₃ sont chacun tels que définis pour R₁ dans la formule 1-1 ou la formule 1-2,
a111 est un nombre entier de 1 à 5,
a112 est un nombre entier de 1 à 3,
a113 est un nombre entier de 1 à 5, et
* indique un site de liaison à un atome voisin,
a1, a2, a31 à a33, et a4 sont chacun indépendamment un nombre entier de 1 à 20,
R₂ au nombre de a2, R₃₁ au nombre de a31, R₃₂ au nombre de a32, R₃₃ au nombre de a33, et R₄ au nombre de a4 sont facultativement liés les uns aux autres pour former un groupe carbocyclique en C₃-C₆₀ non substitué ou substitué avec au moins un R₁₀ₐ ou un groupe hétérocyclique en C₁-C₆₀ non substitué ou substitué avec au moins un R₁₀ₐ,
R₁₀ₐ est :
un hydrogène, -F, -Cl, -Br, -I, un groupe hydroxyle, un groupe cyano ou un groupe nitro ;
un groupe alkyle en C₁-C₆₀, un groupe alcényle en C₂-C₆₀, un groupe alcynyle en C₂-C₆₀, ou un groupe alcoxy en C₁-C₆₀, chacun non substitué ou substitué avec un deutérium, -F, -Cl, -Br, -I, un groupe hydroxyle, un groupe cyano, un groupe nitro, un groupe carbocyclique en C₃-C₆₀, un groupe hétérocyclique en C₁-C₆₀, un groupe aryloxy en C₆-C₆₀, un groupe arylthio en C₆-C₆₀, -Si(Q₁₁)(Q₁₂)(Q₁₃), -N(Q₁₁)(Q₁₂),-B(Q₁₁)(Q₁₂), -C(=O)(Q₁₁), -S(=O)₂(Q₁₁), -P(=O)(Q₁₁)(Q₁₂), ou n'importe quelle combinaison de ceux-ci ;
un groupe carbocyclique en C₃-C₆₀, un groupe hétérocyclique en C₁-C₆₀, un groupe aryloxy en C₆-C₆₀, ou un groupe arylthio en C₆-C₆₀, chacun non substitué ou substitué avec un deutérium, -F, -Cl, -Br, -I, un groupe hydroxyle, un groupe cyano, un groupe nitro, un groupe alkyle en C₁-C₆₀, un groupe alcényle en C₂-C₆₀, un groupe alcynyle en C₂-C₆₀, un groupe alcoxy en C₁-C₆₀, un groupe carbocyclique en C₃-C₆₀, un groupe hétérocyclique en C₁-C₆₀, un groupe aryloxy en C₆-C₆₀, un groupe arylthio en C₆-C₆₀, -Si(Q₂₁)(Q₂₂)(Q₂₃), -N(Q₂₁)(Q₂₂), -B(Q₂₁)(Q₂₂), -C(=O)(Q₂₁),-S(=O)₂(Q₂₁), -P(=O)(Q₂₁)(Q₂₂), ou n'importe quelle combinaison de ceux-ci, ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou-P(=O)(Q₃₁)(Q₃₂), et
Q₁ à Q₃, Q₁₁ à Q₁₃, Q₂₁ à Q₂₃, et Q₃₁ à Q₃₃ sont chacun indépendamment : un hydrogène, un deutérium, -F, -CI, -Br, -I, un groupe hydroxyle, un groupe cyano, un groupe nitro, un groupe alkyle en C₁-C₆₀, un groupe alcényle en C₂-C₆₀, un groupe alcynyle en C₂-C₆₀, ou un groupe alcoxy en C₁-C₆₀ ; ou
un groupe carbocyclique en C₃-C₆₀ ou un groupe hétérocyclique en C₁-C₆₀, chacun non substitué ou substitué avec un deutérium, -F, un groupe cyano, un groupe alkyle en C₁-C₆₀, un groupe alcoxy en C₁-C₆₀, un groupe phényle, un groupe biphényle, ou n'importe quelle combinaison de ceux-ci.

2. Composé organométallique selon la revendication 1, dans lequel X₁, X₂ et X₃ sont chacun C, et X₄ est N,
une liaison entre X₁ et M et une liaison entre X₄ et M sont chacune une liaison de coordination, et
une liaison entre X₂ et M et une liaison entre X₃ et M sont chacune une liaison covalente.

3. Composé organométallique selon la revendication 1, dans lequel le cycle CY₁, le cycle CY₂, le cycle CY₃₁ au cycle CY₃₃, et le cycle CY₄ sont chacun indépendamment un groupe benzène, un groupe naphtalène, un groupe anthracène, un groupe phénanthrène, un groupe triphénylène, un groupe pyrène, un groupe chrysène, un groupe cyclopentadiène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe azafluorène, un groupe azacarbazole, un groupe azadibenzofurane, un groupe azadibenzothiophène, un groupe azadibenzosilole, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe dibenzooxasiline, un groupe dibenzothiasiline, un groupe dibenzodihydroazasiline, un groupe dibenzodihydrodisiline, un groupe dibenzodihydrosiline, un groupe dibenzodioxine, un groupe dibenzooxathiine, un groupe dibenzooxazine, un groupe dibenzopyrane, un groupe dibenzodithiine, un groupe dibenzothiazine, un groupe dibenzothiopyrane, un groupe dibenzocyclohexadiène, un groupe dibenzodihydropyridine ou un groupe dibenzodihydropyrazine.

4. Composé organométallique selon la revendication 1, dans lequel R₁, R₂, R₃₁ à R₃₃, et R₄ sont chacun indépendamment :
un hydrogène, un deutérium, -F, un groupe alkyle en C₁-C₂₀, ou un groupe alcoxy en C₁-C₂₀ ;
un groupe alkyle en C₁-C₂₀ ou un groupe alcoxy en C₁-C₂₀, chacun substitué avec un deutérium, -F, -CD₃, -CD₂H, -CDH₂, -CF₃, -CF₂H, -CFH₂, un groupe alkyle en C₁-C₁₀, un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe naphtyle, un groupe pyridinyle, un groupe pyrimidinyle, ou n'importe quelle combinaison de ceux-ci ;
un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe (alkyle en C₁ -C₁₀), un groupe naphtyle, un groupe fluorényle, un groupe phénanthrényle, un groupe anthracényle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe benzimidazolyle, un groupe benzofuranyle, un groupe benzothiophényle, un groupe dibenzofuranyle, ou un groupe dibenzothiophényle, chacun non substitué ou substitué avec un deutérium, -F, -CD₃, -CD₂H, -CDH₂, -CF₃, -CF₂H, -CFH₂, un groupe alkyle en C₁-C₂₀, un groupe alcoxy en C₁-C₂₀, un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe (alkyle en C₁-C₁₀)phényle, un groupe naphtyle, un groupe fluorényle, un groupe phénanthrényle, un groupe anthracényle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe benzimidazolyle, un groupe benzofuranyle, un groupe benzothiophényle, un groupe dibenzofuranyle, un groupe dibenzothiophényle, - O(Q₃₁), -S(Q₃₁), -Si(Q₃₁)(Q₃₂)(Q₃₃), -N(Q₃₁)(Q₃₂), ou n'importe quelle combinaison de ceux-ci ; ou
-C(Q₁)(Q₂)(Q₃), -Si(Q₁)(Q₂)(Q₃), ou -N(Q₁)(Q₂), et
Q₁ à Q₃ et Q₃₁ à Q₃₃ sont chacun indépendamment : un hydrogène, un deutérium, -F, un groupe alkyle en C₁-C₆₀, un groupe alcényle en C₂-C₆₀, un groupe alcynyle en C₂-C₆₀, ou un groupe alcoxy en C₁-C₆₀ ; ou
un groupe carbocyclique en C₃-C₆₀ ou un groupe hétérocyclique en C₁-C₆₀, chacun non substitué ou substitué avec un deutérium, -F, un groupe alkyle en C₁-C₆₀, un groupe alcoxy en C₁-C₆₀, un groupe phényle, un groupe biphényle, ou n'importe quelle combinaison de ceux-ci.

5. Composé organométallique selon la revendication 1, dans lequel Z₁ et Z₂ sont chacun indépendamment :
un groupe alkyle en C₁-C₂₀ ou un groupe alcoxy en C₁-C₂₀ ;
un groupe alkyle en C₁-C₂₀ ou un groupe alcoxy en C₁-C₂₀, chacun substitué avec un deutérium, -F, -CD₃, -CD₂H, -CDH₂, -CF₃, -CF₂H, -CFH₂, un groupe alkyle en C₁-C₁₀, un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe naphtyle, un groupe pyridinyle, un groupe pyrimidinyle, ou n'importe quelle combinaison de ceux-ci ;
un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe alkylphényle en C₁-C₁₀, un groupe naphtyle, un groupe fluorényle, un groupe phénanthrényle, un groupe anthracényle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe benzimidazolyle, un groupe benzofuranyle, un groupe benzothiophényle, un groupe dibenzofuranyle, ou un groupe dibenzothiophényle, chacun non substitué ou substitué avec un deutérium, -F, -CD₃, -CD₂H, -CDH₂, -CF₃, -CF₂H, -CFH₂, un groupe alkyle en C₁-C₂₀, un groupe alcoxy en C₁-C₂₀, un groupe cyclopentyle, un groupe cyclohexyle, un groupe cycloheptyle, un groupe cyclopentényle, un groupe cyclohexényle, un groupe cycloheptényle, un groupe phényle, un groupe biphényle, un groupe alkylphényle en C₁-C₁₀, un groupe naphtyle, un groupe fluorényle, un groupe phénanthrényle, un groupe anthracényle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe benzimidazolyle, un groupe benzofuranyle, un groupe benzothiophényle, un groupe dibenzofuranyle, un groupe dibenzothiophényle, - O(Q₃₁), -S(Q₃₁), -Si(Q₃₁)(Q₃₂)(Q₃₃), -N(Q₃₁)(Q₃₂), ou n'importe quelle combinaison de ceux-ci ; ou
-C(Q₁)(Q₂)(Q₃), -Si(Q₁)(Q₂)(Q₃), ou -N(Q₁)(Q₂), et
Q₁ à Q₃ et Q₃₁ à Q₃₃ sont chacun indépendamment : un hydrogène, un deutérium, -F, un groupe alkyle en C₁-C₆₀, un groupe alcényle en C₂-C₆₀, un groupe alcynyle en C₂-C₆₀, ou un groupe alcoxy en C₁-C₆₀ ; ou un groupe carbocyclique en C₃-C₆₀ ou un groupe hétérocyclique en C₁-C₆₀, chacun non substitué ou substitué avec un deutérium, -F, un groupe alkyle en C₁-C₆₀, un groupe alcoxy en C₁-C₆₀, un groupe phényle, un groupe biphényle, ou n'importe quelle combinaison de ceux-ci.

6. Composé organométallique selon la revendication 1, dans lequel un groupe représenté par 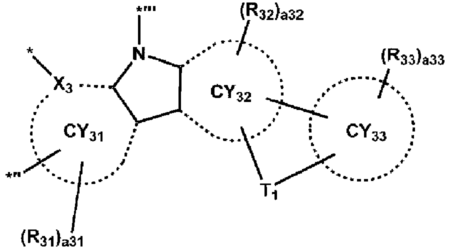 dans la formule 1-1 est un groupe représenté par l'une des formules CY3-1(1) à CY3-1(6), et
un groupe représenté par 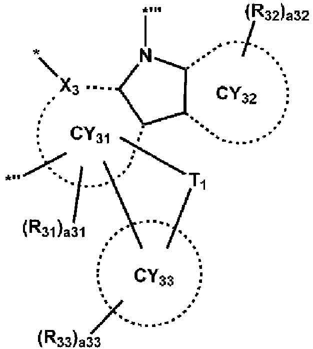 dans la formule 1-2 est un groupe représenté par la formule CY3-2(1) ou CY3-2(2) : 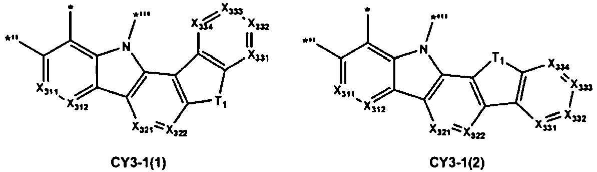 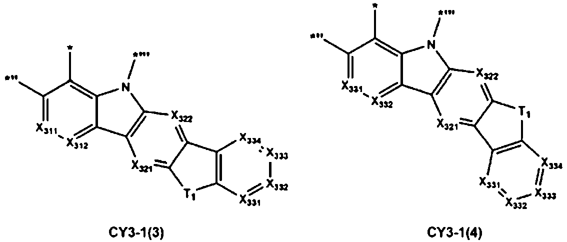 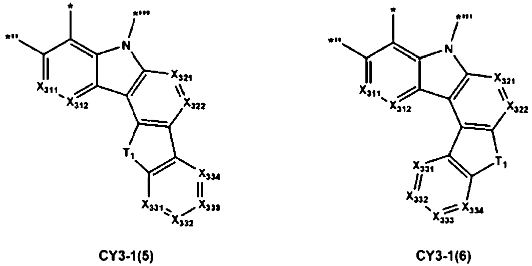 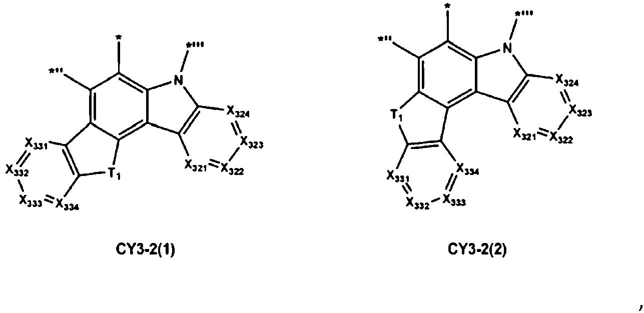 et
dans lequel, dans les formules CY3-1(1) à CY3-1(6), CY3-2(1) et CY3-2(2),
X₃₁₁ est C(R₃₁₁) ou N, et X₃₁₂ est C(R₃₁₂) ou N,
X₃₂₁ est C(R₃₂₁) ou N, X₃₂₂ est C(R₃₂₂) ou N, X₃₂₃ est C(R₃₂₃) ou N, et X₃₂₄ est C(R₃₂₄) ou N,
X₃₃₁ est C(R₃₃₁) ou N, X₃₃₂ est C(R₃₃₂) ou N, X₃₃₃ est C(R₃₃₃) ou N, et X₃₃₄ est C(R₃₃₄) ou N,
T₁ est tel que défini dans la formule 1-1 ou la formule 1-2,
R₃₁₁ et R₃₁₂ sont chacun tels que définis pour R₃₁ dans la formule 1-1 ou la formule 1-2,
R₃₂₁ à R₃₂₄ sont chacun tels que définis pour R₃₂ dans la formule 1-1 ou la formule 1-2,
R₃₃₁ à R₃₃₄ sont chacun tels que définis pour R₃₃ dans la formule 1-1 ou la formule 1-2,
deux groupes voisins ou plus parmi R₃₁₁, R₃₁₂, R₃₂₁ à R₃₂₄, et R₃₃₁ à R₃₃₄ sont facultativement liés les uns aux autres pour former un groupe carbocyclique en C₃-C₆₀ non substitué ou substitué avec au moins un R₁₀ₐ ou un groupe hétérocyclique en C₁-C₆₀ non substitué ou substitué avec au moins un R₁₀ₐ,
* indique un site de liaison à M dans la formule 1-1 ou la formule 1-2,
*" indique un site de liaison à L₂ dans la formule 1-1 ou la formule 1-2, et
*"' indique un site de liaison à L₃ dans la formule 1-1 ou la formule 1-2.

7. Composé organométallique selon la revendication 1, dans lequel,
dans les formules 1-1 et 1-2,
un groupe représenté par 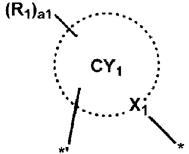 est un groupe représenté par l'une des formules CY1(1) à CY1(11),
un groupe représenté par 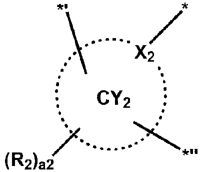 est un groupe représenté par l'une des formules CY2(1) à CY2(13), et
un groupe représenté par 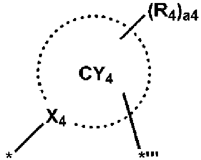 est un groupe représenté par l'une des formules CY4(1) à CY4(29) : 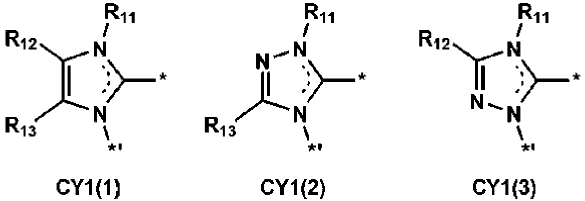 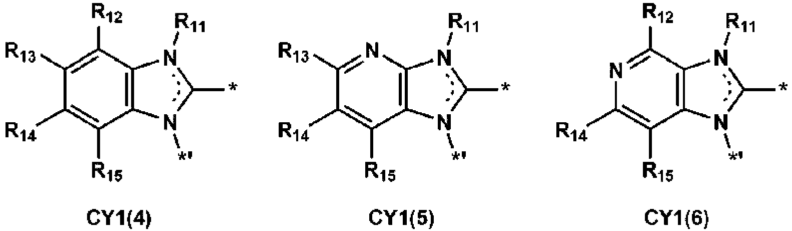 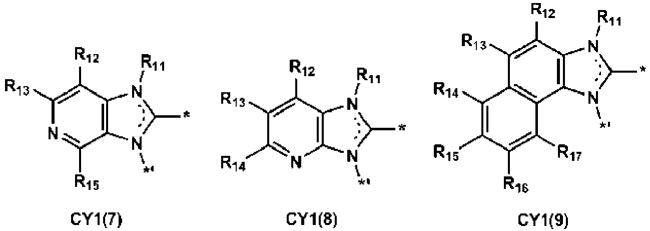 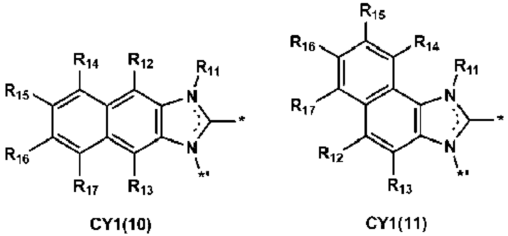 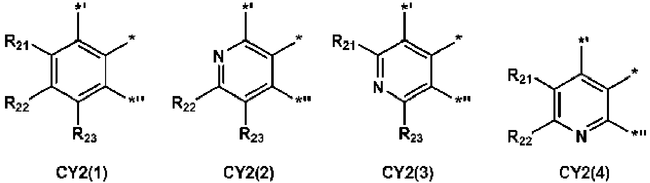 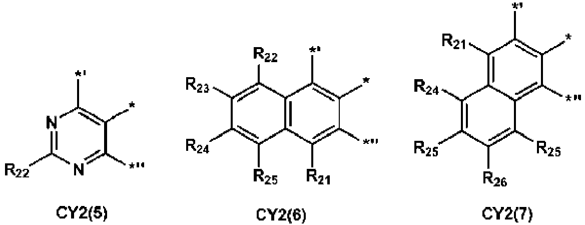 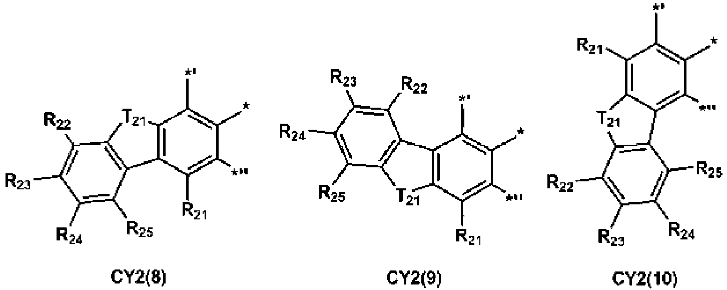 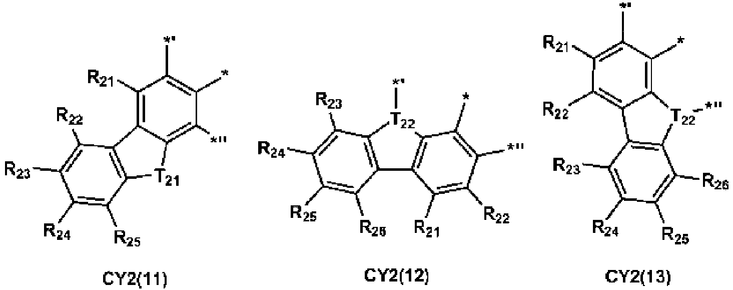 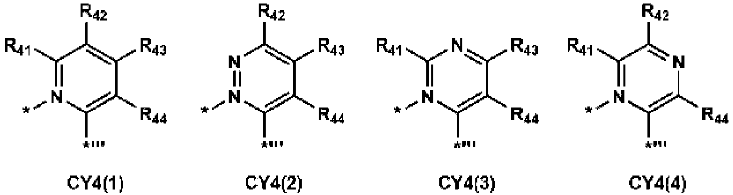 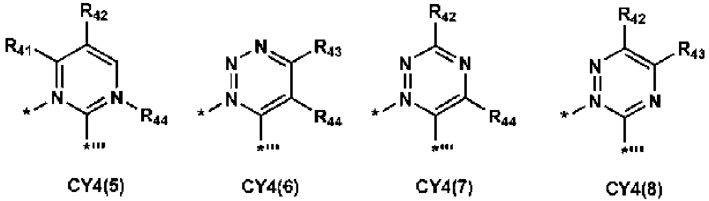 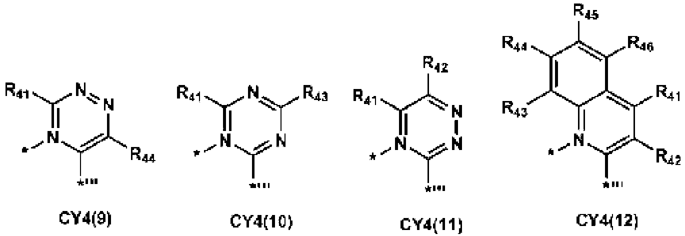 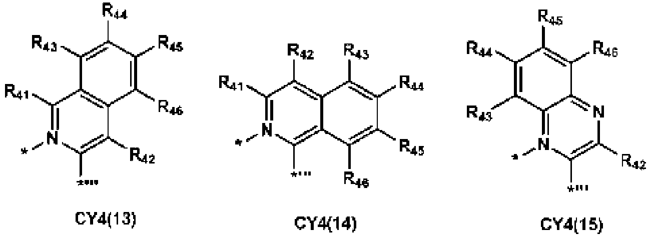 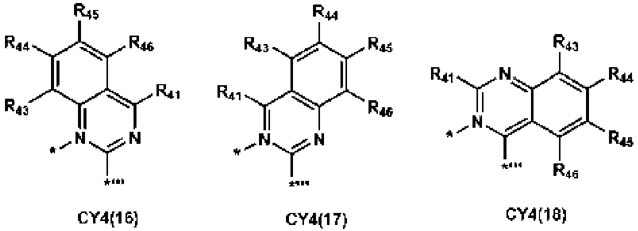 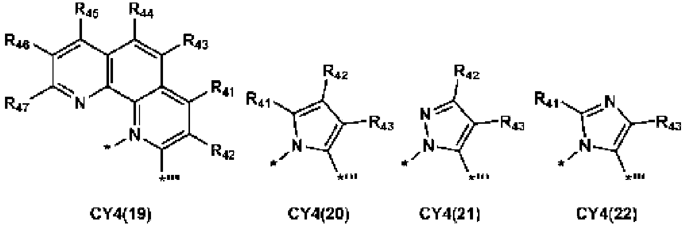 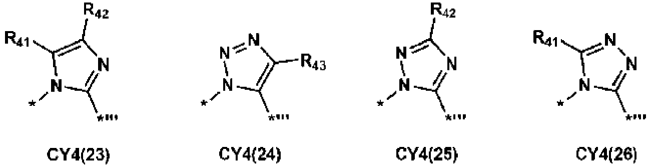 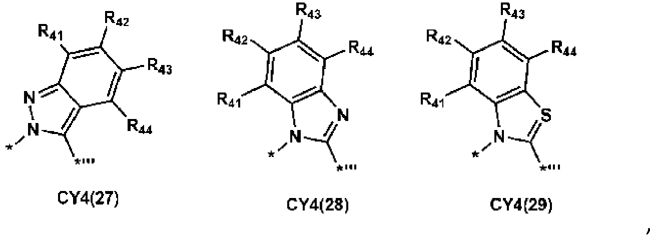 et
dans lequel, dans les formules CY1(1) à CY1(11), CY2(1) à CY2(13), et CY4(1) à CY4(29),
T₂₁ est B(Y₂₁), C(Y₂₁)(Y₂₂), N(Y₂₁), O, S, ou Si(Y₂₁)(Y₂₂),
T₂₂ est C(Y₂₁), N, ou Si(Y₂₁),
R₁₁ à R₁₇ sont chacun tels que définis pour R₁ dans la formule 1-1 ou la formule 1-2,
R₂₁ à R₂₆, Y₂₁, et Y₂₂ sont chacun tels que définis pour R₂ dans la formule 1-1 ou la formule 1-2, R₄₁ à R₄₇ sont chacun tels que définis pour R₄ dans la formule 1-1 ou la formule 1-2, * indique un site de liaison à M dans la formule 1-1 ou la formule 1-2,
*' indique un site de liaison à L₁ dans la formule 1-1 ou la formule 1-2,
*" indique un site de liaison à L₂ dans la formule 1-1 ou la formule 1-2, et
*"' indique un site de liaison à L₃ dans la formule 1-1 ou la formule 1-2.

8. Composé organométallique selon la revendication 1, dans lequel le composé organométallique représenté par la formule 1-1 est un groupe représenté par la formule 1-1(A1) ou 1-1(A2), ou
le composé organométallique représenté par la formule 1-2 est un groupe représenté par la formule 1-2(A1) ou 1-2(A2) : 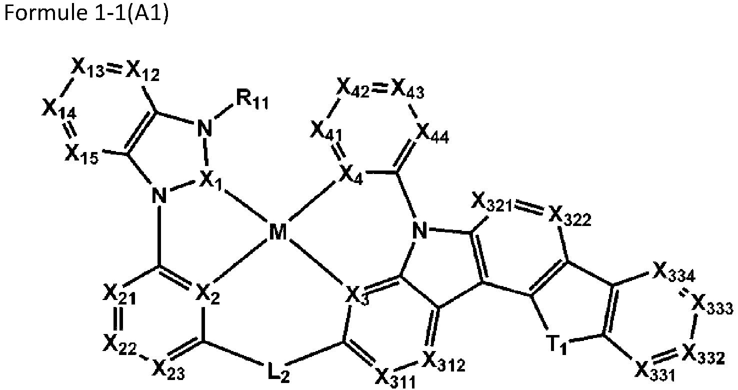 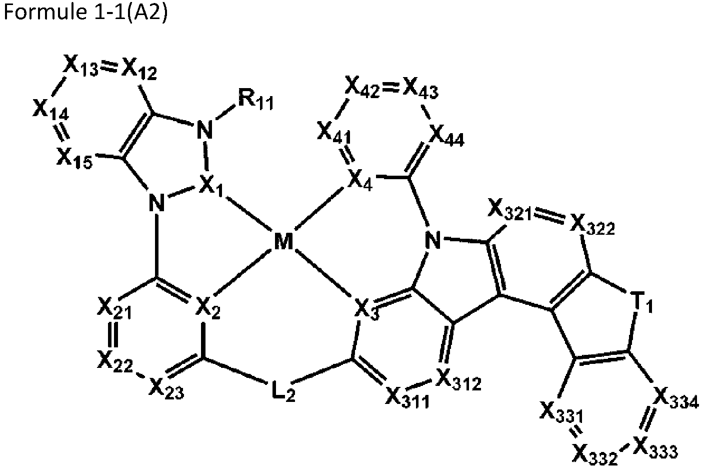 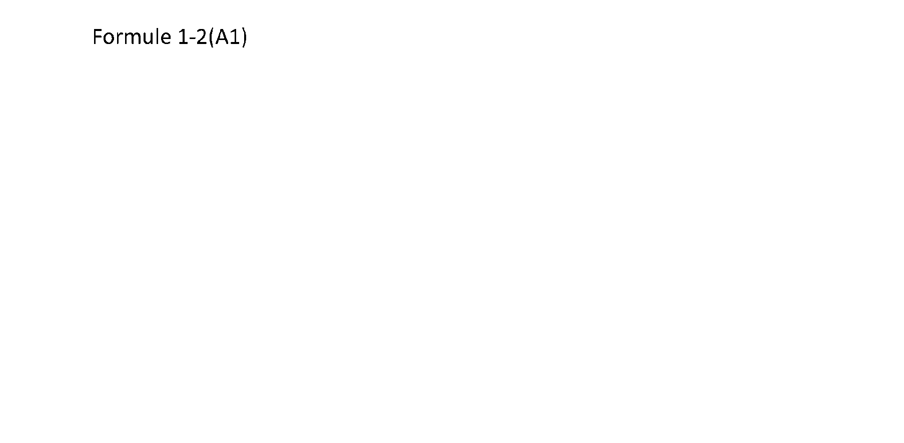 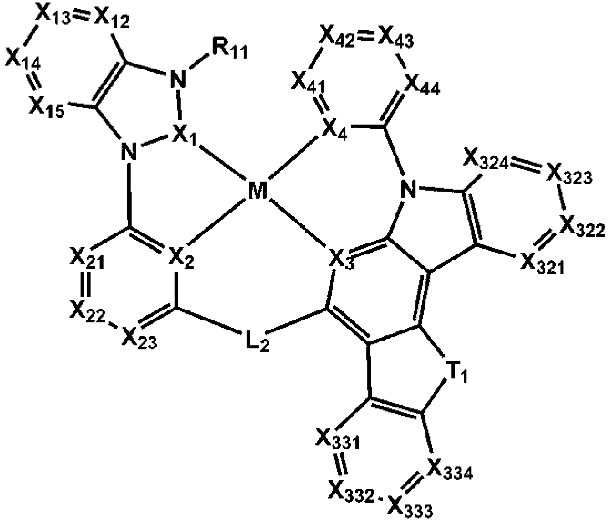 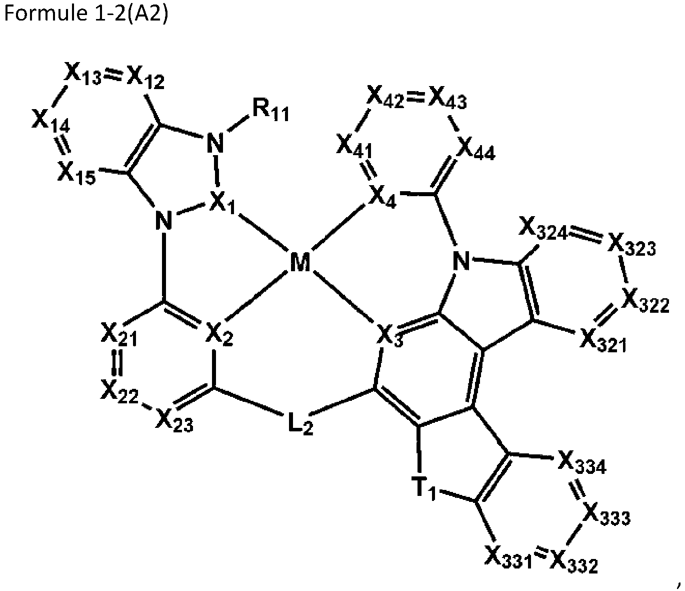 et
dans lequel, dans les formules 1-1(A1), 1-1(A2), 1-2(A1) et 1-2(A2),
M, X₁ à X₄ et T₁ sont chacun tels que définis dans la formule 1-1 ou la formule 1-2,
L₂ est *-O-*', *-S-*', ou *-Se-*',
X₁₂ est C(R₁₂) ou N, X₁₃ est C(R₁₃) ou N, X₁₄ est C(R₁₄) ou N, et X₁₅ est C(R₁₅) ou N,
X₂₁ est C(R₂₁) ou N, X₂₂ est C(R₂₂) ou N, et X₂₃ est C(R₂₃) ou N,
X₃₁₁ est C(R₃₁₁) ou N, X₃₁₂ est C(R₃₁₂) ou N, X₃₂₁ est C(R₃₂₁) ou N, X₃₂₂ est C(R₃₂₂) ou N, X₃₂₃ est C(R₃₂₃) ou N, X₃₂₄ est C(R₃₂₄) ou N, X₃₃₁ est C(R₃₃₁) ou N, X₃₃₂ est C(R₃₃₂) ou N, X₃₃₃ est C(R₃₃₃) ou N, et X₃₃₄ est C(R₃₃₄) ou N,
X₄₁ est C(R₄₁) ou N, X₄₂ est C(R₄₂) ou N, X₄₃ est C(R₄₃) ou N, et X₄₄ est C(R₄₄) ou N,
R₁₁ à R₁₅ sont chacun tels que définis pour R₁ dans la formule 1-1 ou la formule 1-2,
R₂₁ à R₂₃ sont chacun tels que définis pour R₂ dans la formule 1-1 ou la formule 1-2,
R₃₁₁ et R₃₁₂ sont chacun tels que définis pour R₃₁ dans la formule 1-1 ou la formule 1-2,
R₃₂₁ à R₃₂₄ sont chacun tels que définis pour R₃₂ dans la formule 1-1 ou la formule 1-2,
R₃₃₁ à R₃₃₄ sont chacun tels que définis pour R₃₃ dans la formule 1-1 ou la formule 1-2,
R₄₁ à R₄₄ sont chacun tels que définis pour R₄ dans la formule 1-1 ou la formule 1-2,
deux groupes voisins ou plus parmi R₁₁ à R₁₅, R₂₁ à R₂₃, R₃₁₁, R₃₁₂, R₃₂₁ à R₃₂₄, R₃₃₁ à R₃₃₄, R₄₁ à R₄₄, Z₁, et Z₂ sont facultativement liés les uns aux autres pour former un groupe carbocyclique en C₃-C₆₀ non substitué ou substitué avec au moins un R₁₀ₐ ou un groupe hétérocyclique en C₁-C₆₀ non substitué ou substitué avec au moins un R₁₀ₐ, et
R₁₀ₐ est tel que défini dans la formule 1-1 ou la formule 1-2.

9. Composé organométallique selon la revendication 1, dans lequel le composé organométallique est sélectionné parmi les composés 1 à 72 :

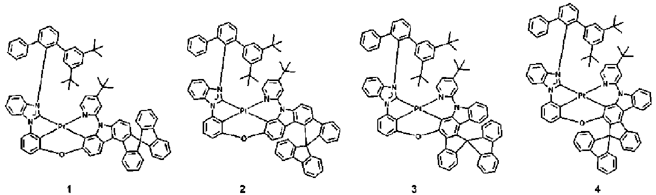

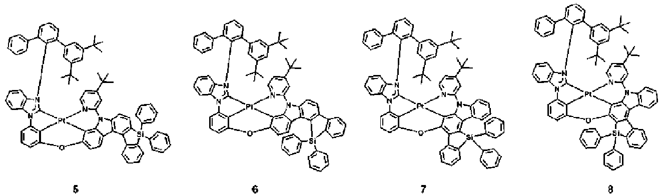

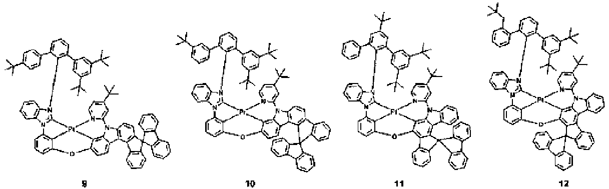

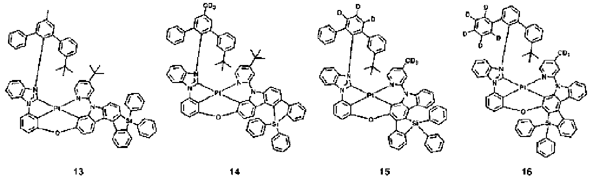

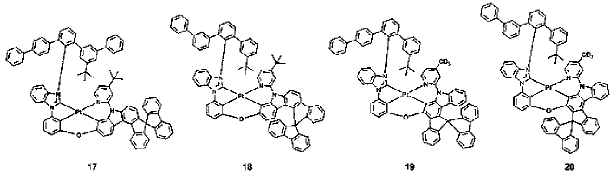

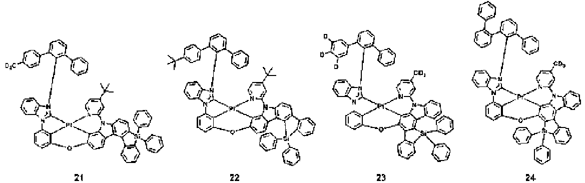

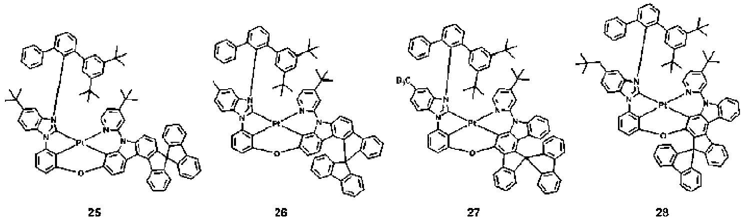

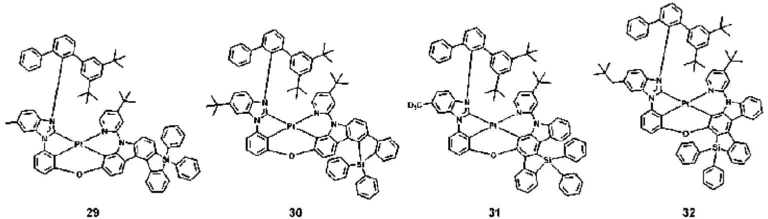

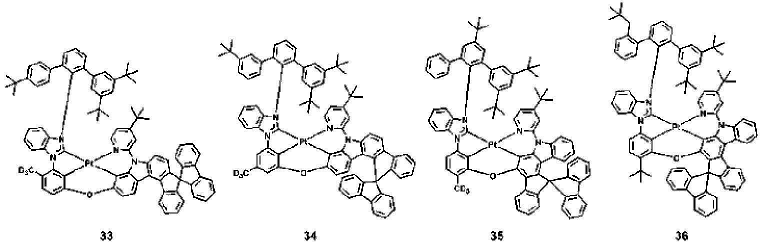

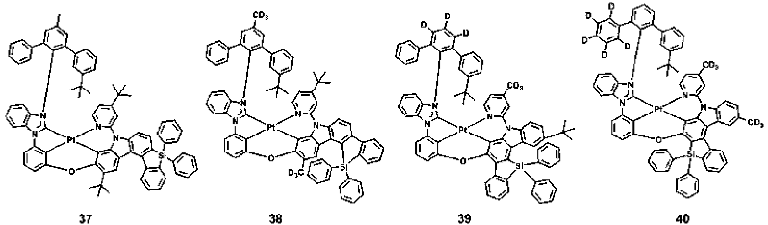

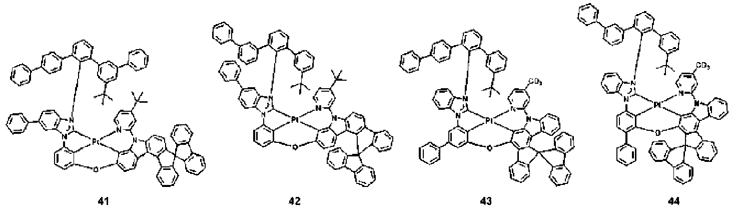

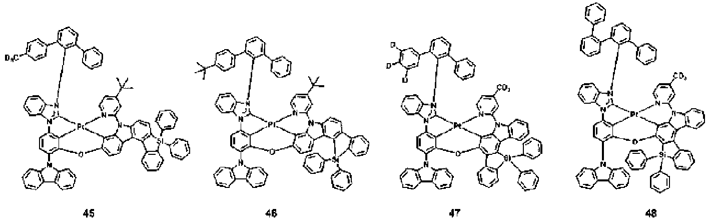

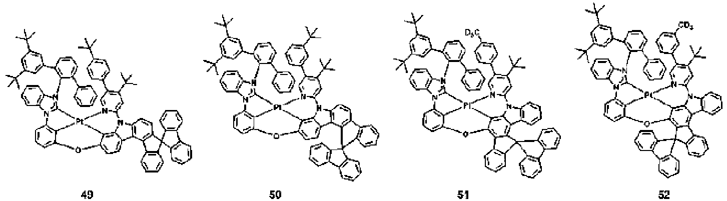

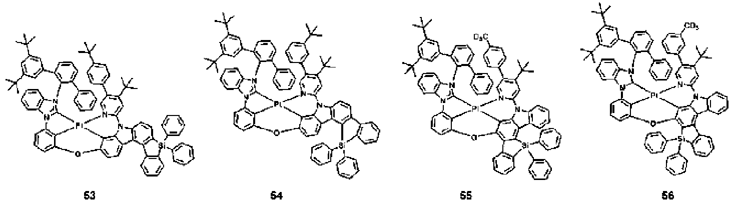

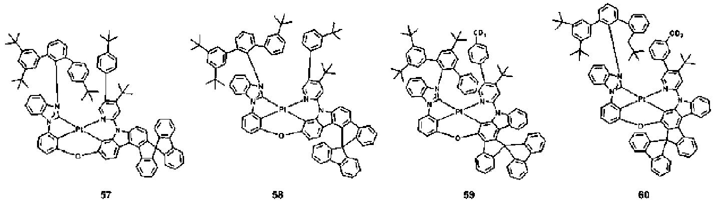

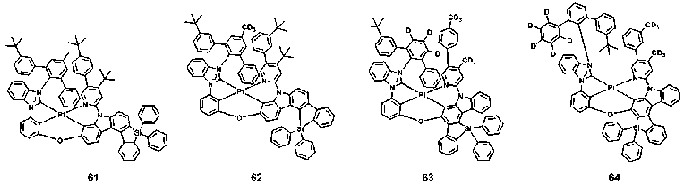

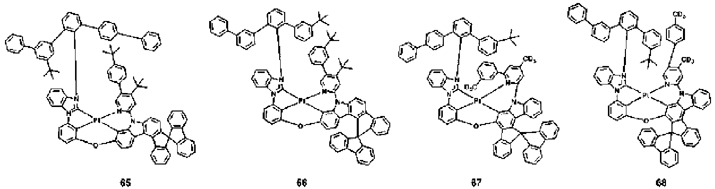

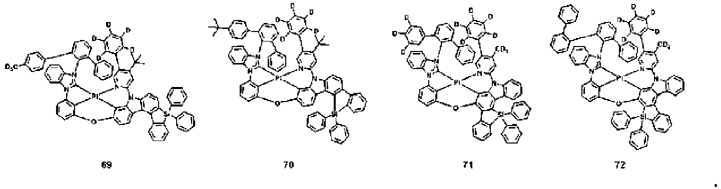

10. Dispositif émetteur de lumière (10) comprenant :
une première électrode (110) ;
une seconde électrode (150) faisant face à la première électrode (110) ;
une couche intermédiaire (130) entre la première électrode (110) et la seconde électrode (150) et comprenant une couche d'émission ; **caractérisé en ce que** le dispositif émetteur de lumière (10) comprend
un composé organométallique selon la revendication 1.

11. Dispositif émetteur de lumière (10) selon la revendication 10, dans lequel la couche d'émission comprend un hôte et un dopant, et
le dopant comprend le composé organométallique.

12. Dispositif émetteur de lumière (10) selon la revendication 10 ou 11, comprenant en outre un deuxième composé comprenant au moins un groupe hétérocyclique comportant 1 à 60 atomes de carbone et incluant *-N=*' en tant que fragment formant un cycle, un troisième composé comprenant un groupe représenté par la formule 3, un quatrième composé pour émettre une fluorescence retardée, ou n'importe quelle combinaison de ceux-ci,
dans lequel le composé organométallique, le deuxième composé, le troisième composé et le quatrième composé sont différents les uns des autres : 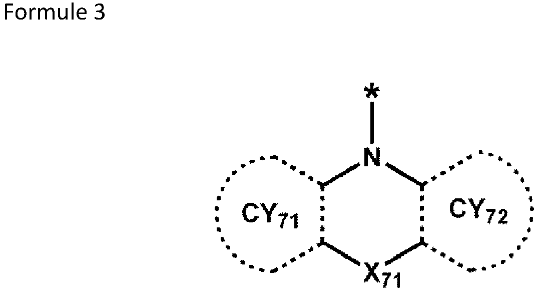
dans lequel, dans la formule 3,
le cycle CY₇₁ et le cycle CY₇₂ sont chacun indépendamment un groupe cyclique ayant 3 à 60 atomes de carbone et n'incluant pas *-N=*' en tant que fragment formant un cycle ou un groupe pyridine,
X₇₁ est une liaison simple, ou un groupe de liaison comprenant O, S, N, B, C, Si ou n'importe quelle combinaison de ceux-ci, et
* indique un site de liaison à tout atome inclus dans une partie restante du troisième composé autre que le groupe représenté par la formule 3.

13. Dispositif émetteur de lumière (10) selon la revendication 12, dans lequel le deuxième composé comprend un groupe pyridine, un groupe pyrimidine, un groupe pyrazine, un groupe pyridazine, un groupe triazine, ou n'importe quelle combinaison de ceux-ci, et
le quatrième composé est un composé comprenant un groupe cyclique comprenant un bore (B) et un azote (N) en tant qu'atomes formant un cycle.

14. Dispositif émetteur de lumière (10) selon la revendication 12, dans lequel la couche d'émission comprend :
i) le composé organométallique ; et
ii) le deuxième composé, le troisième composé, le quatrième composé, ou n'importe quelle combinaison de ceux-ci, et
la couche d'émission est configurée pour émettre une lumière bleue.

15. Appareil électronique comprenant le dispositif émetteur de lumière (10) selon la revendication 10.

16. Appareil électronique selon la revendication 15, comprenant en outre un transistor à couche mince (TFT),
dans lequel le transistor à couche mince (TFT) comprend une électrode de source (260) et une électrode de drain (270), et
la première électrode (110) du dispositif émetteur de lumière (10) est connectée électriquement à l'électrode de source (260) ou à l'électrode de drain (270) du transistor à couche mince (TFT).

17. Appareil électronique selon la revendication 15, comprenant en outre un filtre de couleur, une couche de conversion de couleur, une couche d'écran tactile, une couche de polarisation, ou n'importe quelle combinaison de ceux-ci.

18. Équipement électronique comprenant le dispositif émetteur de lumière (10) selon la revendication 10.

19. Équipement électronique selon la revendication 18, dans lequel l'équipement électronique est au moins l'un sélectionné parmi un écran plat, un écran incurvé, un moniteur d'ordinateur, un moniteur médical, un téléviseur, un panneau publicitaire, un éclairage intérieur ou extérieur et/ou un éclairage de signalisation, un affichage tête haute, un écran totalement ou partiellement transparent, un écran flexible, un écran enroulable, un écran pliable, un écran extensible, une imprimante laser, un téléphone, un téléphone portable, une tablette, une phablette, un assistant numérique personnel (PDA), un dispositif portable, un ordinateur portable, un appareil photo numérique, un caméscope, un viseur, un micro-écran, un écran tridimensionnel (3D), un écran de réalité virtuelle ou de réalité augmentée, un véhicule, un mur vidéo à plusieurs écrans juxtaposés, un écran de théâtre ou de stade, un dispositif de photothérapie, un panneau de signalisation, et les combinaisons de ceux-ci.
